# EUROPÄISCHE PATENTSCHRIFT

(11) **EP 3 601 304 B1**
(45) Veröffentlichungstag und Bekanntmachung des Hinweises auf die Patenterteilung: **27.10.2021**
(21) Anmeldenummer: 18712235.3
(22) Anmeldetag: 26.03.2018
(51) Int. Cl.: C07F 15/00, C09K 11/06, H01L 51/50, H01L 51/00

(54) **METALLKOMPLEXE**
METAL COMPLEXES
COMPLEXES MÉTALLIQUES

(30) Priorität: 29.03.2017 EP 17163531; 04.12.2017 EP 17205103
(43) Veröffentlichungstag der Anmeldung: 05.02.2020
(73) Patentinhaber: Merck Patent GmbH, 64293 Darmstadt (DE)
(72) Erfinder: STOESSEL, Philipp, 60389 Frankfurt am Maim (DE); AUCH, Armin, 64297 Darmstadt (DE); MAY, Falk, 55124 Mainz (DE); PFISTER, Jochen, 64342 Seeheim-Jugenheim (DE)
(86) Internationale Anmeldenummer: PCT/EP2018/057621
(87) Internationale Veröffentlichungsnummer: WO 2018/178001

(56) Entgegenhaltungen:
- WO-A1-2016/124304
- WO-A1-2018/019687
- WO-A1-2018/019688

## Beschreibung

Die vorliegende Erfindung betrifft Iridiumkomplexe, welche sich für den Einsatz in organischen Elektrolumineszenzvorrichtungen, insbesondere als Emitter, eignen.

Gemäß dem Stand der Technik werden in phosphoreszierenden organischen Elektrolumineszenzvorrichtungen (OLEDs) als Triplettemitter vor allem Iridiumkomplexe eingesetzt, insbesondere bis- oder tris-orthometallierte Komplexe mit aromatischen Liganden, wobei die Liganden über ein negativ geladenes Kohlenstoffatom und ein neutrales Stickstoffatom oder über ein negativ geladenes Kohlenstoffatom und ein neutrales Carben-Kohlenstoffatom an das Metall binden. Beispiele für solche Komplexe sind Tris(phenylpyridyl)iridium(III) und Derivate davon, sowie eine Vielzahl verwandter Komplexe, beispielsweise mit 1- oder 3-Phenylisochinolinliganden oder mit 2-Phenylchinolinliganden. Derartige Komplexe sind auch mit polypodalen Liganden bekannt, wie beispielsweise in WO 2016/124304 beschrieben. Auch wenn diese Komplexe mit polypodalen Liganden Vorteile gegenüber den Komplexen zeigen, die ansonsten die gleiche Ligandenstruktur aufweisen, deren einzelne Liganden jedoch nicht polypodal verbrückt sind, gibt es noch Verbesserungsbedarf. Dieser liegt insbesondere in der Effizienz der Lumineszenz der Verbindungen, wodurch auch eine höhere Lebensdauer erreicht werden kann.

Aufgabe der vorliegenden Erfindung ist daher die Bereitstellung verbesserter Metallkomplexe, welche sich als Emitter für die Verwendung in OLEDs eignen. Insbesondere ist es die Aufgabe der Erfindung, Metallkomplexe bereitzustellen, welche bei Verwendung als Emitter in einer OLED zu einer verbesserten EQE und einer verbesserten Leistungseffizienz führen und somit in Folge weiterhin auch zu einer verbesserten Lebensdauer führen.

Überraschend wurde gefunden, dass Metallkomplexe mit einem hexadentaten tripodalen Liganden, die die nachfolgend beschriebene Struktur aufweisen, diese Aufgabe lösen und sich sehr gut für die Verwendung in einer organischen Elektrolumineszenzvorrichtung eignen. Diese Metallkomplexe und organische Elektrolumineszenzvorrichtungen, welche diese Komplexe enthalten, sind daher der Gegenstand der vorliegenden Erfindung.

Gegenstand der Erfindung ist somit eine Verbindung der Formel (1), 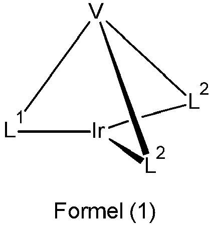
wobei für die verwendeten Symbole gilt:
   - L¹: ist ein Teilligand gemäß einer der folgenden Formel (2a) bis (2d), der über die beiden Gruppen D an das Iridium koordiniert und der über die gestrichelte Bindung an V gebunden ist, 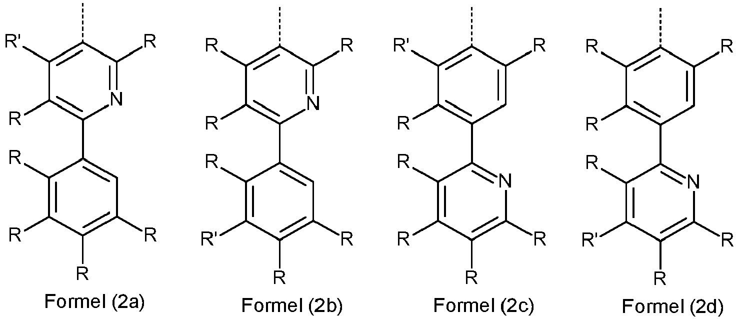 wobei gilt:
   R' ist eine Gruppe der folgenden Formel (3), 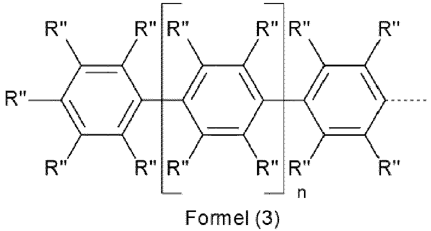 wobei die gestrichelte Bindung die Verknüpfung der Gruppe andeutet;
   R" ist gleich oder verschieden bei jedem Auftreten H, D, F, CN, eine geradkettige Alkylgruppe mit 1 bis 10 C-Atomen, in der auch ein oder mehrere H-Atome durch D oder F ersetzt sein können, oder eine verzweigte oder cyclische Alkylgruppe mit 3 bis 10 C-Atomen, in der auch ein oder mehrere H-Atome durch D oder F ersetzt sein können, oder eine Alkenylgruppe mit 2 bis 10 C-Atomen, in der auch ein oder mehrere H-Atome durch D oder F ersetzt sein können; dabei können auch zwei benachbarte Reste R" bzw. zwei Reste R" an benachbarten Phenylgruppen mitein-ander ein Ringsystem bilden; oder zwei R" an benachbarten Phenylgruppen stehen zusammen für eine Gruppe ausgewählt aus O oder S, so dass die beiden Phenylringe zusammen mit der verbrückenden Gruppe für ein Dibenzofuran oder Dibenzothiophen stehen, und die weiteren R" sind wie vorstehend definiert;
   n ist 0, 1, 2, 3, 4 oder 5;
   - L²: ist gleich oder verschieden bei jedem Auftreten ein bidentater, monoanionischer Teilligand, der über ein Kohlenstoffatom und ein Stickstoffatom oder über zwei Kohlenstoffatome oder über zwei Stickstoffatome an das Iridium koordiniert und der mit einem oder mehreren Resten R substituiert sein kann;
   - V: ist eine Gruppe der Formel (6b) oder (7b), wobei die gestrichelten Bindungen die Position der Verknüpfung der Teilliganden L¹ und L² darstellen, 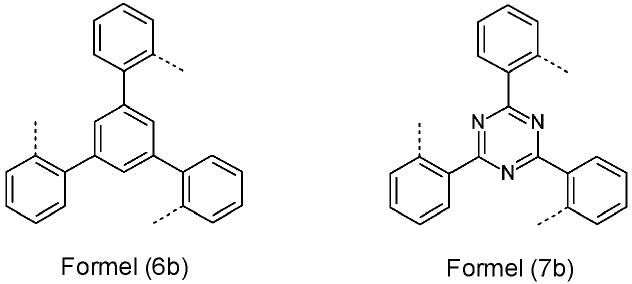
   wobei gilt:
   - R: ist bei jedem Auftreten gleich oder verschieden H, D, F, Cl, Br, I, N(R¹)₂, OR¹, SR¹, CN, NO₂, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann und wobei eine oder mehrere nicht benachbarte CH₂-Gruppen durch Si(R¹)₂, C=O, NR¹, O, S oder CONR¹ ersetzt sein können, oder eine Aryl- oder Heteroarylgruppe mit 5 bis 10 aromatischen Ringatomen, die jeweils durch einen oder mehrere nicht-aromatische Reste R¹ substituiert sein kann; dabei können zwei Reste R auch miteinander ein aliphatisches oder heteroaliphatisches Ringsystem bilden;
   - R¹: ist bei jedem Auftreten gleich oder verschieden H, D, F, Cl, Br, I, N(R²)₂, OR², SR², CN, NO₂, Si(R²)₃, B(OR²)₂, C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere nicht benachbarte CH₂-Gruppen durch Si(R²)₂, C=O, NR², O, S oder CONR² ersetzt sein können, oder eine Aryl- oder Heteroarylgruppe mit 5 bis 10 aromatischen Ringatomen, die jeweils durch einen oder mehrere Reste R² substituiert sein kann; dabei können zwei oder mehrere Reste R¹ miteinander ein aliphatisches oder heteroaliphatisches Ringsystem bilden;
   - R²: ist bei jedem Auftreten gleich oder verschieden H, D, F oder ein aliphatischer organischer Rest, insbesondere ein Kohlenwasserstoffrest, mit 1 bis 20 C-Atomen, in dem auch ein oder mehrere H-Atome durch F ersetzt sein können;
dabei können die drei bidentaten Teilliganden L¹ und L² außer durch die Brücke V auch noch durch eine weitere Brücke zu einem Kryptat geschlossen sein;
dabei ist die folgende Verbindung von der Erfindung ausgenommen:

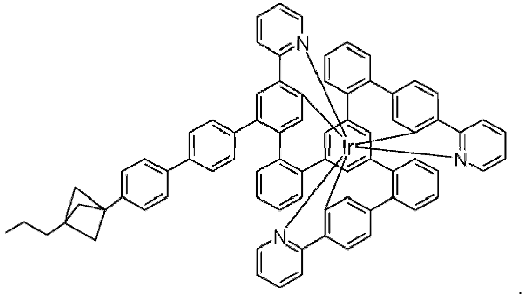

Bei dem Liganden handelt es sich erfindungsgemäß somit um einen hexadentaten, tripodalen Liganden mit einem bidentaten Teilliganden L¹ und zwei bidentaten Teilliganden L². Dabei bedeutet bidentat, dass der jeweilige Teilligand im Komplex über zwei Koordinationsstellen an das Iridium koordiniert bzw. bindet. Tripodal bedeutet, dass der Ligand drei Teilliganden aufweist, die an die Brücke V bzw. die Brücke der Formel (6b) bzw. (7b) gebunden sind. Da der Ligand drei bidentate Teilliganden aufweist, ergibt sich insgesamt ein hexadentater Ligand, also ein Ligand, der über sechs Koordinationsstellen an das Iridium koordiniert bzw. bindet. Der Begriff "bidentater Teilligand" bedeutet im Sinne dieser Anmeldung, dass es sich bei L¹ bzw. L² jeweils um einen bidentaten Liganden handeln würde, wenn die Brücke V bzw. die Brücke der Formel (6b) bzw. (7b) nicht vorhanden wäre. Durch die formale Abstraktion eines Wasserstoffatoms von diesem bidentaten Liganden und die Anknüpfung an die Brücke V bzw. die Brücke der Formel (6b) bzw. (7b) ist dieser jedoch kein separater Ligand mehr, sondern ein Teil des so entstehenden hexadentaten Liganden, so dass hierfür der Begriff "Teilligand" verwendet wird.

Wenn in der vorliegenden Anmeldung die Rede davon ist, dass der Ligand bzw. ein Teilligand an das Iridium koordiniert oder bindet, so bezeichnet dies im Sinne der vorliegenden Anmeldung jede Art der Bindung von dem Liganden bzw. Teilliganden an das Iridium, unabhängig vom kovalenten Anteil der Bindung.

Wenn zwei Reste R bzw. R¹ miteinander ein Ringsystem bilden, so kann dieses mono- oder polycyclisch, aliphatisch oder heteroaliphatisch sein. Dabei können diese Reste, die miteinander ein Ringsystem bilden, benachbart sein, d. h. dass diese Reste an dasselbe Kohlenstoffatom oder an Kohlenstoffatome, die direkt aneinander gebunden sind, gebunden sind, oder sie können weiter voneinander entfernt sein. Bevorzugt ist eine solche Ringbildung bei Resten, die an direkt aneinander gebundene Kohlenstoffatome gebunden sind. Wenn zwei Reste R" in Formel (3) miteinander ein Ringsystem bilden, dann handelt es sich dabei um ein aliphatisches Ringsystem. Bei Ringbildung von zwei Substituenten R" an benachbarten Phenylgruppen entsteht ein Fluoren bzw. ein Phenanthren bzw. ein Triphenylen. Ebenso können, wie vorne beschrieben, zwei R" an benachbarten Phenylgruppen zusammen für eine Gruppe ausgewählt aus O oder S stehen, so dass die beiden Phenylringe zusammen mit der verbrückenden Gruppe für ein Dibenzofuran oder Dibenzothiophen stehen.

Unter der Formulierung, dass zwei oder mehr Reste miteinander einen Ring bilden können, soll im Rahmen der vorliegenden Beschreibung unter anderem verstanden werden, dass die beiden Reste miteinander durch eine chemische Bindung unter formaler Abspaltung von zwei Wasserstoffatomen verknüpft sind. Dies wird durch das folgende Schema verdeutlicht.

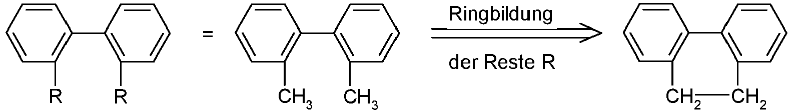

Weiterhin soll unter der oben genannten Formulierung auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

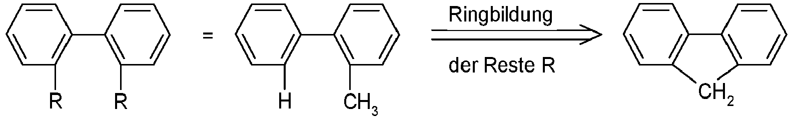

Weiterhin soll unter der oben genannten Formulierung auch verstanden werden, dass für den Fall, dass die beiden Reste Alkenylgruppen darstellen, die Reste unter Bildung einer ankondensierten Arylgruppe miteinander einen Ring bilden. Analog ist bei einem Aryloxy-Substituenten die Bildung einer ankondensierten Benzofurangruppe und bei einem Arylamino-Substituenten die Bildung einer ankondensierten Indolgruppe möglich. Dies soll durch die folgenden Schemata verdeutlicht werden:

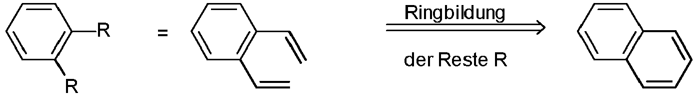

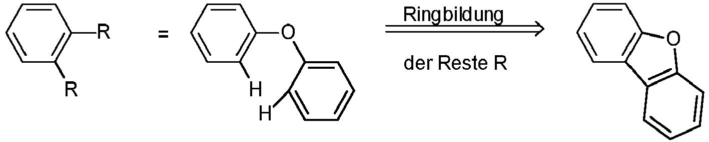

Unter einer cyclischen Alkyl-, Alkoxy- oder Thioalkoxygruppe im Sinne dieser Erfindung wird eine monocyclische, eine bicyclische oder eine polycyclische Gruppe verstanden.

Im Rahmen der vorliegenden Erfindung werden unter einer C₁-bis C₂₀-Alkylgruppe, in der auch einzelne H-Atome oder CH₂-Gruppen durch die oben genannten Gruppen substituiert sein können, beispielsweise die Reste Methyl, Ethyl, n-Propyl, i-Propyl, Cyclopropyl, n-Butyl, i-Butyl, s-Butyl, t-Butyl, Cyclobutyl, 2-Methylbutyl, n-Pentyl, s-Pentyl, t-Pentyl, 2-Pentyl, neo-Pentyl, Cyclopentyl, n-Hexyl, s-Hexyl, t-Hexyl, 2-Hexyl, 3-Hexyl, neo-Hexyl, Cyclohexyl, 1-Methylcyclopentyl, 2-Methylpentyl, n-Heptyl, 2-Heptyl, 3-Heptyl, 4-Heptyl, Cycloheptyl, 1-Methylcyclohexyl, n-Octyl, 2-Ethylhexyl, Cyclooctyl, 1-Bicyclo[2,2,2]octyl, 2-Bicyclo[2,2,2]-octyl, 2-(2,6-Dimethyl)octyl, 3-(3,7-Dimethyl)octyl, Adamantyl, Trifluormethyl, Pentafluorethyl, 2,2,2-Trifluorethyl, 1,1-Dimethyl-n-hex-1-yl-, 1,1-Dimethyl-n-hept-1-yl-, 1,1-Dimethyl-n-oct-1-yl-, 1,1-Dimethyl-n-dec-1 -yl-, 1,1-Dimethyl-n-dodec-1-yl-, 1,1-Dimethyl-n-tetradec-1-yl-, 1,1-Dimethyl-n-hexadec-1-yl-, 1,1-Dimethyl-n-octadec-1-yl-, 1,1-Diethyl-n-hex-1-yl-, 1,1-Diethyl-n-hept-1-yl-, 1,1-Diethyl-n-oct-1-yl-, 1,1-Diethyl-n-dec-1-yl-, 1,1-Diethyl-n-dodec-1-yl-, 1,1-Diethyl-n-tetradec-1-yl-, 1,1-Diethyln-n-hexadec-1-yl-, 1,1-Diethyl-n-octadec-1-yl-, 1-(n-Propyl)-cyclohex-1-yl-, 1-(n-Butyl)-cyclohex-1-yl-, 1-(n-Hexyl)-cyclohex-1-yl-, 1-(n-Octyl)-cyclohex-1-yl- und 1-(n-Decyl)-cyclohex-1-yl- verstanden. Unter einer Alkenylgruppe werden beispielsweise Ethenyl, Propenyl, Butenyl, Pentenyl, Cyclopentenyl, Hexenyl, Cyclohexenyl, Heptenyl, Cycloheptenyl, Octenyl, Cyclooctenyl oder Cyclooctadienyl verstanden. Unter einer Alkinylgruppe werden beispielsweise Ethinyl, Propinyl, Butinyl, Pentinyl, Hexinyl, Heptinyl oder Octinyl verstanden. Unter einer Gruppe OR¹ werden beispielsweise Methoxy, Trifluormethoxy, Ethoxy, n-Propoxy, i-Propoxy, n-Butoxy, i-Butoxy, s-Butoxy, t-Butoxy oder 2-Methylbutoxy verstanden.

Eine Arylgruppe im Sinne dieser Erfindung enthält 6 bis 10 C-Atome; eine Heteroarylgruppe im Sinne dieser Erfindung enthält 2 bis 10 C-Atome und mindestens ein Heteroatom, mit der Maßgabe, dass die Summe aus C-Atomen und Heteroatomen mindestens 5 ergibt. Die Heteroatome sind bevorzugt ausgewählt aus N, O und/oder S. Dabei enthält die Heteroarylgruppe bevorzugt maximal drei Heteroatome. Unter einer Arylgruppe bzw. Heteroarylgruppe wird entweder ein einfacher aromatischer Cyclus bzw. ein einfacher heteroaromatischer Cyclus oder eine kondensierte Aryl- oder Heteroarylgruppe verstanden. Beispiele für erfindungsgemäße Aryl- bzw. Heteroarylgruppen sind Gruppen, die abgeleitet sind von Benzol, Naphthalin, Furan, Benzofuran, Thiophen, Benzothiophen, Pyrrol, Indol, Pyridin, Pyridazin, Pyrimidin, Pyrazin, Chinolin, Isochinolin, Chinazolin, Chinoxalin, Pyrazol, Imidazol, Benzimidazol, Pyridimidazol, Pyrazinimidazol, Oxazol, Benzoxazol, 1,2-Thiazol, 1,3-Thiazol und Benzothiazol.

Im Folgenden werden die bidentaten Teilliganden L¹ beschrieben. Wie oben beschrieben, weist der Teilligand L¹ eine Struktur gemäß einer der Formeln (2a) bis (2d) auf und ist mit genau einer Gruppe der Formel (3) substituiert.

Besonders bevorzugt weist der Teilligand der Formel (2a) bis (2d) eine Struktur gemäß einer der folgenden Formeln (2a') bis (2d') auf, 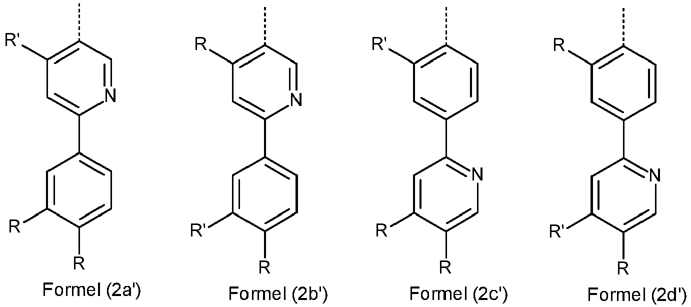 wobei die verwendeten Symbole die oben genannten Bedeutungen aufweisen.

Die Reste R am Teilliganden L¹ der Formeln (2a) bis (2d) bzw. Formeln (2a') bis (2d') sind bevorzugt ausgewählt aus der Gruppe bestehend aus H, D, CN, OR¹, einer geradkettigen Alkylgruppe mit 1 bis 6 C-Atomen, bevorzugt mit 1 bis 3 C-Atomen, oder einer verzweigten oder cyclischen Alkylgruppe mit 3 bis 6 C-Atomen oder einer Alkenylgruppe mit 2 bis 6 C-Atomen, bevorzugt mit 2 bis 4 C-Atomen, die jeweils durch einen oder mehrere Reste R¹ substituiert sein kann, oder einer Phenylgruppe, die durch einen oder mehrere nicht-aromatische Reste R¹ substituiert sein kann. Dabei können zwei oder mehrere benachbarte Reste R auch miteinander ein Ringsystem bilden.

Dabei ist der Substituent R, der in ortho-Position sowohl zu dem koordinierenden Atom wie auch zur Verknüpfung zu V bzw. zur Gruppe der Formel (6b) bzw. (7b) gebunden ist, bevorzugt ausgewählt aus der Gruppe bestehend aus H, D, F oder Methyl, besonders bevorzugt H, D oder Methyl und insbesondere H oder D.

Weiterhin ist es bevorzugt, wenn alle Substituenten R, die in ortho-Position zu R' stehen, für H oder D stehen.

Wie oben beschrieben, ist R' eine Gruppe der Formel (3), welche in der para-Position mit dem Teilliganden L¹ verknüpft ist.

In einer bevorzugten Ausführungsform der Erfindung ist n = 0, 1 oder 2, bevorzugt 0 oder 1 und ganz besonders bevorzugt 0.

In einer weiteren bevorzugten Ausführungsform der Erfindung sind beide Substituenten R", welche in den ortho-Positionen zu dem Kohlenstoffatom gebunden sind, mit dem die Gruppe der Formel (3) an den Phenylpyridinliganden gebunden ist, gleich oder verschieden H oder D.

Bevorzugte Ausführungsformen der Struktur der Formel (3) sind die Strukturen der Formeln (3a) bis (3n), 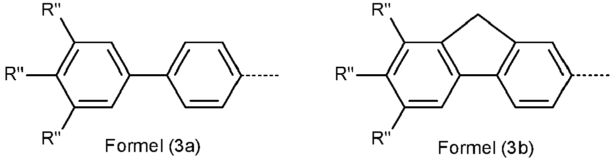 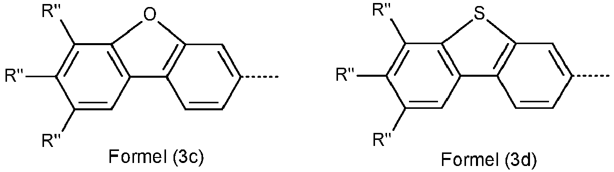 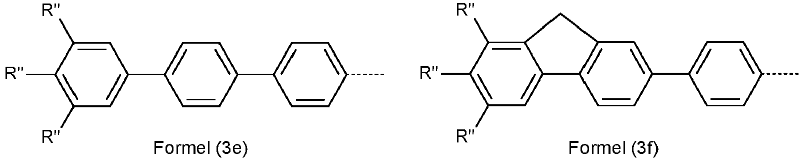 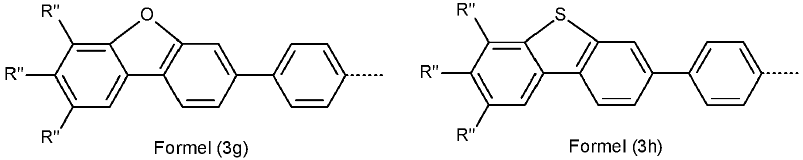 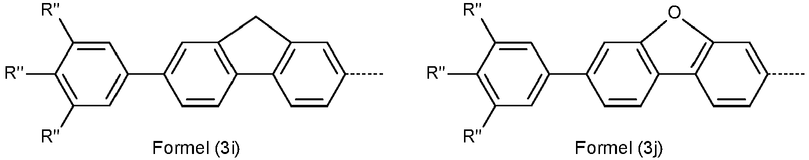 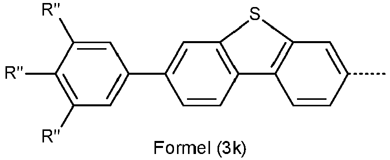 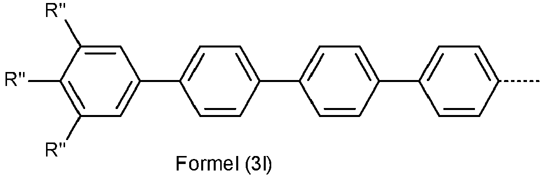 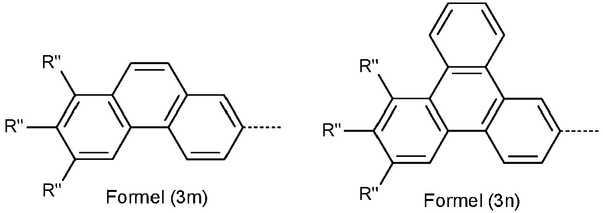 wobei die verwendeten Symbole die oben genannten Bedeutungen aufweisen und wobei die Fluorengruppe in 9-Position noch mit ein oder zwei Alkylgruppen mit jeweils 1 bis 6 C-Atomen substituiert sein kann, bevorzugt mit 1 bis 4 C-Atomen, besonders bevorzugt mit zwei Methylgruppen.

Bevorzugte Substituenten R" an den Gruppen der Formel (3) bzw. den bevorzugten Ausführungsformen sind gewählt aus der Gruppe bestehend aus der Gruppe bestehend aus H, D, CN und einer Alkylgruppe mit 1 bis 4 C-Atomen, besonders bevorzugt H, D oder Methyl.

Im Folgenden werden die bidentaten Teilliganden L² beschrieben. Wie oben beschrieben koordinieren die Teilliganden L² an das Iridium über ein Kohlenstoffatom und ein Stickstoffatom oder über zwei Kohlenstoffatome oder über zwei Stickstoffatome. Wenn L² über zwei Kohlenstoffatome an das Iridium koordiniert, ist eines der beiden Kohlenstoffatome ein Carben-Kohlenstoffatom. Wenn L² über zwei Stickstoffatome an das Iridium koordiniert, ist eines der beiden Stickstoffatome neutral und das andere anionisch. Weiterhin ist L² verschieden von L¹, da L¹ einen Substituenten der Formel (3) aufweist, während L² nur durch eine kleinere Aryl- oder Heteroarylgruppe substituiert sein kann, nicht jedoch durch eine Biphenylgruppe oder eine Oligophenylengruppe. In einer bevorzugten Ausführungsform der Erfindung sind die beiden Teilliganden L² identisch.

Bevorzugt weist mindestens einer der Teilliganden L² ein Kohlenstoffatom und ein Stickstoffatom oder zwei Kohlenstoffatome als koordinierende Atome auf. Besonders bevorzugt weisen beide Teilliganden L² ein Kohlenstoffatom und ein Stickstoffatom oder zwei Kohlenstoffatome als koordinierende Atome auf. Ganz besonders bevorzugt weisen beide Teilliganden L² jeweils ein Kohlenstoffatom und ein Stickstoffatom als koordinierende Atome auf.

Es ist weiterhin bevorzugt, wenn es sich bei dem Metallacyclus, der aus dem Iridium und dem Teilliganden L² aufgespannt wird, um einen Fünfring handelt. Dies wird im Folgenden schematisch dargestellt: 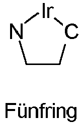 wobei N ein koordinierendes Stickstoffatom und C ein koordinierendes Kohlenstoffatom darstellen und die eingezeichneten Kohlenstoffatome Atome des Teilliganden L² darstellen.

In einer bevorzugten Ausführungsform der Erfindung weist das Strukturfragment Ir(L²) eine höhere Triplettenergie auf als das Strukturfragment Ir(L¹). Dadurch wird erreicht, dass die Emission des Komplexes überwiegend aus dem Strukturfragment Ir(L¹) kommt, was zu einer höheren Effizienz führt. Die Triplettenergie wird durch quantenchemische Rechnung bestimmt, wie nachfolgend im Beispielteil allgemein beschrieben. Dabei ist es bevorzugt, wenn die Triplettenergie des Strukturfragments Ir(L²) mindestens 0.025 eV größer ist als die des Strukturfragments Ir(L¹), besonders bevorzugt mindestens 0.05 eV größer, ganz besonders bevorzugt mindestens 0.1 eV und noch mehr bevorzugt mindestens 0.2 eV.

In einer bevorzugten Ausführungsform der Erfindung stehen die Teilliganden L² gleich oder verschieden bei jedem Auftreten, bevorzugt gleich, für eine Struktur gemäß den folgenden Formeln (L-1), (L-2) oder (L-3), 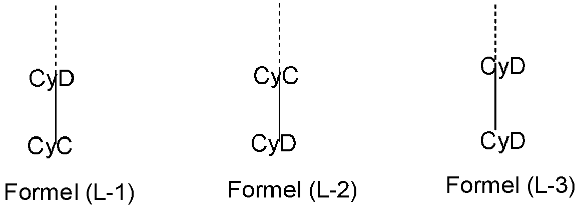
wobei die gestrichelte Bindung die Bindung des Teilliganden an die Brücke V, also die Brücke der Formel (5), darstellt und für die weiteren verwendeten Symbole gilt:
   - CyC: ist gleich oder verschieden bei jedem Auftreten eine durch R substituierte oder unsubstituierte Aryl- oder Heteroarylgruppe mit 5 bis 14 aromatischen Ringatomen, welche jeweils über ein Kohlenstoffatom an das Metall koordiniert und welche über eine kovalente Bindung mit CyD verbunden ist;

   - CyD: ist gleich oder verschieden bei jedem Auftreten eine durch R substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;
dabei können mehrere der Substituenten R miteinander ein aliphatisches oder heteroaliphatisches Ringsystem bilden, und CyC und CyD können miteinander durch eine Gruppe gemäß einer der Formeln (17) bis (26) verknüpft sein, 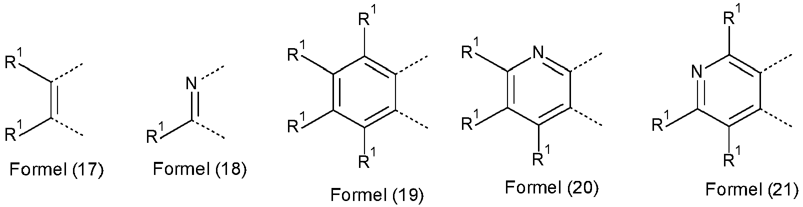 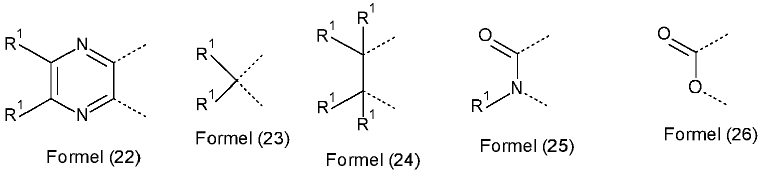
wobei R¹ die oben genannten Bedeutungen aufweist und die gestrichelten Bindungen die Bindungen an CyC bzw. CyD andeuten.

Dabei koordiniert CyD in (L-1) und (L-2) über ein neutrales Stickstoffatom oder über ein Carben-Kohlenstoffatom und in (L-3) über ein neutrales und ein anionisches Stickstoffatom. Weiterhin koordiniert CyC über ein anionisches Kohlenstoffatom.

Bevorzugt weisen beide Teilliganden L² eine Struktur der Formel (L-1) auf, oder beide Teilliganden L² weisen eine Struktur der Formel (L-2) auf, oder einer der Teilliganden L² weist eine Struktur der Formel (L-1), und der andere der Teilliganden weist eine Struktur der Formel (L-2) auf, oder beide Teilliganden L² weisen eine Struktur der Formel (L-3) auf. Bevorzugt sind die beiden Teilliganden L² gleich.

In einer bevorzugten Ausführungsform der vorliegenden Erfindung ist CyC eine Aryl- oder Heteroarylgruppe mit 6 bis 13 aromatischen Ringatomen, besonders bevorzugt mit 6 bis 10 aromatischen Ringatomen, ganz besonders bevorzugt mit 6 aromatischen Ringatomen, welche über ein Kohlenstoffatom an das Metall koordiniert, welche mit einem oder mehreren Resten R substituiert sein kann und welche über eine kovalente Bindung mit CyD verbunden ist.

Bevorzugte Ausführungsformen der Gruppe CyC sind die Strukturen der folgenden Formeln (CyC-1) bis (CyC-19), wobei die Gruppe CyC jeweils an der durch # gekennzeichneten Position an CyD bindet und an der durch * gekennzeichneten Position an das Iridium koordiniert, 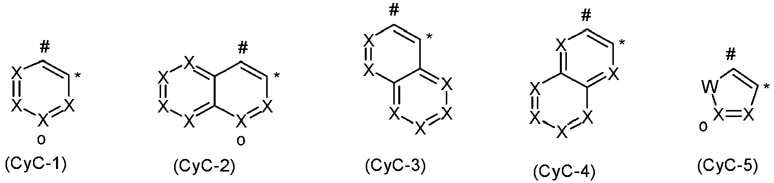 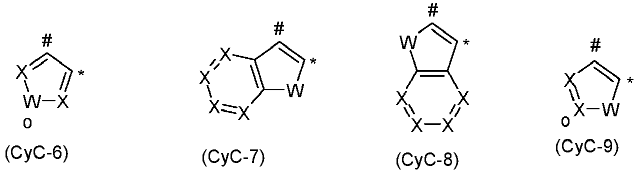 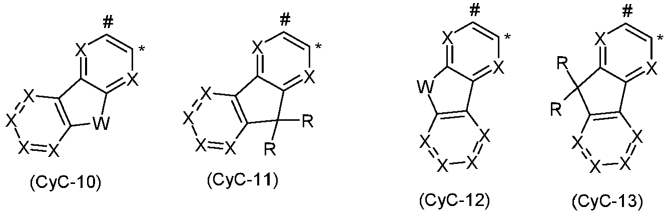 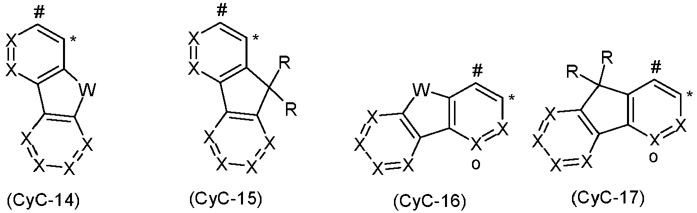 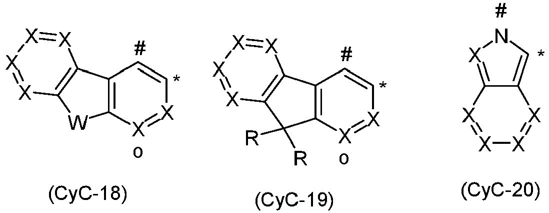
wobei R die oben genannten Bedeutungen aufweist und für die weiteren verwendeten Symbole gilt:
   - X: ist bei jedem Auftreten gleich oder verschieden CR oder N mit der Maßgabe, dass maximal zwei Symbole X pro Cyclus für N stehen;
   - W: ist bei jedem Auftreten gleich oder verschieden NR, O oder S;
mit der Maßgabe, dass, wenn die Brücke V bzw. die Brücke der Formel (6b) bzw. (7b) an CyC gebunden ist, ein Symbol X für C steht und die Brücke der Formel (6b) bzw. (7b) an dieses Kohlenstoffatom gebunden ist. Wenn die Gruppe CyC an die Brücke der Formel (6b) bzw. (7b) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke V bzw. die Brücke der Formel (6b) bzw. (7b) gebunden, da eine solche Bindung an die Brücke aus sterischen Gründen nicht vorteilhaft ist.

Bevorzugt stehen insgesamt maximal zwei Symbole X in CyC für N, besonders bevorzugt steht maximal ein Symbol X in CyC für N, ganz besonders bevorzugt stehen alle Symbole X für CR, mit der Maßgabe, dass, wenn die Brücke V bzw. die Brücke der Formel (6b) bzw. (7b) an CyC gebunden ist, ein Symbol X für C steht und die Brücke V bzw. die Brücke der Formel (6b) bzw. (7b) an dieses Kohlenstoffatom gebunden ist.

Besonders bevorzugte Gruppen CyC sind die Gruppen der folgenden Formeln (CyC-1 a) bis (CyC-20a), 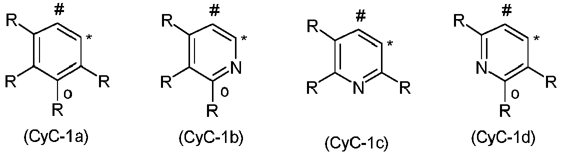 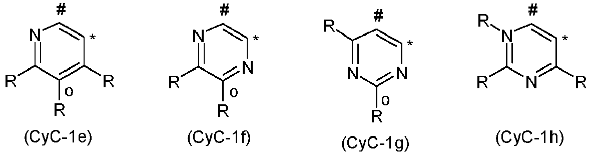 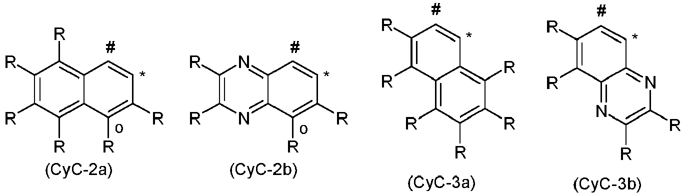 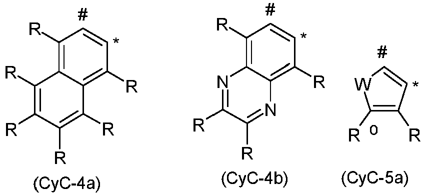 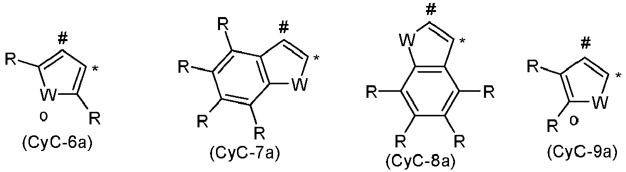 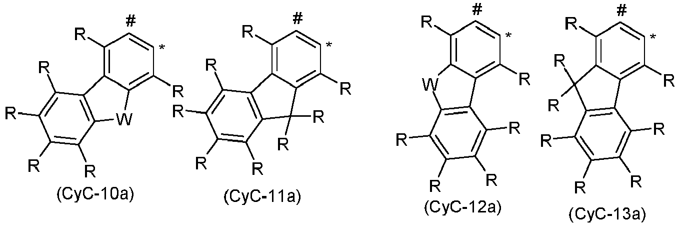 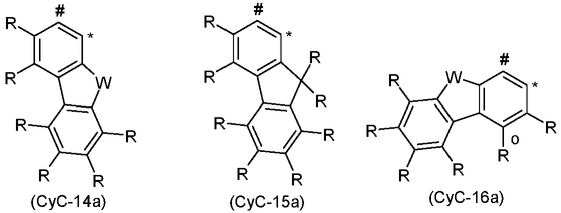 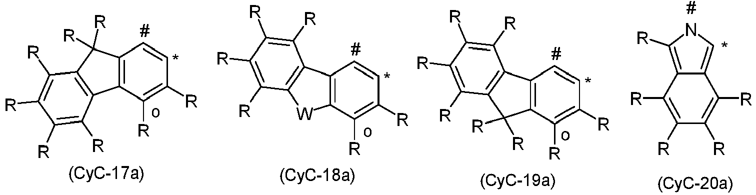 wobei die verwendeten Symbole die oben genannten Bedeutungen aufweisen und, wenn die Brücke V bzw. die Brücke der Formel (6b) bzw. (7b) an CyC gebunden ist, ein Rest R nicht vorhanden ist und die Brücke der Formel (6b) bzw. (7b) an das entsprechende Kohlenstoffatom gebunden ist. Wenn die Gruppe CyC an die Brücke der Formel (6b) bzw. (7b) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Brücke V bzw. die Brücke der Formel (6b) bzw. (7b) gebunden.

Bevorzugte Gruppen unter den Gruppen (CyC-1) bis (CyC-19) sind die Gruppen (CyC-1), (CyC-3), (CyC-8), (CyC-10), (CyC-12), (CyC-13) und (CyC-16), und besonders bevorzugt sind die Gruppen (CyC-1 a), (CyC-3a), (CyC-8a), (CyC-10a), (CyC-12a), (CyC-13a) und (CyC-16a).

In einer weiteren bevorzugten Ausführungsform der Erfindung ist CyD eine Heteroarylgruppe 5 bis 13 aromatischen Ringatomen, besonders bevorzugt mit 6 bis 10 aromatischen Ringatomen, welche über ein neutrales Stickstoffatom oder über ein Carben-Kohlenstoffatom an das Metall koordiniert und welche mit einem oder mehreren Resten R substituiert sein kann und welche über eine kovalente Bindung mit CyC verbunden ist.

Bevorzugte Ausführungsformen der Gruppe CyD sind die Strukturen der folgenden Formeln (CyD-1) bis (CyD-14), wobei die Gruppe CyD jeweils an der durch # gekennzeichneten Position an CyC bindet und an der durch * gekennzeichneten Position an das Iridium koordiniert, 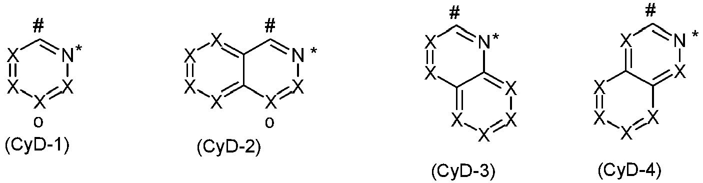 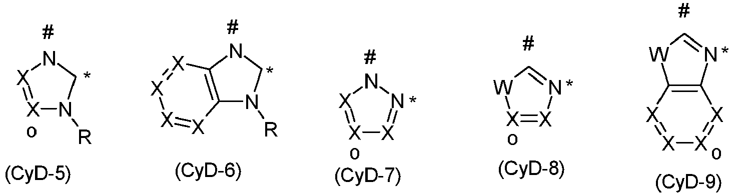 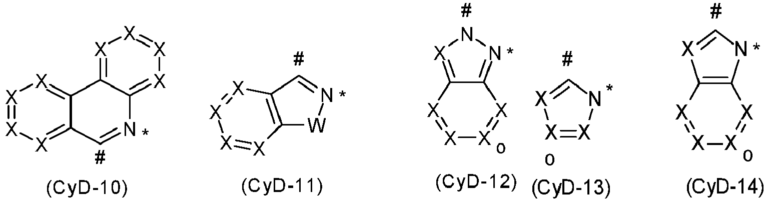 wobei X, W und R die oben genannten Bedeutungen aufweisen, mit der Maßgabe, dass, wenn die Brücke V bzw. die Brücke der Formel (6b) bzw. (7b) an CyD gebunden ist, ein Symbol X für C steht und die Brücke V bzw. die Brücke der Formel (6b) bzw. (7b) an dieses Kohlenstoffatom gebunden ist. Wenn die Gruppe CyD an die Brücke V bzw. die Brücke der Formel (6b) bzw. (7b) gebunden ist, so erfolgt die Bindung bevorzugt über die mit "o" markierte Position der oben abgebildeten Formeln, so dass dann bevorzugt das mit "o" markierte Symbol X für C steht. Die oben abgebildeten Strukturen, die kein mit "o" markiertes Symbol X enthalten, sind bevorzugt nicht direkt an die Brücke der Formel (6b) bzw. (7b) gebunden, da eine solche Bindung an die Brücke aus sterischen Gründen nicht vorteilhaft ist.

Dabei koordinieren die Gruppen (CyD-1) bis (CyD-4) und (CyD-7) bis (CyD-12) über ein neutrales Stickstoffatom und (CyD-5) und (CyD-6) über ein Carben-Kohlenstoffatom an das Iridium. Die Gruppen (CyD-13) und (CyD-14) koordinieren über ein anionisches Stickstoffatom an das Iridium.

Bevorzugt stehen insgesamt maximal zwei Symbole X in CyD für N, besonders bevorzugt steht maximal ein Symbol X in CyD für N, insbesondere bevorzugt stehen alle Symbole X für CR, mit der Maßgabe, dass, wenn die Brücke der Formel (6b) bzw. (7b) an CyD gebunden ist, ein Symbol X für C steht und die Brücke der Formel (6b) bzw. (7b) an dieses Kohlenstoffatom gebunden ist.

Besonders bevorzugte Gruppen CyD sind die Gruppen der folgenden Formeln (CyD-1 a) bis (CyD-14b), 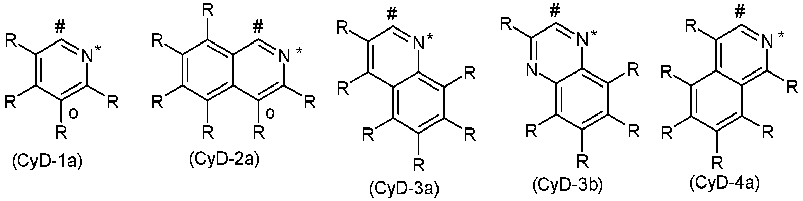 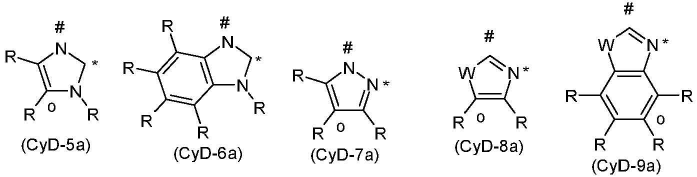 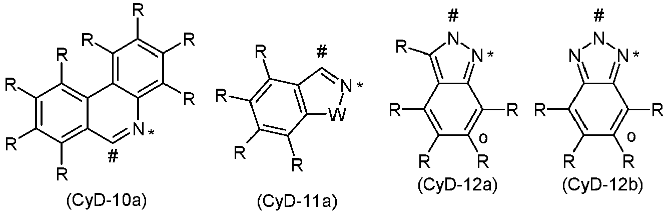 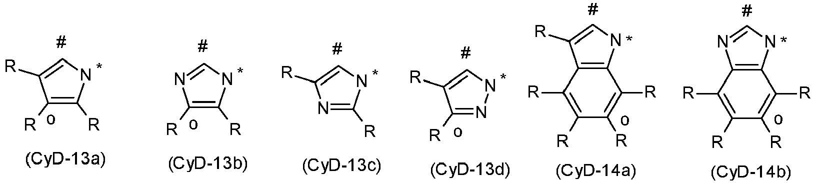 wobei die verwendeten Symbole die oben genannten Bedeutungen aufweisen und, wenn die Brücke V bzw. die Brücke der Formel (6b) bzw. (7b) an CyD gebunden ist, ein Rest R nicht vorhanden ist und die Brücke der Formel (6b) bzw. (7b) an das entsprechende Kohlenstoffatom gebunden ist. Wenn die Gruppe CyD an die Brücke V bzw. die Brücke der Formel (6b) bzw. (7b) gebunden ist, so erfolgt die Bindung bevorzugt über die mit "o" markierte Position der oben abgebildeten Formeln, so dass dann bevorzugt in dieser Position der Rest R nicht vorhanden ist. Die oben abgebildeten Strukturen, die kein mit "o" markiertes Kohlenstoffatom enthalten, sind bevorzugt nicht direkt an die Brücke der Formel (6b) bzw. (7b) gebunden.

Bevorzugte Gruppen unter den Gruppen (CyD-1) bis (CyD-12) sind die Gruppen (CyD-1), (CyD-2), (CyD-3), (CyD-4), (CyD-5) und (CyD-6), insbesondere (CyD-1), (CyD-2) und (CyD-3), und besonders bevorzugt sind die Gruppen (CyD-1 a), (CyD-2a), (CyD-3a), (CyD-4a), (CyD-5a) und (CyD-6a), insbesondere (CyD-1 a), (CyD-2a) und (CyD-3a).

In einer bevorzugten Ausführungsform der vorliegenden Erfindung ist CyC eine Aryl- oder Heteroarylgruppe mit 6 bis 13 aromatischen Ringatomen, und gleichzeitig ist CyD eine Heteroarylgruppe mit 5 bis 13 aromatischen Ringatomen. Besonders bevorzugt ist CyC eine Aryl- oder Heteroarylgruppe mit 6 bis 10 aromatischen Ringatomen, und gleichzeitig ist CyD eine Heteroarylgruppe mit 5 bis 10 aromatischen Ringatomen. Ganz besonders bevorzugt ist CyC eine Aryl- oder Heteroarylgruppe mit 6 aromatischen Ringatomen und CyD eine Heteroarylgruppe mit 6 bis 10 aromatischen Ringatomen. Dabei können CyC und CyD mit einem oder mehreren Resten R substituiert sein.

Die oben genannten bevorzugten Gruppen (CyC-1) bis (CyC-20) und (CyD-1) bis (CyD-12) können beliebig miteinander kombiniert werden, sofern mindestens eine der Gruppen CyC bzw. CyD eine geeignete Anknüpfungsstelle an die Brücke V bzw. die Brücke der Formel (6b) bzw. (7b) aufweist, wobei geeignete Anknüpfungsstellen in den oben genannten Formeln mit "o" gekennzeichnet sind.

Insbesondere bevorzugt ist es, wenn die oben als besonders bevorzugt genannten Gruppen CyC und CyD, also die Gruppen der Formeln (CyC-1 a) bis (CyC-20a) und die Gruppen der Formeln (CyD1-a) bis (CyD-14b) miteinander kombiniert werden, sofern mindestens eine der bevorzugten Gruppen CyC bzw. CyD eine geeignete Anknüpfungsstelle an die Brücke V bzw. die Brücke der Formel (6b) bzw. (7b) aufweist, wobei geeignete Anknüpfungsstellen in den oben genannten Formeln mit "o" gekennzeichnet sind. Kombinationen, in denen weder CyC noch CyD eine solche geeignete Anknüpfungsstelle für die Brücke der Formel (6b) bzw. (7b) aufweist, sind daher nicht bevorzugt.

Ganz besonders bevorzugt ist es, wenn eine der Gruppen (CyC-1), (CyC-3), (CyC-8), (CyC-10), (CyC-12), (CyC-13) und (CyC-16), insbesondere die Gruppen (CyC-1 a), (CyC-3a), (CyC-8a), (CyC-10a), (CyC-12a), (CyC-13a) und (CyC-16a), mit einer der Gruppen (CyD-1), (CyD-2) und (CyD-3), insbesondere mit einer der Gruppen (CyD-1 a), (CyD-2a) und (CyD-3a), kombiniert wird.

Bevorzugte Teilliganden (L-1) sind die Strukturen der Formeln (L-1-1) und (L-1-2), und bevorzugte Teilliganden (L-2) sind die Strukturen der Formeln (L-2-1) bis (L-2-4), 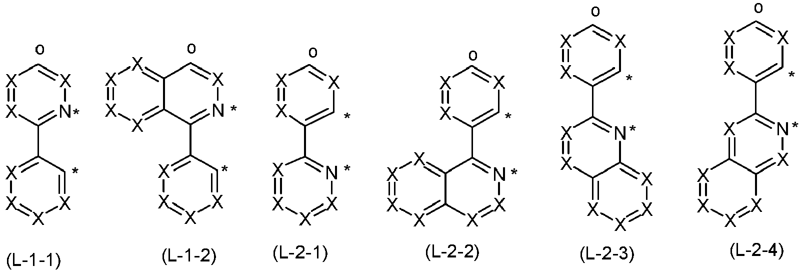 wobei die verwendeten Symbole die oben genannten Bedeutungen aufweisen und "o" die Position der Bindung an die Brücke V bzw. die Brücke der Formel (6b) bzw. (7b) darstellt.

Besonders bevorzugte Teilliganden (L-1) sind die Strukturen der Formeln (L-1-1a) und (L-1-2b), und besonders bevorzugte Teilliganden (L-2) sind die Strukturen der Formeln (L-2-1 a) bis (L-2-4a), 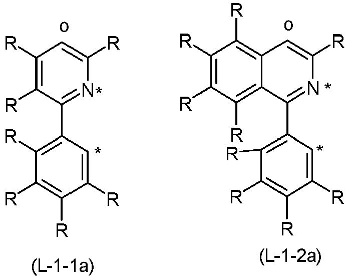 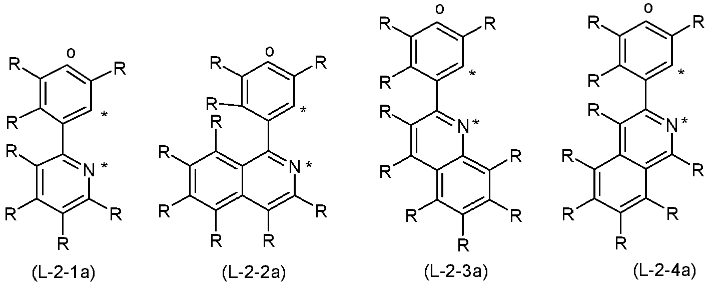 wobei die verwendeten Symbole die oben genannten Bedeutungen aufweisen und "o" die Position der Bindung an die Brücke V bzw. die Brücke der Formel (6b) bzw. (7b) darstellt.

Wenn zwei Reste R, von denen einer an CyC und der andere an CyD gebunden sind, miteinander ein aromatisches Ringsystem bilden, können sich überbrückte Teilliganden ergeben, wobei manche dieser überbrückten Teilliganden dann insgesamt eine einzige größere Heteroarylgruppe darstellen, wie beispielsweise Benzo[h]chinolin, etc.. Die Ringbildung zwischen den Substituenten an CyC und CyD erfolgt dabei wie oben beschrieben durch eine Gruppe gemäß einer der oben abgebildeten Formeln (17) bis (26). Dabei können die unsymmetrischen der oben genannten Gruppen in jeder der beiden Möglichkeiten eingebaut werden. So kann beispielsweise bei der Gruppe der Formel (26) das Sauerstoffatom an die Gruppe CyC und die Carbonylgruppe an die Gruppe CyD binden, oder das Sauerstoffatom kann an die Gruppe CyD und die Carbonylgruppe an die Gruppe CyC binden.

Dabei ist die Gruppe der Formel (23) besonders dann bevorzugt, wenn sich dadurch die Ringbildung zu einem Sechsring ergibt, wie beispielsweise unten durch die Formeln (L-21) und (L-22) dargestellt.

Bevorzugte Liganden, die durch Ringbildung zweier Reste R an den unterschiedlichen Cyclen entstehen, sind die im Folgenden aufgeführten Strukturen der Formeln (L-3) bis (L-30), 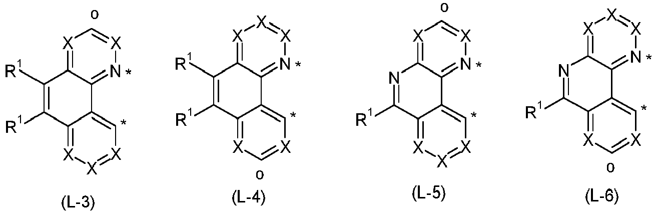 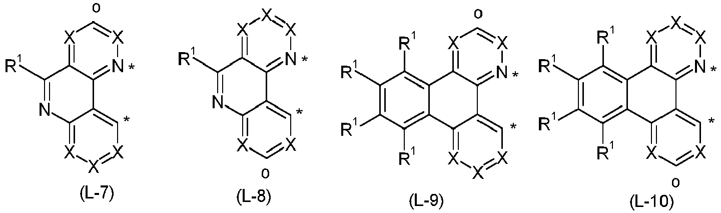 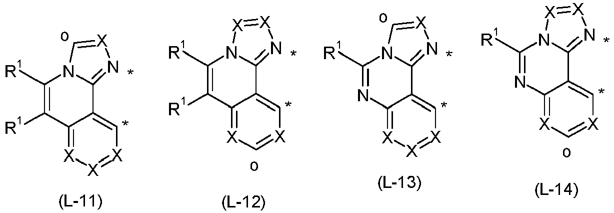 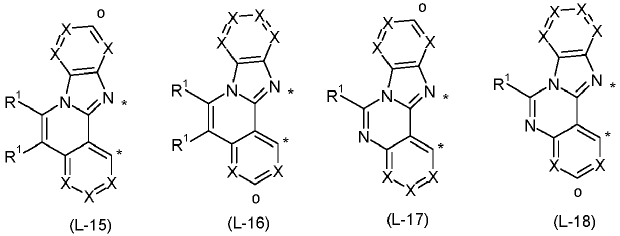 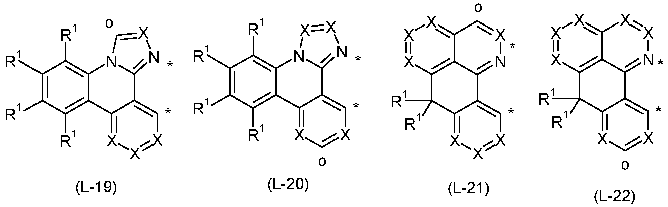 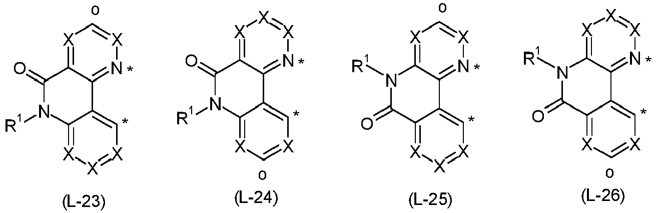 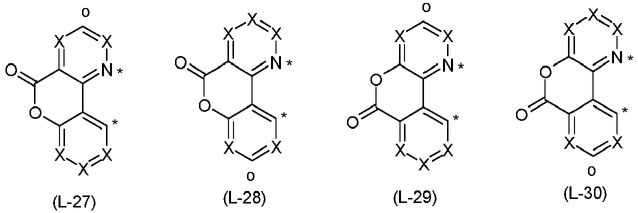 wobei die verwendeten Symbole die oben genannten Bedeutungen aufweisen und "o" die Position angibt, an denen dieser Teilligand mit der Gruppe der Formel (6b) bzw. (7b) verknüpft ist.

In einer bevorzugten Ausführungsform der Teilliganden der Formeln (L-3) bis (L-30) steht insgesamt ein Symbol X für N, und die anderen Symbole X stehen für CR, oder alle Symbole X stehen für CR.

In einer weiteren Ausführungsform der Erfindung ist es bevorzugt, falls in den Gruppen (CyC-1) bis (CyC-20) oder (CyD-1) bis (CyD-14) oder in den Teilliganden (L-3) bis (L-30) eines der Atome X für N steht, wenn benachbart zu diesem Stickstoffatom eine Gruppe R als Substituent gebunden ist, welche ungleich Wasserstoff oder Deuterium ist. Dies gilt analog für die bevorzugten Strukturen (CyC-1 a) bis (CyC-20a) oder (CyD-1 a) bis (CyD-14b), in denen bevorzugt benachbart zu einem nicht koordinierenden Stickstoffatom eine Gruppe R als Substituent gebunden ist, welche ungleich Wasserstoff oder Deuterium ist.

Dabei ist dieser Substituent R bevorzugt eine Gruppe, ausgewählt aus CF₃, OCF₃, Alkylgruppen mit 1 bis 10 C-Atomen, insbesondere verzweigten oder cyclischen Alkylgruppen mit 3 bis 10 C-Atomen, OR¹, wobei R¹ für eine Alkylgruppe mit 1 bis 10 C-Atomen, insbesondere eine verzweigte oder cyclische Alkylgruppe mit 3 bis 10 C-Atomen steht, Dialkylaminogruppen mit 2 bis 10 C-Atomen oder Aryl- bzw. Heteroarylgruppen mit 5 bis 10 aromatischen Ringatomen. Es handelt sich bei diesen Gruppen um sterisch anspruchsvolle Gruppen. Weiterhin bevorzugt kann dieser Rest R auch mit einem benachbarten Rest R einen aliphatischen oder heteroaliphatischen Cyclus bilden.

Ein weiterer geeigneter bidentater Teilligand ist ein Teilligand der folgenden Formel (L-31) oder (L-32), 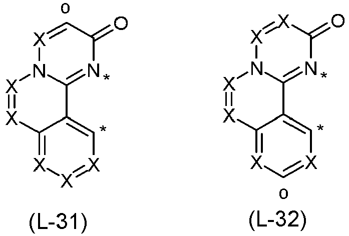 wobei R die oben genannten Bedeutungen aufweist, * die Position der Koordination an das Iridium darstellt, "o" die Position der Verknüpfung des Teilliganden mit V bzw. der Gruppe der Formel (6b) bzw. (7b) darstellt und für die weiteren verwendeten Symbole gilt:
- X: ist bei jedem Auftreten gleich oder verschieden CR oder N mit der Maßgabe, dass maximal ein Symbol X pro Cyclus für N steht.

In einer bevorzugten Ausführungsform der Erfindung stehen im Teilliganden der Formel (L-31) und (L-32) insgesamt 0, 1 oder 2 der Symbole X und, falls vorhanden, Y für N. Besonders bevorzugt stehen insgesamt 0 oder 1 der Symbole X und, falls vorhanden, Y für N.

Bevorzugte Ausführungsformen der Formeln (L-31) und (L-32) sind die Strukturen der folgenden Formeln (L-33a) bis (L-34d), 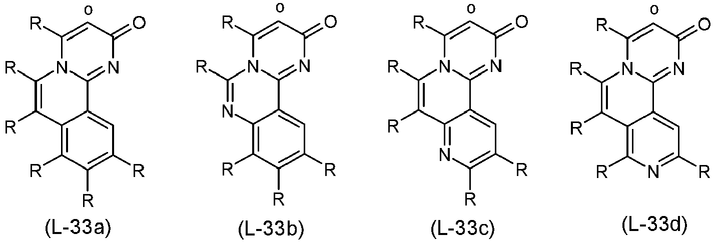 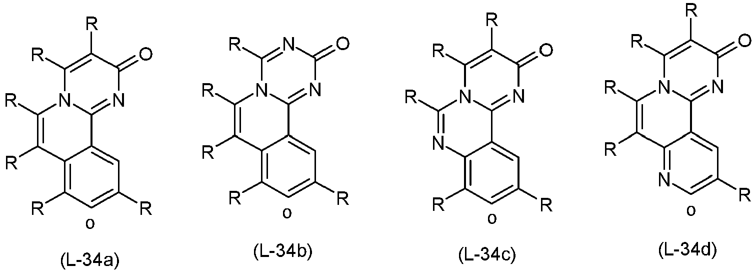 wobei die verwendeten Symbole die oben genannten Bedeutungen aufweisen und "o" die Position der Verknüpfung mit der Gruppe der Formel (6b) bzw. (7b) anzeigt.

In einer bevorzugten Ausführungsform der Erfindung steht die Gruppe X, die in ortho-Position zur Koordination an das Metall vorliegt, für CR. Dabei ist in dieser Rest R, der in ortho-Position zur Koordination an das Metall gebunden ist, bevorzugt ausgewählt aus der Gruppe bestehend aus H, D, F und Methyl.

In einer weiteren Ausführungsform der Erfindung ist es bevorzugt, falls eines der Atome X oder, wenn vorhanden, Y für N steht, wenn benachbart zu diesem Stickstoffatom eine Gruppe R als Substituent gebunden ist, welche ungleich H oder D ist. Dabei ist dieser Substituent R bevorzugt eine Gruppe, ausgewählt aus CF₃, OCF₃, Alkylgruppen mit 1 bis 10 C-Atomen, insbesondere verzweigten oder cyclischen Alkylgruppen mit 3 bis 10 C-Atomen, OR¹, wobei R¹ für eine Alkylgruppe mit 1 bis 10 C-Atomen, insbesondere eine verzweigte oder cyclische Alkylgruppe mit 3 bis 10 C-Atomen steht, Dialkylaminogruppen mit 2 bis 10 C-Atomen oder Aryl- bzw. Heteroarylgruppen mit 5 bis 10 aromatischen Ringatomen. Es handelt sich bei diesen Gruppen um sterisch anspruchsvolle Gruppen. Weiterhin bevorzugt kann dieser Rest R auch mit einem benachbarten Rest R einen aliphatischen oder heteroaliphatischen Cyclus bilden.

Im Folgenden werden bevorzugte Substituenten beschrieben, wie sie an den oben beschriebenen Teilliganden L¹ und/oder L² vorliegen können.

In einer weiteren Ausführungsform der Erfindung enthält der erfindungsgemäße Metallkomplex zwei Substituenten R oder zwei Substituenten R¹, die an benachbarte Kohlenstoffatome gebunden sind und die miteinander einen aliphatischen Ring gemäß einer der nachfolgend beschriebenen Formeln bilden. Dabei können die beiden Substituenten R, die diesen aliphatischen Ring bilden, an einem oder mehreren der bidentaten Teilliganden vorliegen. Der aliphatische Ring, der durch die Ringbildung von zwei Substituenten R miteinander oder von zwei Substituenten R¹ miteinander gebildet wird, wird bevorzugt durch eine der folgenden Formeln (27) bis (33) beschrieben, 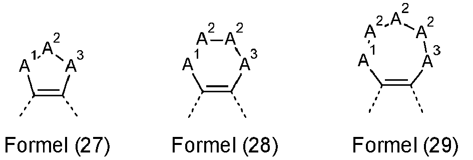 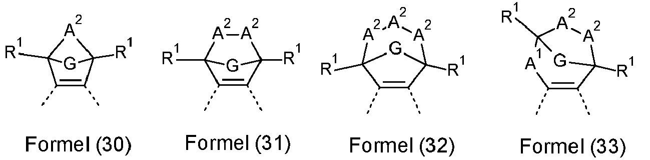
wobei R¹ und R² die oben genannten Bedeutungen aufweisen, die gestrichelten Bindungen die Verknüpfung der beiden Kohlenstoffatome im Liganden andeuten und weiterhin gilt:
   - A¹, A³: ist gleich oder verschieden bei jedem Auftreten C(R³)₂, O, S, NR³ oder C(=O);
   - A²: ist C(R¹)₂, O, S, NR³ oder C(=O);
   - G: ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 oder 6 aromatischen Ringatomen, welche durch einen oder mehrere Reste R² substituiert sein kann;
   - R³: ist gleich oder verschieden bei jedem Auftreten H, F, OR², eine geradkettige Alkylgruppe mit 1 bis 10 C-Atomen, eine verzweigte oder cyclische Alkylgruppe mit 3 bis 10 C-Atomen, wobei die Alkylgruppe jeweils mit einem oder mehreren Resten R² substituiert sein kann, wobei eine oder mehrere nicht benachbarte CH₂-Gruppen durch R²C=CR², C=C, Si(R²)₂, C=O, NR², O, S oder CONR² ersetzt sein können, oder eine Aryl- oder Heteroarylgruppe mit 5 oder 6 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches Ringsystem bilden und so ein Spirosystem aufspannen; weiterhin kann R³ mit einem benachbarten Rest R oder R¹ ein aliphatisches Ringsystem bilden;
mit der Maßgabe, dass in diesen Gruppen nicht zwei Heteroatome direkt aneinander gebunden sind und nicht zwei Gruppen C=O direkt aneinander gebunden sind.

In den oben abgebildeten Strukturen der Formeln (27) bis (33) sowie den weiteren als bevorzugt genannten Ausführungsformen dieser Strukturen wird formal eine Doppelbindung zwischen den zwei Kohlenstoffatomen abgebildet. Dies stellt eine Vereinfachung der chemischen Struktur dar, wenn diese beiden Kohlenstoffatome in ein aromatisches oder heteroaromatisches System eingebunden sind und somit die Bindung zwischen diesen beiden Kohlenstoffatomen formal zwischen dem Bindungsgrad einer Einfachbindung und dem einer Doppelbindung liegt. Das Einzeichnen der formalen Doppelbindung ist somit nicht limitierend für die Struktur auszulegen, sondern es ist für den Fachmann offensichtlich, dass es sich hier um eine aromatische Bindung handelt.

Wenn benachbarte Reste in den erfindungsgemäßen Strukturen ein aliphatisches Ringsystem bilden, dann ist es bevorzugt, wenn dieses keine aziden benzylischen Protonen aufweist. Unter benzylischen Protonen werden Protonen verstanden, die an ein Kohlenstoffatom binden, welches direkt an den Liganden gebunden sind. Dies kann dadurch erreicht werden, dass die Kohlenstoffatome des aliphatischen Ringsystems, die direkt an eine Aryl- oder Heteroarylgruppe binden, vollständig substituiert sind und keine Wasserstoffatome gebunden enthalten. So wird die Abwesenheit von aziden benzylischen Protonen in den Formeln (27) bis (29) dadurch erreicht, dass A¹ und A³, wenn diese für C(R³)₂ stehen, so definiert sind, dass R³ ungleich Wasserstoff ist. Dies kann weiterhin auch dadurch erreicht werden, dass die Kohlenstoffatome des aliphatischen Ringsystems, die direkt an eine Aryl- oder Heteroarylgruppe binden, die Brückenköpfe einer bi- oder polycyclischen Struktur sind. Die an Brückenkopfkohlenstoffatome gebundenen Protonen sind aufgrund der räumlichen Struktur des Bi- oder Polycyclus wesentlich weniger azide als benzylische Protonen an Kohlenstoffatomen, die nicht in einer bi- oder polycyclischen Struktur gebunden sind, und werden im Sinne der vorliegenden Erfindung als nicht-azide Protonen angesehen. So wird die Abwesenheit von aziden benzylischen Protonen ist in Formeln (30) bis (33) dadurch erreicht, dass es sich dabei um eine bicyclische Struktur handelt, wodurch R¹, wenn es für H steht, deutlich weniger azide als benzylische Protonen, da das korrespondierende Anion der bicyclischen Struktur nicht mesomeriestabilisiert ist. Auch wenn R¹ in Formeln (30) bis (33) für H steht, handelt es sich dabei daher um ein nicht-azides Proton im Sinne der vorliegenden Anmeldung.

In einer bevorzugten Ausführungsform der Erfindung ist R³ ungleich H.

In einer bevorzugten Ausführungsform der Struktur gemäß Formel (27) bis (33) steht maximal eine der Gruppen A¹, A² und A³ für ein Heteroatom, insbesondere für O oder NR³, und die anderen Gruppen stehen für C(R³)₂ bzw. C(R¹)₂ oder A¹ und A³ stehen gleich oder verschieden bei jedem Auftreten für O oder NR³ und A² steht für C(R¹)₂. In einer besonders bevorzugten Ausführungsform der Erfindung stehen A¹ und A³ gleich oder verschieden bei jedem Auftreten für C(R³)₂ und A² steht für C(R¹)₂ und besonders bevorzugt für C(R³)₂ oder CH₂.

Bevorzugte Ausführungsformen der Formel (27) sind somit die Strukturen der Formel (27-A), (27-B), (27-C) und (27-D), und eine besonders bevorzugte Ausführungsform der Formel (27-A) sind die Strukturen der Formel (27-E) und (27-F), 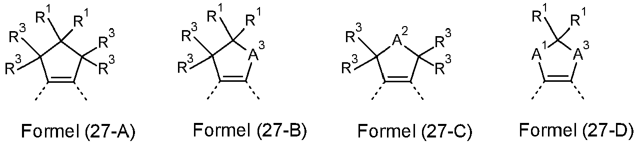 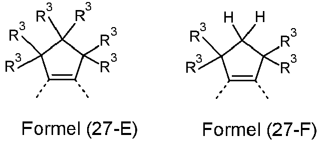 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (28) sind die Strukturen der folgenden Formeln (28-A) bis (28-F), 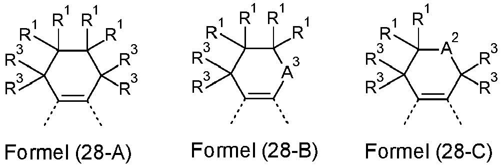 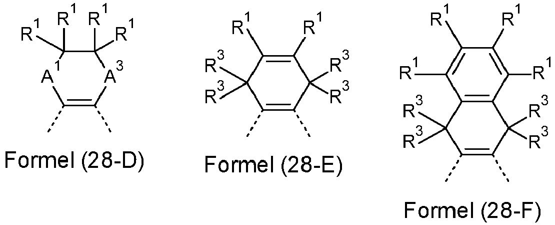 wobei R¹ und R³ die oben genannten Bedeutungen aufweisen und A¹, A² und A³ gleich oder verschieden bei jedem Auftreten für O oder NR³ steht.

Bevorzugte Ausführungsformen der Formel (29) sind die Strukturen der folgenden Formeln (29-A) bis (29-E), 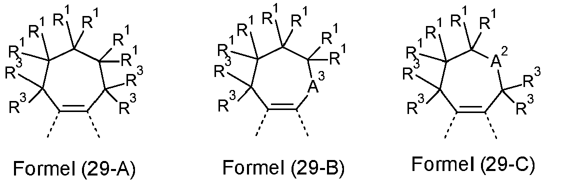 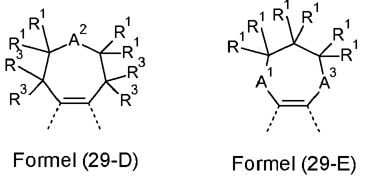 wobei R¹ und R³ die oben genannten Bedeutungen aufweisen und A¹, A² und A³ gleich oder verschieden bei jedem Auftreten für O oder NR³ steht.

In einer bevorzugten Ausführungsform der Struktur gemäß Formel (30) stehen die Reste R¹, die an den Brückenkopf gebunden sind, für H, D, F oder CH₃. Weiterhin bevorzugt steht A² für C(R¹)₂ oder O, und besonders bevorzugt für C(R³)₂. Bevorzugte Ausführungsformen der Formel (48) sind somit eine Strukturen der Formel (30-A) und (30-B), und eine besonders bevorzugte Ausführungsform der Formel (30-A) ist eine Struktur der Formel (30-C), 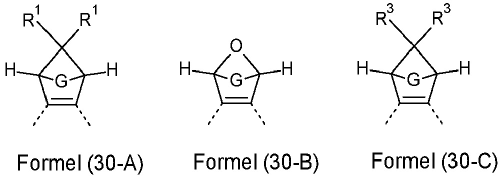 wobei die verwendeten Symbole die oben genannten Bedeutungen aufweisen.

In einer bevorzugten Ausführungsform der Struktur gemäß Formel (31), (32) und (33) stehen die Reste R¹, die an den Brückenkopf gebunden sind, für H, D, F oder CH₃. Weiterhin bevorzugt steht A² für C(R¹)₂. Bevorzugte Ausführungsformen der Formel (31), (32) und (33) sind somit die Strukturen der Formeln (31-A), (32-A) und (33-A), 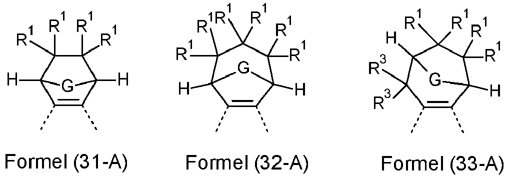 wobei die verwendeten Symbole die oben genannten Bedeutungen aufweisen.

Weiterhin bevorzugt steht die Gruppe G in den Formeln (30), (30-A), (30-B), (30-C), (31), (31-A), (32), (32-A), (33) und (33-A) für eine 1,2-Ethylengruppe, welche mit einem oder mehreren Resten R² substituiert sein kann, wobei R² bevorzugt gleich oder verschieden bei jedem Auftreten für H oder eine Alkylgruppe mit 1 bis 4 C-Atomen steht, oder eine ortho-Arylengruppe mit 6 bis 10 C-Atomen, welche mit einem oder mehreren Resten R² substituiert sein kann, bevorzugt aber unsubstituiert ist, insbesondere eine ortho-Phenylengruppe, welche mit einem oder mehreren Resten R² substituiert sein kann, bevorzugt aber unsubstituiert ist.

In einer weiteren bevorzugten Ausführungsform der Erfindung steht R³ in den Gruppen der Formel (27) bis (33) und in den bevorzugten Ausführungsformen gleich oder verschieden bei jedem Auftreten für F, eine geradkettige Alkylgruppe mit 1 bis 10 C-Atomen oder eine verzweigte oder cyclische Alkylgruppe mit 3 bis 20 C-Atomen, wobei jeweils eine oder mehrere nicht benachbarte CH₂-Gruppen durch R²C=CR² ersetzt sein können und ein oder mehrere H-Atome durch D oder F ersetzt sein können, oder Phenylgruppe, die durch einen oder mehrere Reste R² substituiert sein kann; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

In einer besonders bevorzugten Ausführungsform der Erfindung steht R³ in den Gruppen der Formeln (27) bis (33) und in den bevorzugten Ausführungsformen gleich oder verschieden bei jedem Auftreten für F, eine geradkettige Alkylgruppe mit 1 bis 3 C-Atomen, insbesondere Methyl, oder eine Phenylgruppe, die durch einen oder mehrere Reste R² substituiert sein kann, bevorzugt aber unsubstituiert ist; dabei können zwei Reste R³, welche an dasselbe Kohlenstoffatom gebunden sind, miteinander ein aliphatisches oder aromatisches Ringsystem bilden und so ein Spirosystem aufspannen; weiterhin kann R³ mit einem benachbarten Rest R oder R¹ ein aliphatisches Ringsystem bilden.

Beispiele für besonders geeignete Gruppen der Formel (27) sind die im Folgenden aufgeführten Strukturen:

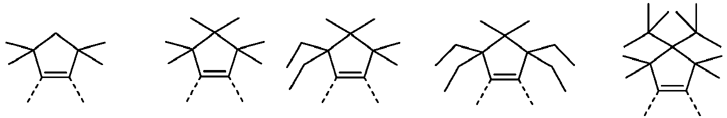

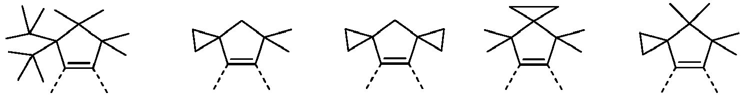

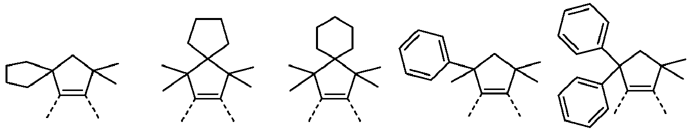

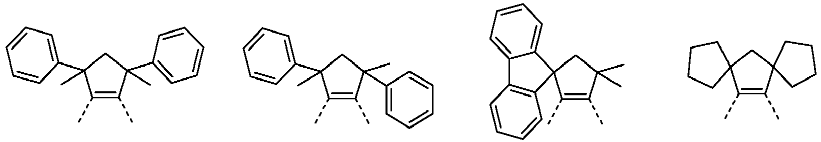

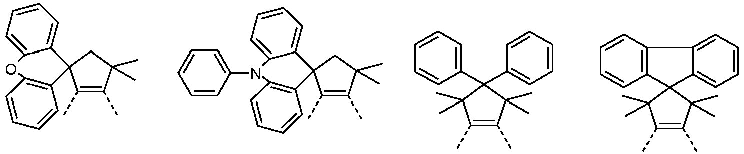

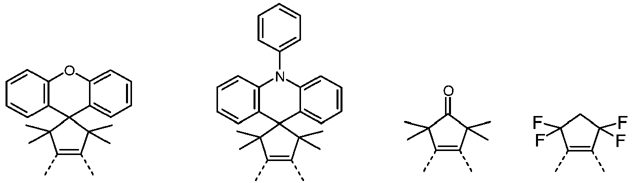

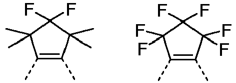

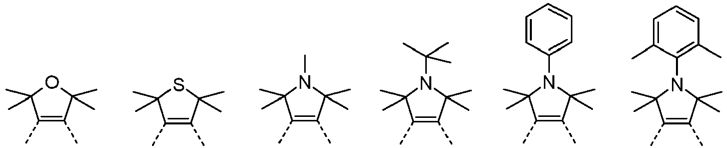

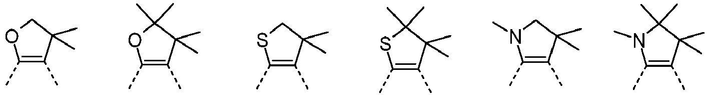

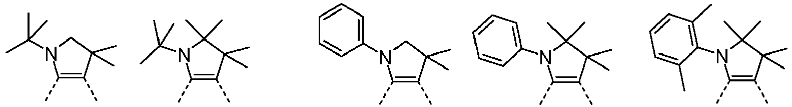

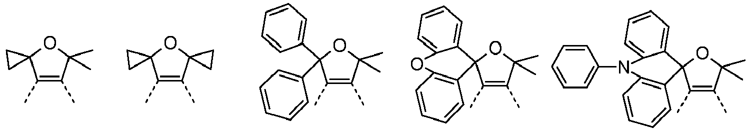

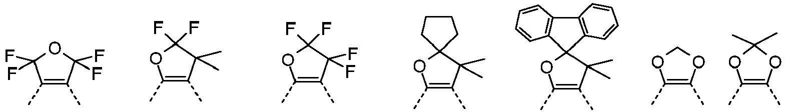

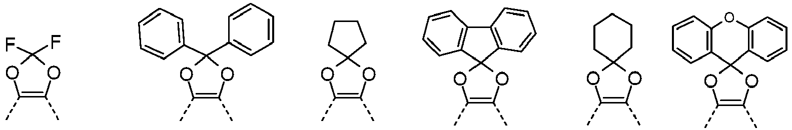

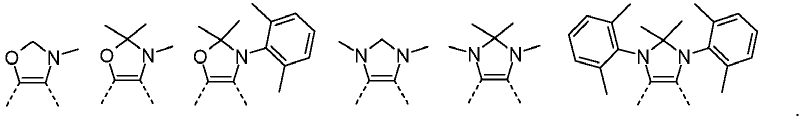

Beispiele für besonders geeignete Gruppen der Formel (28) sind die im Folgenden aufgeführten Strukturen:

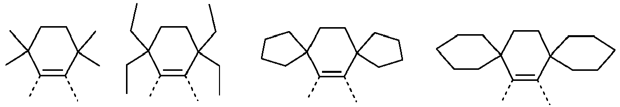

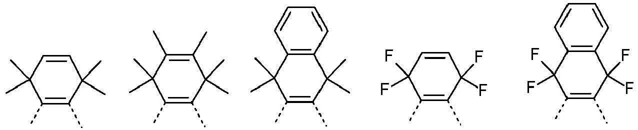

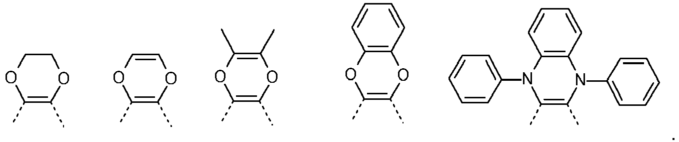

Beispiele für besonders geeignete Gruppen der Formel (29), (32) und (33) sind die im Folgenden aufgeführten Strukturen:

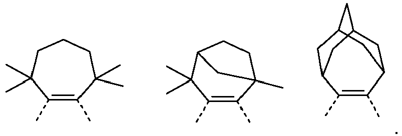

Beispiele für besonders geeignete Gruppen der Formel (30) sind die im Folgenden aufgeführten Strukturen:

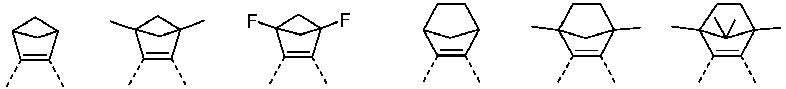

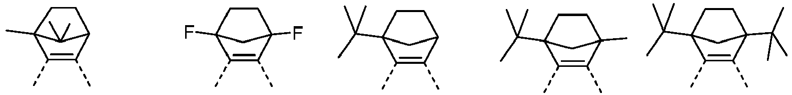

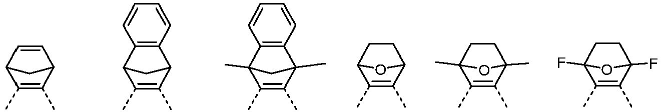

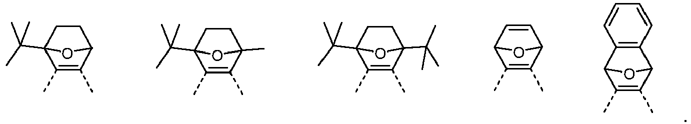

Beispiele für besonders geeignete Gruppen der Formel (31) sind die im Folgenden aufgeführten Strukturen:

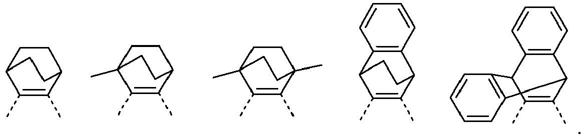

Wenn in den bidentaten Teilliganden L¹ bzw. L² Reste R gebunden sind, so sind diese Reste R bei jedem Auftreten gleich oder verschieden bevorzugt ausgewählt aus der Gruppe bestehend aus H, D, F, Br, I, N(R¹)₂, CN, Si(R¹)₃, B(OR¹)₂, C(=O)R¹, einer geradkettigen Alkylgruppe mit 1 bis 10 C-Atomen oder einer Alkenylgruppe mit 2 bis 10 C-Atomen oder einer verzweigten oder cyclischen Alkylgruppe mit 3 bis 10 C-Atomen, wobei die Alkyl oder Alkenylgruppe jeweils mit einem oder mehreren Resten R¹ substituiert sein kann, oder einer Phenylgruppe, die durch einen oder mehrere nicht-aromatische Reste R¹ substituiert sein kann, oder einer Heteroarylgruppe mit 5 oder 6 aromatischen Ringatomen, die durch einen oder mehrere nicht-aromatische Reste R¹ substituiert sein kann; dabei können zwei benachbarte Rest R oder R mit R¹ auch miteinander ein mono- oder polycyclisches, aliphatisches Ringsystem bilden. Besonders bevorzugt sind diese Reste R bei jedem Auftreten gleich oder verschieden ausgewählt aus der Gruppe bestehend aus H, D, F, N(R¹)₂, einer geradkettigen Alkylgruppe mit 1 bis 6 C-Atomen oder einer verzweigten oder cyclischen Alkylgruppe mit 3 bis 10 C-Atomen, wobei ein oder mehrere H-Atome durch D oder F ersetzt sein können, oder einer Phenylgruppe, die durch einen oder mehrere nicht-aromatische Reste R¹ substituiert sein kann, oder einer Heteroarylgruppe mit 6 aromatischen Ringatomen, die durch einen oder mehrere nicht-aromatische Reste R¹ substituiert sein kann; dabei können zwei benachbarte Reste R oder R mit R¹ auch miteinander ein mono- oder polycyclisches, aliphatisches Ringsystem bilden.

Bevorzugte Reste R¹, die an R gebunden sind, sind bei jedem Auftreten gleich oder verschieden H, D, F, N(R²)₂, CN, eine geradkettige Alkylgruppe mit 1 bis 10 C-Atomen oder eine Alkenylgruppe mit 2 bis 10 C-Atomen oder eine verzweigte oder cyclische Alkylgruppe mit 3 bis 10 C-Atomen, wobei die Alkylgruppe jeweils mit einem oder mehreren Resten R² substituiert sein kann, oder eine Phenylgruppe, die durch einen oder mehrere Reste R² substituiert sein kann, oder eine Heteroarylgruppe mit 5 oder 6 aromatischen Ringatomen, die durch einen oder mehrere Reste R² substituiert sein kann; dabei können zwei oder mehrere benachbarte Reste R¹ miteinander ein mono- oder polycyclisches, aliphatisches Ringsystem bilden. Besonders bevorzugte Reste R¹, die an R gebunden sind, sind bei jedem Auftreten gleich oder verschieden H, F, CN, eine geradkettige Alkylgruppe mit 1 bis 5 C-Atomen oder eine verzweigte oder cyclische Alkylgruppe mit 3 bis 5 C-Atomen, die jeweils mit einem oder mehreren Resten R² substituiert sein kann, oder eine Phenylgruppe, die durch einen oder mehrere Reste R² substituiert sein kann, oder eine Heteroarylgruppe mit 5 oder 6 aromatischen Ringatomen, die durch einen oder mehrere Reste R² substituiert sein kann; dabei können zwei oder mehrere benachbarte Reste R¹ miteinander ein mono- oder polycyclisches, aliphatisches Ringsystem bilden.

Bevorzugte Reste R² sind bei jedem Auftreten gleich oder verschieden H, F oder ein aliphatischer Kohlenwasserstoffrest mit 1 bis 5 C-Atomen oder ein aromatischer Kohlenwasserstoffrest mit 6 bis 12 C-Atomen; dabei können zwei oder mehrere Substituenten R² auch miteinander ein mono- oder polycyclisches, aliphatisches Ringsystem bilden.

Die oben genannten bevorzugten Ausführungsformen sind beliebig innerhalb der Grenzen des Anspruches 1 miteinander kombinierbar. In einer besonders bevorzugten Ausführungsform der Erfindung gelten die oben genannten bevorzugten Ausführungsformen gleichzeitig.

Beispiele für geeignete erfindungsgemäße Strukturen sind die nachfolgend abgebildeten Verbindungen.

| | |
|---|---|
| 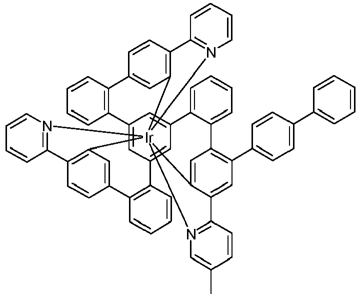 | 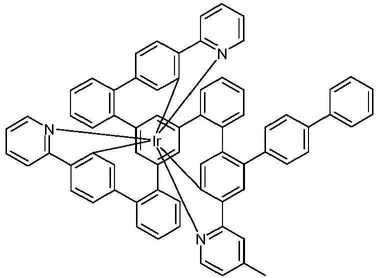 |
| 1 | 2 |
| 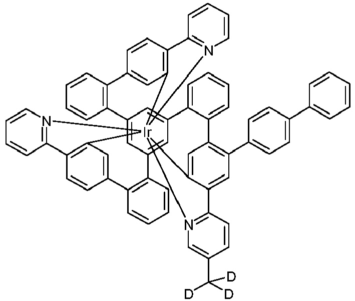 | 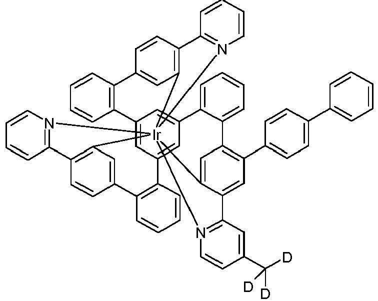 |
| 3 | 4 |
| 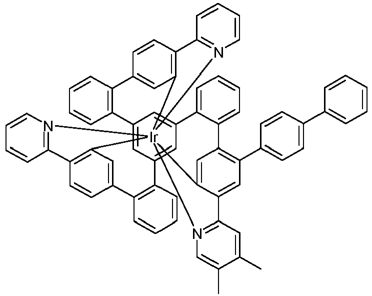 | 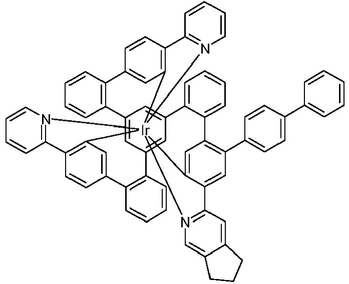 |
| 5 | 6 |
| 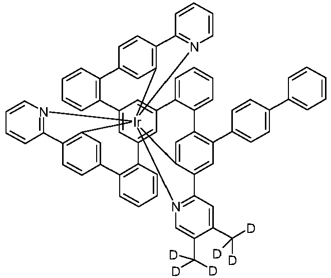 | 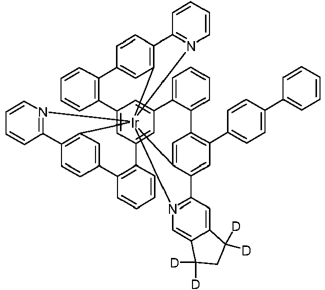 |
| 7 | 8 |
| 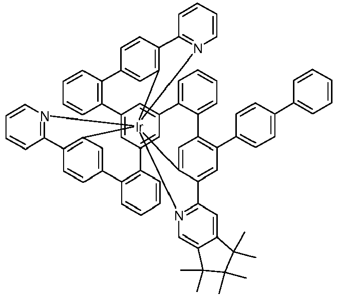 | 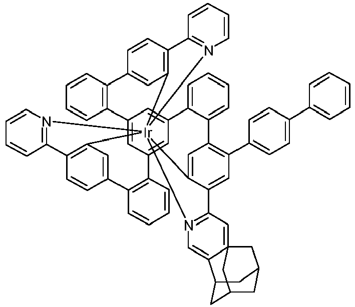 |
| 9 | 10 |
| 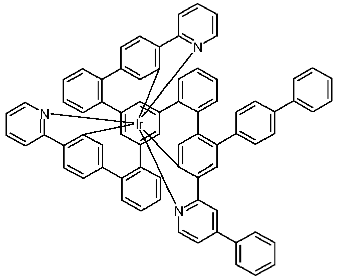 | 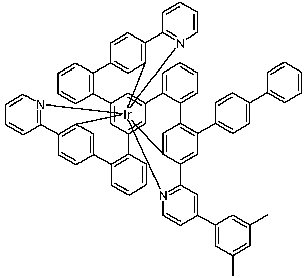 |
| 11 | 12 |
| 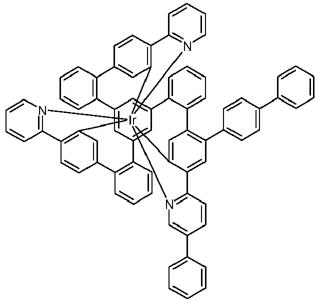 | 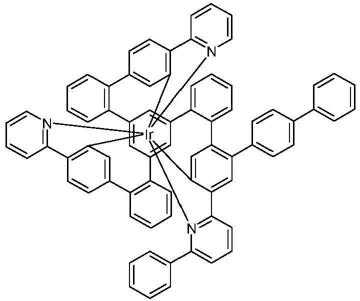 |
| 13 | 14 |
| 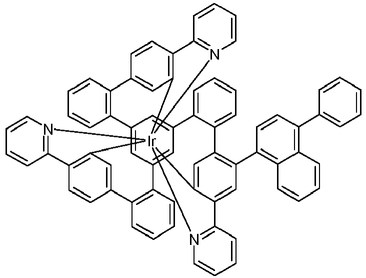 | 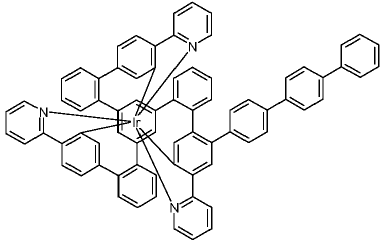 |
| 15 | 16 |
| 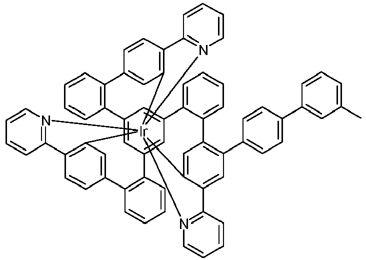 | 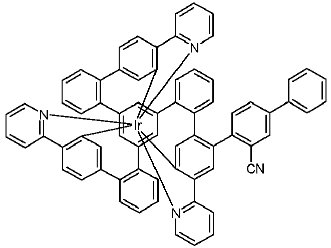 |
| 17 | 18 |
| 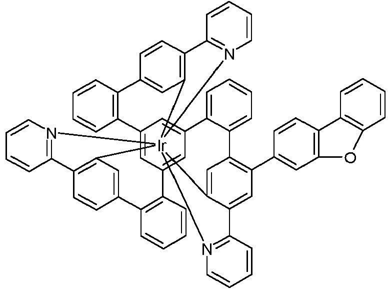 | 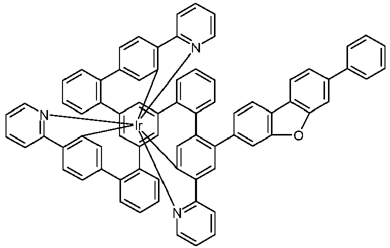 |
| 19 | 20 |
| 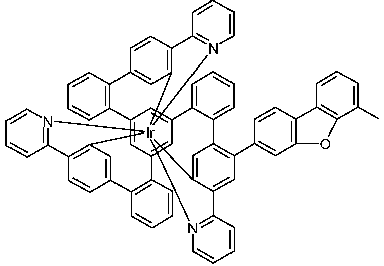 | 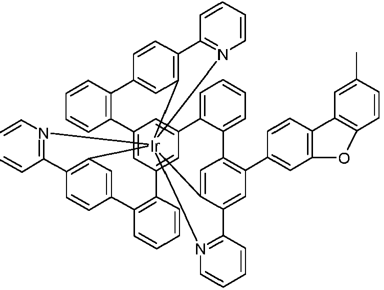 |
| 21 | 22 |
| 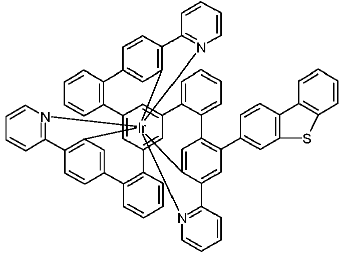 | 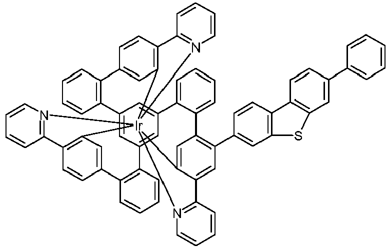 |
| 23 | 24 |
| 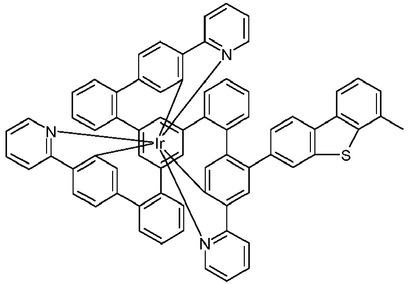 | 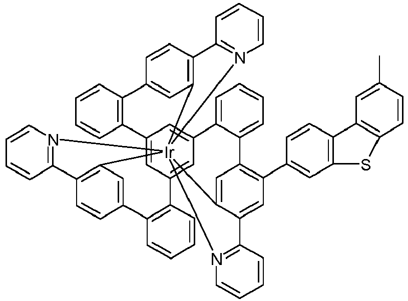 |
| 25 | 26 |
| 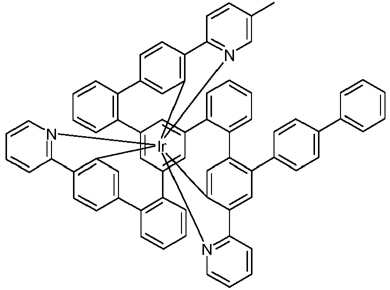 | 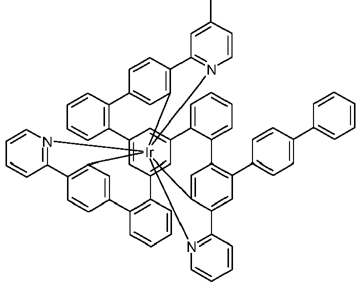 |
| 29 | 30 |
| 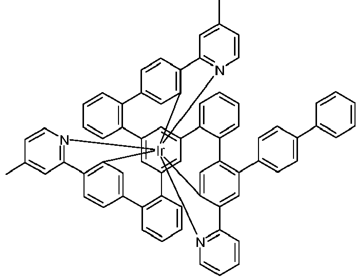 | 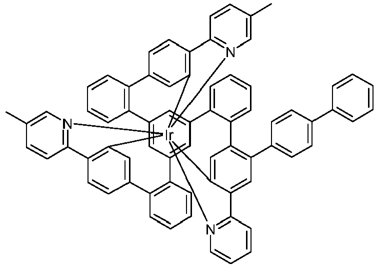 |
| 31 | 32 |
| 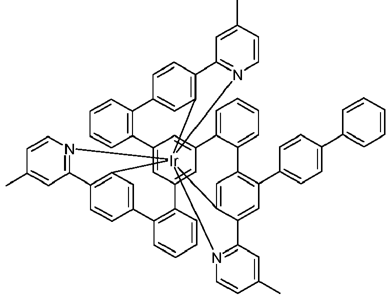 | 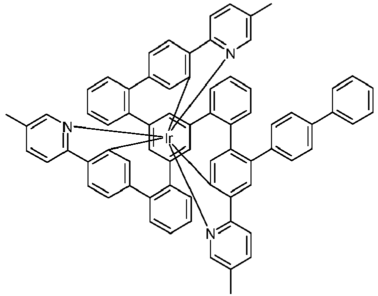 |
| 33 | 34 |
| 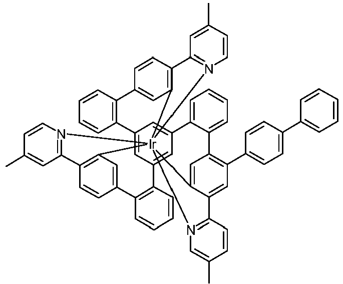 | 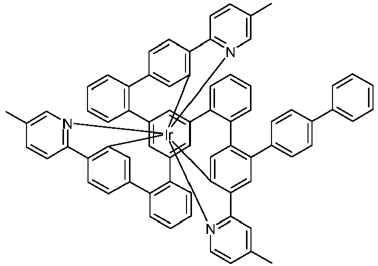 |
| 35 | 36 |
| 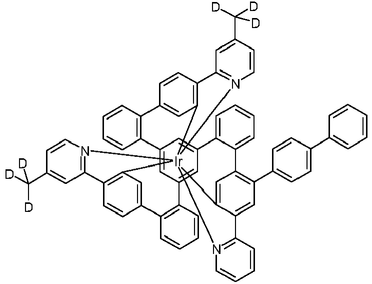 | 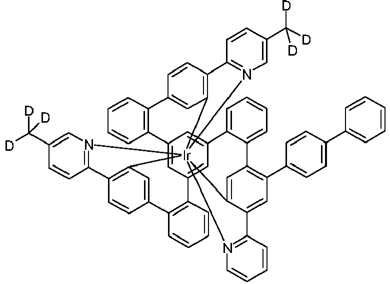 |
| 37 | 38 |
| 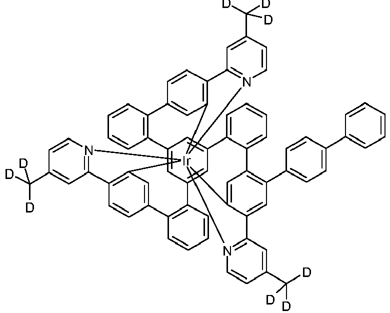 | 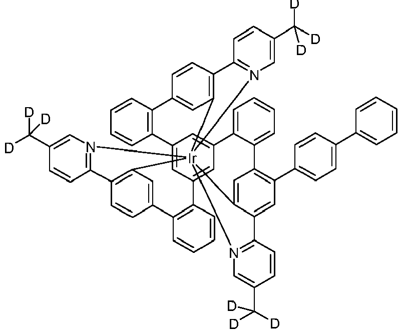 |
| 39 | 40 |
| 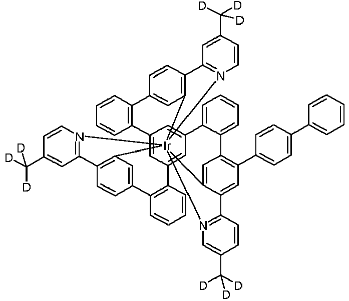 | 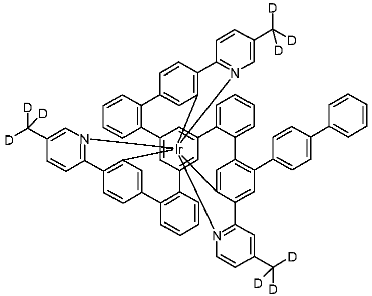 |
| 41 | 42 |
| 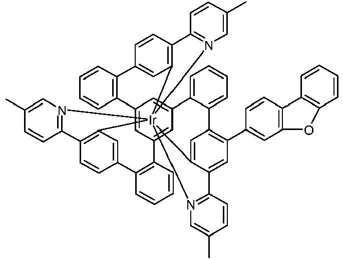 | 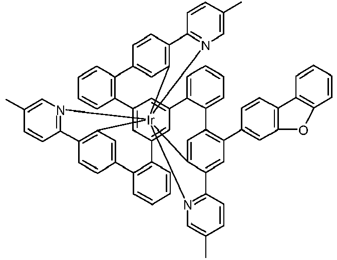 |
| 43 | 44 |
| 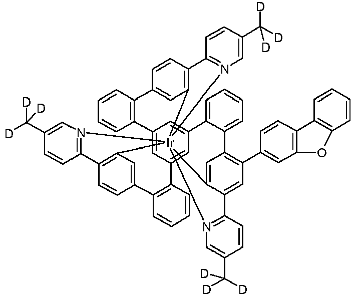 | 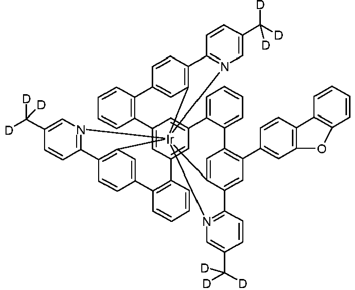 |
| 45 | 46 |
| 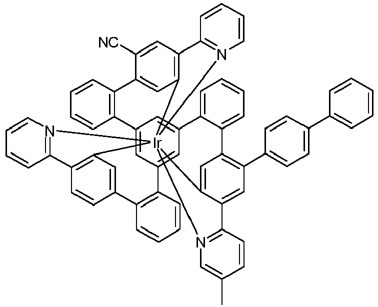 | 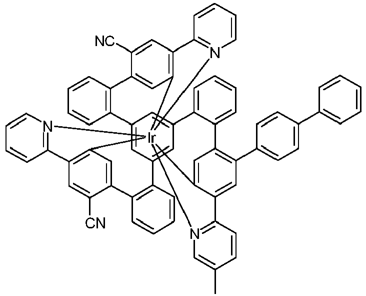 |
| 51 | 52 |
| 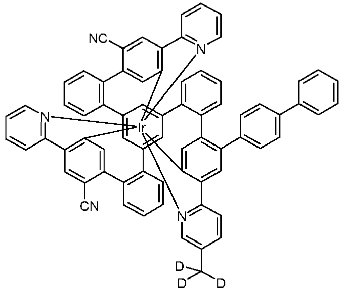 | 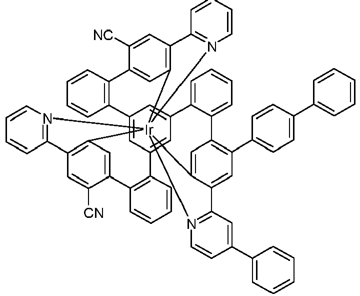 |
| 53 | 54 |
| 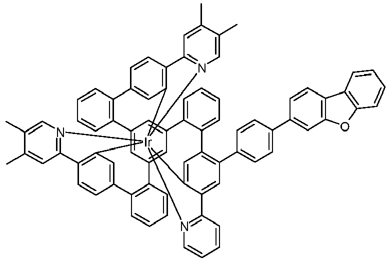 | 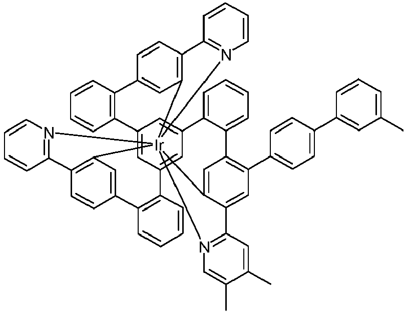 |
| 60 | 61 |
| 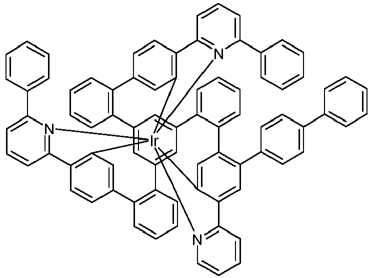 | 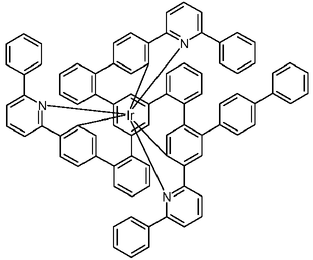 |
| 63 | 64 |
| 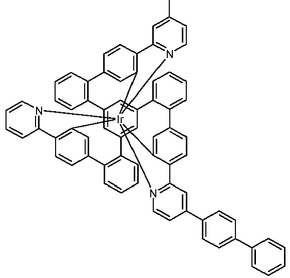 | 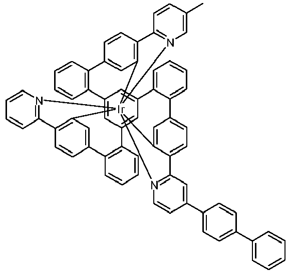 |
| 84 | 86 |
| 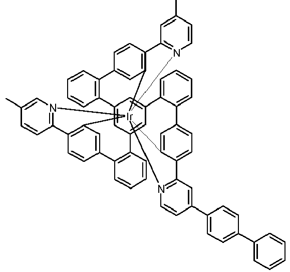 | 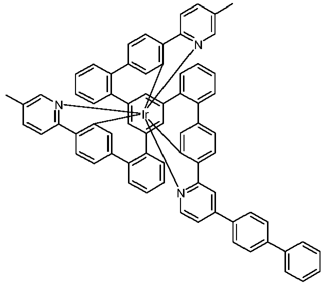 |
| 87 | 88 |
| 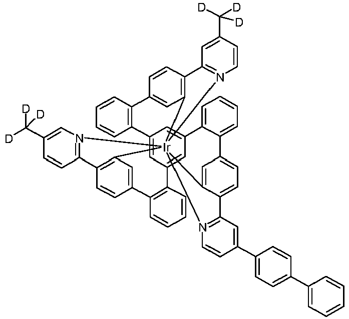 | 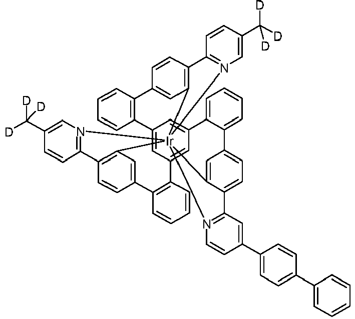 |
| 89 | 90 |
| 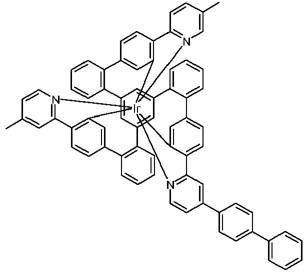 | 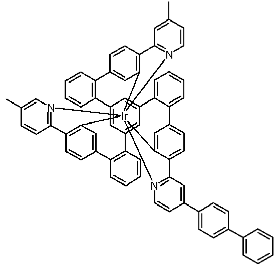 |
| 91 | 92 |
| 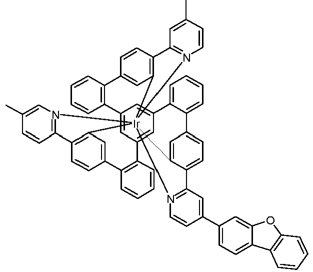 | 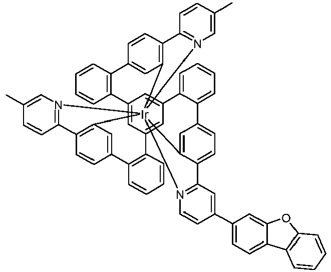 |
| 93 | 94 |
| 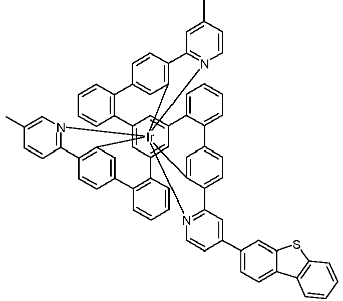 | 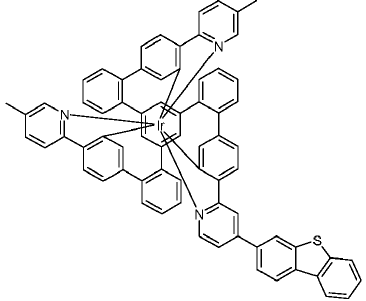 |
| 95 | 96 |
| 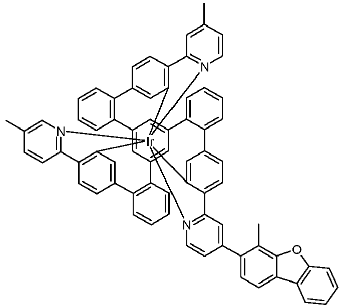 | 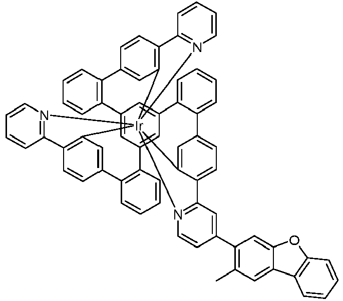 |
| 101 | 102 |
| 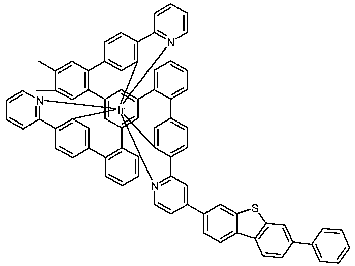 | 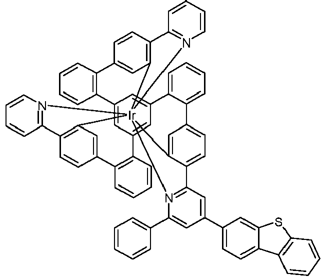 |
| 103 | 104 |
| 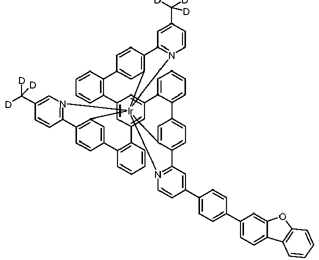 | 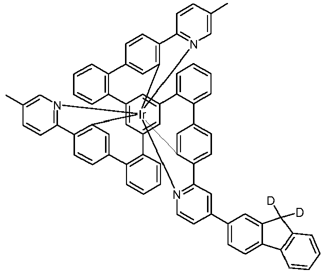 |
| 105 | 106 |
| | 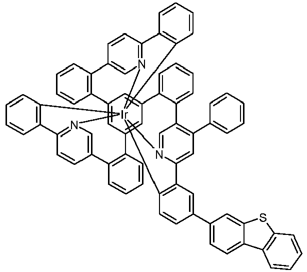 |
| | 114 |
| 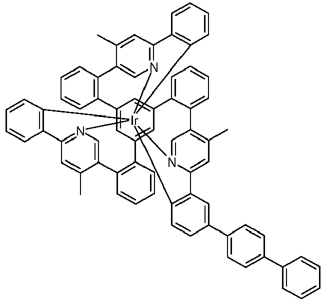 | 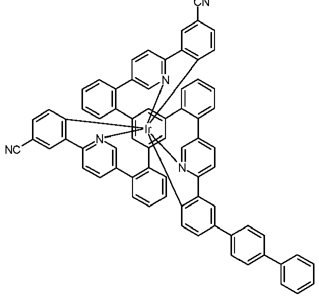 |
| 117 | 118 |
| 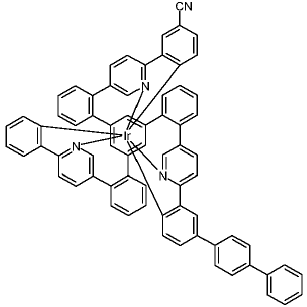 | 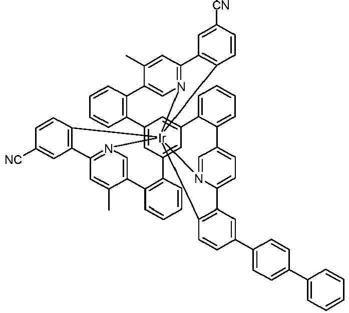 |
| 119 | 120 |
| 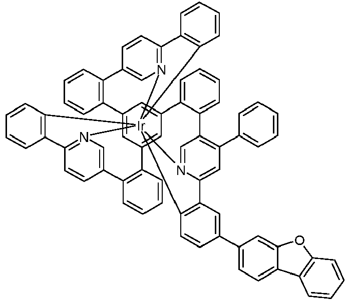 | 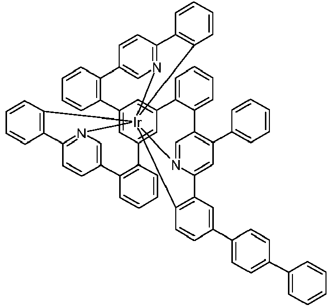 |
| 121 | 122 |
| 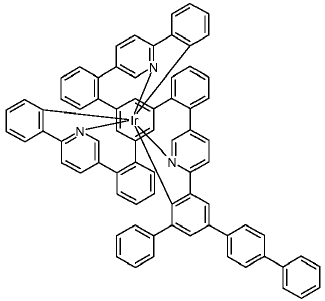 | 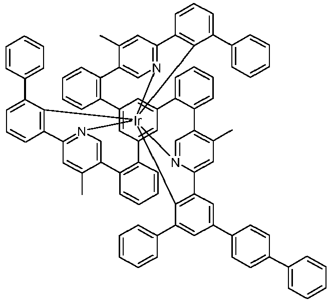 |
| 123 | 124 |
| 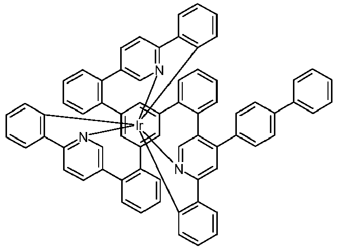 | 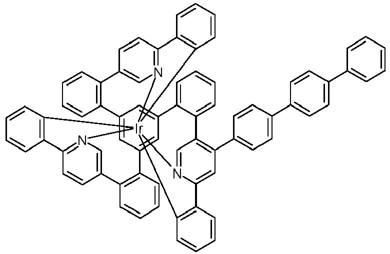 |
| 125 | 126 |
| 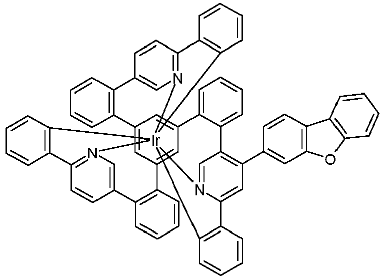 | 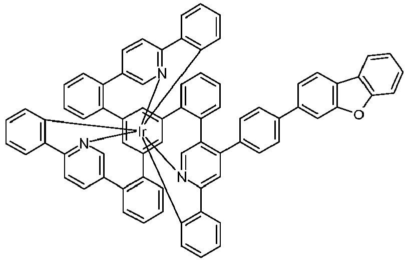 |
| 129 | 130 |
| 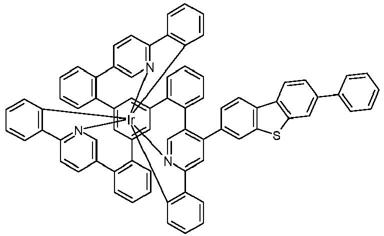 | 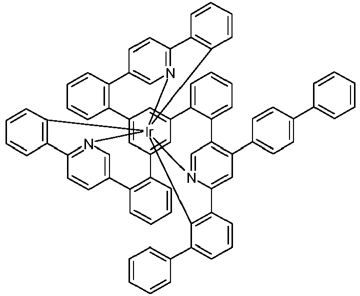 |
| 131 | 132 |
| 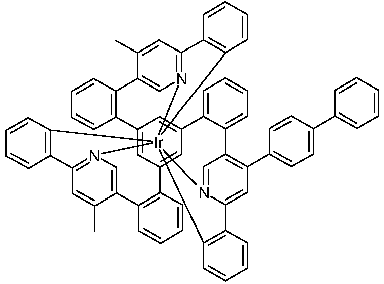 | 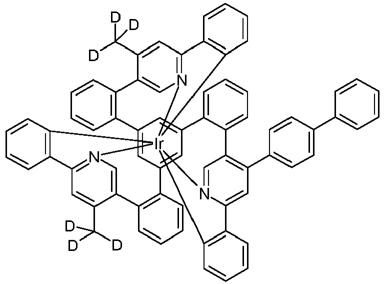 |
| 133 | 134 |
| 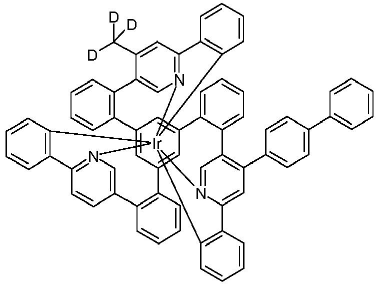 | 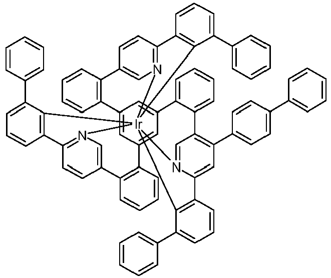 |
| 135 | 136 |
| 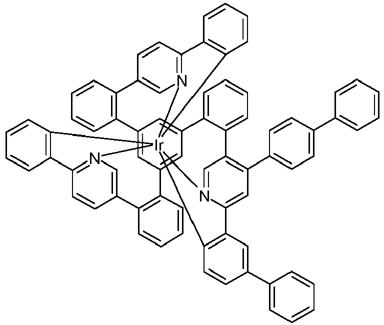 | 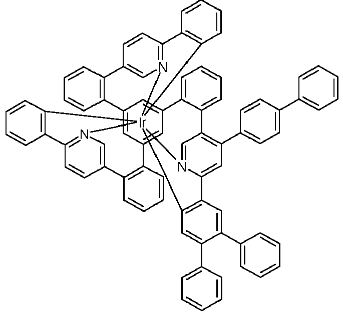 |
| 137 | 138 |
| 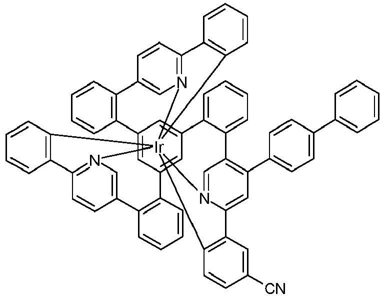 | |
| 139 | |
| 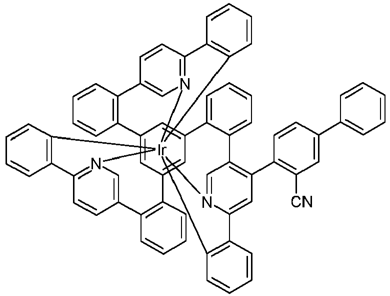 | 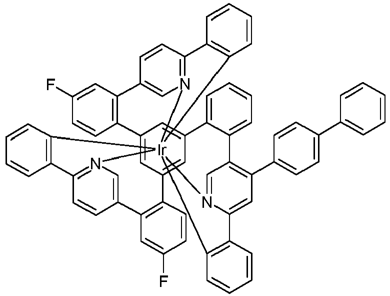 |
| 141 | 142 |
| 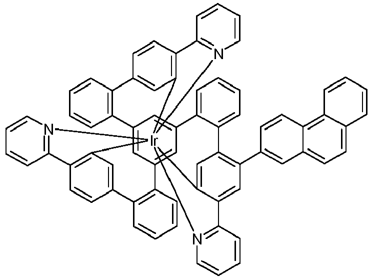 | 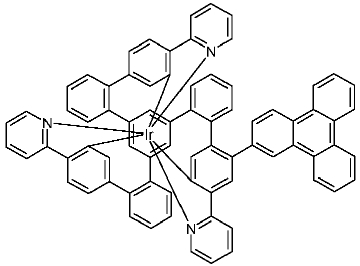 |
| 143 | 144 |
| 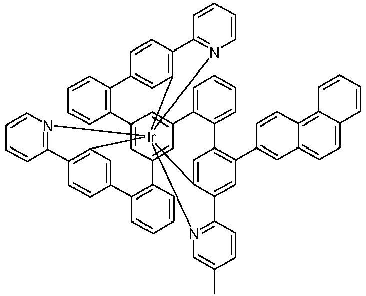 | 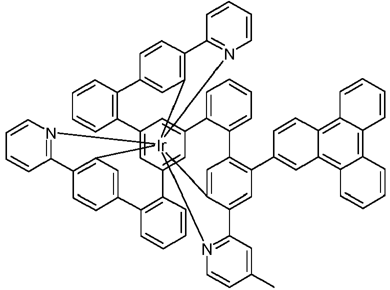 |
| 145 | 146 |
| 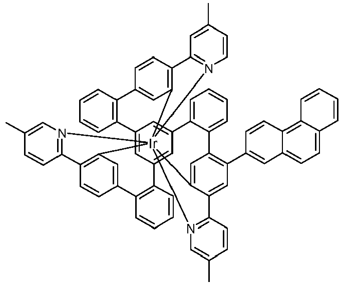 | 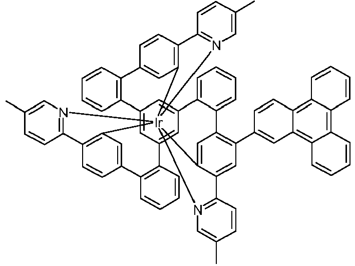 |
| 147 | 148 |
| 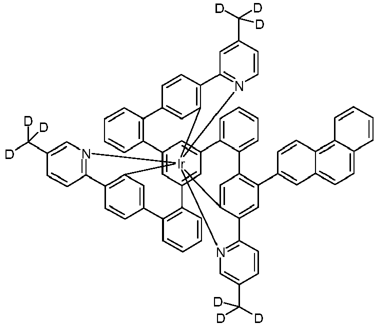 | 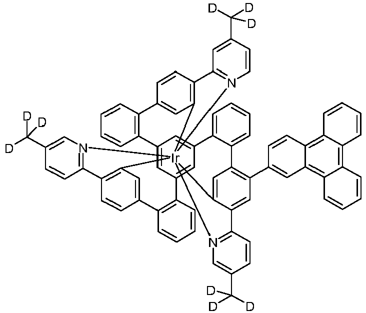 |
| 149 | 150 |
| 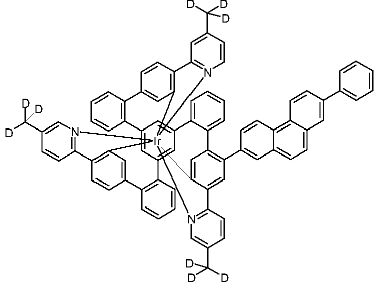 | 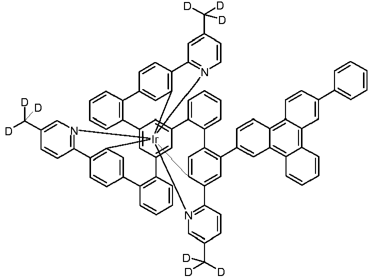 |
| 151 | 152 |
| 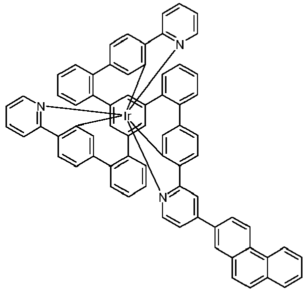 | 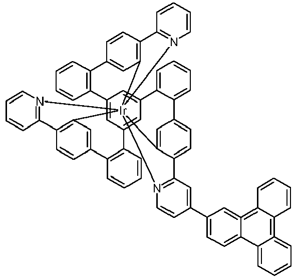 |
| 153 | 154 |
| 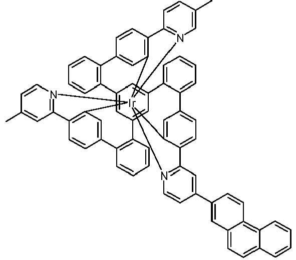 | 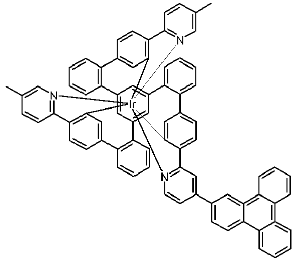 |
| 155 | 156 |
| 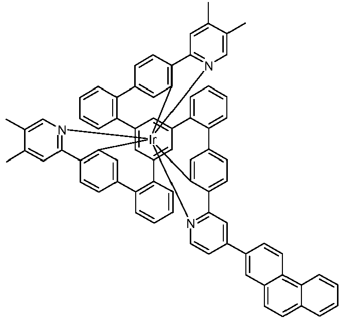 | 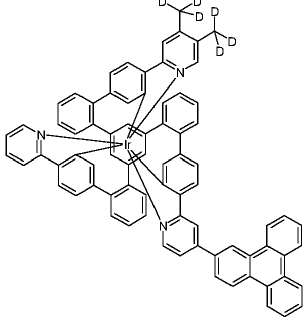 |
| 157 | 158 |
| 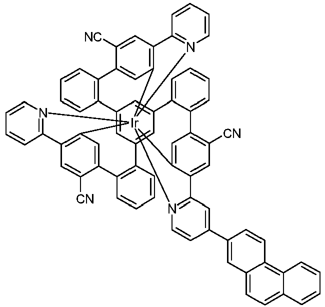 | 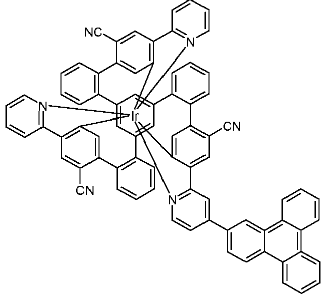 |
| 159 | 160 |
| 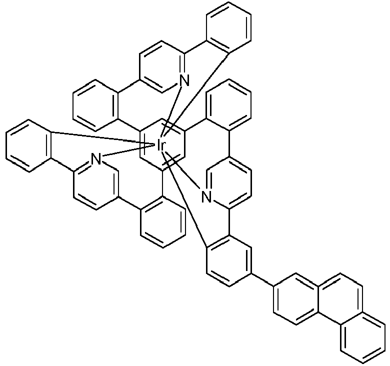 | 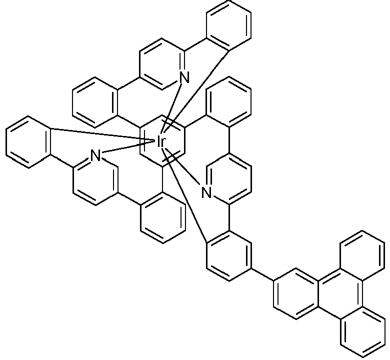 |
| 161 | 162 |
| 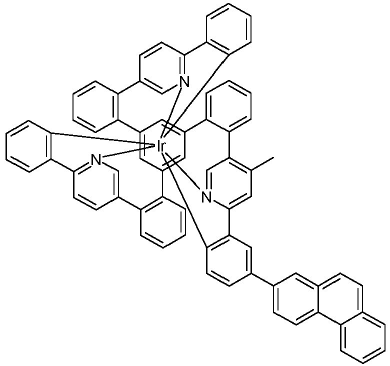 | 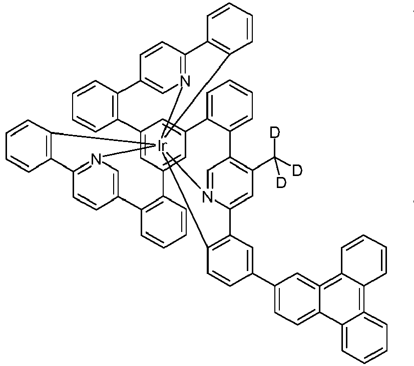 |
| 163 | 164 |
| 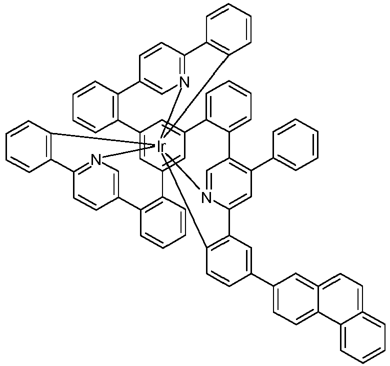 | 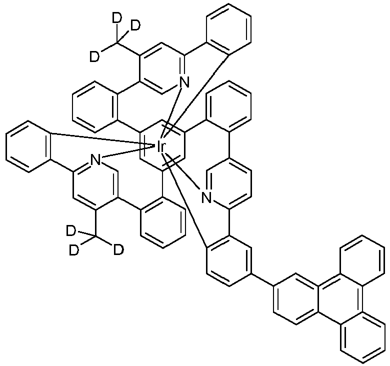 |
| 165 | 166 |
| 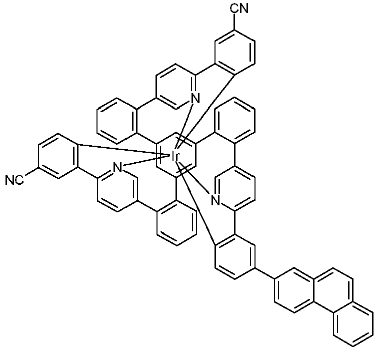 | 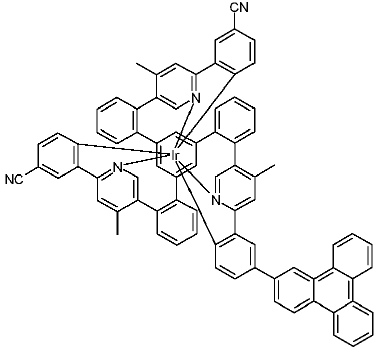 |
| 167 | 168 |
| 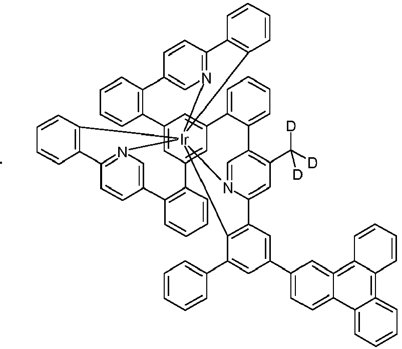 | 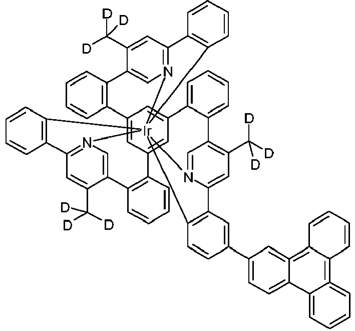 |
| 169 | 170 |
| 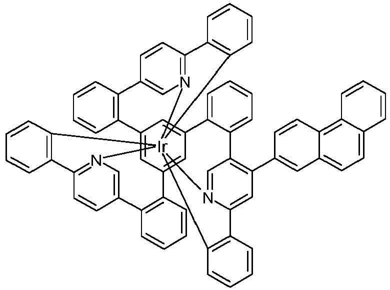 | 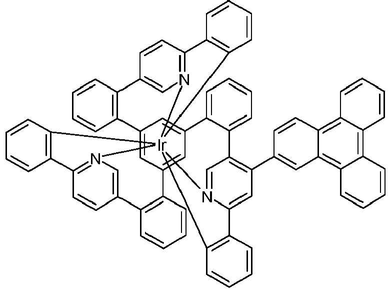 |
| 171 | 172 |
| 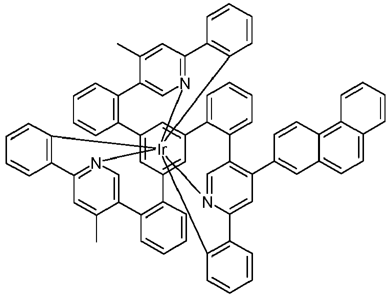 | 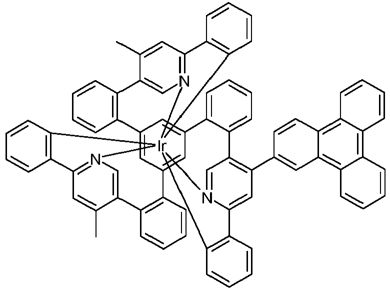 |
| 173 | 174 |
| 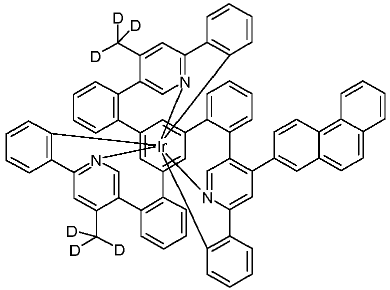 | 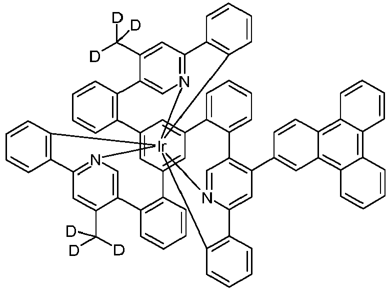 |
| 175 | 176 |
| 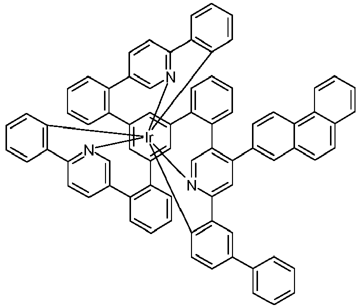 | 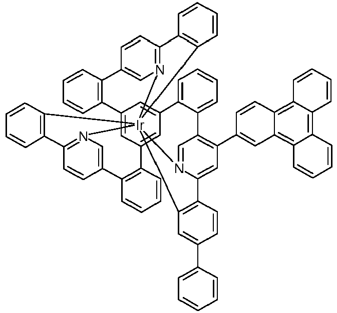 |
| 177 | 178 |
| 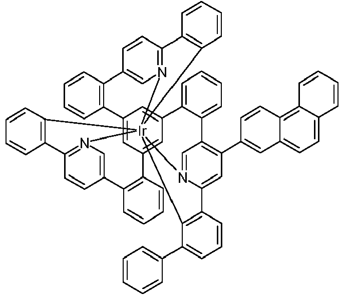 | 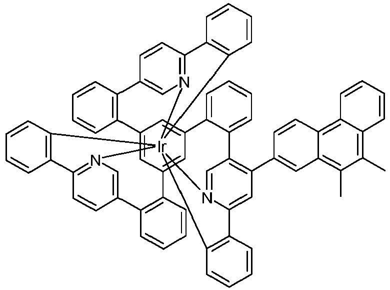 |
| 179 | 180 |
| 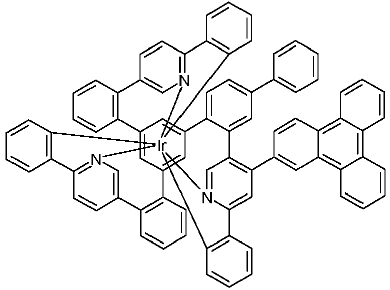 | 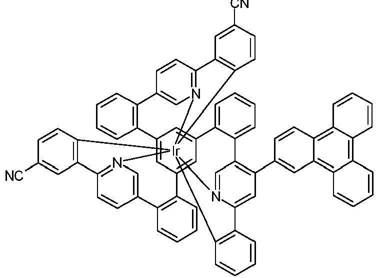 |
| 181 | 182 |
| 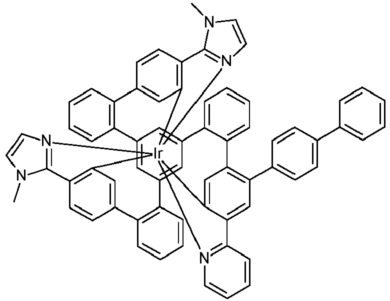 | 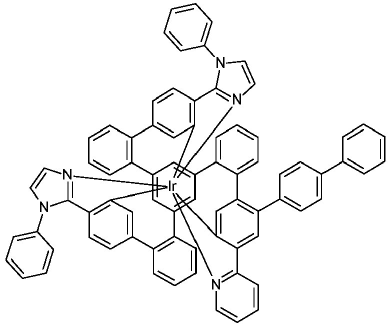 |
| 183 | 184 |
| 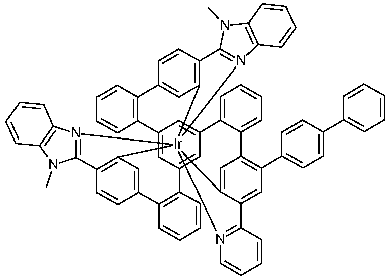 | 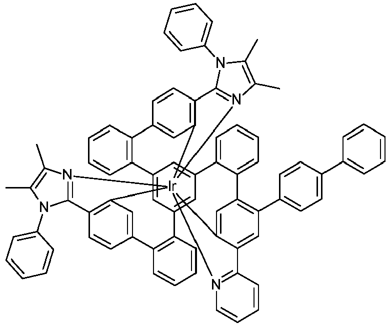 |
| 185 | 186 |
| 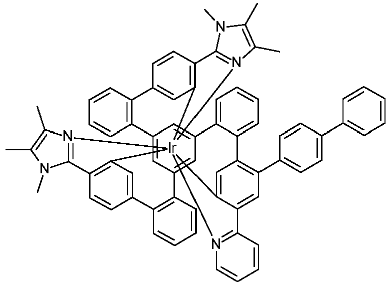 | 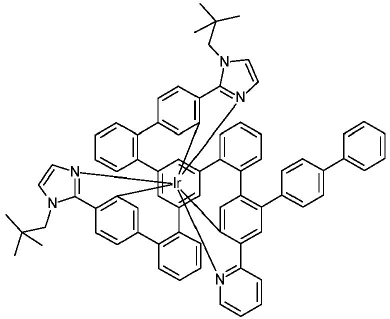 |
| 187 | 188 |
| 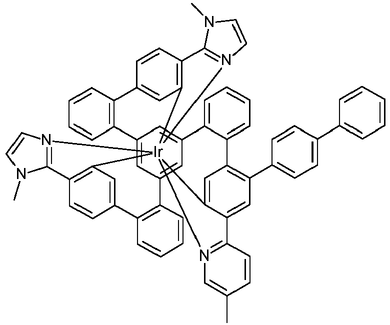 | 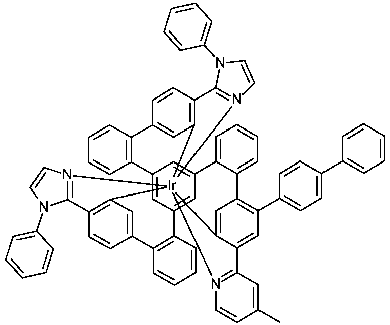 |
| 189 | 190 |
| 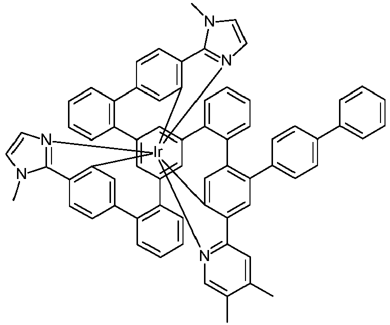 | 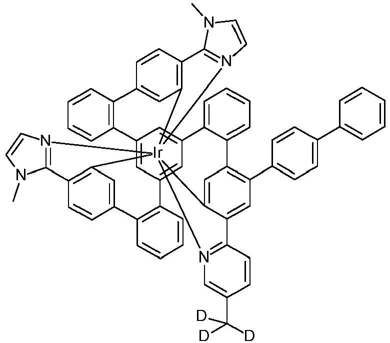 |
| 192 | 192 |
| 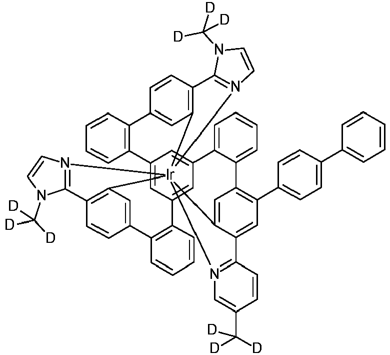 | |
| 193 | |
| 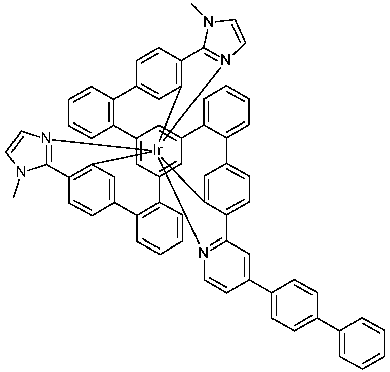 | 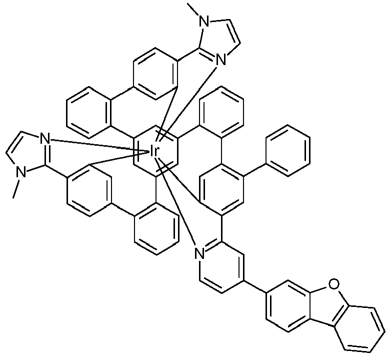 |
| 194 | 196 |
| 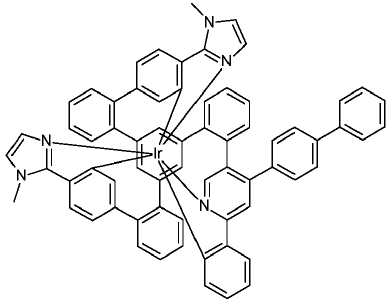 | 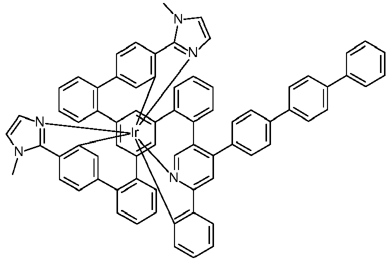 |
| 197 | 198 |
| 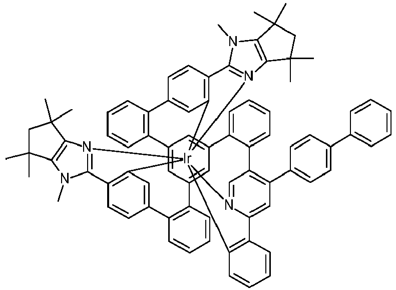 | 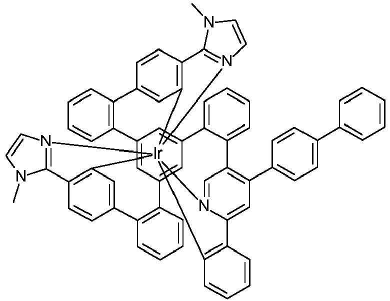 |
| 199 | 200 |
| 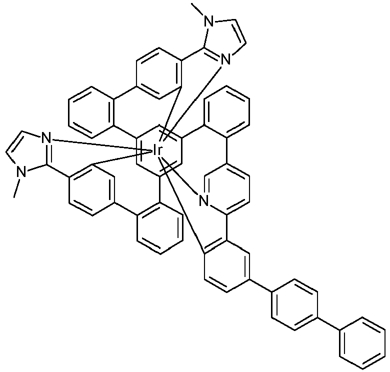 | 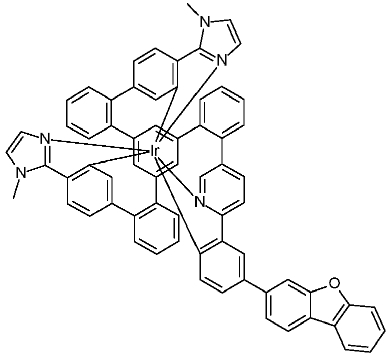 |
| 201 | 202 |
| 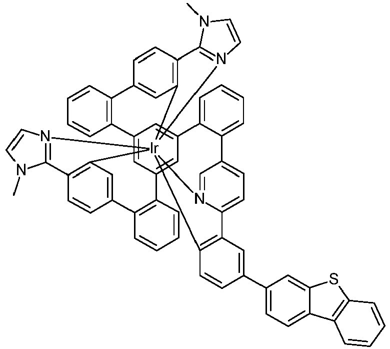 | 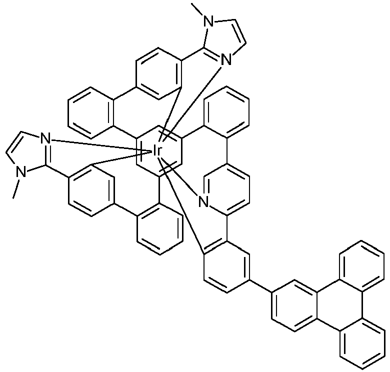 |
| 203 | 204 |
| 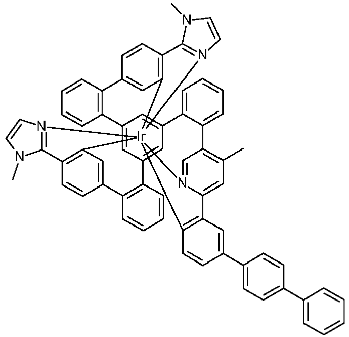 | 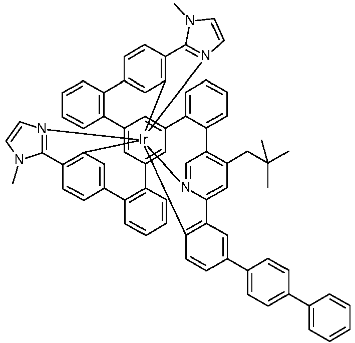 |
| 205 | 206 |
| 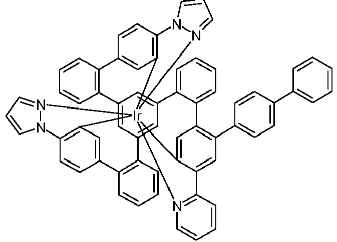 | 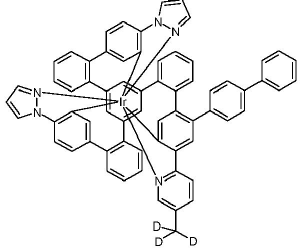 |
| 207 | 208 |
| 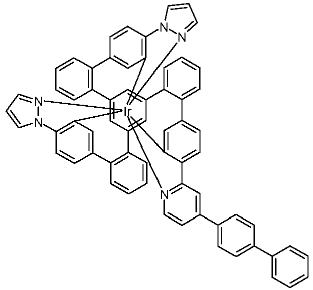 | 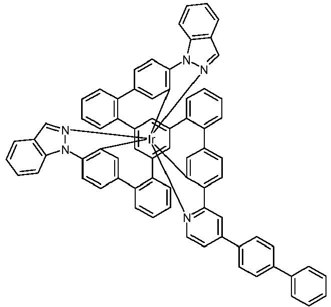 |
| 209 | 210 |
| 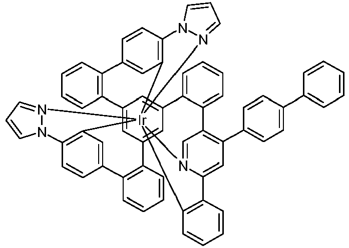 | 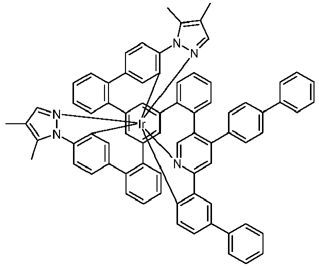 |
| 211 | 212 |
| 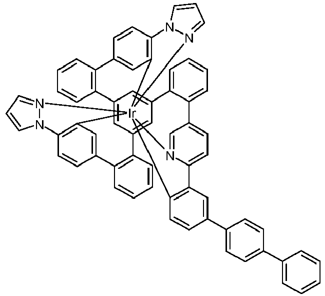 | 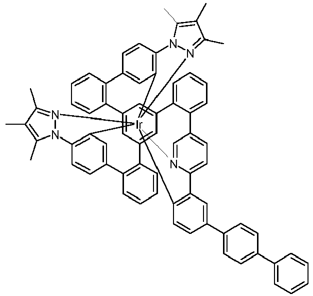 |
| 213 | 214 |
| 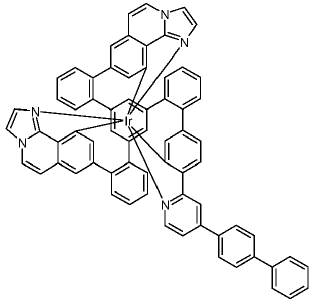 | 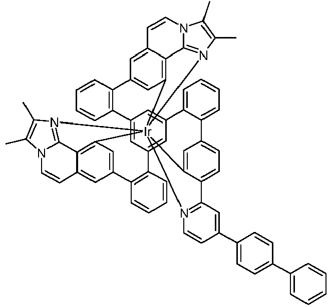 |
| 217 | 218 |
| 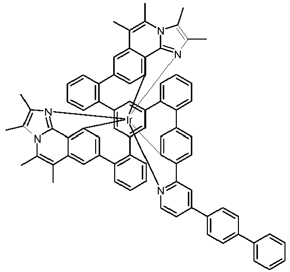 | 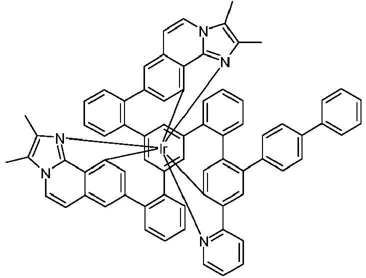 |
| 219 | 220 |
| 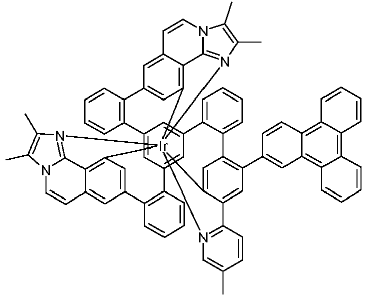 | 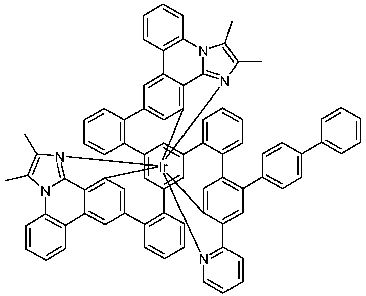 |
| 221 | 222 |
| 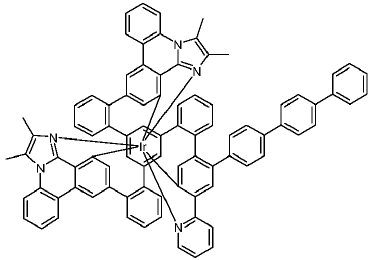 | 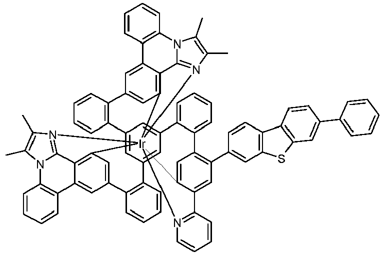 |
| 223 | 224 |
| 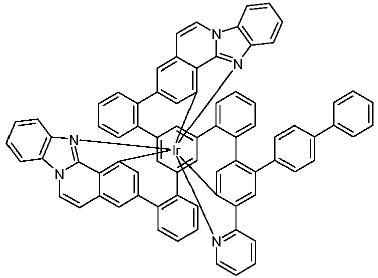 | 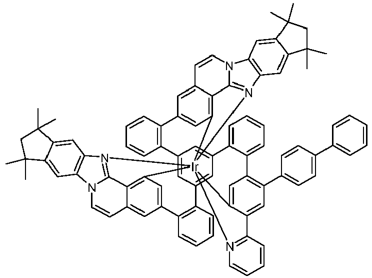 |
| 225 | 226 |
| 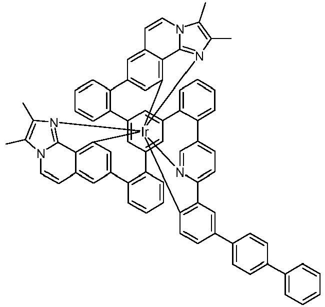 | 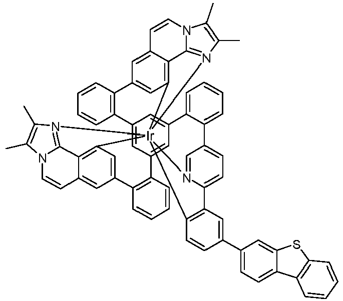 |
| 227 | 228 |
| 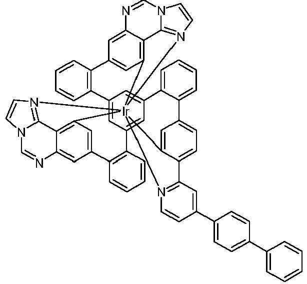 | 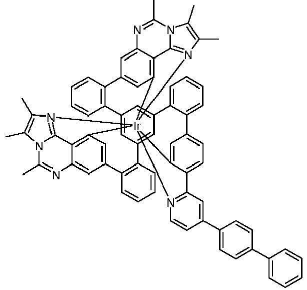 |
| 229 | 230 |
| 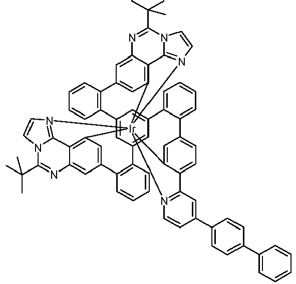 | 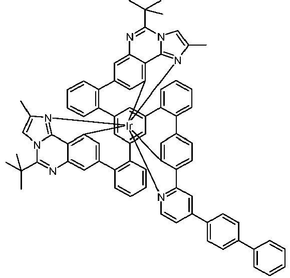 |
| 231 | 232 |
| 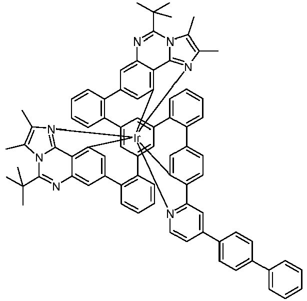 | 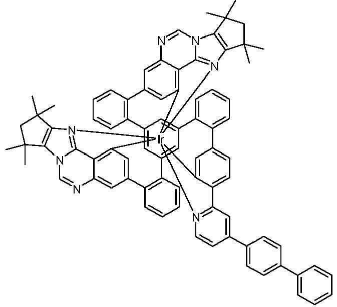 |
| 233 | 234 |
| 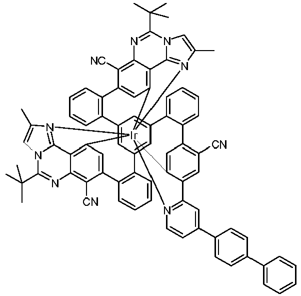 | 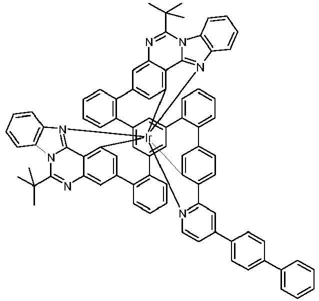 |
| 235 | 236 |
| 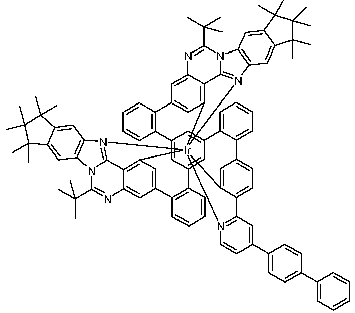 | 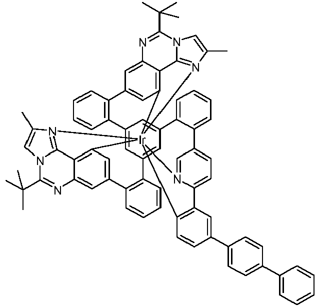 |
| 237 | 238 |
| 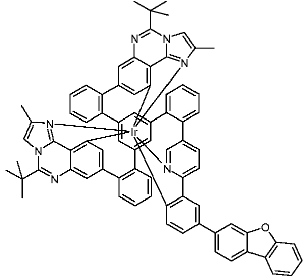 | 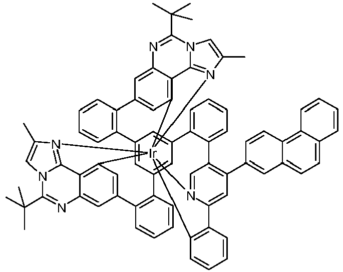 |
| 239 | 240 |
| 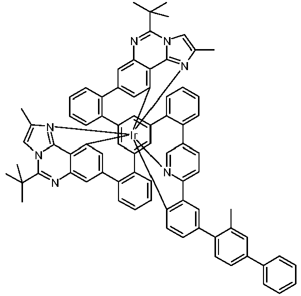 | 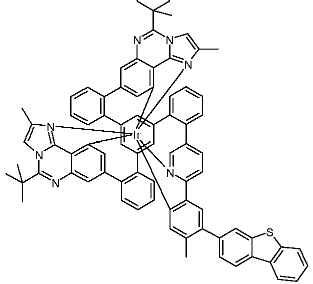 |
| 241 | 242 |
| 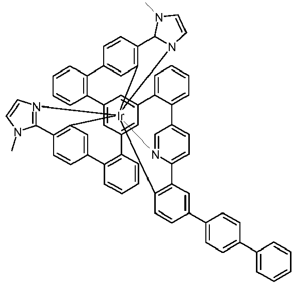 | 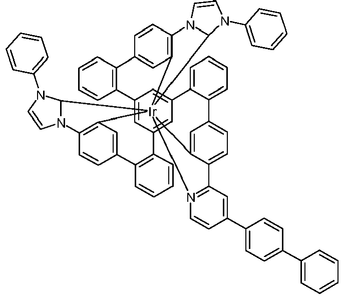 |
| 243 | 244 |
| 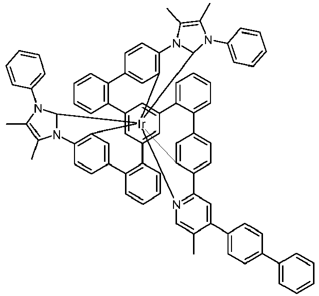 | 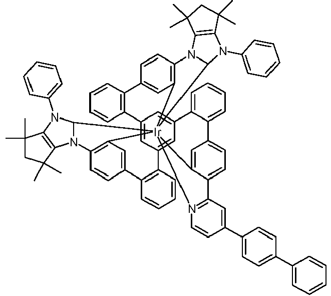 |
| 245 | 246 |
| 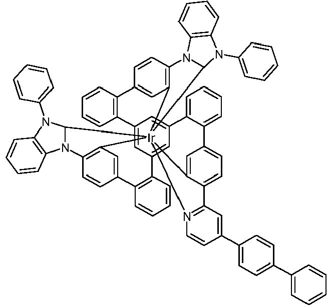 | 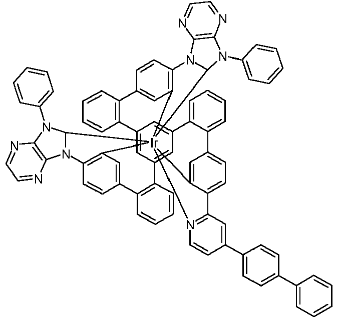 |
| 247 | 248 |
| 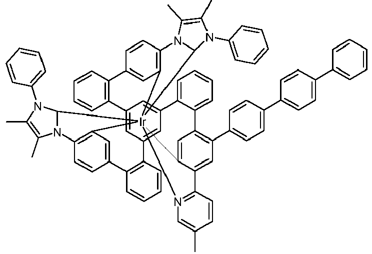 | 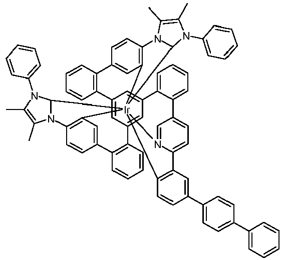 |
| 249 | 250 |
| 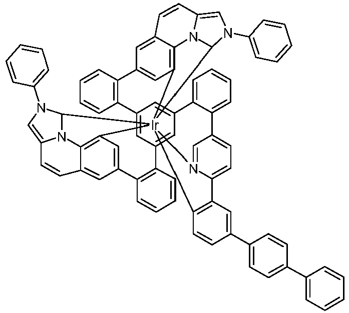 | 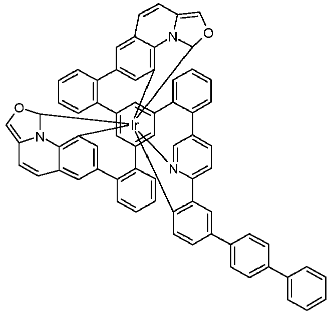 |
| 251 | 252 |
| 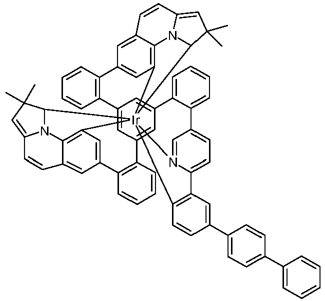 | 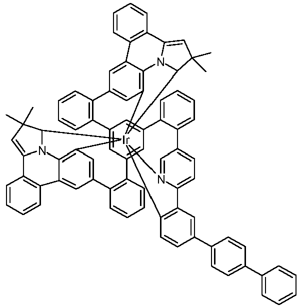 |
| 253 | 254 |
| 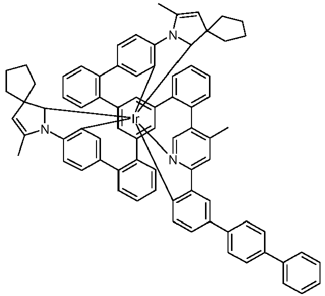 | 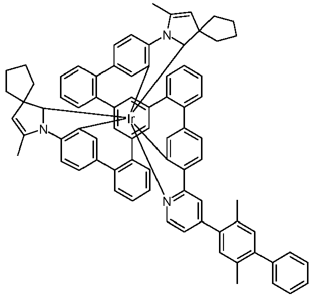 |
| 255 | 256 |
| 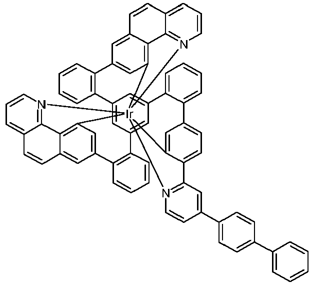 | 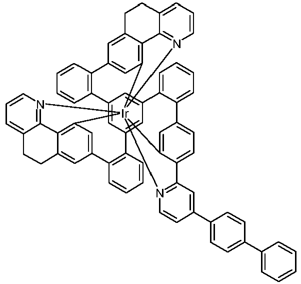 |
| 257 | 258 |
| 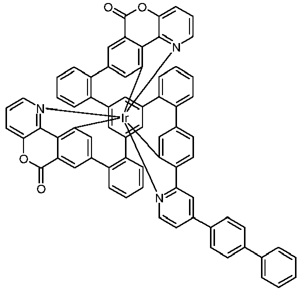 | 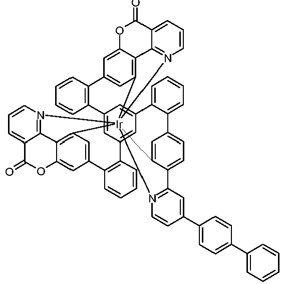 |
| 259 | 260 |
| 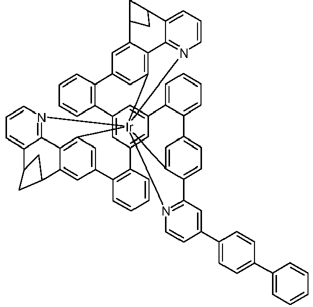 | 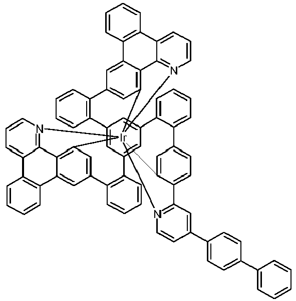 |
| 261 | 262 |
| 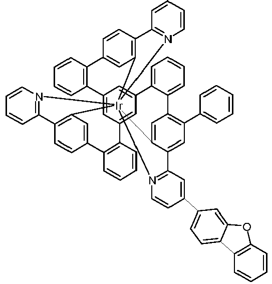 | |
| 263 | |
| 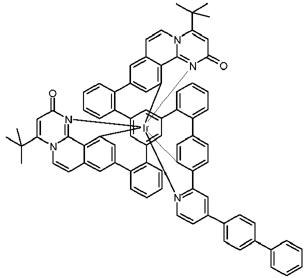 | 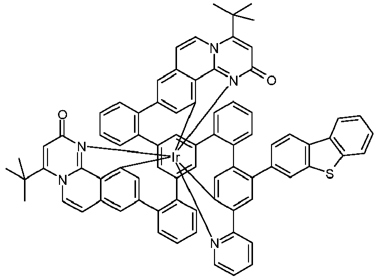 |
| 277 | 278 |
| 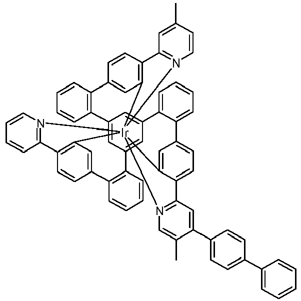 | 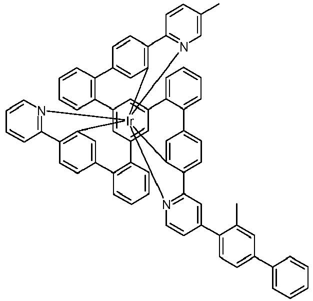 |
| 289 | 290 |
| 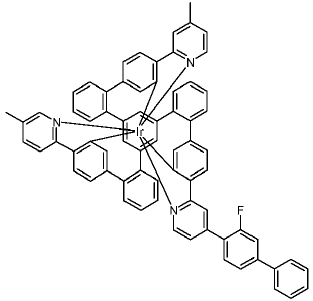 | 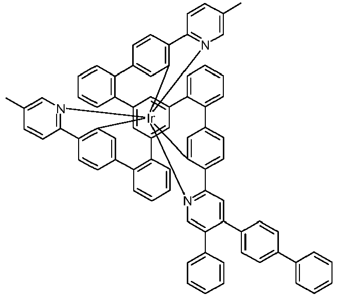 |
| 291 | 292 |
| 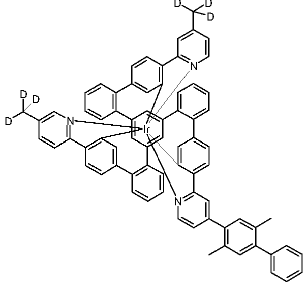 | 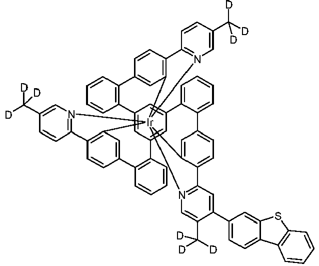 |
| 293 | 294 |
| 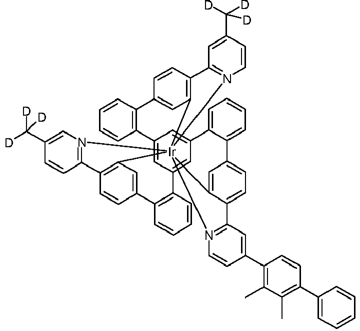 | 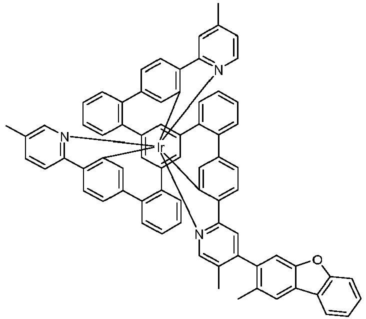 |
| 295 | 296 |
| 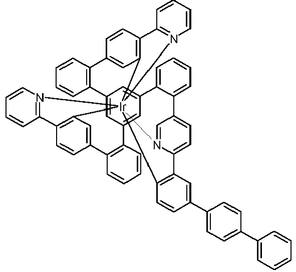 | 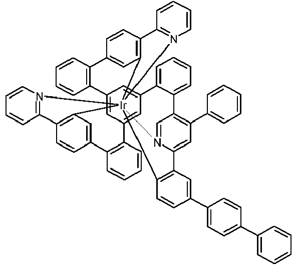 |
| 297 | 298 |
| 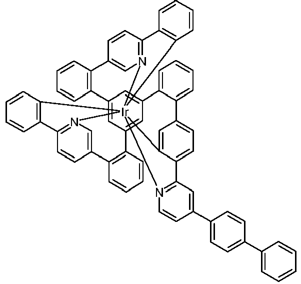 | 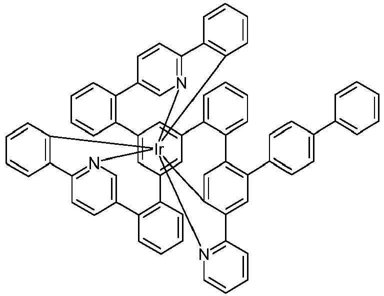 |
| 299 | 300 |
| 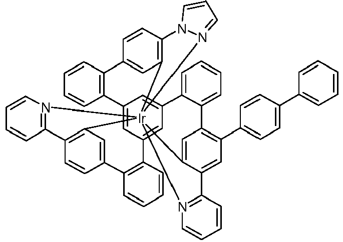 | 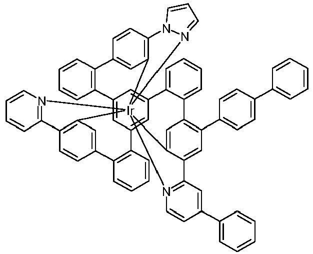 |
| 301 | 302 |
| 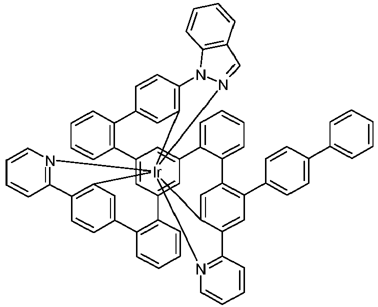 | 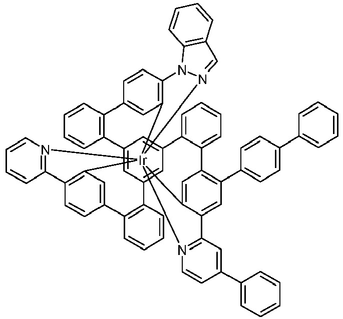 |
| 303 | 304 |
| 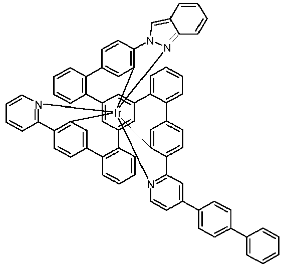 | 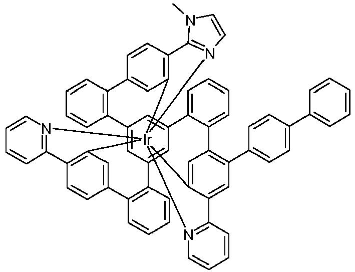 |
| 305 | 306 |
| 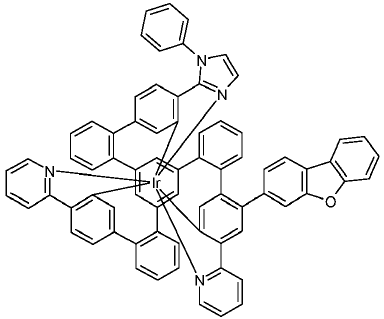 | |
| 307 | |
| 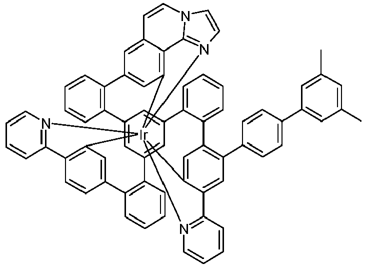 | 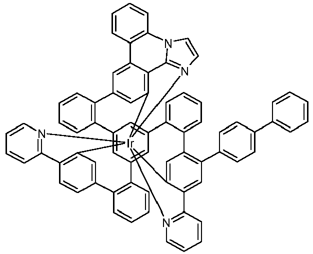 |
| 309 | 310 |
| 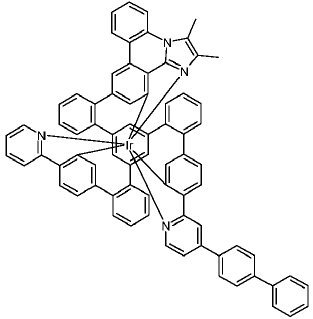 | 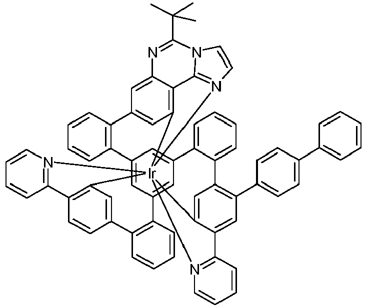 |
| 311 | 312 |
| 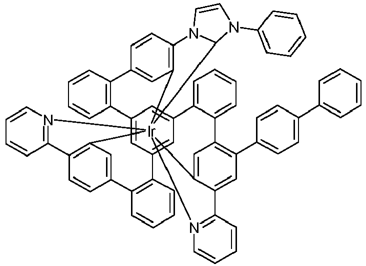 | 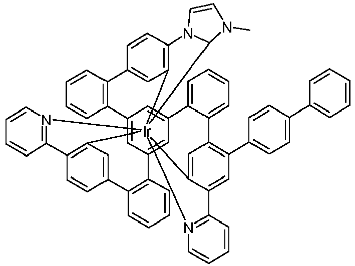 |
| 313 | 314 |
| 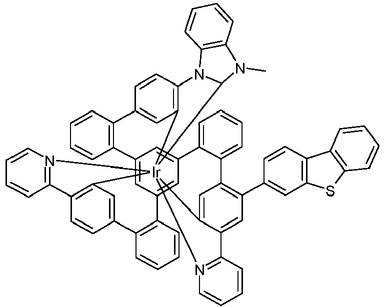 | 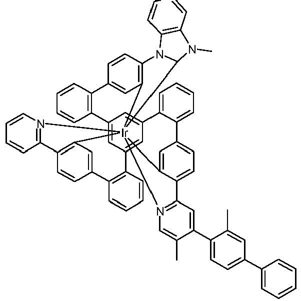 |
| 315 | 316 |
| 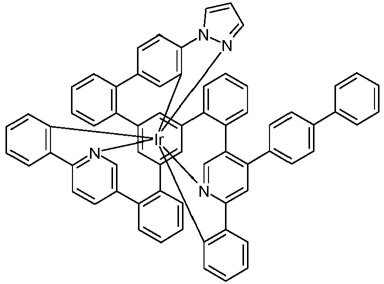 | 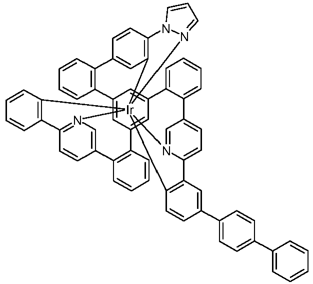 |
| 317 | 318 |
| 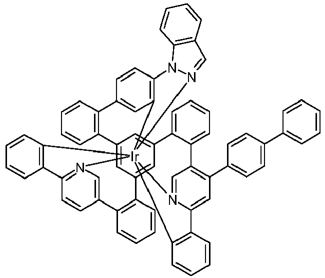 | 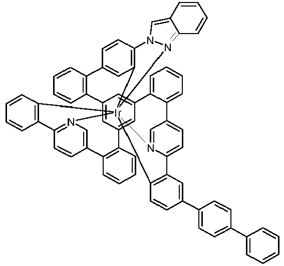 |
| 319 | 320 |
| 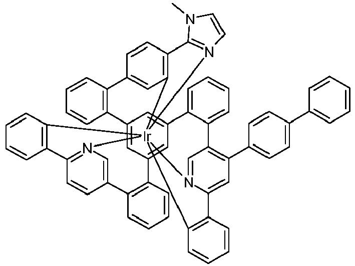 | 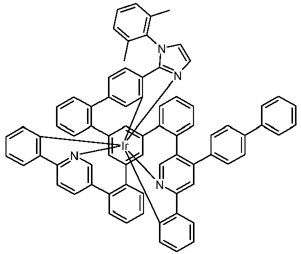 |
| 321 | 322 |
| 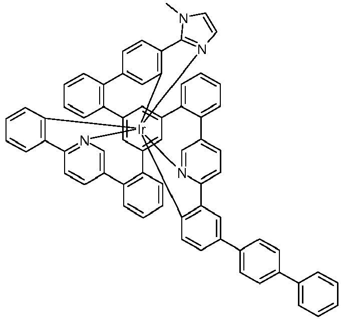 | 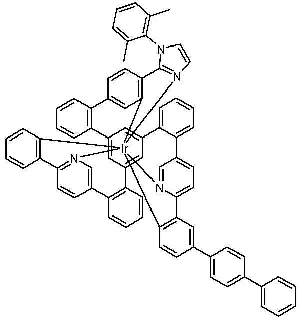 |
| 323 | 324 |
| 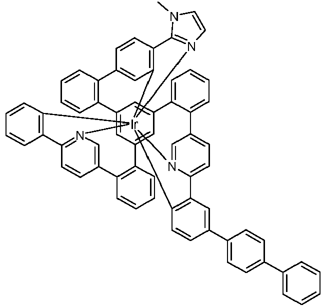 | 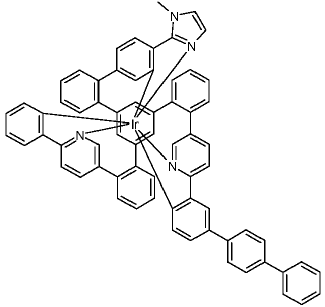 |
| 325 | 326 |
| 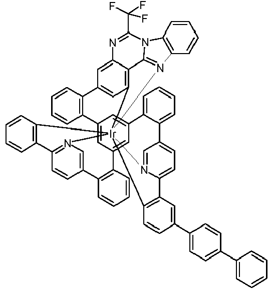 | 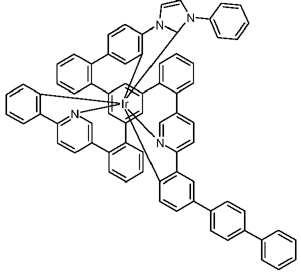 |
| 327 | 328 |
| 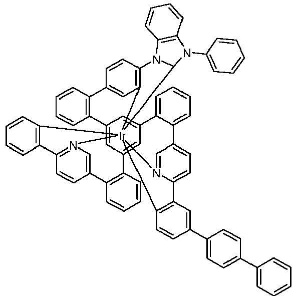 | 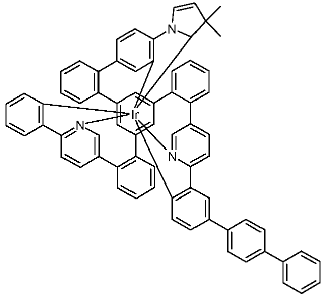 |
| 329 | 330 |
| 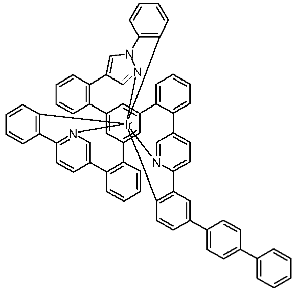 | 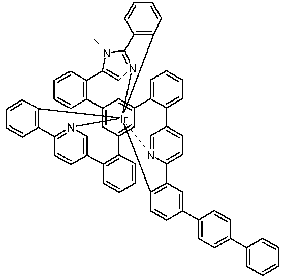 |
| 331 | 332 |
| 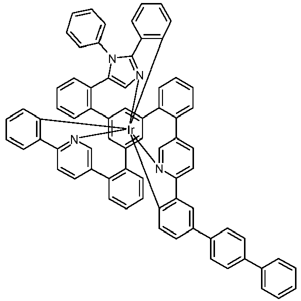 | 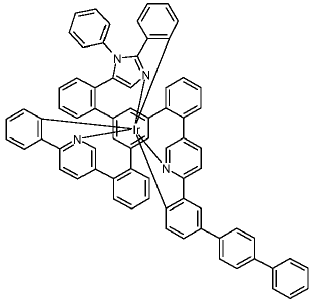 |
| 333 | 334 |
| 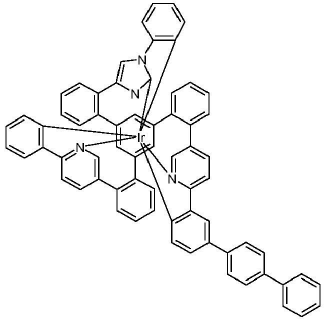 | 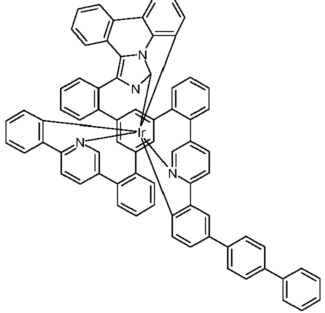 |
| 335 | 336 |
| 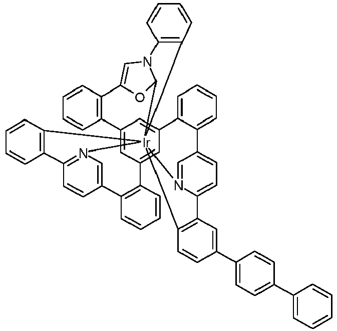 | 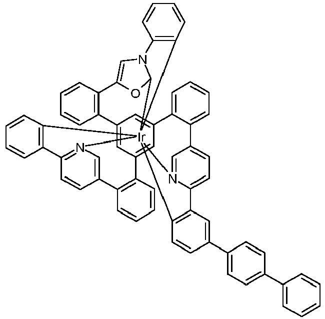 |
| 337 | 338 |
| 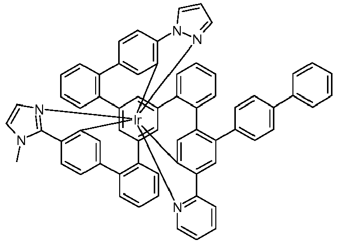 | 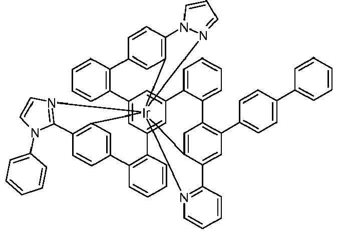 |
| 339 | 340 |
| 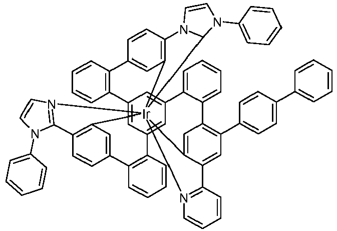 | 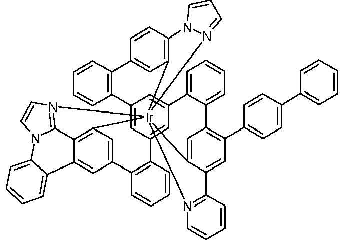 |
| 341 | 342 |
| 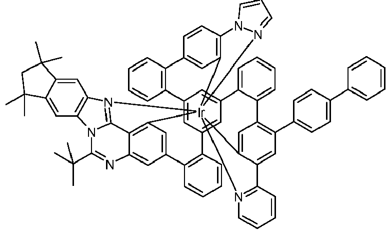 | 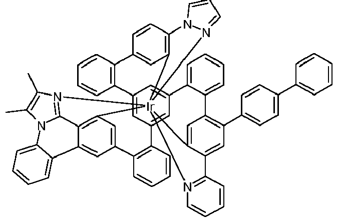 |
| 343 | 344 |

Bei den erfindungsgemäßen Metallkomplexen handelt es sich um chirale Strukturen. Wenn zusätzlich auch der tripodale Ligand des Komplexes chiral ist, ist die Bildung von Diastereomeren und mehreren Enantiomerenpaaren möglich. Die erfindungsgemäßen Komplexe umfassen dann sowohl die Mischungen der verschiedenen Diastereomere bzw. die entsprechenden Racemate wie auch die einzelnen isolierten Diastereomere bzw. Enantiomere.

Werden in der ortho-Metallierung Liganden mit zwei identischen Teilliganden L² eingesetzt, fällt üblicherweise ein racemisches Gemisch der C₁-symmetrischen Komplexe, also des Δ- und des Λ-Enantiomers, an. Diese können durch gängige Methoden (Chromatographie an chiralen Materialien / Säulen oder Racemattrennung durch Kristallisation) getrennt werden, wie in Schema 1 dargestellt, wobei R für eine Gruppe der Formel (3) oder (4) steht.

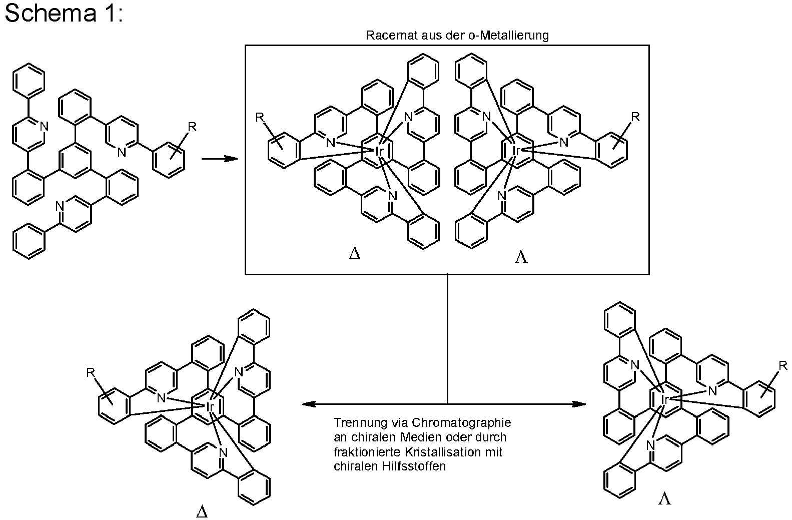

Die Racemattrennung via fraktionierter Kristallisation von diastereomeren Salzpaaren kann nach üblichen Methoden erfolgen. Hierzu bietet es sich an, die neutralen Ir(III)-Komplexe zu oxidieren (z. B. mit Peroxiden, H₂O₂ oder elektrochemisch), die so erzeugten kationischen Ir(IV)-Komplexe mit dem Salz einer enantiomerenreinen, monoanionischen Base (chirale Base) zu versetzen, die so erzeugten diasteromeren Salze durch fraktionierte Kristallisation zu trennen und diese dann mit Hilfe eines Reduktionsmittels (z. B. Zink, Hydrazinhydrat, Ascorbinsäure, etc.) zu den enantiomerenreinen neutralen Komplex zu reduzieren, wie in Schema 2 dargestellt.

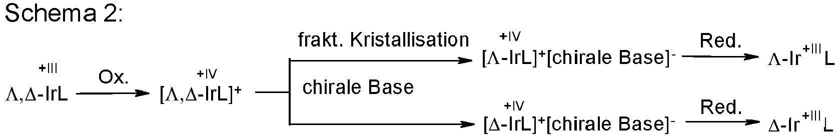

Daneben ist eine enantiomerenreine bzw. enantiomerenanreichernde Synthese durch Komplexierung in einem chiralen Medium (z. B. R- oder S-1,1-Binaphthol) möglich.

Werden in der Komplexierung Liganden mit drei unterschiedlichen Teilliganden L¹ und L² eingesetzt, fällt üblicherweise ein Diastereomerengemisch der Komplexe an, das durch gängige Methoden (Chromatographie, Kristallisation, etc.) getrennt werden kann.

Enantiomerenreine C₁-symmetrische Komplexe können auch gezielt synthetisiert werden, wie in Schema 3 dargestellt. Dazu wird ein enantiomerenreiner, C₁-symmetrischer Ligand dargestellt, komplexiert, das erhaltene Diastereomerengemisch wird getrennt und anschließend wird die chirale Gruppe abgespalten.

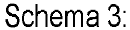

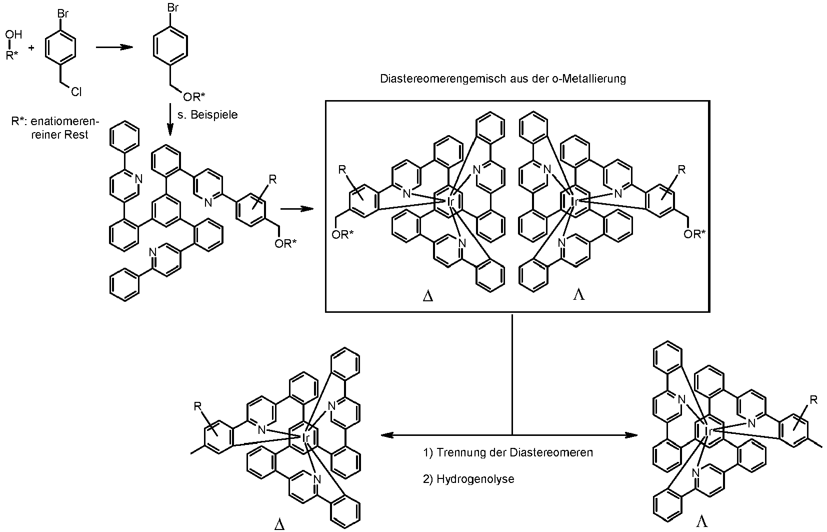

Die erfindungsgemäßen Verbindungen sind prinzipiell durch verschiedene Verfahren darstellbar. Generell wird hierzu ein Iridiumsalz mit dem entsprechenden freien Liganden umgesetzt.

Daher ist ein weiterer Gegenstand der vorliegenden Erfindung ein Verfahren zur Herstellung der erfindungsgemäßen Verbindungen durch Umsetzung der entsprechenden freien Liganden mit Iridiumalkoholaten der Formel (34), mit Iridiumketoketonaten der Formel (35), mit Iridiumhalogeniden der Formel (36) oder mit Iridiumcarboxylaten der Formel (37), 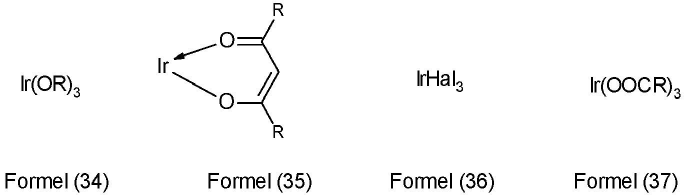 wobei R die oben angegebenen Bedeutungen hat, Hal = F, Cl, Br oder I ist und das Iridiumedukt auch als das entsprechende Hydrat vorliegen kann. Dabei steht R bevorzugt für eine Alkylgruppe mit 1 bis 4 C-Atomen.

Es können ebenfalls Iridiumverbindungen, die sowohl Alkoholat- und/oder Halogenid- und/oder Hydroxy- wie auch Ketoketonatreste tragen, verwendet werden. Diese Verbindungen können auch geladen sein. Entsprechende Iridiumverbindungen, die als Edukte besonders geeignet sind, sind in WO 2004/085449 offenbart. Besonders geeignet sind [IrCl₂(acac)₂]⁻, beispielsweise Na[IrCl₂(acac)₂], Metallkomplexe mit Acetylacetonat-Derivaten als Ligand, beispielsweise Ir(acac)₃ oder Tris(2,2,6,6-Tetramethylheptan-3,5-dionato)iridium, und IrCl_{3·}xH₂O, wobei x üblicherweise für eine Zahl zwischen 2 und 4 steht.

Die Synthese der Komplexe wird bevorzugt durchgeführt wie in WO 2002/060910 und in WO 2004/085449 beschrieben. Dabei kann die Synthese beispielsweise auch thermisch, photochemisch und/oder durch Mikrowellenstrahlung aktiviert werden. Weiterhin kann die Synthese auch im Autoklaven bei erhöhtem Druck und/oder erhöhter Temperatur durchgeführt werden.

Die Reaktionen können ohne Zusatz von Lösemitteln oder Schmelzhilfen in einer Schmelze der entsprechenden zu o-metallierenden Liganden durchgeführt werden. Gegebenenfalls können auch Lösemittel oder Schmelzhilfen zugesetzt werden. Geeignete Lösemittel sind protische oder aprotische Lösemittel, wie aliphatische und / oder aromatische Alkohle (Methanol, Ethanol, iso-Propanol, t-Butanol, etc.), Oligo- und Polyalkohole (Ethylenglykol, 1,2-Propandiol, Glycerin, etc.), Alkoholether (Ethoxyethanol, Diethylenglykol, Triethylenglycol, Polyethylenglykol, etc.), Ether (Di- und Triethylenglykoldimethylether, Diphenylether, etc.), aromatische, heteroaromatische und oder aliphatische Kohlenwasserstoffe (Toluol, Xylol, Mesitylen, Chlorbenzol, Pyridin, Lutidin, Chinolin, Isochinolin, Tridecan, Hexadecan, etc.), Amide (DMF, DMAC, etc.), Lactame (NMP), Sulfoxide (DMSO) oder Sulfone (Dimethylsulfon, Sulfolan, etc.). Geeignete Schmelzhilfen sind Verbindungen, die bei Rautemperatur fest vorliegen, jedoch beim Erwärmen der Reaktionsmischung schmelzen und die Reaktanden lösen, so dass eine homogene Schmelze entsteht. Besonders geeignet sind Biphenyl, m-Terphenyl, Triphenylen, R- oder S-Binaphthol oder auch das entsprechende Racemat, 1,2-, 1,3-, 1,4-Bisphenoxybenzol, Triphenylphosphinoxid, 18-Krone-6, Phenol, 1-Naphthol, Hydrochinon, etc.. Dabei ist die Verwendung von Hydrochinon besonders bevorzugt.

Durch diese Verfahren, gegebenenfalls gefolgt von Aufreinigung, wie z. B. Umkristallisation oder Sublimation, lassen sich die erfindungsgemäßen Verbindungen gemäß Formel (1) in hoher Reinheit, bevorzugt mehr als 99 % (bestimmt mittels ¹H-NMR und/oder HPLC) erhalten.

Die erfindungsgemäßen Verbindungen können auch durch geeignete Substitution, beispielsweise durch längere Alkylgruppen (ca. 4 bis 20 C-Atome), insbesondere verzweigte Alkylgruppen, löslich gemacht werden. Insbesondere auch die Verwendung von ankondensierten aliphatischen Gruppen, wie sie beispielsweise durch die oben offenbarten Formeln (27) bis (33) dargestellt werden, führt zu einer deutlichen Verbesserung der Löslichkeit der Metallkomplexe. Solche Verbindungen sind dann in gängigen organischen Lösemitteln, wie beispielsweise Toluol oder Xylol bei Raumtemperatur in ausreichender Konzentration löslich, um die Komplexe aus Lösung verarbeiten zu können. Diese löslichen Verbindungen eignen sich besonders gut für die Verarbeitung aus Lösung, beispielsweise durch Druckverfahren.

Für die Verarbeitung der erfindungsgemäßen Iridiumkomplexe aus flüssiger Phase, beispielsweise durch Spin-Coating oder durch Druckverfahren, sind Formulierungen der erfindungsgemäßen Iridiumkomplexe erforderlich. Diese Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, NMP, p-Cymol, Phenetol, 1,4-Diisopropylbenzol, Dibenzylether, Diethylenglycolbutylmethylether, Triethylenglycolbutylmethylether, Diethylenglycoldibutylether, Triethylenglycoldimethylether, Diethylenglycolmonobutylether, Tripropyleneglycoldimethylether, Tetraethylenglycoldimethylether, 2-Isopropylnaphthalin, Pentylbenzol, Hexylbenzol, Heptylbenzol, Octylbenzol, 1,1-Bis(3,4-dimethylphenyl)ethan, Hexamethylindan, 2-Methylbiphenyl, 3-Methylbiphenyl, 1-Methylnaphthalin, 1-Ethylnaphthalin, Ethyloctanoat, Sebacinsäure-diethylester, Octyloctanoat, Heptylbenzol, Menthyl-isovalerat, Cyclohexylhexanoat oder Mischungen dieser Lösemittel.

Ein weiterer Gegenstand der vorliegenden Erfindung ist daher eine Formulierung, enthaltend mindestens eine erfindungsgemäßen Verbindung und mindestens eine weitere Verbindung. Die weitere Verbindung kann beispielsweise ein Lösemittel sein, insbesondere eines der oben genannten Lösemittel oder eine Mischung dieser Lösemittel. Die weitere Verbindung kann aber auch eine weitere organische oder anorganische Verbindung sein, die ebenfalls in der elektronischen Vorrichtung eingesetzt wird, beispielsweise ein Matrixmaterial. Diese weitere Verbindung kann auch polymer sein.

Die erfindungsgemäße Verbindung kann in der elektronischen Vorrichtung als aktive Komponente, bevorzugt als Emitter in der emissiven Schicht oder als Loch- oder Elektronentransportmaterial in einer loch- bzw. elektronentransportierenden Schicht, oder als Sauerstoff-Sensibilisatoren oder als Photoinitiator oder Photokatalysator verwendet werden. Ein weiterer Gegenstand der vorliegenden Erfindung ist somit die Verwendung einer erfindungsgemäßen Verbindung in einer elektronischen Vorrichtung oder als Sauerstoff-Sensibilisator oder als Photoinitiator oder Photokatalysator. Enantiomerenreine erfindungsgemäße Iridiumkomplexe eignen sich als Photokatalysatoren für chirale photoinduzierte Synthesen.

Nochmals ein weiterer Gegenstand der vorliegenden Erfindung ist eine elektronische Vorrichtung enthaltend mindestens eine erfindungsgemäße Verbindung.

Unter einer elektronischen Vorrichtung wird eine Vorrichtung verstanden, welche Anode, Kathode und mindestens eine Schicht enthält, wobei diese Schicht mindestens eine organische bzw. metallorganische Verbindung enthält. Die erfindungsgemäße elektronische Vorrichtung enthält also Anode, Kathode und mindestens eine Schicht, welche mindestens einen erfindungsgemäßen Iridiumkomplex enthält. Dabei sind bevorzugte elektronische Vorrichtungen ausgewählt aus der Gruppe bestehend aus organischen Elektrolumineszenzvorrichtungen (OLEDs, PLEDs), organischen integrierten Schaltungen (O-ICs), organischen Feld-Effekt-Transistoren (O-FETs), organischen Dünnfilmtransistoren (O-TFTs), organischen lichtemittierenden Transistoren (O-LETs), organischen Solarzellen (O-SCs), wobei hierunter sowohl rein organische Solarzellen wie auch farbstoffsensibilisierte Solarzellen verstanden werden, organischen optischen Detektoren, organischen Photorezeptoren, organischen Feld-Quench-Devices (O-FQDs), lichtemittierenden elektrochemischen Zellen (LECs), Sauerstoff-Sensoren oder organischen Laserdioden (O-Laser), enthaltend in mindestens einer Schicht mindestens eine erfindungsgemäße Verbindung. Verbindungen, die im Infraroten emittieren, eignen sich für den Einsatz in organischen Infrarot-Elektrolumineszenzvorrichtungen und Infrorot-Sensoren. Besonders bevorzugt sind organische Elektrolumineszenzvorrichtungen. Aktive Komponenten sind generell die organischen oder anorganischen Materialien, welche zwischen Anode und Kathode eingebracht sind, beispielsweise Ladungsinjektions-, Ladungstransport- oder Ladungsblockiermaterialien, insbesondere aber Emissionsmaterialien und Matrixmaterialien. Die erfindungsgemäßen Verbindungen zeigen besonders gute Eigenschaften als Emissionsmaterial in organischen Elektrolumineszenzvorrichtungen. Eine bevorzugte Ausführungsform der Erfindung sind daher organische Elektrolumineszenzvorrichtungen. Weiterhin können die erfindungsgemäßen Verbindungen zur Erzeugung von Singulett-Sauerstoff oder in der Photokatalyse eingesetzt werden.

Die organische Elektrolumineszenzvorrichtung enthält Kathode, Anode und mindestens eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten, Ladungserzeugungsschichten und/oder organische oder anorganische p/n-Übergänge. Dabei ist es möglich, dass eine oder mehrere Lochtransportschichten p-dotiert sind, beispielsweise mit Metalloxiden, wie MoO₃ oder WO₃, oder mit (per)fluorierten elektronenarmen Aromaten oder mit elektronenarmen Cyano-substituieren Heteroaromaten (z. B. gemäß JP 4747558, JP 2006-135145, US 2006/0289882, WO 2012/095143), oder mit chinoiden Systemen (z. B. gemäß EP1336208) oder mit LewisSäuren, oder mit Boranen (z. B. gemäß US 2003/0006411,

WO 2002/051850, WO 2015/049030) oder mit Carboxylaten der Elemente der 3. , 4. oder 5. Hauptgruppe (WO 2015/018539) und/oder dass eine oder mehrere Elektronentransportschichten n-dotiert sind.

Ebenso können zwischen zwei emittierende Schichten Interlayers eingebracht sein, welche beispielsweise eine Exzitonen-blockierende Funktion aufweisen und/oder die Ladungsbalance in der Elektrolumineszenzvorrichtung steuern und/oder Ladungen erzeugen (Charge-Generation-Layer, z. B. in Schichtsystemen mit mehreren emittierenden Schichten, z. B. in weiß emittierenden OLED-Bauteilen) . Es sei aber darauf hingewiesen, dass nicht notwendigerweise jede dieser Schichten vorhanden sein muss.

Dabei kann die organische Elektrolumineszenzvorrichtung eine emittierende Schicht enthalten, oder sie kann mehrere emittierende Schichten enthalten. Wenn mehrere Emissionsschichten vorhanden sind, weisen diese bevorzugt insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können. Insbesondere bevorzugt sind Dreischichtsysteme, wobei die drei Schichten blaue, grüne und orange oder rote Emission zeigen (für den prinzipiellen Aufbau siehe z. B. WO 2005/011013) bzw. Systeme, welche mehr als drei emittierende Schichten aufweisen. Es kann sich auch um ein Hybrid-System handeln, wobei eine oder mehrere Schichten fluoreszieren und eine oder mehrere andere Schichten phosphoreszieren. Eine bevorzugte Ausführungsform sind Tandem-OLEDs. Weiß emittierende organische Elektrolumineszenzvorrichtungen können für Beleuchtungsanwendungen oder mit Farbfilter auch für Vollfarb-Displays verwendet werden.

In einer bevorzugten Ausführungsform der Erfindung enthält die organische Elektrolumineszenzvorrichtung den erfindungsgemäßen Iridiumkomplex als emittierende Verbindung in einer oder mehreren emittierenden Schichten.

Wenn der erfindungsgemäße Iridiumkomplex als emittierende Verbindung in einer emittierenden Schicht eingesetzt wird, wird er bevorzugt in Kombination mit einem oder mehreren Matrixmaterialien eingesetzt. Die Mischung aus dem erfindungsgemäßen Iridiumkomplex und dem Matrixmaterial enthält zwischen 0.1 und 99 Vol.-%, vorzugsweise zwischen 1 und 90 Vol.-%, besonders bevorzugt zwischen 3 und 40 Vol.-%, insbesondere zwischen 5 und 15 Vol.-% des erfindungsgemäßen Iridiumkomplexes bezogen auf die Gesamtmischung aus Emitter und Matrixmaterial. Entsprechend enthält die Mischung zwischen 99.9 und 1 Vol.-%, vorzugsweise zwischen 99 und 10 Vol.-%, besonders bevorzugt zwischen 97 und 60 Vol.-%, insbesondere zwischen 95 und 85 Vol.-% des Matrixmaterials bezogen auf die Gesamtmischung aus Emitter und Matrixmaterial.

Als Matrixmaterial können generell alle Materialien eingesetzt werden, die gemäß dem Stand der Technik hierfür bekannt sind. Bevorzugt ist das Triplett-Niveau des Matrixmaterials höher als das Triplett-Niveau des Emitters.

Geeignete Matrixmaterialien für die erfindungsgemäßen Verbindungen sind Ketone, Phosphinoxide, Sulfoxide und Sulfone, z. B. gemäß WO 2004/013080, WO 2004/093207, WO 2006/005627 oder WO 2010/006680, Triarylamine, Carbazolderivate, z. B. CBP (N,N-Bis-carbazolylbiphenyl), m-CBP oder die in WO 2005/039246, US 2005/0069729, JP 2004/288381, EP 1205527, WO 2008/086851 oder US 2009/0134784 offenbarten Carbazolderivate, Biscarbazolderivate, Indolocarbazolderivate, z. B. gemäß WO 2007/063754 oder WO 2008/056746, Indenocarbazolderivate, z. B. gemäß WO 2010/136109 oder WO 2011/000455, Azacarbazole, z. B. gemäß EP 1617710, EP 1617711, EP 1731584, JP 2005/347160, bipolare Matrixmaterialien, z. B. gemäß WO 2007/137725, Silane, z. B. gemäß WO 2005/111172, Azaborole oder Boronester, z. B. gemäß WO 2006/117052, Diazasilolderivate, z. B. gemäß WO 2010/054729, Diazaphospholderivate, z. B. gemäß WO 2010/054730, Triazinderivate, z. B. gemäß WO 2010/015306, WO 2007/063754 oder WO 2008/056746, Zinkkomplexe, z. B. gemäß EP 652273 oder WO 2009/062578, Dibenzofuranderivate, z. B. gemäß WO 2009/148015, WO 2015/169412, WO 2017/148564 oder WO 2017/148565, oder verbrückte Carbazolderivate, z. B. gemäß US 2009/0136779, WO 2010/050778, WO 2011/042107 oder WO 2011/088877.

Es kann auch bevorzugt sein, mehrere verschiedene Matrixmaterialien als Mischung einzusetzen, insbesondere mindestens ein elektronenleitendes Matrixmaterial und mindestens ein lochleitendes Matrixmaterial. Eine bevorzugte Kombination ist beispielsweise die Verwendung eines aromatischen Ketons, eines Triazin-Derivats oder eines Phosphinoxid-Derivats mit einem Triarylamin-Derivat oder einem Carbazol-Derivat als gemischte Matrix für den erfindungsgemäßen Metallkomplex. Ebenso bevorzugt ist die Verwendung einer Mischung aus einem ladungstransportierenden Matrixmaterial und einem elektrisch inerten Matrixmaterial (so genannter "wide bandgap host"), welches nicht bzw. nicht in wesentlichem Maße am Ladungstransport beteiligt ist, wie z. B. in WO 2010/108579 oder WO 2016/184540 beschrieben. Ebenso bevorzugt ist die Verwendung von zwei elektronentransportierenden Matrixmaterialien, beispielsweise Triazinderivaten und Lactamderivaten, wie z. B. in WO 2014/094964 beschrieben.

Nachfolgend sind Beispiele für Verbindungen abgebildet, die sich als Matrixmaterialien für die erfindungsgemäßen Verbindungen eignen.

Beispiele für Triazine und Pyrimidine, welche als elektronentransportierende Matrixmaterialien eingesetzt werden können, sind die folgenden Strukturen:

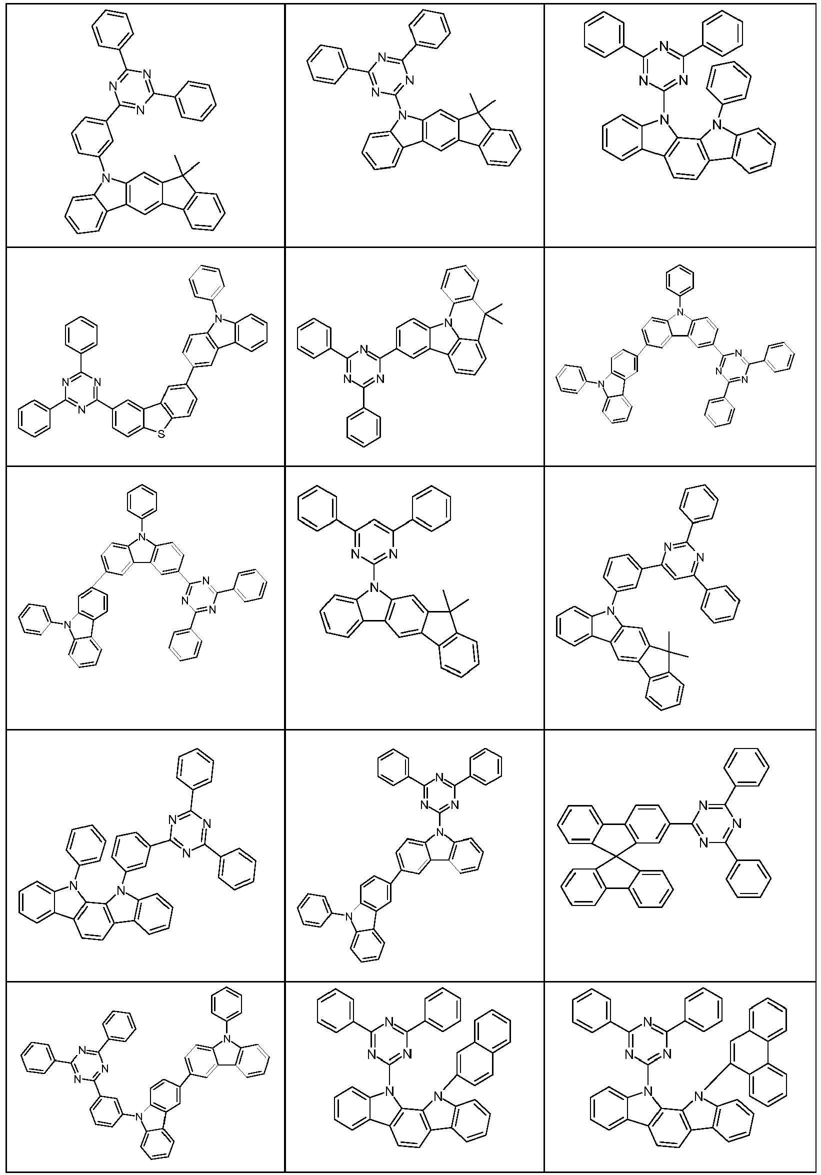

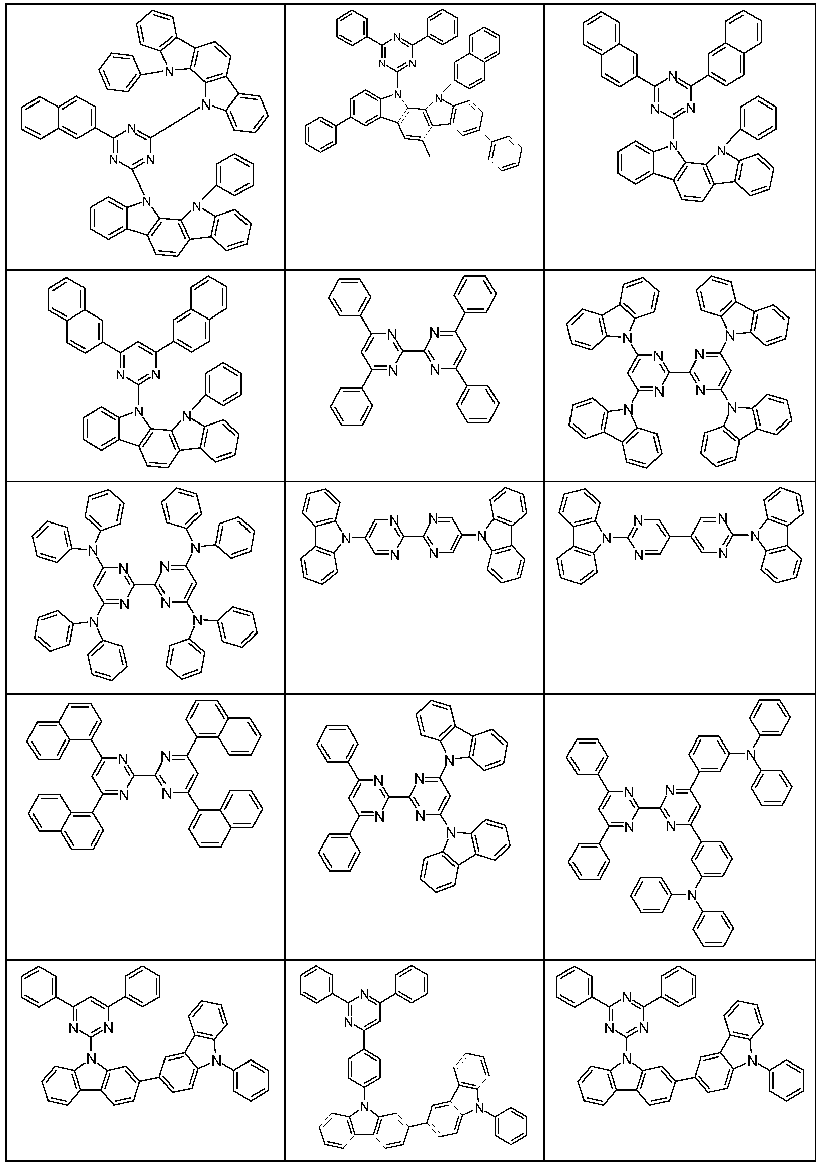

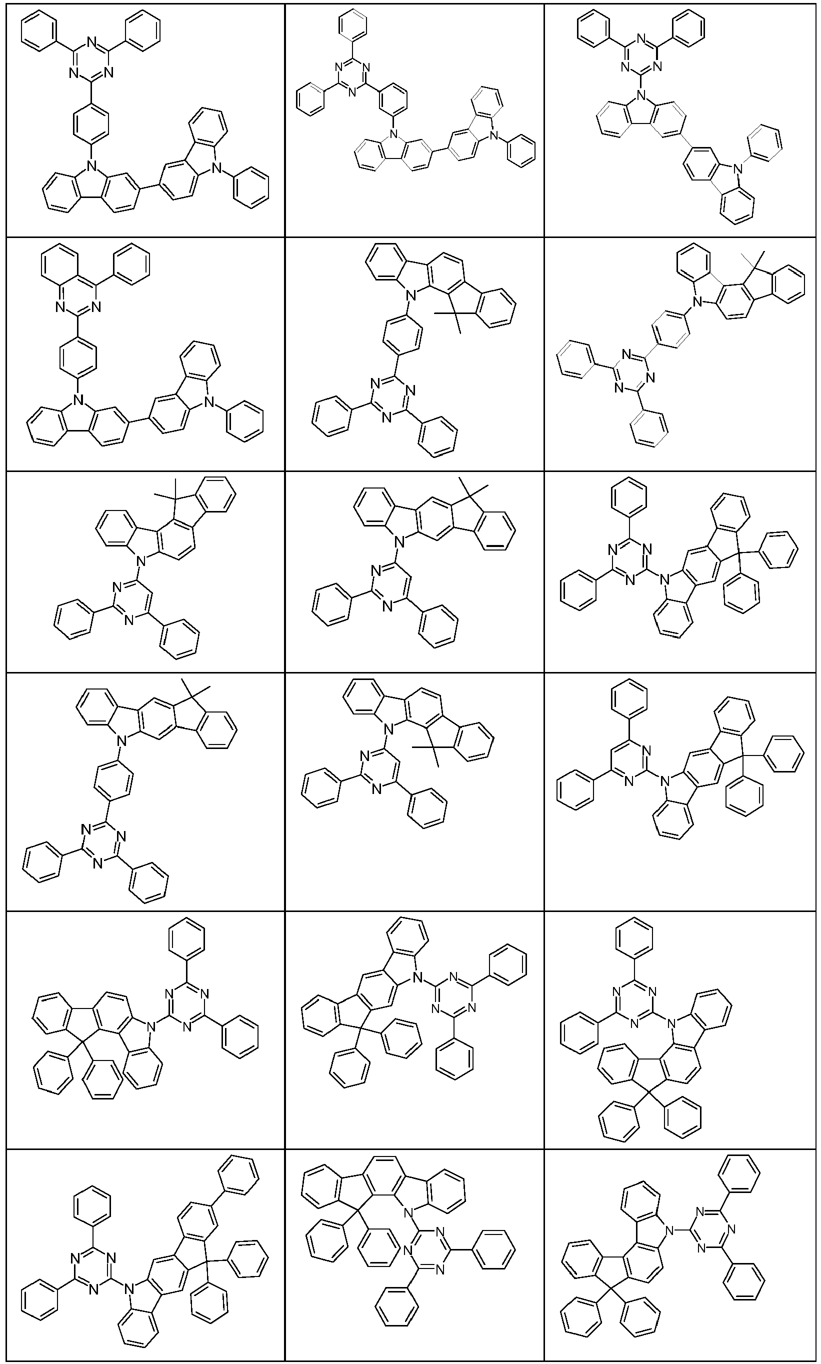

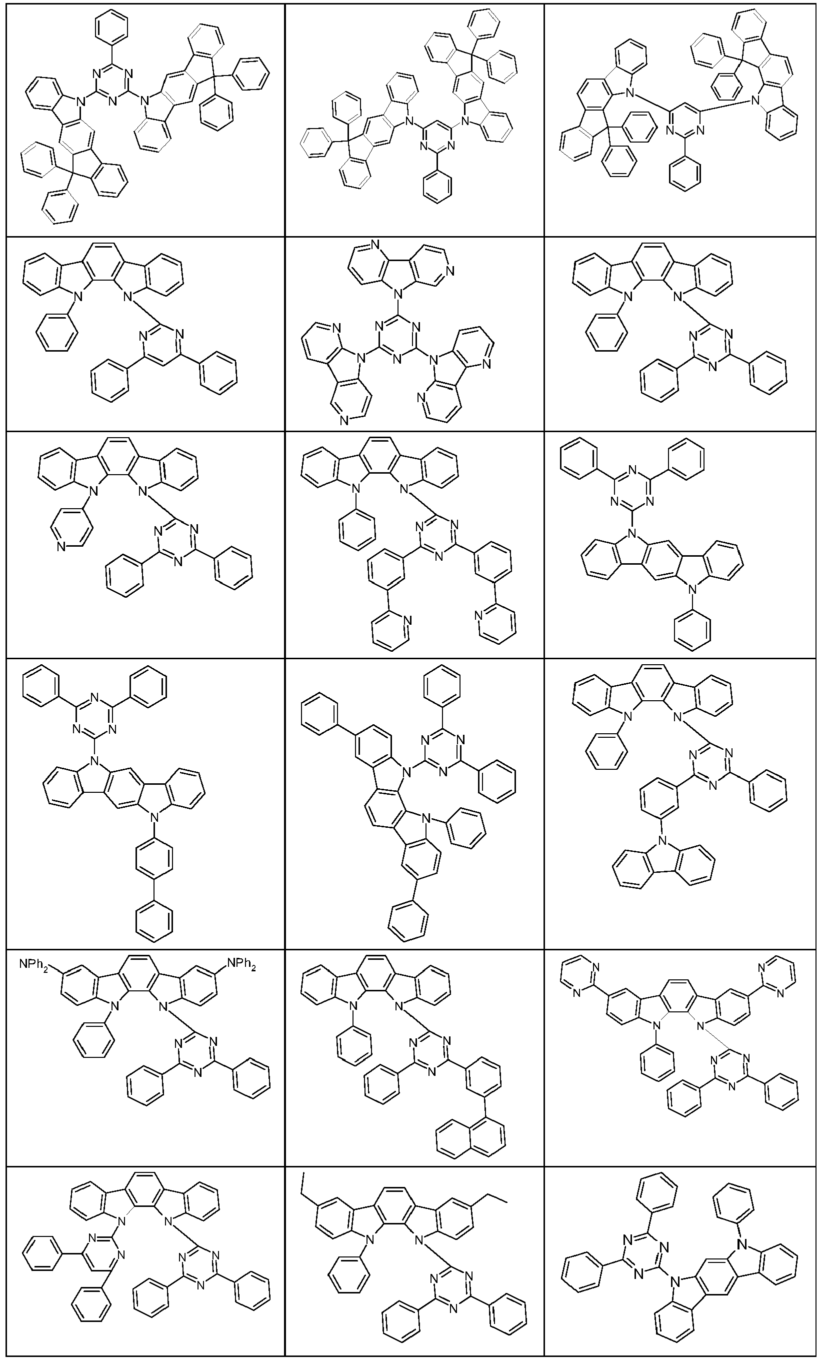

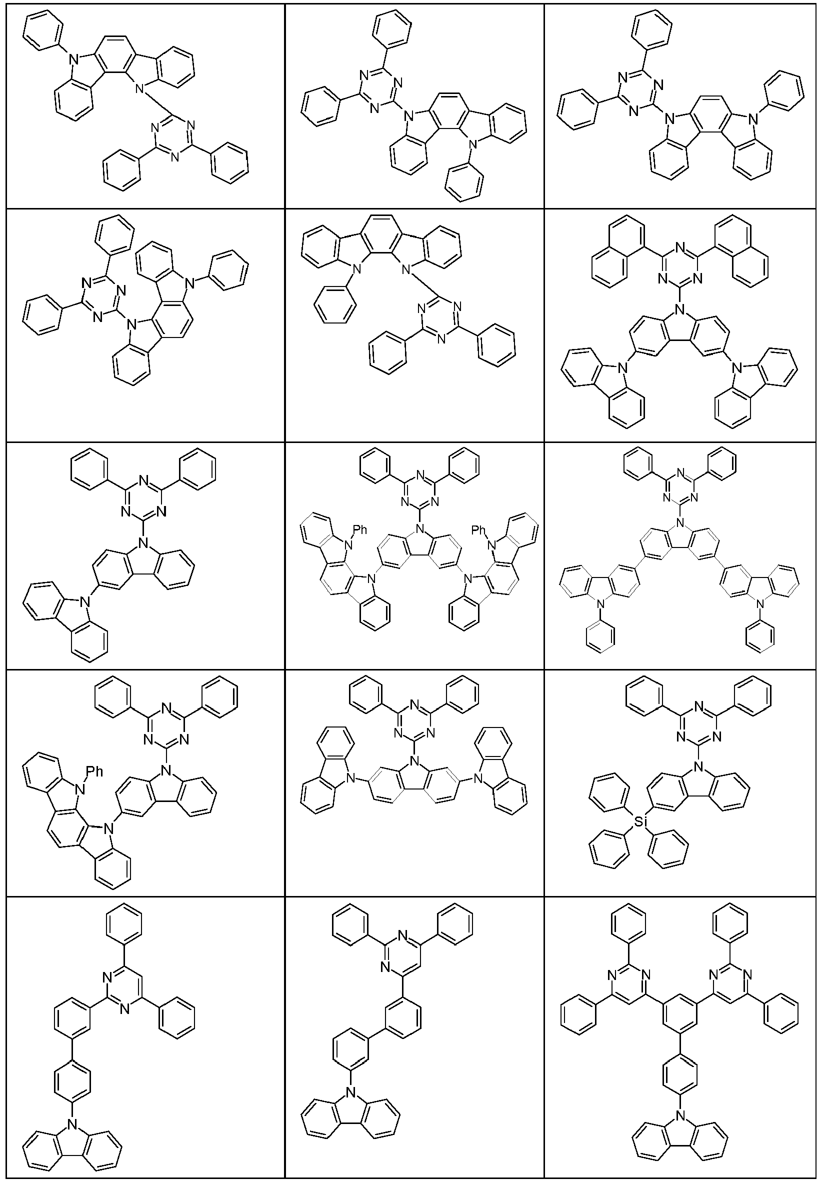

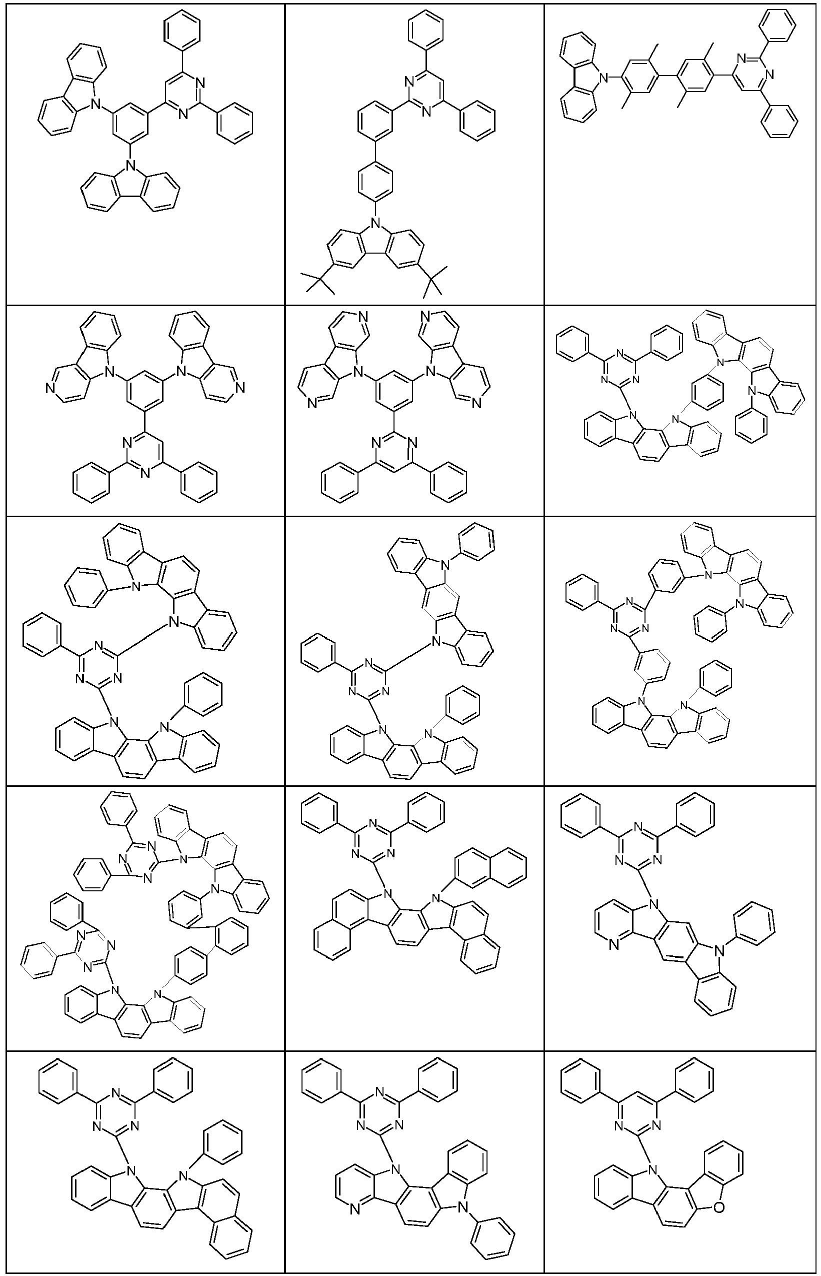

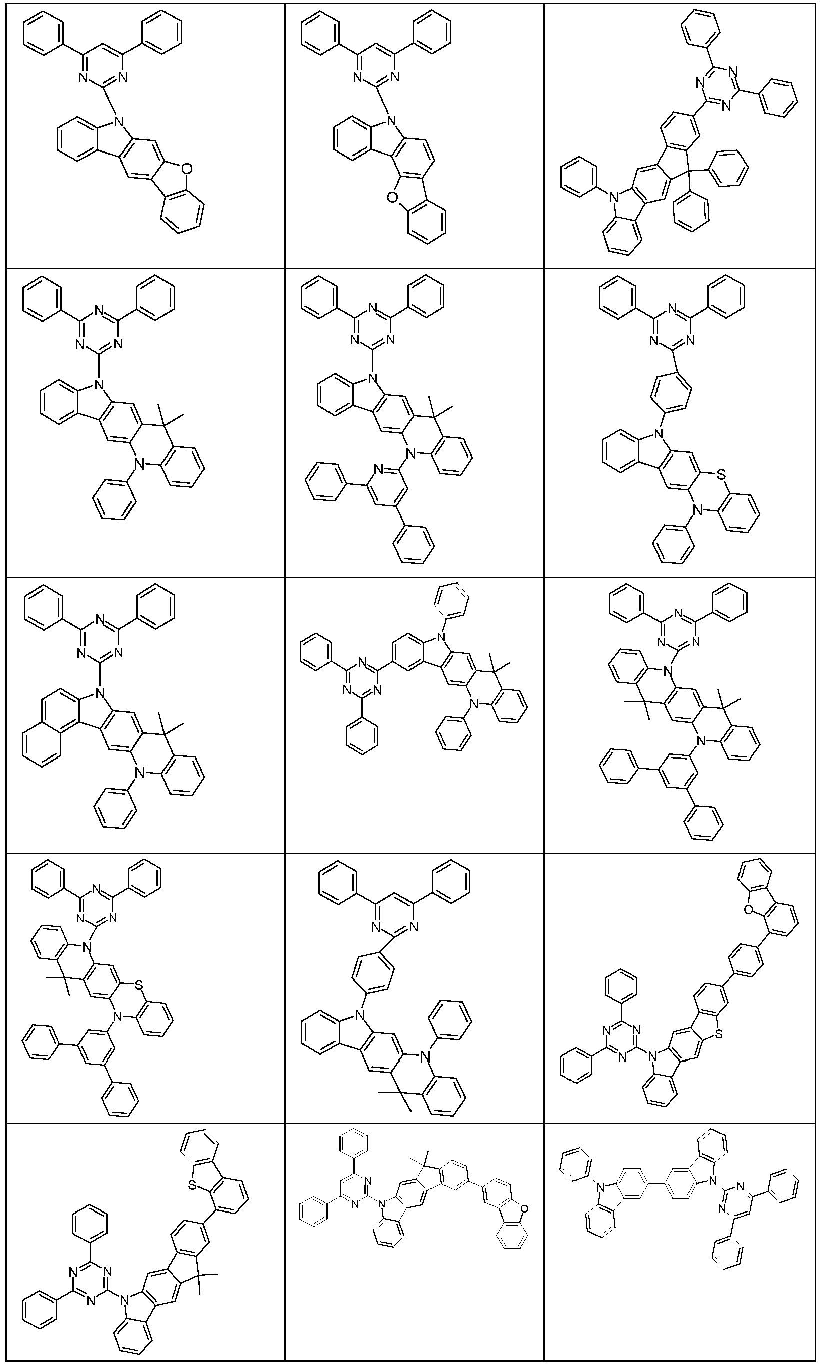

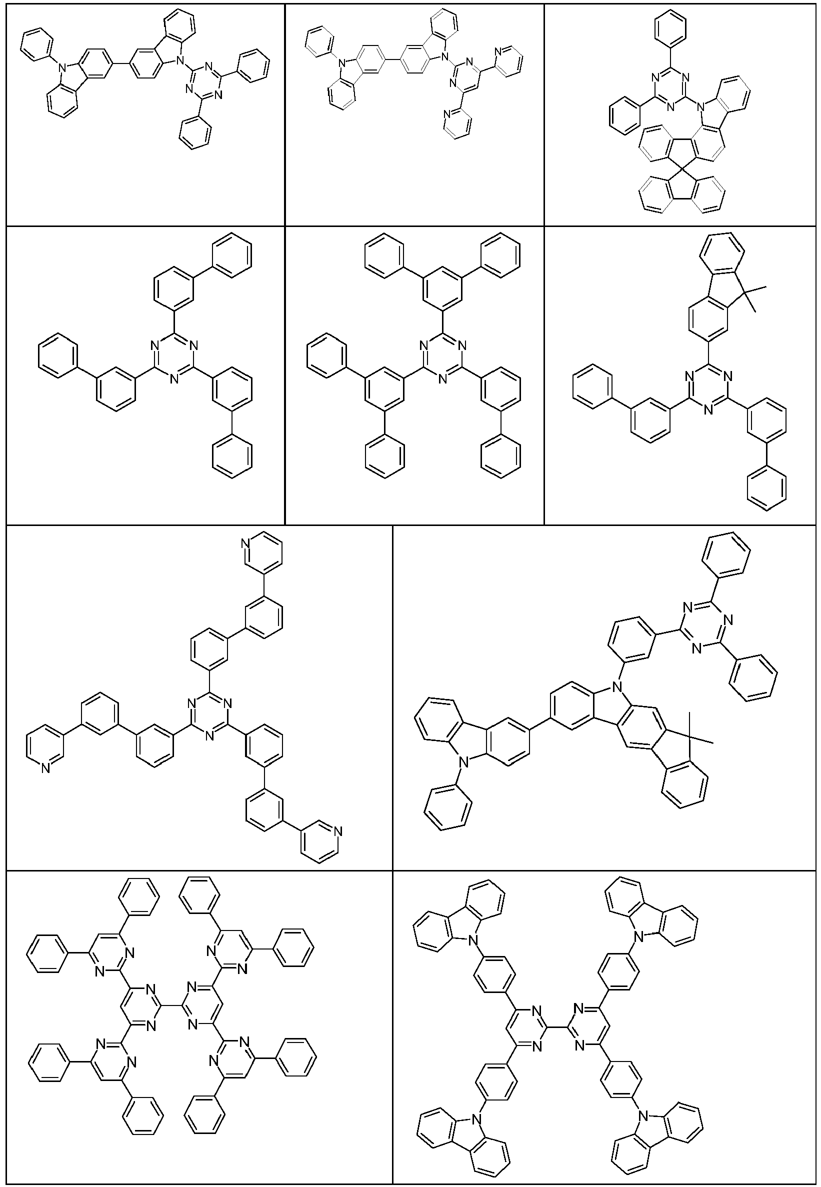

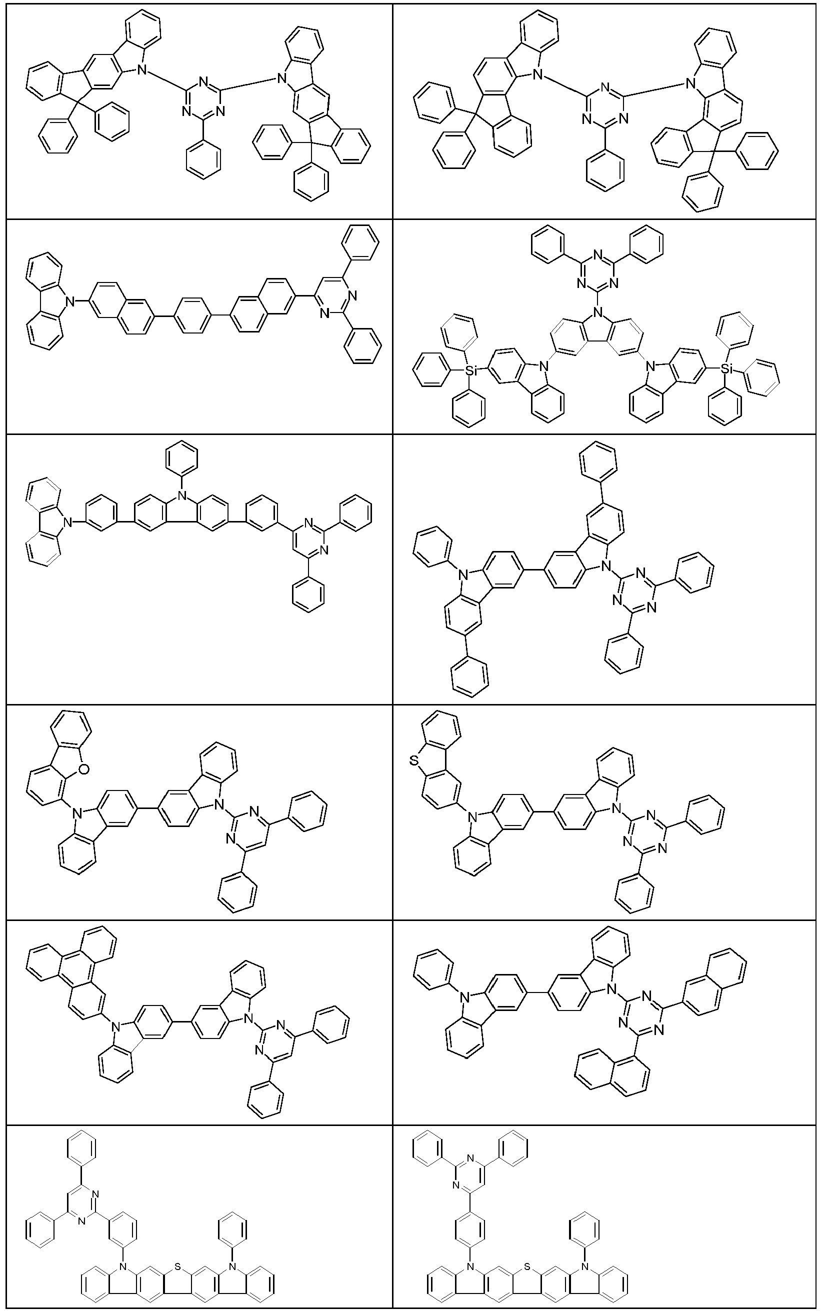

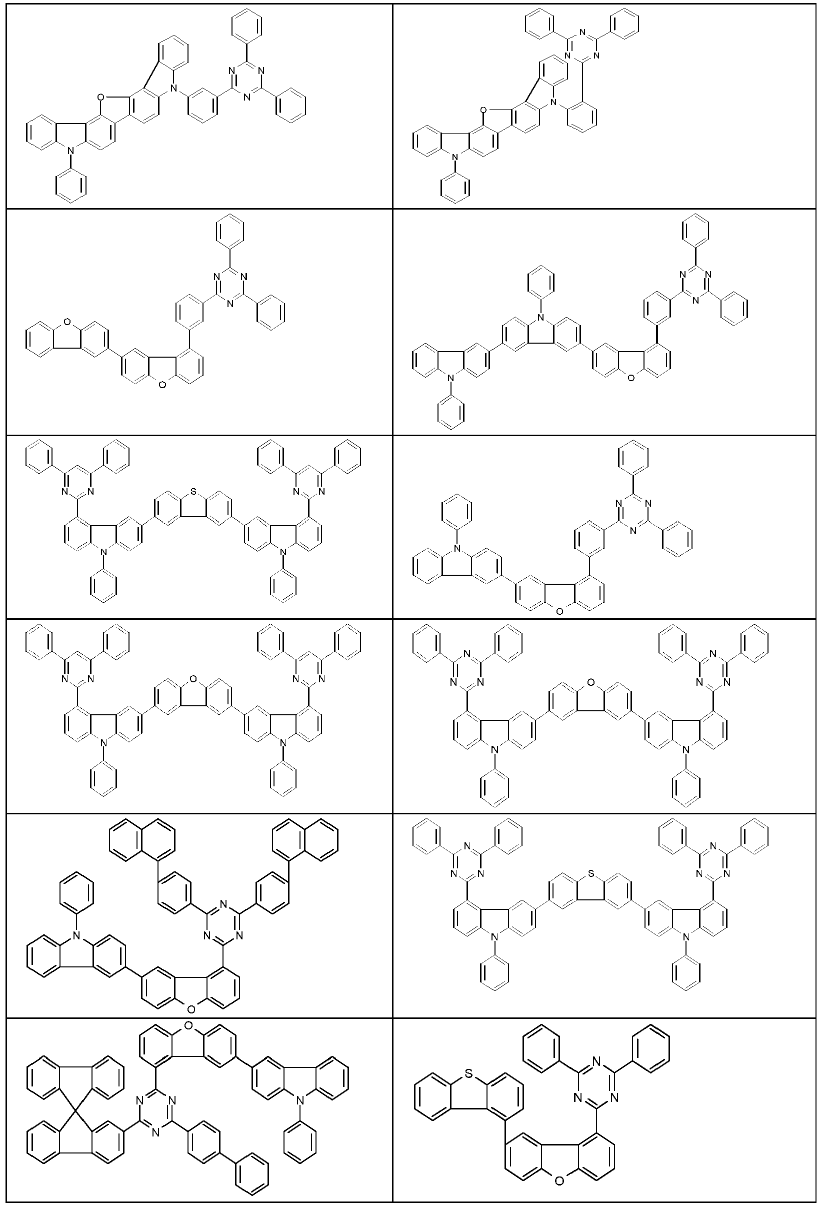

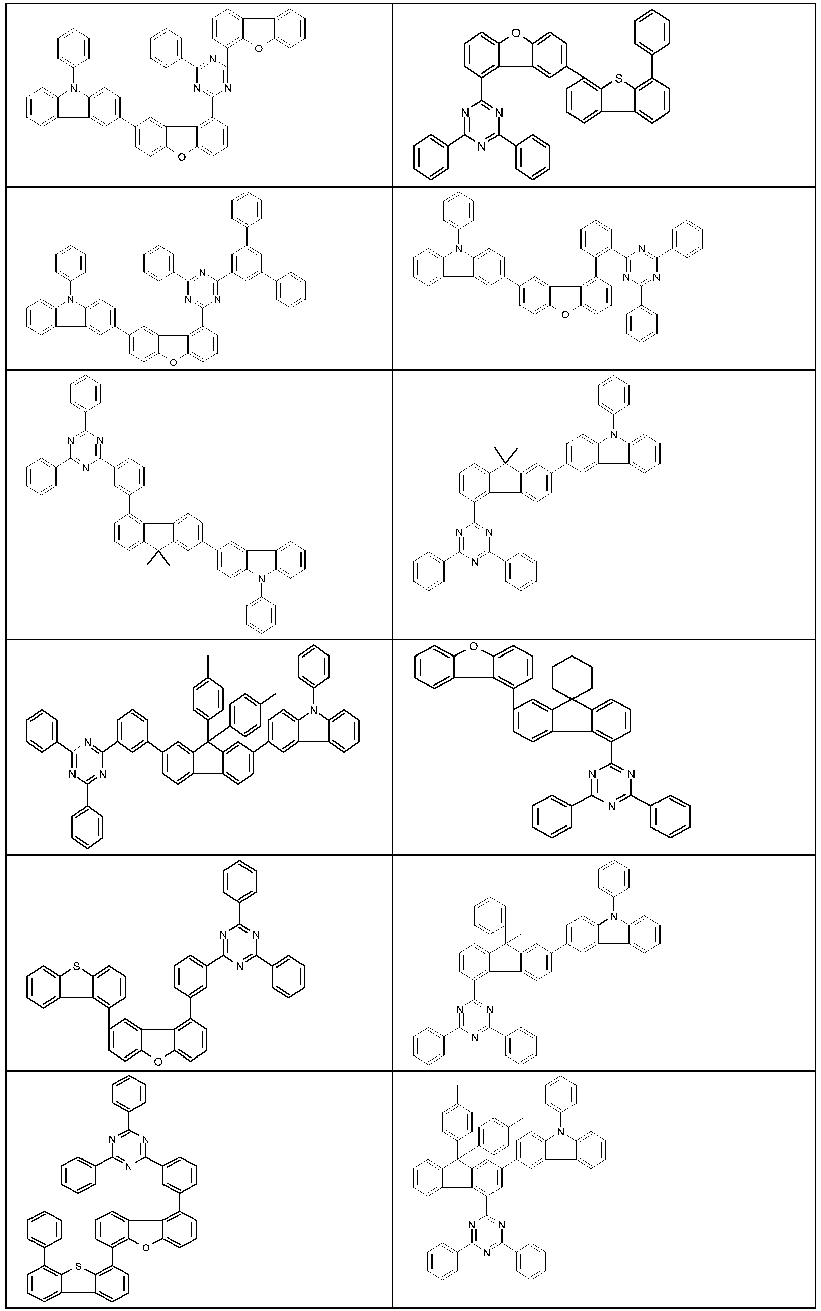

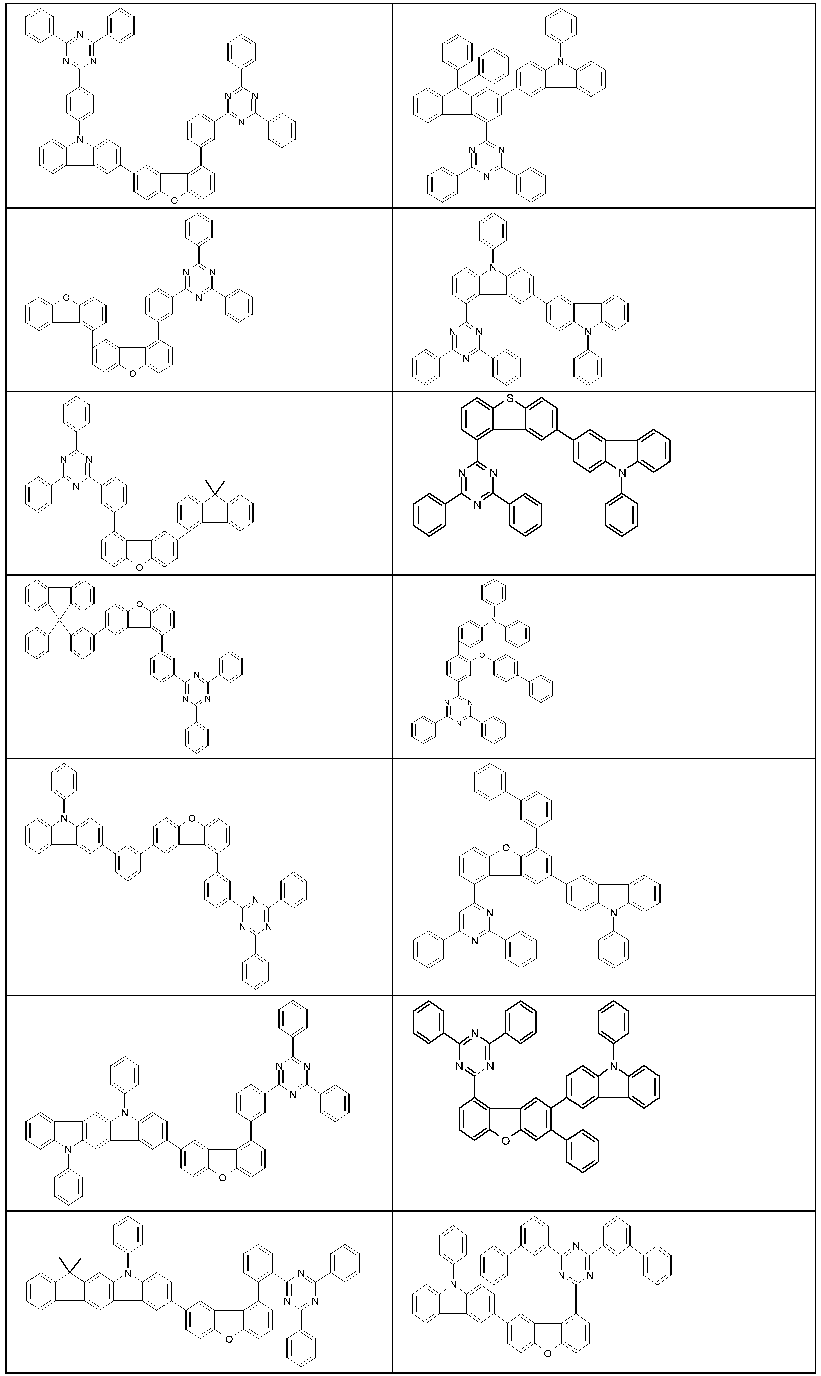

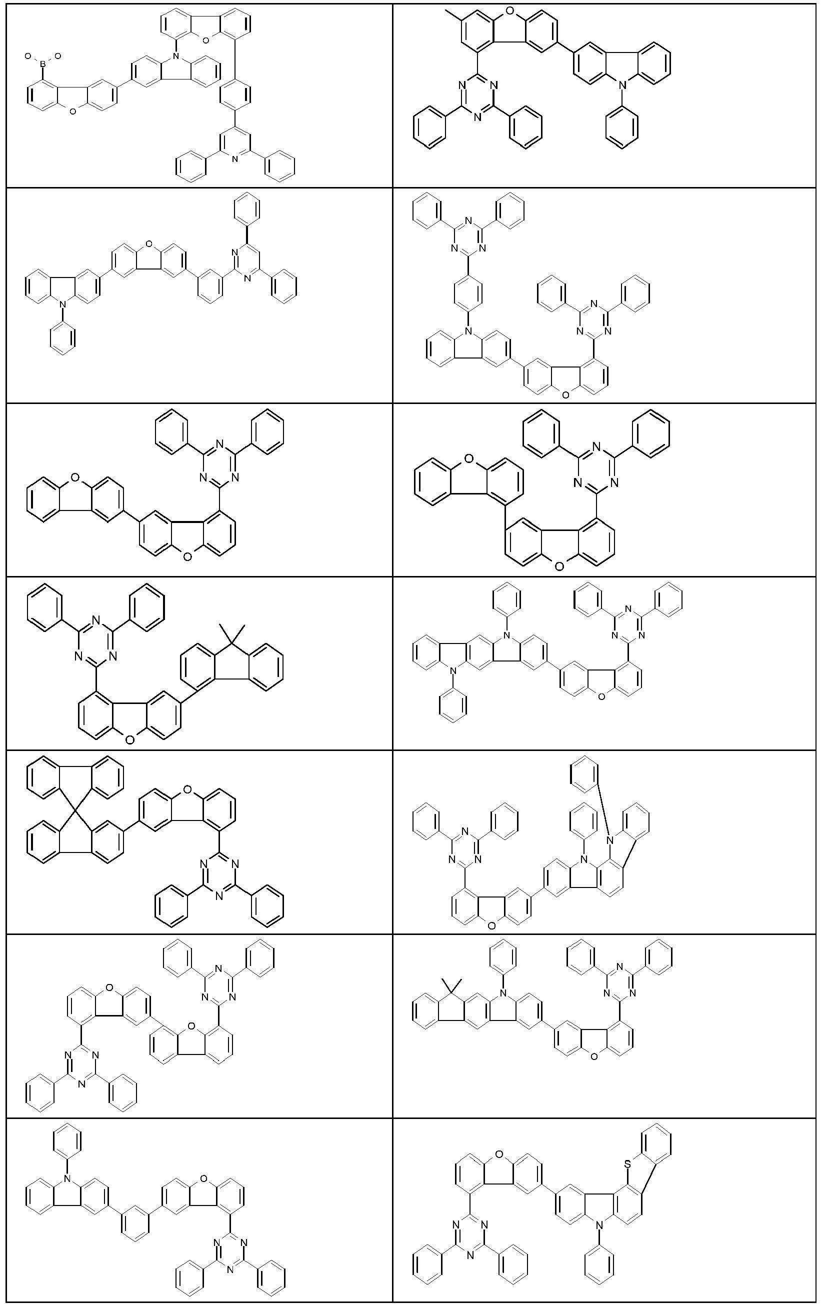

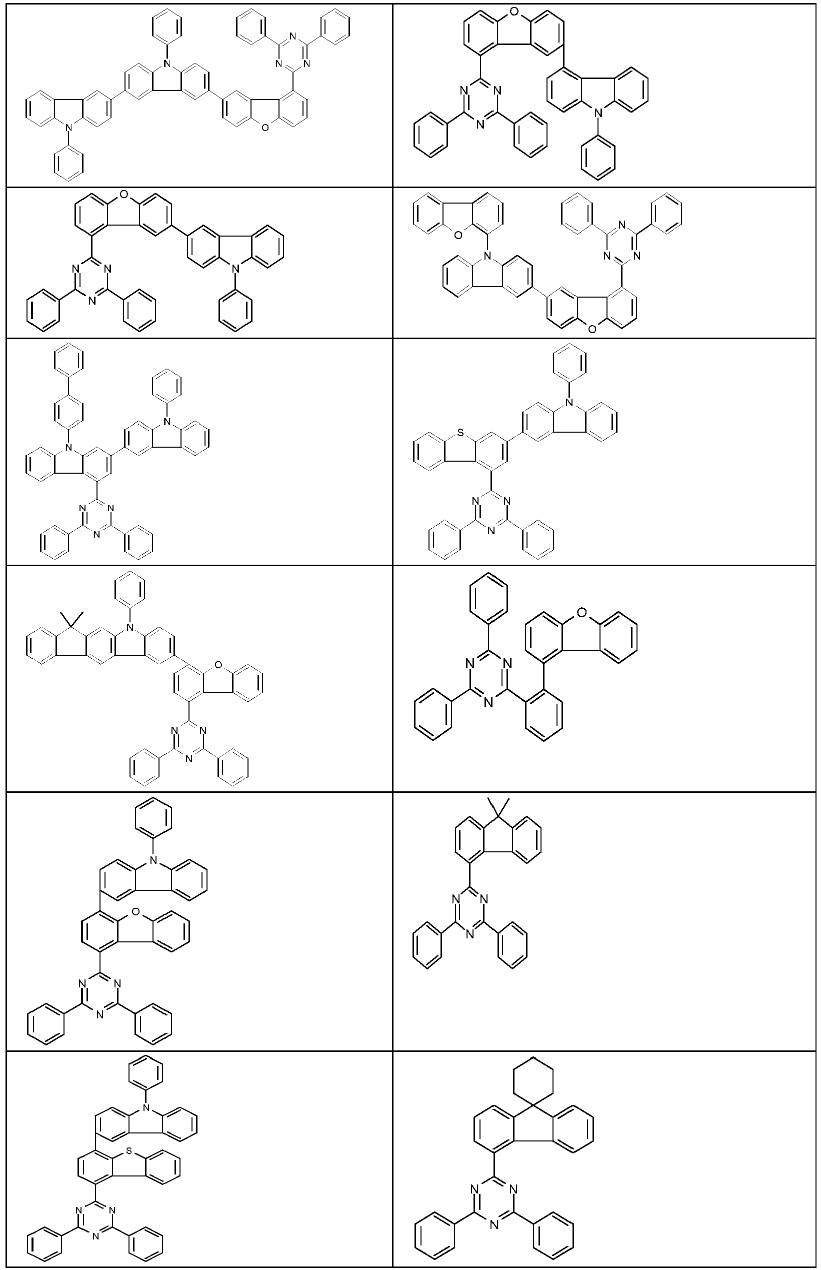

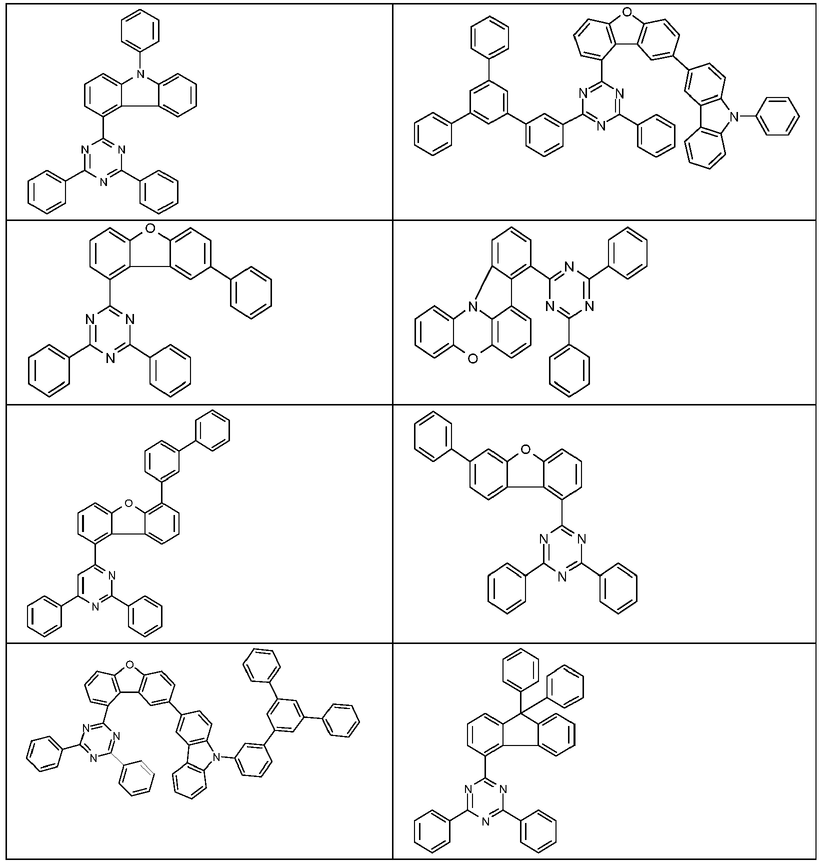

Beispiele für Lactame, welche als elektronentransportierende Matrixmaterialien eingesetzt werden können, sind die folgenden Strukturen:

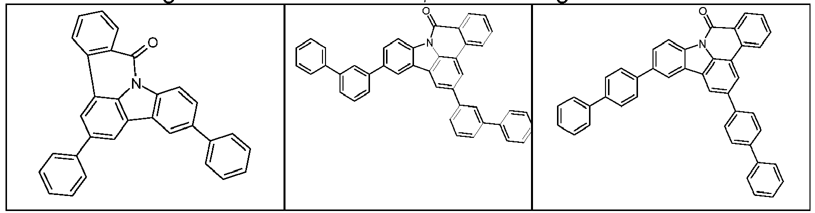

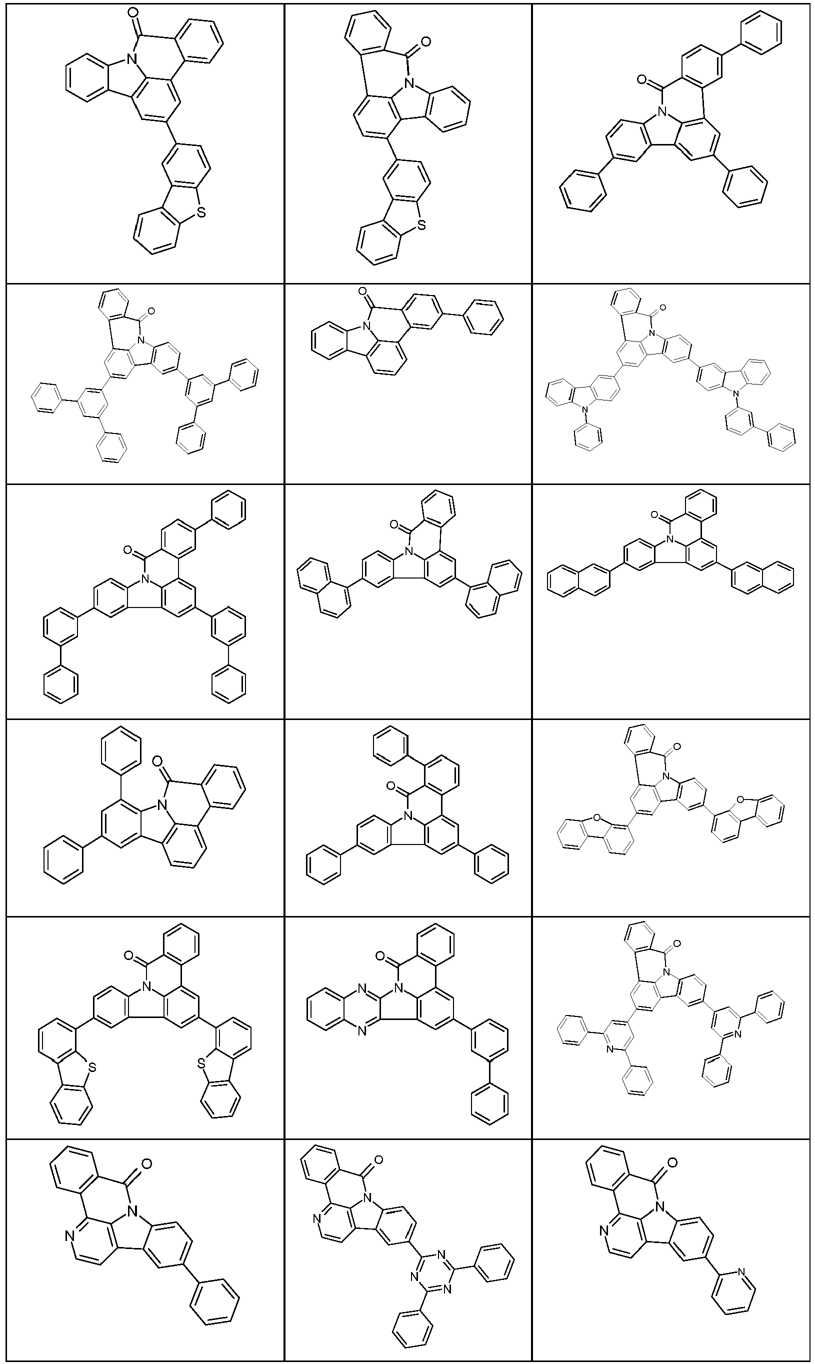

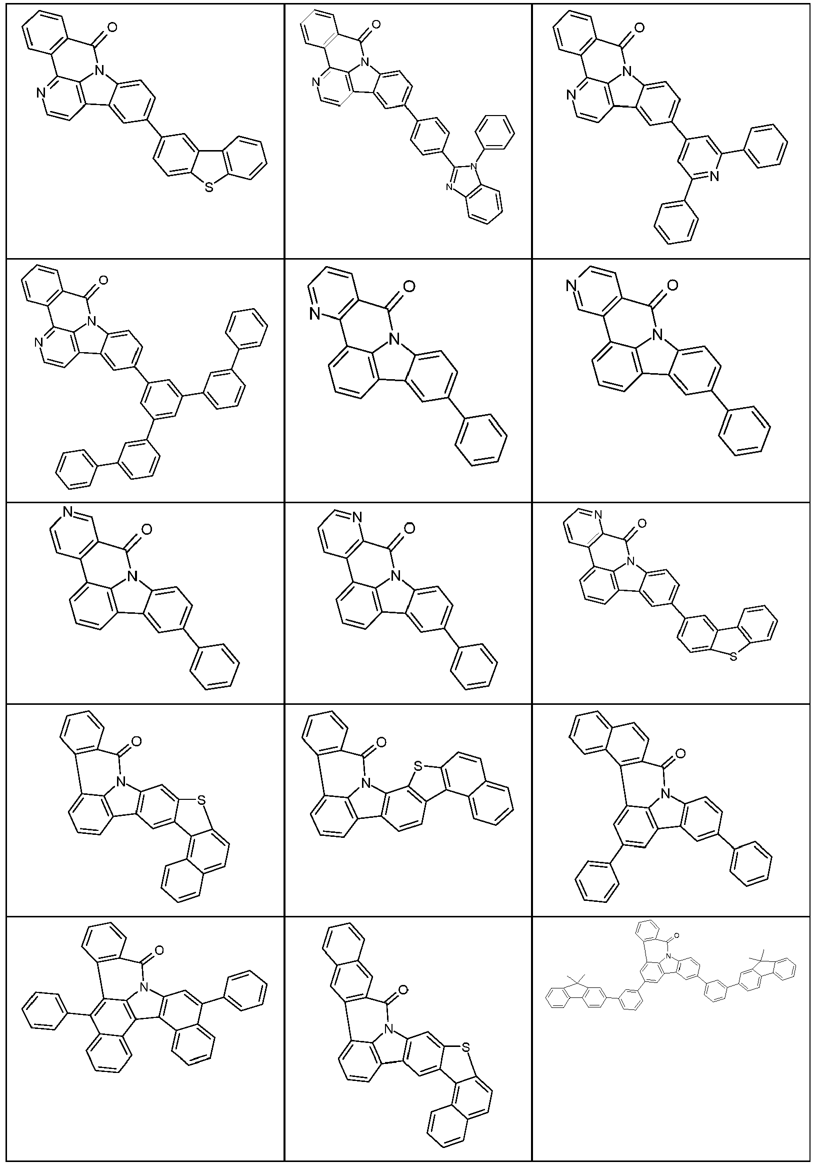

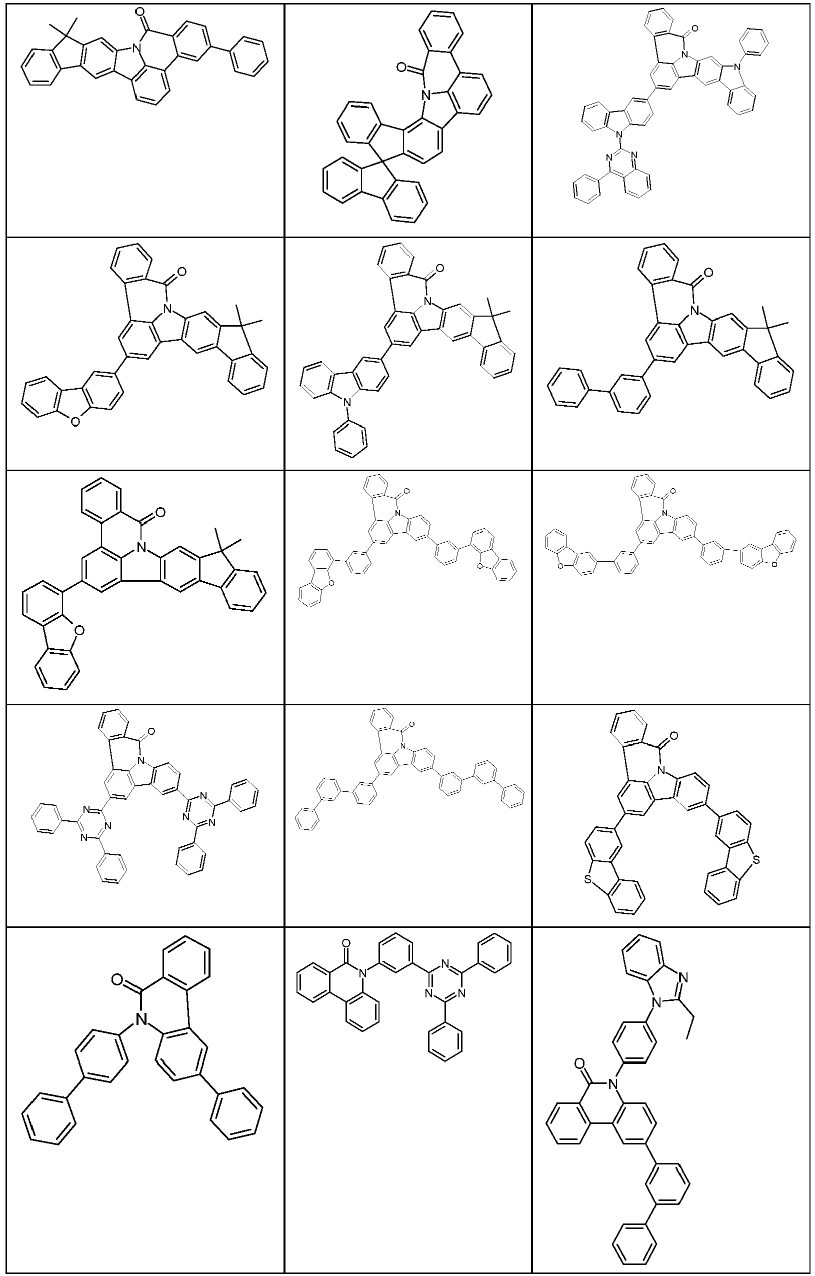

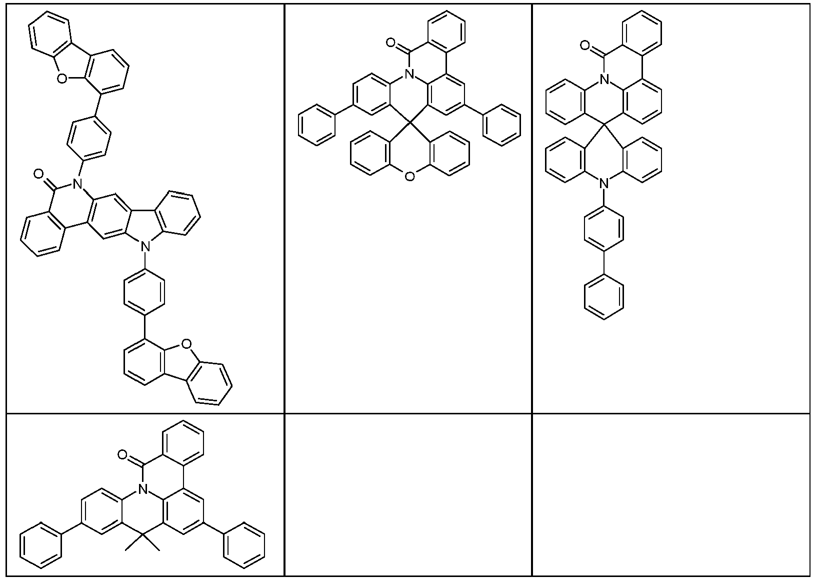

Beispiele für Indolo- und Indenocarbazolderivate im weitesten Sinn, welche je nach Substitutionsmuster als loch- oder elektronentransportierende Matrixmaterialien eingesetzt werden können, sind die folgenden Strukturen:

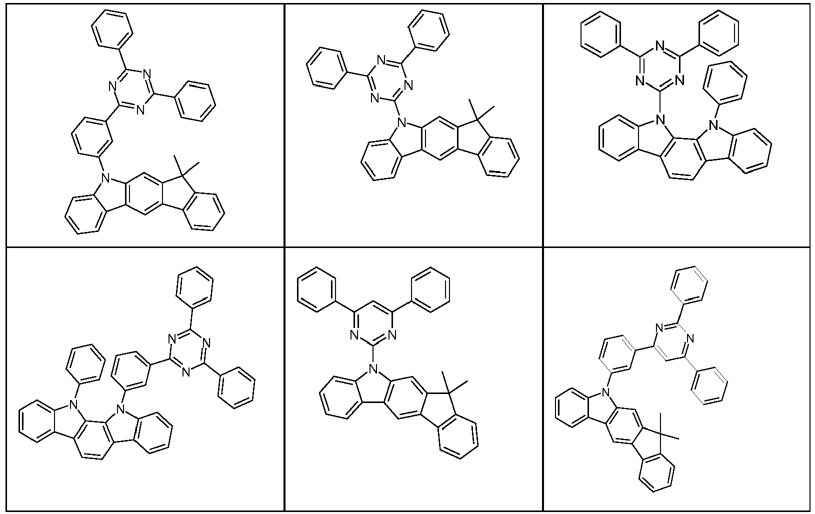

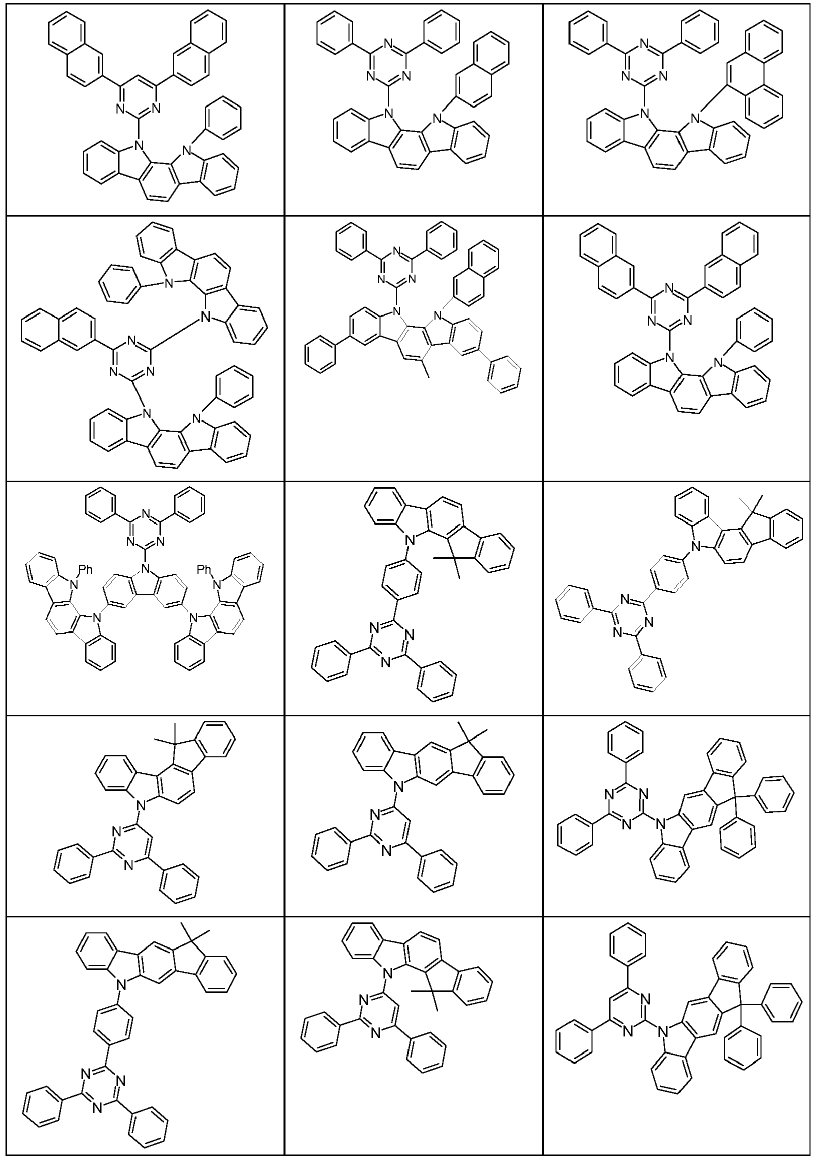

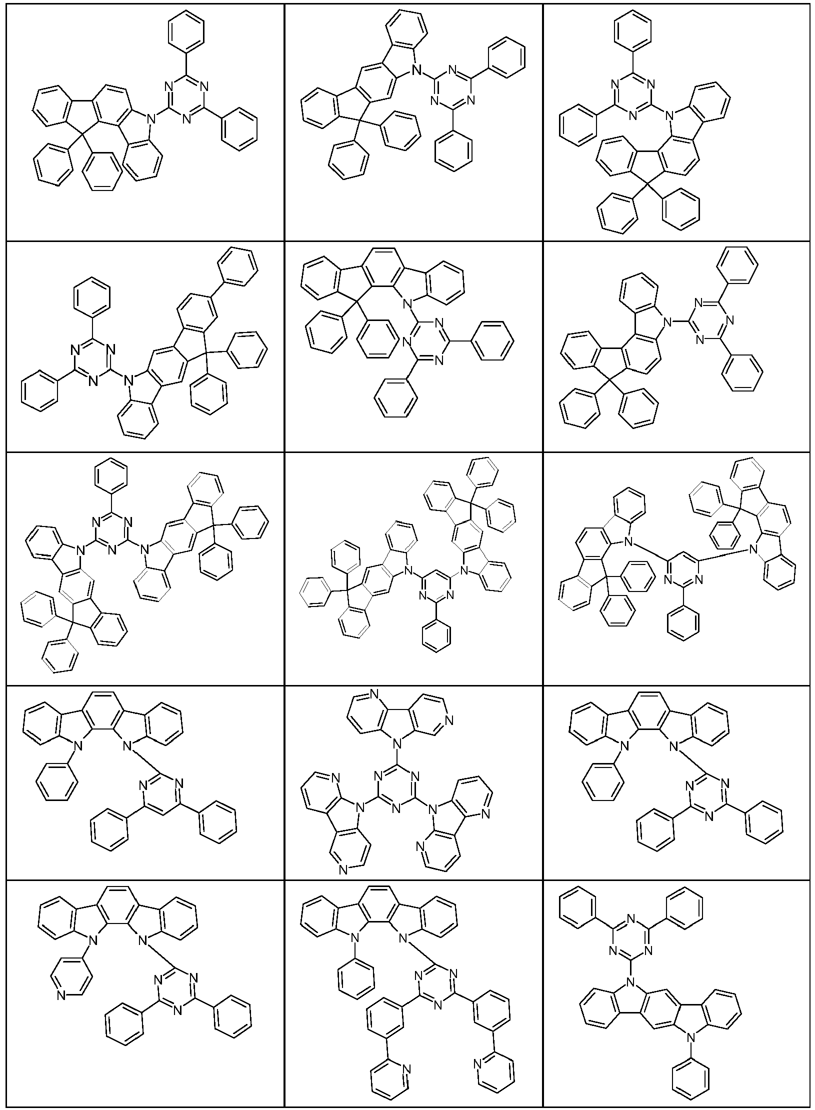

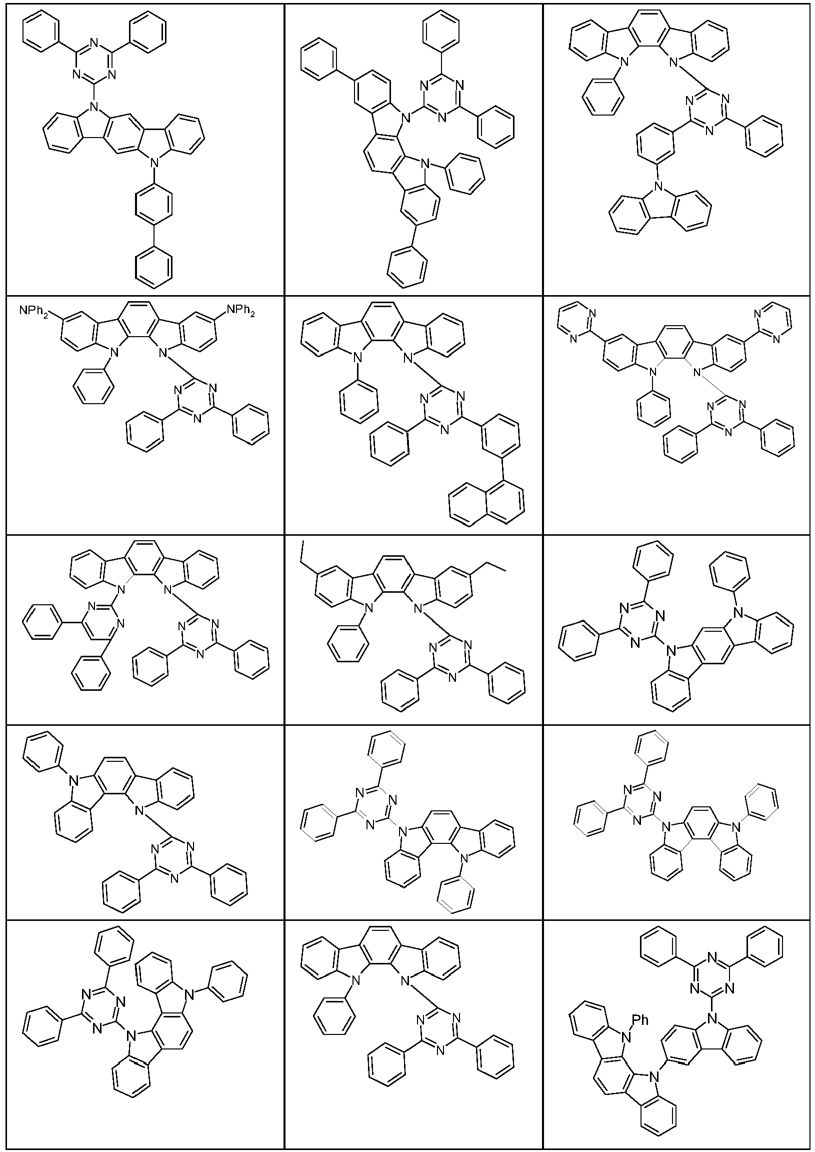

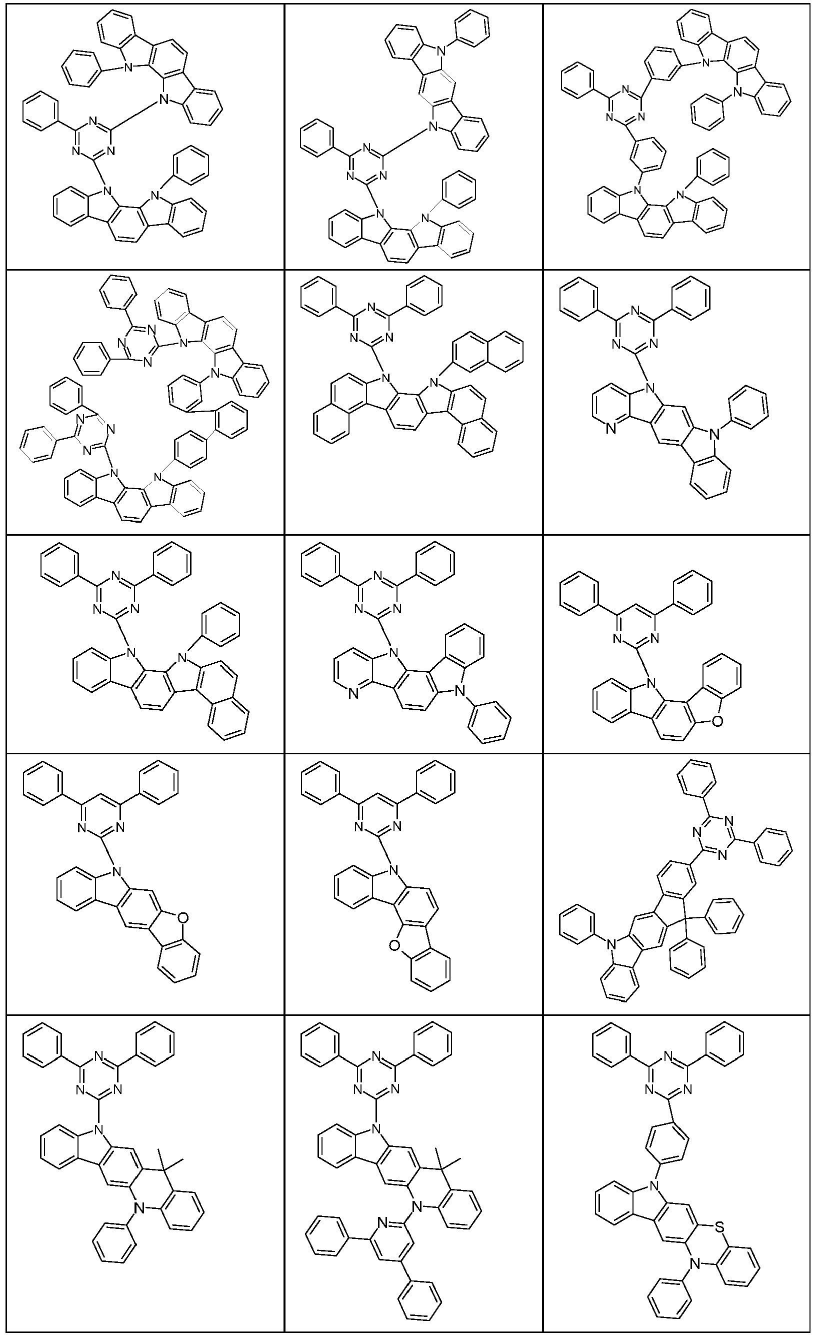

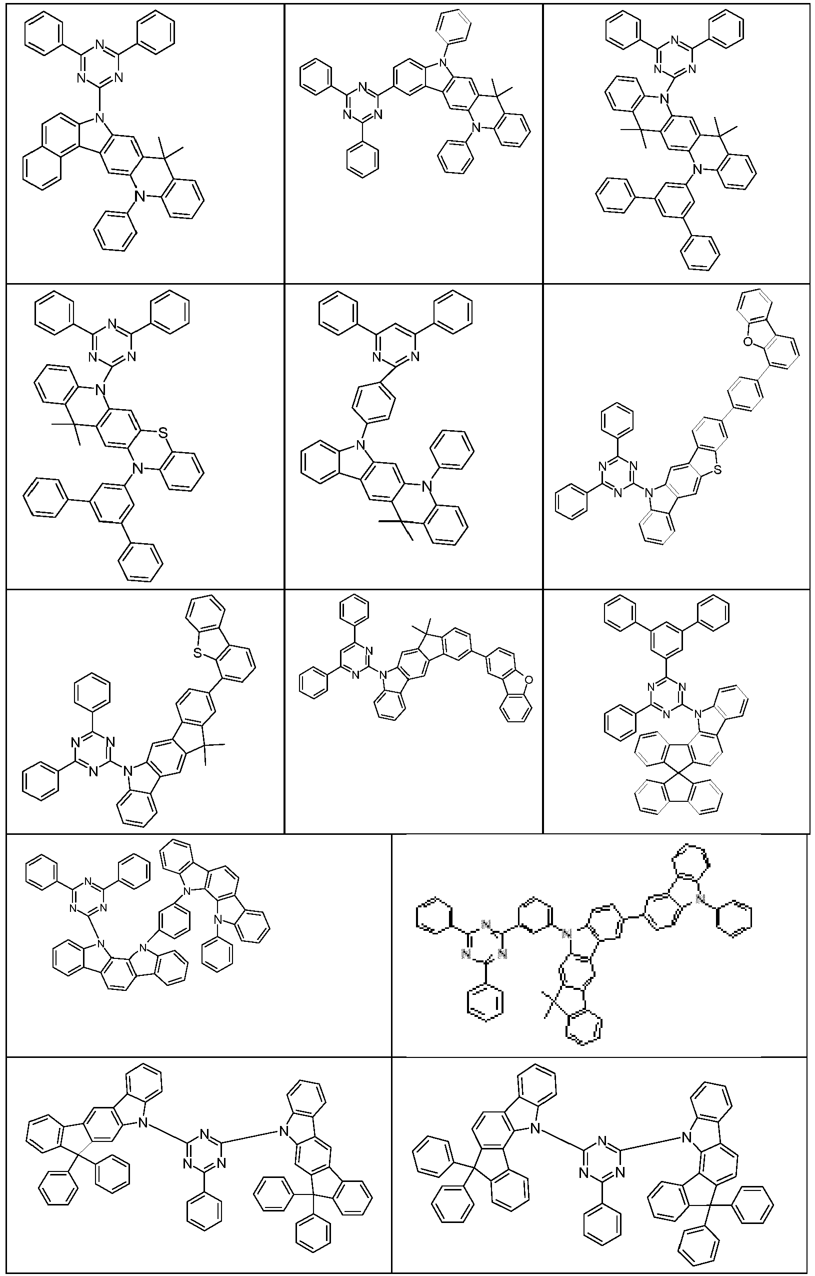

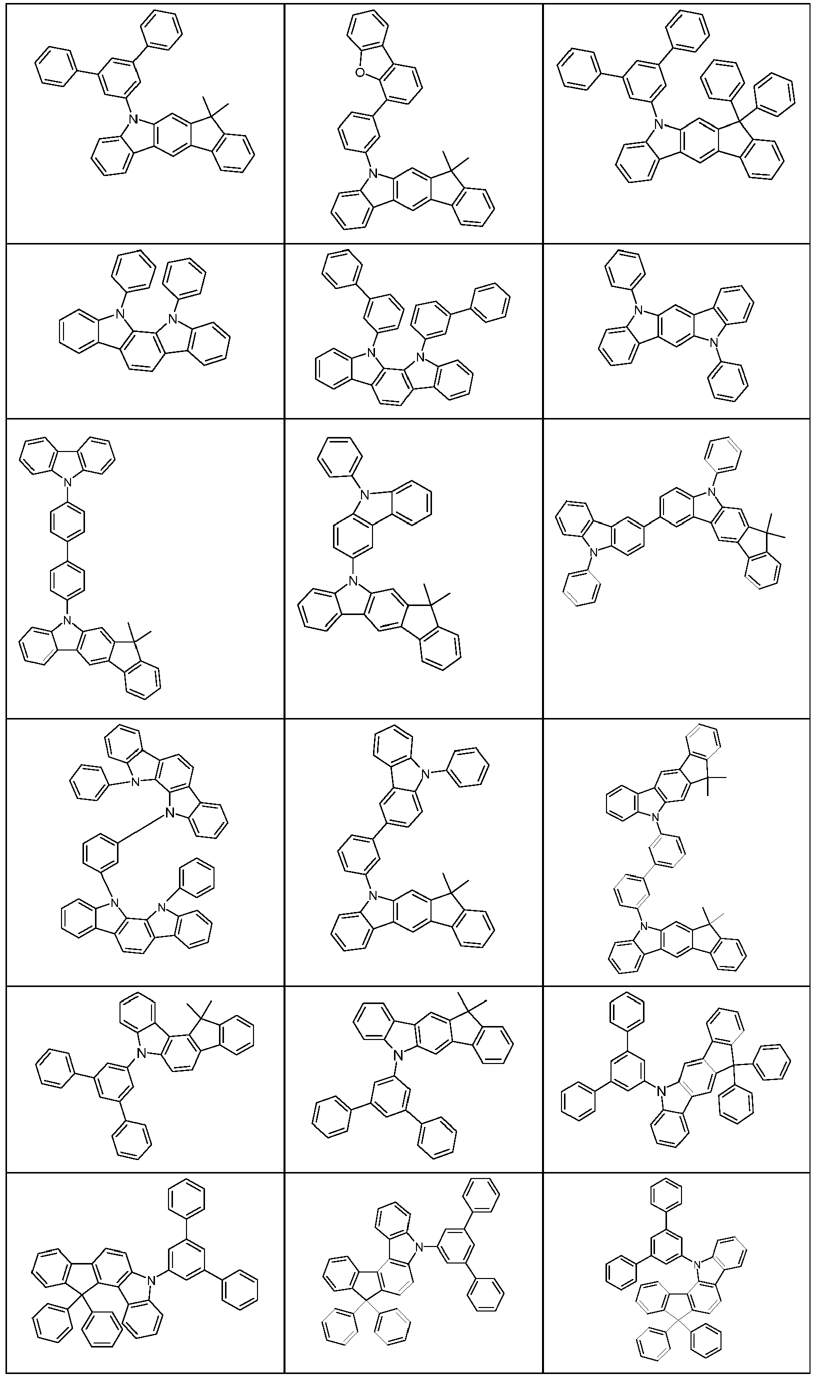

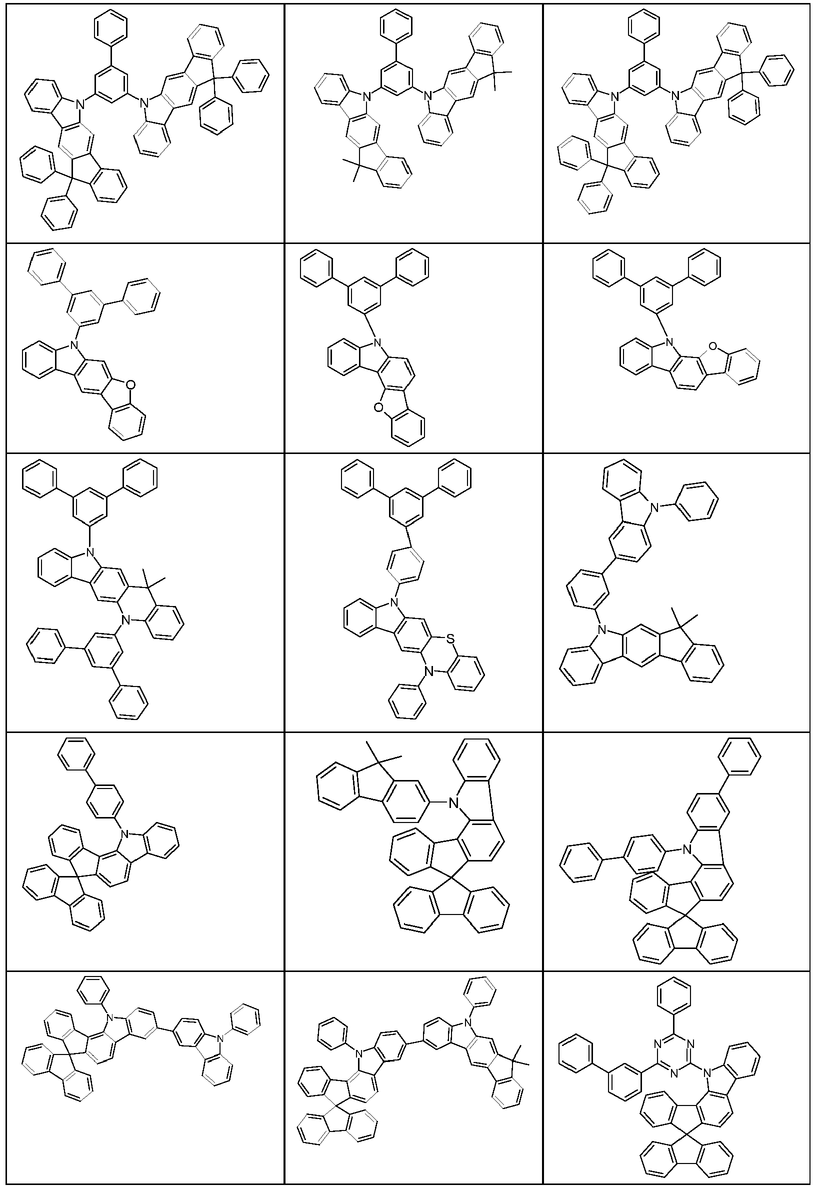

Beispiele für Carbazolderivate, welche je nach Substitutionsmuster als loch- oder elektronentransportierende Matrixmaterialien eingesetzt werden können, sind die folgenden Strukturen:

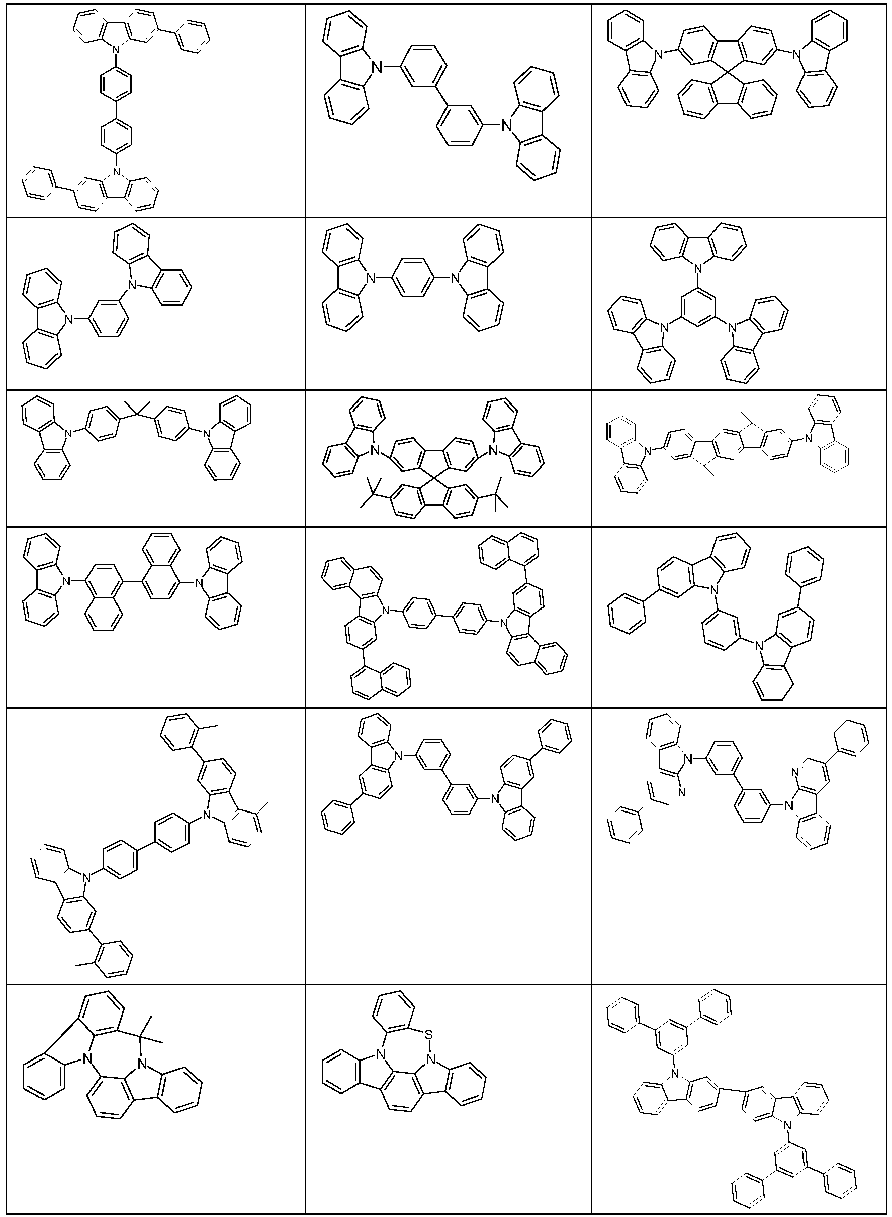

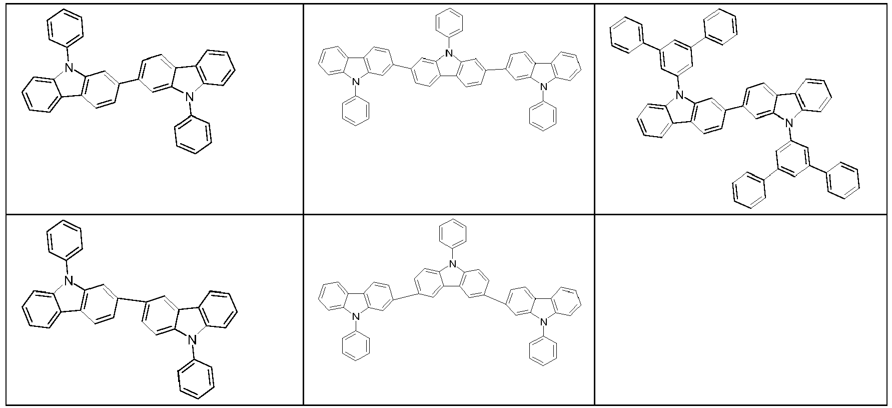

Beispiele für verbrückte Carbazolderivate, welche als lochtransportierende Matrixmaterialien eingesetzt werden können:

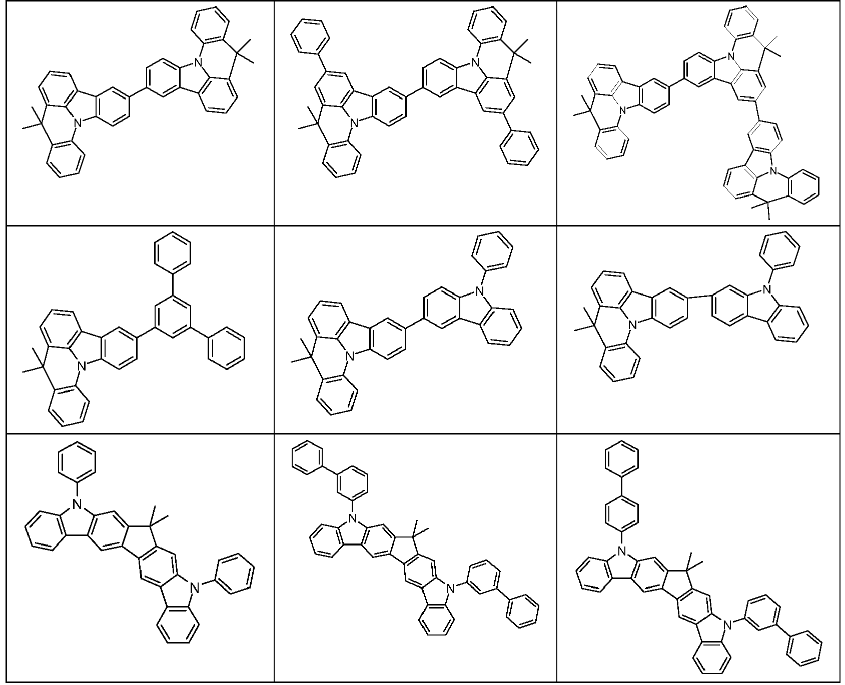

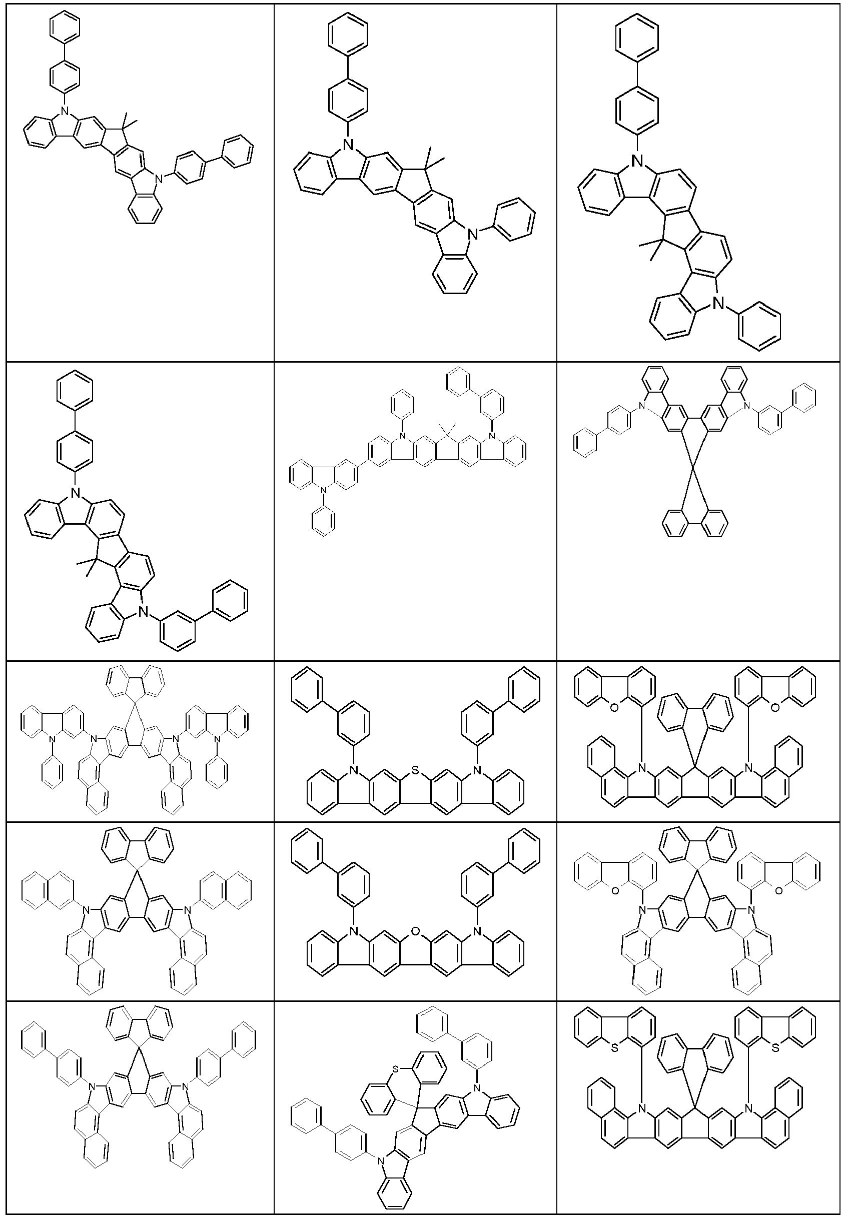

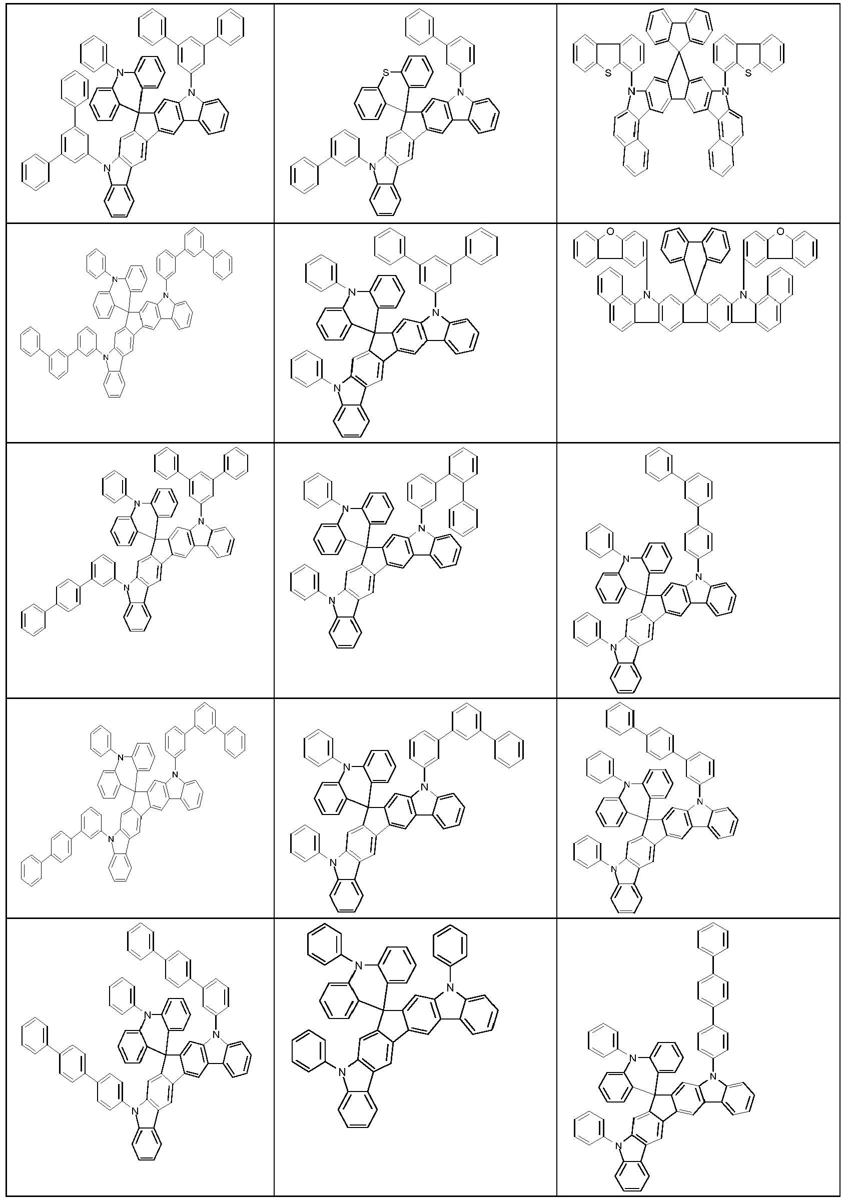

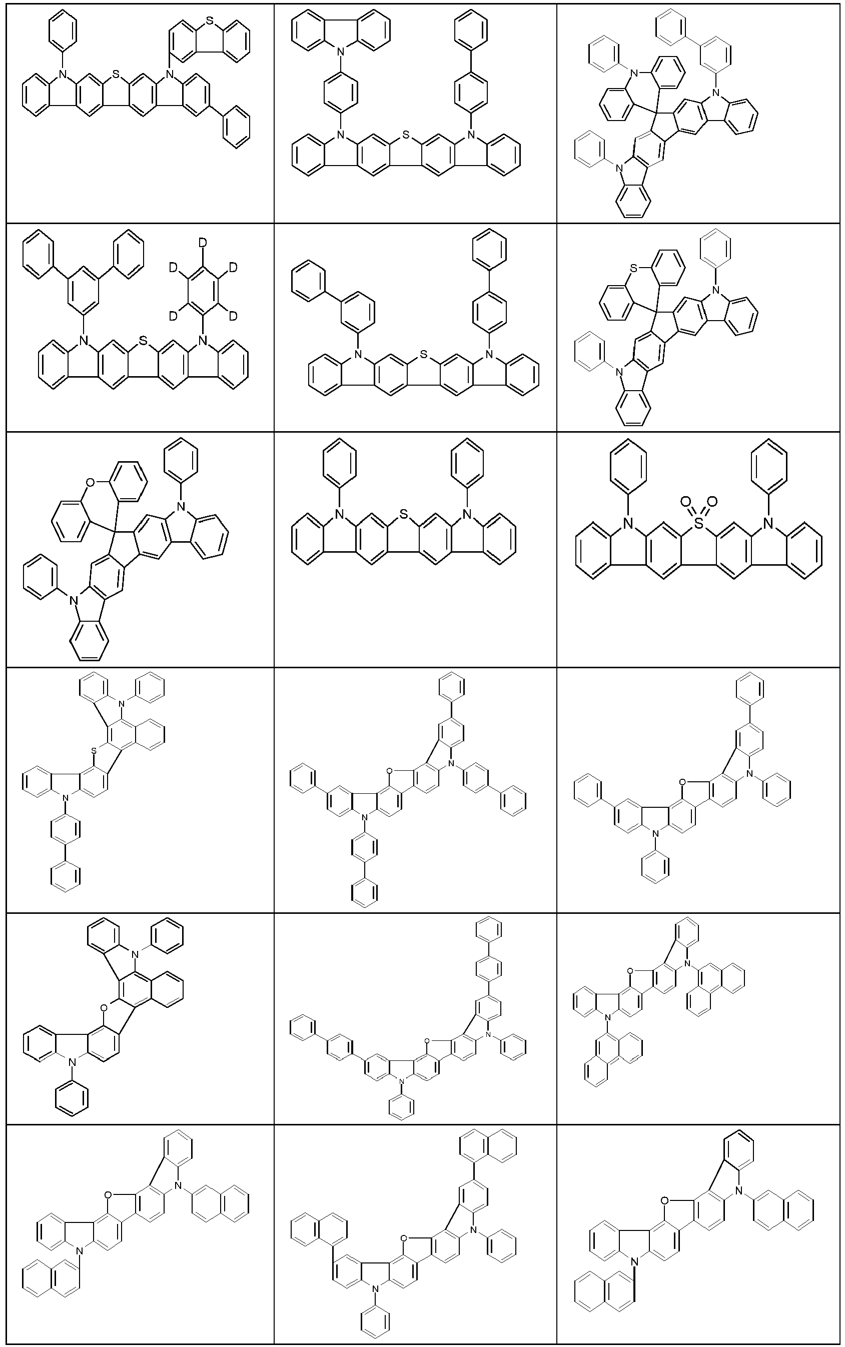

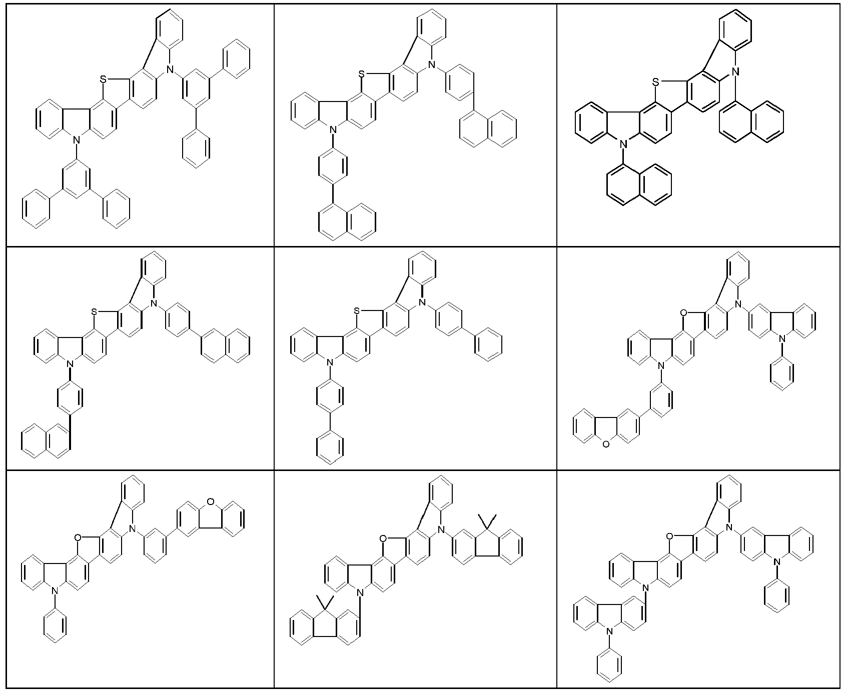

Beispiele für Biscarbazolderivate, welche als lochtransportierende Matrixmaterialien eingesetzt werden können:

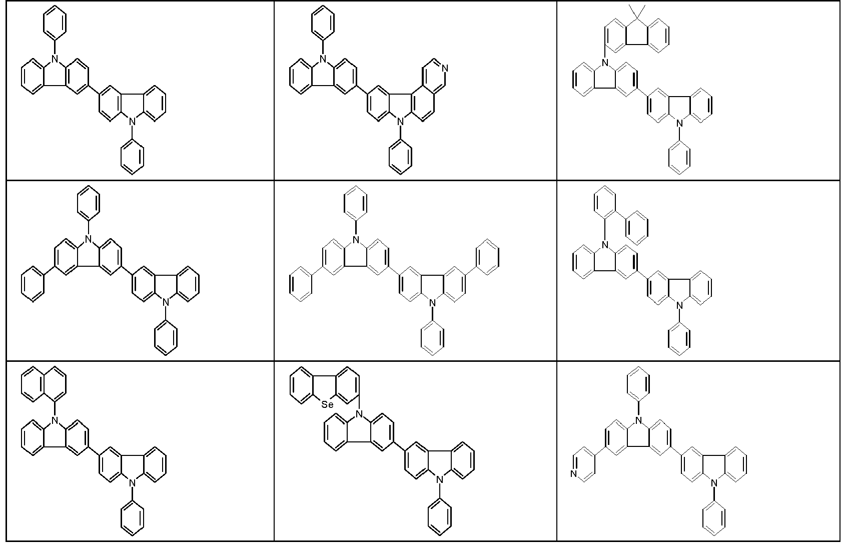

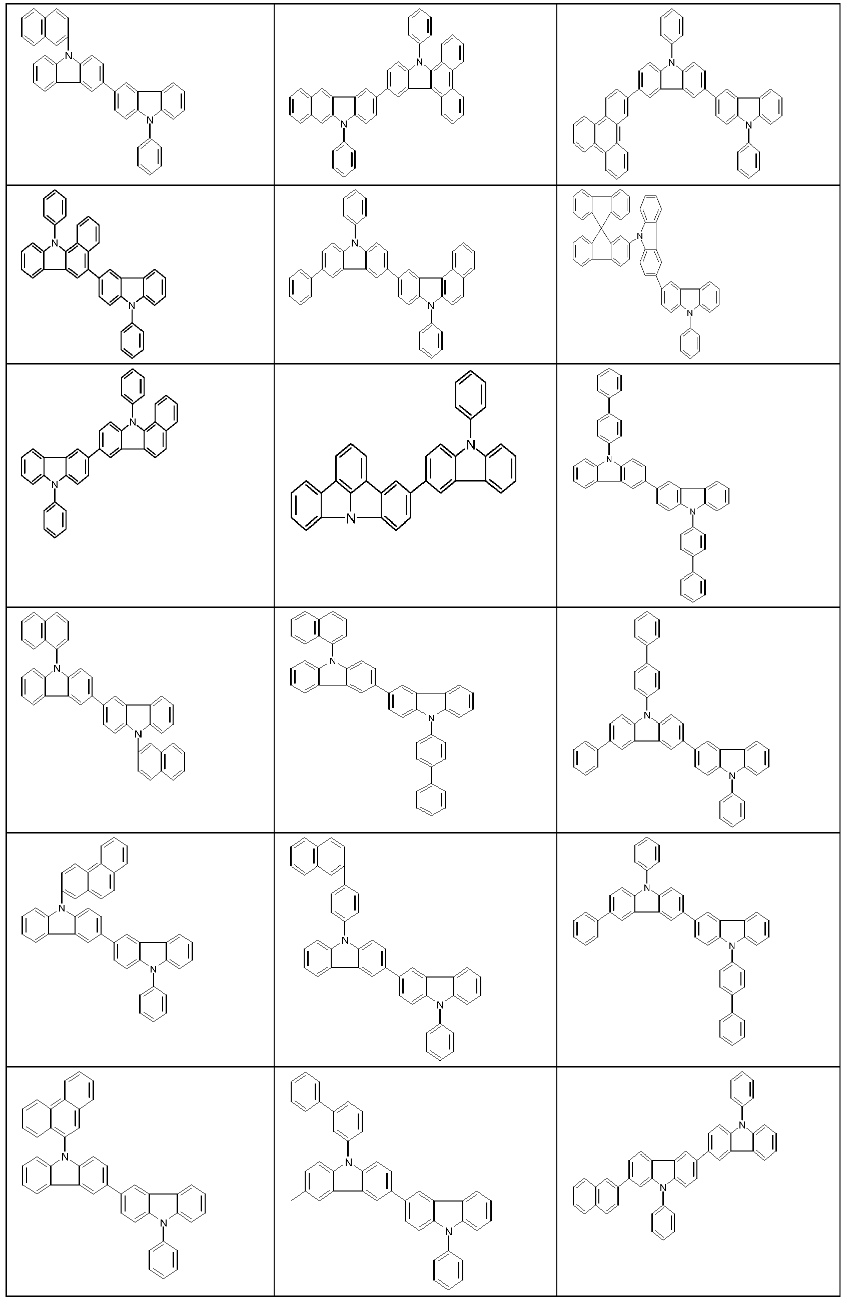

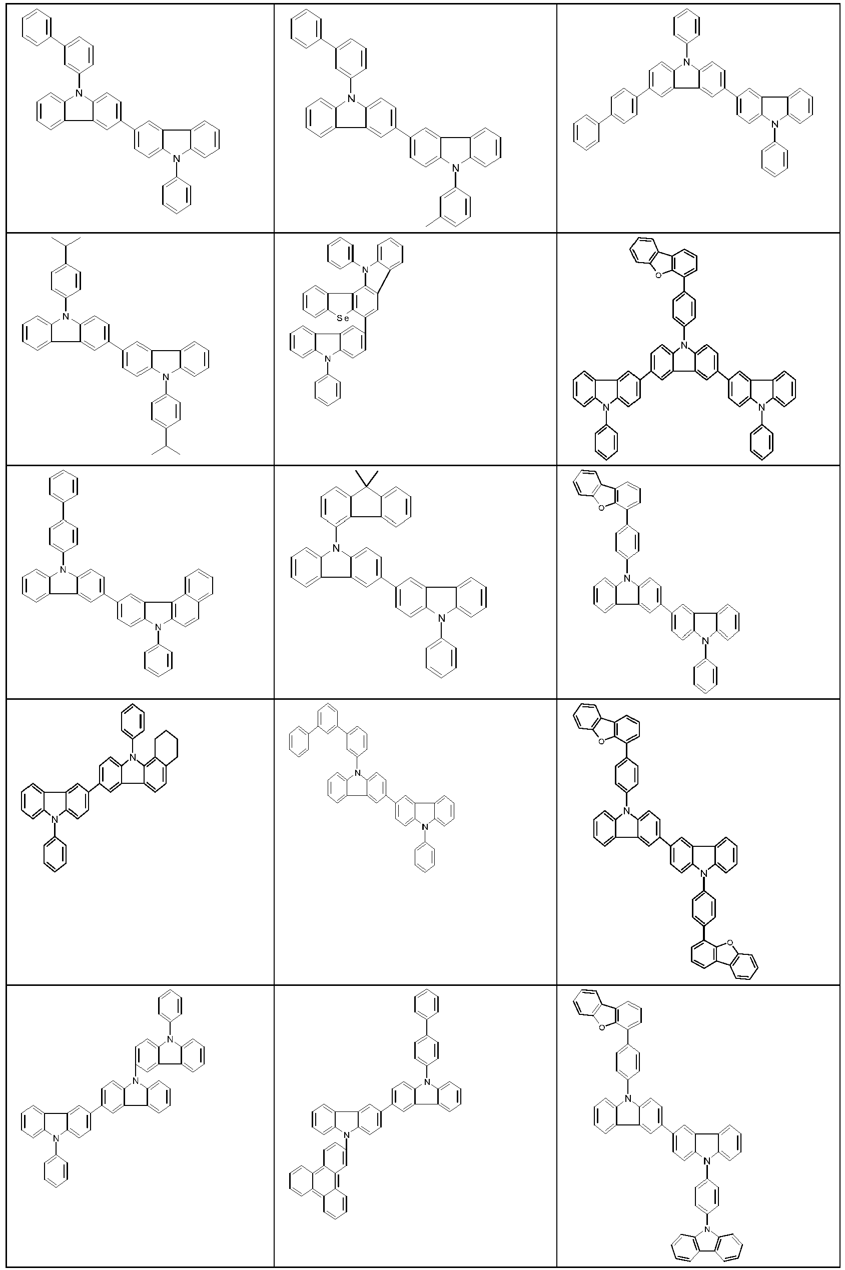

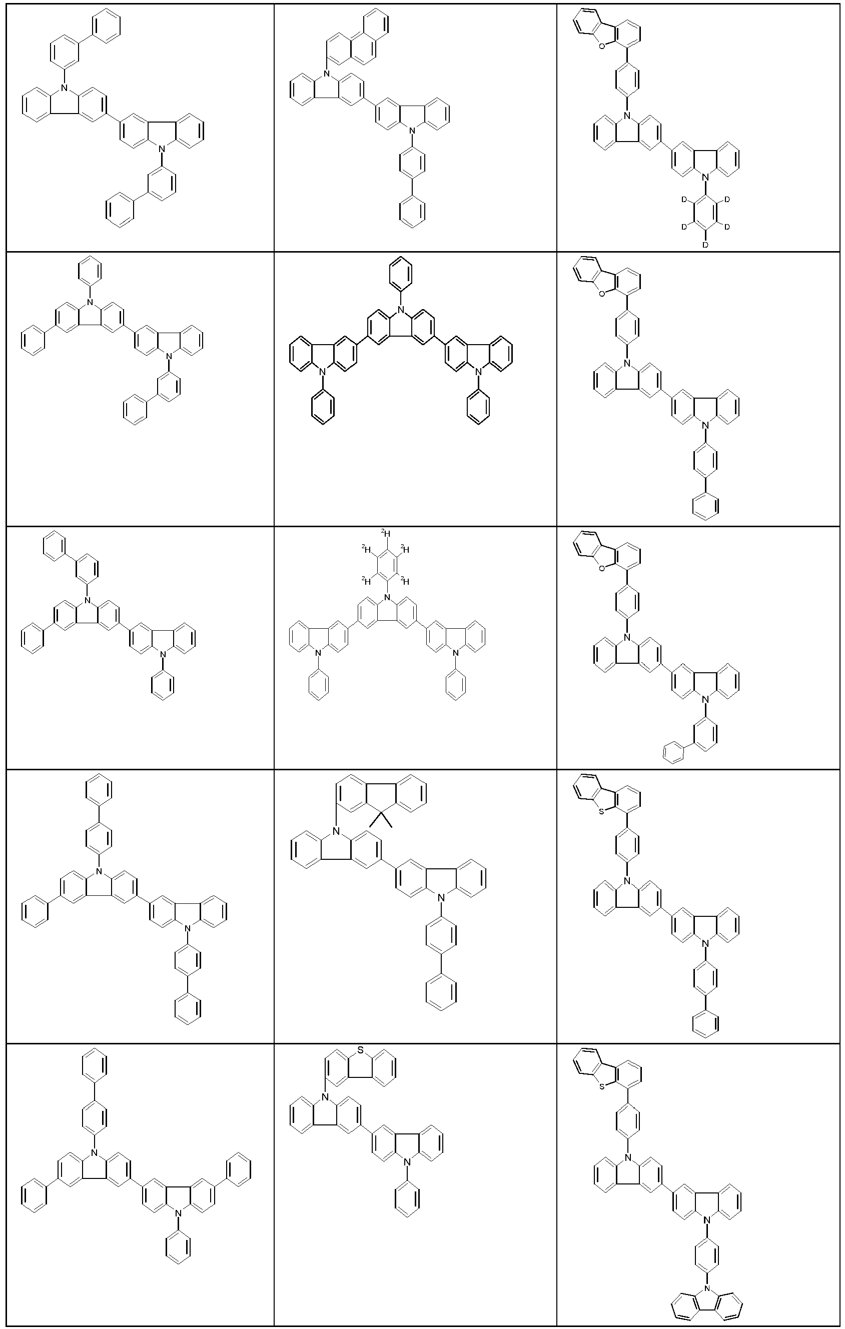

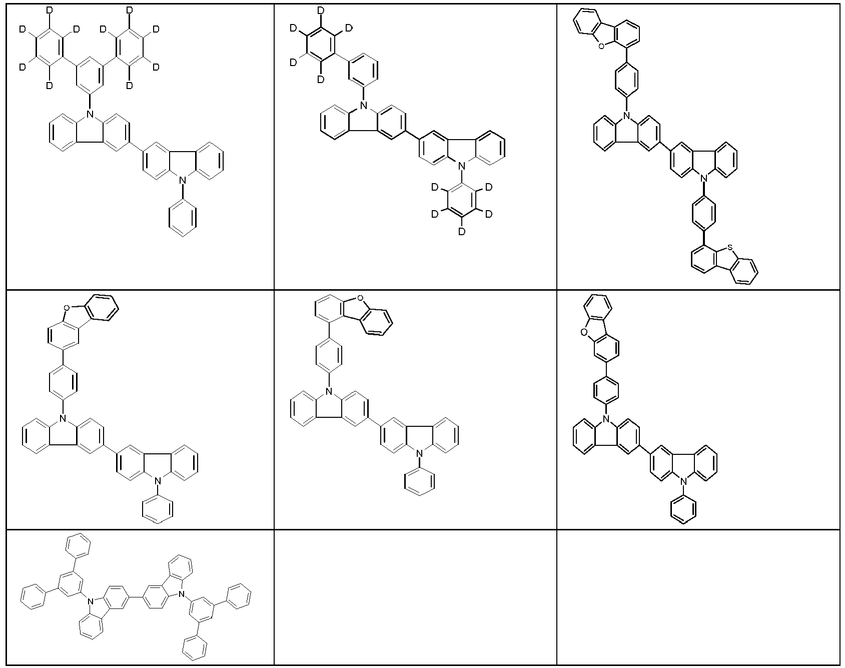

Beispiele für Amine, welche als lochtransportierende Matrixmaterialien eingesetzt werden können:

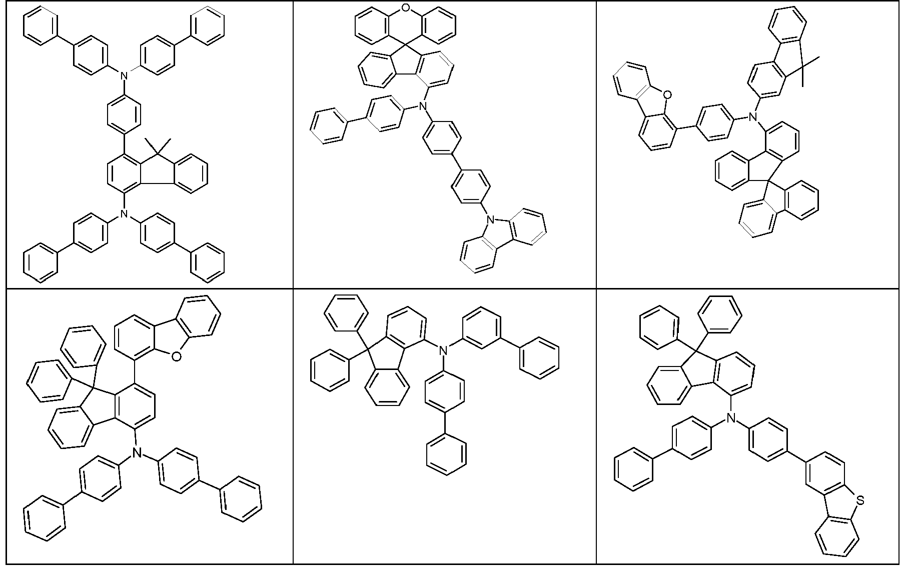

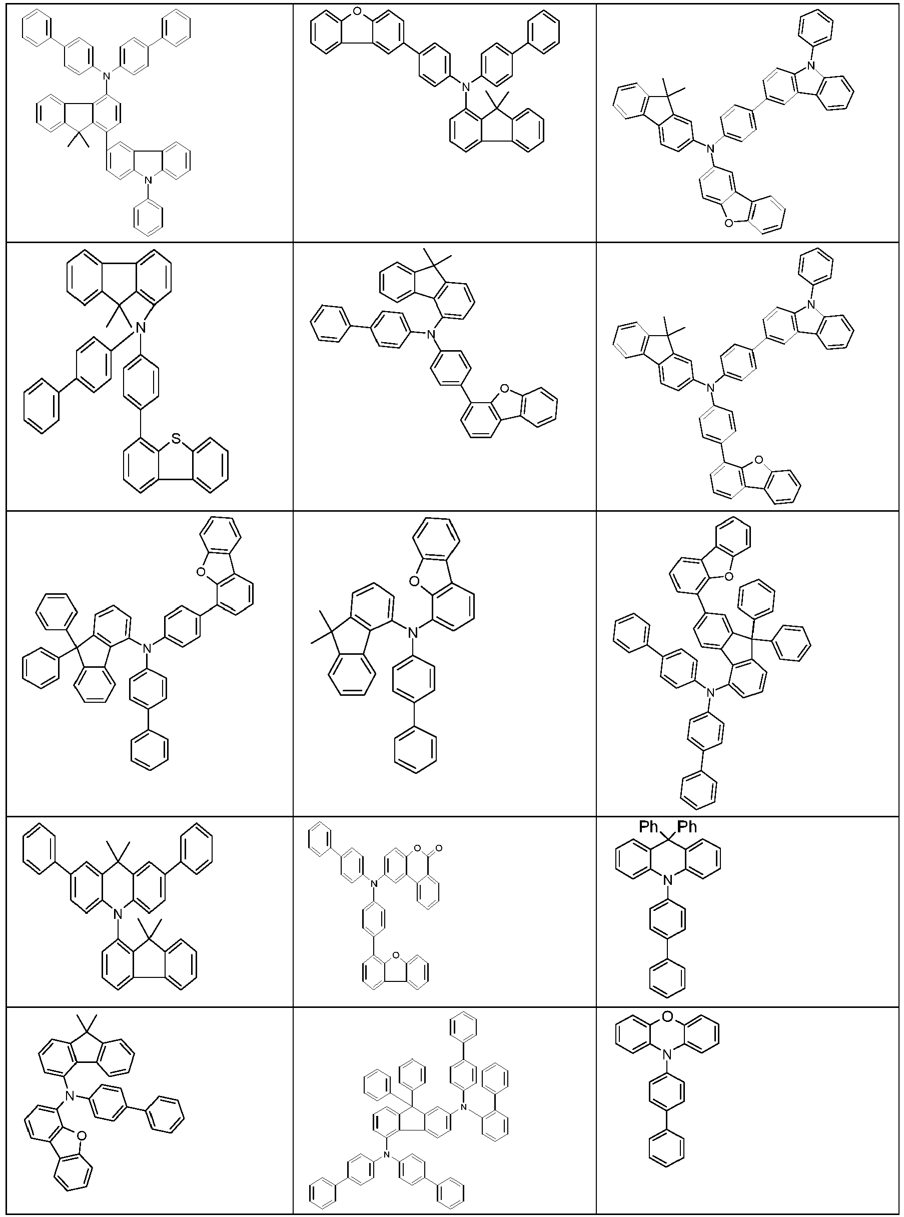

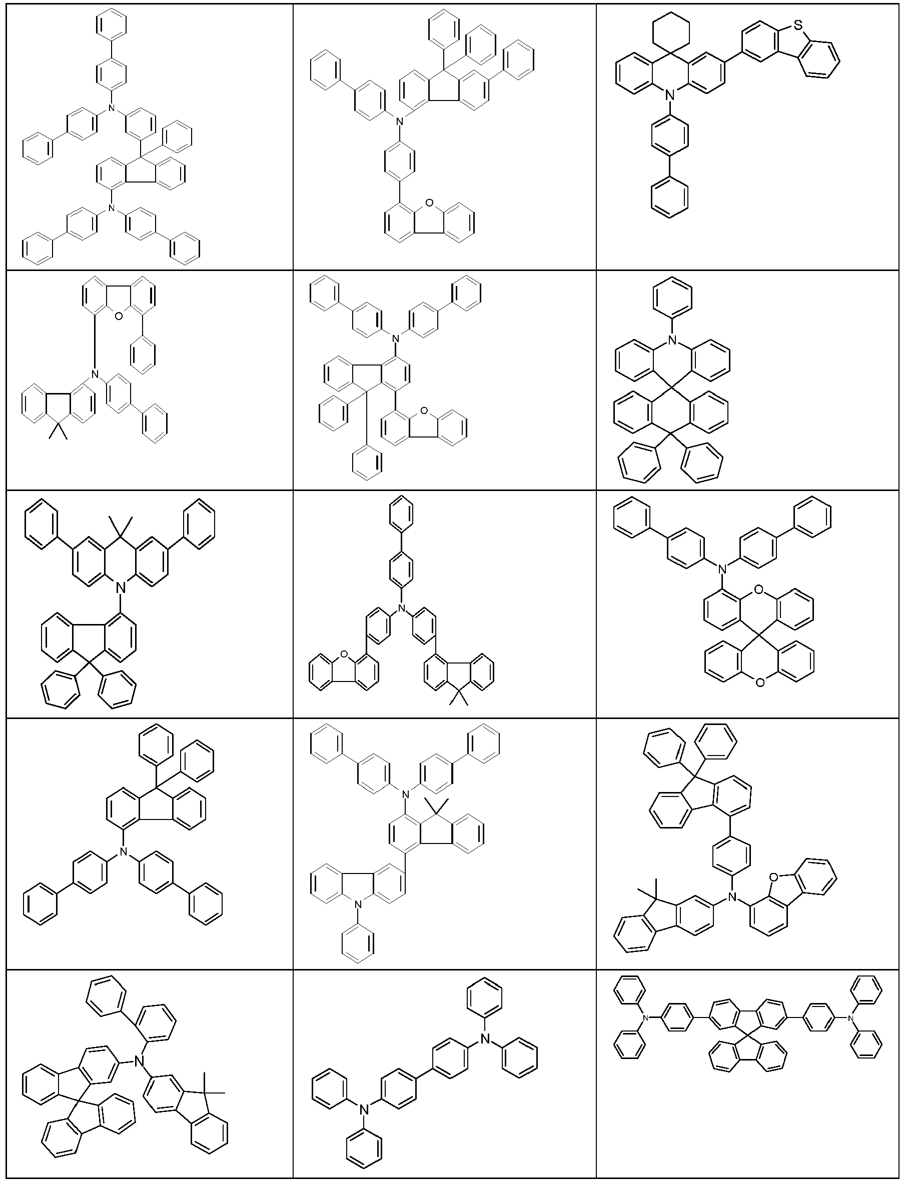

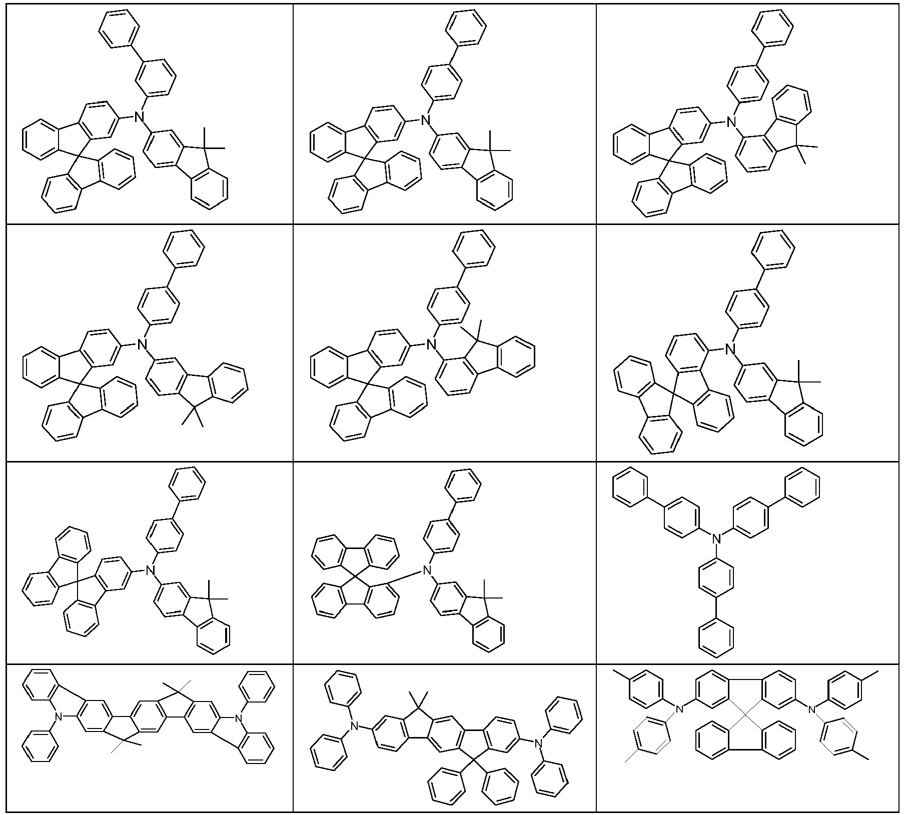

Beispiele für Materialien, welche als Wide Bandgap Matrixmaterialien eingesetzt werden können:

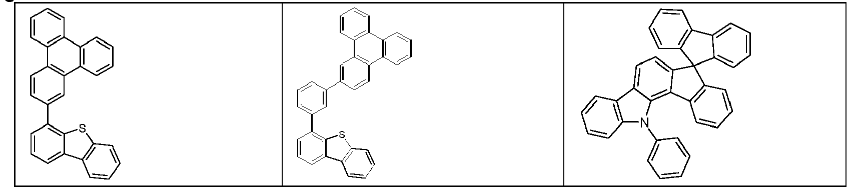

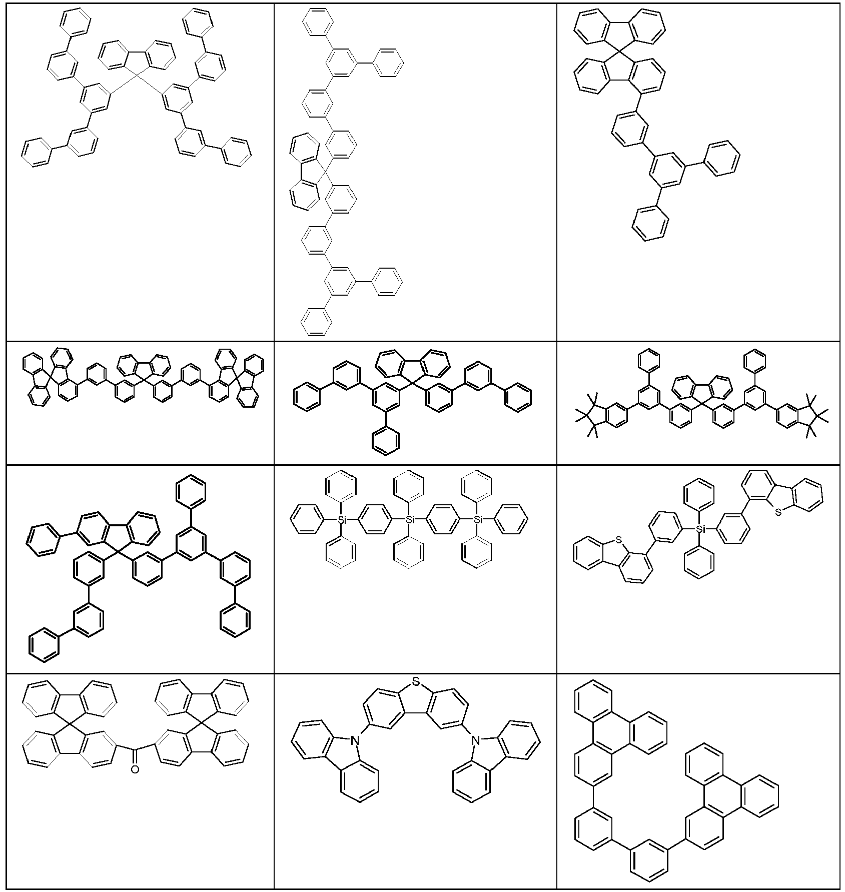

Weiterhin bevorzugt ist es, eine Mischung aus zwei oder mehr Triplett-Emittern, insbesondere zwei oder drei Triplettemittern, zusammen mit einem oder mehreren Matrixmaterialien einzusetzen. Dabei dient der Triplett-Emitter mit dem kürzerwelligen Emissionsspektrum als Co-Matrix für den Triplett-Emitter mit dem längerwelligen Emissionsspektrum. So können beispielsweise die erfindungsgemäßen Metallkomplexe mit einem kürzerwelligen, z.B. blau, grün oder gelb emittierenden, Metallkomplex als Co-Matrix kombiniert werden. Es können beispislweise auch erfindungsgemäße Metallkomplexe als Co-Matrix für längerwellig emittierende Triplettemitter, beispielsweise für rot emittierende Triplettemitter, eingesetzt werden. Dabei kann es auch bevorzugt sein, wenn sowohl der kürzerwellig wie auch der längerwellig emittierende Metallkomplex eine erfindungsgemäße Verbindung ist. Eine bevorzugte Ausführungsform bei Verwendung einer Mischung aus drei Triplett-Emittern ist, wenn zwei als Co-Host und einer als emittierendes Material eingesetzt werden. Dabei weisen diese Triplett-Emitter bevorzugt die Emissionsfarben Grün, Gelb und Rot oder Blau, Grün und Orange auf.

Eine bevorzugte Mischung in der emittierenden Schicht enthält ein elektronentransportierendes Hostmaterial, ein so genanntes "wide bandgap" Hostmaterial, das aufgrund seiner elektronischen Eigenschaften nicht oder nicht in wesentlichem Umfang am Ladungstransport in der Schicht beteiligt ist, einen Co-Dotanden, welcher ein Triplettemitter ist, welcher bei einer kürzeren Wellenlänge als die erfindungsgemäße Verbindung emittiert, sowie eine erfindungsgemäße Verbindung.

Eine weitere bevorzugte Mischung in der emittierenden Schicht enthält ein elektronentransportierendes Hostmaterial, ein so genanntes "wide band gap" Hostmaterial, das aufgrund seiner elektronischen Eigenschaften nicht oder nicht in wesentlichem Umfang am Ladungstransport in der Schicht beteiligt ist, ein lochtransportierendes Hostmaterial, einen Co-Dotanden, welcher ein Triplettemitter ist, welcher bei einer kürzeren Wellenlänge als die erfindungsgemäße Verbindung emittiert, sowie eine erfindungsgemäße Verbindung.

Die erfindungsgemäßen Verbindungen lassen sich auch in anderen Funktionen in der elektronischen Vorrichtung einsetzen, beispielsweise als Lochtransportmaterial in einer Lochinjektions- oder -transportschicht, als Ladungserzeugungsmaterial, als Elektronenblockiermaterial, als Lochblockiermaterial oder als Elektronentransportmaterial, beispielsweise in einer Elektronentransportschicht. Ebenso lassen sich die erfindungsgemäßen Verbindungen als Matrixmaterial für andere phosphoreszierende Metallkomplexe in einer emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Mg/Ag, Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Ebenso kommen hierfür organische Alkalimetallkomplexe in Frage, z. B. Liq (Lithiumchinolinat). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (O-SC) oder die Auskopplung von Licht (OLED/PLED, O-LASER) zu ermöglichen. Bevorzugte Anodenmaterialien sind hier leitfähige gemischte Metalloxide. Besonders bevorzugt sind Indium-Zinn-Oxid (ITO) oder Indium-Zink-Oxid (IZO). Bevorzugt sind weiterhin leitfähige, dotierte organische Materialien, insbesondere leitfähige dotierte Polymere, z. B. PEDOT, PANI oder Derivate dieser Polymere. Bevorzugt ist weiterhin, wenn auf die Anode ein p-dotiertes Lochtransportmaterial als Lochinjektionsschicht aufgebracht wird, wobei sich als p-Dotanden Metalloxide, beispielsweise MoO₃ oder WO₃, oder (per)fluorierte elektronenarme Aromaten eignen. Weitere geeignete p-Dotanden sind HAT-CN (Hexacyano-hexaazatriphenylen) oder die Verbindung NPD9 von Novaled. Eine solche Schicht vereinfacht die Lochinjektion in Materialien mit einem tiefen HOMO, also einem betragsmäßig großen HOMO.

In den weiteren Schichten können generell alle Materialien verwendet werden, wie sie gemäß dem Stand der Technik für die Schichten verwendet werden, und der Fachmann kann ohne erfinderisches Zutun jedes dieser Materialien in einer elektronischen Vorrichtung mit den erfindungsgemäßen Materialien kombinieren.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden. Bevorzugt sind als Lochtransportmaterialien, die in einer Lochtransport-, Lochinjektions- oder Elektronenblockierschicht in der erfindungsgemäßen Elektrolumineszenzvorrichtung verwendet werden können, Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627, WO2014/056565), Fluoren-Amine (z. B. gemäß EP 2875092, EP 2875699 und EP 2875004), Spiro-Dibenzopyran-Amine (z. B. EP 2780325) und Dihydroacridin-Derivate (z. B. gemäß WO 2012/150001).

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, dadurch gekennzeichnet, dass eine oder mehrere Schichten mit einem Sublimationsverfahren beschichtet werden. Dabei werden die Materialien in Vakuum-Sublimationsanlagen bei einem Anfangsdruck von üblicherweise kleiner 10⁻⁵ mbar, bevorzugt kleiner 10⁻⁶ mbar aufgedampft. Es ist auch möglich, dass der Anfangsdruck noch geringer oder noch höher ist, beispielsweise kleiner 10⁻⁷ mbar.

Bevorzugt ist ebenfalls eine organische Elektrolumineszenzvorrichtung, dadurch gekennzeichnet, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden.

Weiterhin bevorzugt ist eine organische Elektrolumineszenzvorrichtung, dadurch gekennzeichnet, dass eine oder mehrere Schichten aus Lösung, wie z. B. durch Spincoating, oder mit einem beliebigen Druckverfahren, wie z. B. Siebdruck, Flexodruck, Offsetdruck oder Nozzle-Printing, besonders bevorzugt aber LITI (Light Induced Thermal Imaging, Thermotransferdruck) oder Ink-Jet Druck (Tintenstrahldruck), hergestellt werden. Hierfür sind lösliche Verbindungen nötig, welche beispielsweise durch geeignete Substitution erhalten werden.

Die organische Elektrolumineszenzvorrichtung kann auch als Hybridsystem hergestellt werden, indem eine oder mehrere Schichten aus Lösung aufgebracht werden und eine oder mehrere andere Schichten aufgedampft werden. So ist es beispielsweise möglich, eine emittierende Schicht enthaltend einen erfindungsgemäßen Metallkomplex und ein Matrixmaterial aus Lösung aufzubringen und darauf eine Lochblockierschicht und/oder eine Elektronentransportschicht im Vakuum aufzudampfen.

Diese Verfahren sind dem Fachmann generell bekannt und können von ihm ohne Probleme auf organische Elektrolumineszenzvorrichtungen enthaltend Verbindungen gemäß Formel (1) bzw. die oben aufgeführten bevorzugten Ausführungsformen angewandt werden.

Die erfindungsgemäßen elektronischen Vorrichtungen, insbesondere organische Elektrolumineszenzvorrichtungen, zeichnen sich durch einen oder mehrere der folgenden überraschenden Vorteile gegenüber dem Stand der Technik aus:
1. Die erfindungsgemäßen Metallkomplexe weisen bei Verwendung als Emitter in einer organischen Elektrolumineszenzvorrichtung eine sehr hohe EQE (externe Quanteneffizienz) und eine sehr hohe Leistungseffizienz auf und zeigen orientierte Emission. Insbesondere ist die Effizienz deutlich höher im Vergleich zu Metallkomplexen, die ansonsten die gleiche Ligandenstruktur aufweisen, jedoch keinen Substituenten der Formel (3) aufweisen. Ebenso ist die Effizienz deutlich höher im Vergleich zu Metallkomplexen, die ansonsten die gleiche Ligandenstruktur aufweisen, die jedoch an jedem der drei Teilliganden einen Substituenten der Formel (3) aufweisen.
2. Die erfindungsgemäßen Metallkomplexe weisen bei Verwendung als Emitter in einer organischen Elektrolumineszenzvorrichtung eine sehr gute Lebensdauer auf. Insbesondere ist die Lebensdauer bei konstanter Leuchtdichte höher im Vergleich zu Metallkomplexen, die ansonsten die gleiche Ligandenstruktur aufweisen, jedoch keinen Substituenten der Formel (3) aufweisen. Ebenso ist die Lebensdauer höher im Vergleich zu Metallkomplexen, die ansonsten die gleiche Ligandenstruktur aufweisen, die jedoch an jedem der drei Teilliganden einen Substituenten der Formel (3) aufweisen.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen ohne erfinderisches Zutun weitere erfindungsgemäße elektronische Vorrichtungen herstellen und somit die Erfindung im gesamten beanspruchten Bereich ausführen.

### Beispiele:

Die nachfolgenden Synthesen werden, sofern nicht anders angegeben, unter einer Schutzgasatmosphäre in getrockneten Lösungsmitteln durchgeführt. Die Metallkomplexe werden zusätzlich unter Ausschluss von Licht bzw. unter Gelblicht gehandhabt. Die Lösungsmittel und Reagenzien können z. B. von Sigma-ALDRICH bzw. ABCR bezogen werden. Die jeweiligen Angaben in eckigen Klammern bzw. die zu einzelnen Verbindungen angegebenen Nummern beziehen sich auf die CAS-Nummern der literaturbekannten Verbindungen. Bei Verbinden die mehrere tautomere Formen ausweisen können wird eine tautomere Form stellvertretend gezeigt.

### Allgemeines Verfahren zur Bestimmung von Orbitalenergien und elektronischer Zustände

Für die Bestimmung, ob das Strukturfragment Ir(L²) eine höhere Triplettenergie aufweist als das Strukturfragment Ir(L¹), wird eine quantenchemische Rechnung durchgeführt. Dafür wird die Triplettenergie der jeweiligen pseudohomoleptischen Komplexe bestimmt, also eines Komplexes der Formel (1), der jedoch drei Teilliganden L¹ aufweist, und eines Komplexes der Formel (1), der jedoch drei Teilliganden L² aufweist, wobei die Komplexe außer den Teilliganden L¹ bzw. L² die jeweils gleiche Struktur aufweisen.

Das Triplettniveau (= Triplettenergie = E(T1)) der C₃-symmetrischen, trispseudo-homoleptischen Metallkomplexe wird über quantenchemische Rechnungen bestimmt. Die hierin beschriebene Methode ist jedoch unabhängig von dem verwendeten Softwarepaket und liefert immer dieselben Ergebnisse. Beispiele oft benutzter Programme für diesen Zweck sind "Gaussian09" (Gaussian Inc.) und Q-Chem 4.1 (Q-Chem, Inc.). Vorliegend wird zur Berechnung der Energien das Programmpaket "Gaussian09, Revision D.01" (Gaussian Inc.) verwendet.

Die Geometrie wird mit der Methode Hartree-Fock und dem Basissatz LanL2MB (Gaussian-Eingabezeile"# HF/LanL2MB opt") optimiert (Ladung 0, Multiplizität 1). Im Anschluss erfolgt auf Grundlage der optimierten Geometrie eine Energierechnung (single point) für den elektronischen Grundzustand und das Triplett-Niveau.

Hierbei wird die TDDFT-Methode (time dependent density functional theory) B3PW91 mit dem Basissatz 6-31G(d) (Gaussian-Eingabezeile"# B3PW91/6-31G(d) td=(50-50,nstates=4)") verwendet (Ladung 0, Multiplizität 1) für alle Atome außer Iridium. Für das Iridiumatom wird der Basissatz "LanL2DZ" verwendet (Gaussian-Eingabezeile "#B3PW91/gen pseudo=lanl2 td=(50-50,nstates=4)").

Das Triplettniveau eines Materials ist definiert als die relative Anregungsenergie (in eV) des Triplettzustands mit der niedrigsten Energie, der sich aus der quantenchemischen Energierechnung ergibt.

Wenn die Triplettenergie, die aus der Rechnung erhalten wird, des pseudohomoleptischen Komplexes enthaltend den Teilliganden L² größer ist als die Triplettenergie des pseudohomoleptischen Komplexes enthaltend den Teilliganden L¹, dann weist im Sinne der vorliegenden Erfindung das Strukturfragment Ir(L²) eine höhere Triplettenergie auf als das Strukturfragment Ir(L¹).

### A: Synthese der Synthone S:

### Beispiel S1:

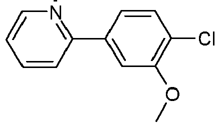

### Variante A: Kupplung der 2-Brompyridine, S1

Ein Gemisch aus 26.9 g (100 mmol) 2-(4-Chlor-3-methoxyphenyl)-4,4,5,5-tetramethyl-1,3,2-dioxaborolan [627525-96-6], 19.0 g (120 mmol) 2-Brompyridin, 21.2 g (200 mmol) Natriumcarbonat, 200 ml Toluol, 50 ml Ethanol und 100 ml Wasser wird unter sehr gutem Rühren mit 1.2 g (1 mmol) Tetrakis-triphenylphosphino-palladium(0) versetzt und dann 24 h unter Rückfluss erhitzt. Nach Erkalten trennt man die org. Phase ab, wäscht diese einmal mit 300 ml Wasser, einmal mit 300 ml ges. Kochsalzlösung und trocknet über Magnesiumsulfat. Man filtriert vom Trockenmittel ab, engt das Filtrat um Vakuum vollständig ein und unterzieht den Rückstand einer Kugelrohrdestillation (p ∼ 10⁻² mbar, T ∼ 200 °C). Ausbeute: 19.8 g (90 mmol), 90 %; Reinheit: ca. 95 %ig n. ¹H-NMR.

### Variante B: Kupplung der 2,5-Dibrompyridine, S7

Ein Gemisch aus 23.7 g (100 mmol) 2,5-Dibrompyridin [624-28-2], 23.4 g (100 mmol) 2-(3-Methoxyphenyl)-4,4,5,5-tetramethyl-1,3,2-dioxaborolan [325142-84-5], 27.6 g (200 mmol) Kaliumcarbonat, 50 g Glaskugeln (3 mm Durchmesser), 526 mg (2 mmol) Triphenylphosphin, 225 mg (1 mmol) Palladium(II)acetat, 200 ml Acetonitril und 100 ml Methanol wird unter gutem Rühren 16 h unter Rückfluss erhitzt. Nach Erkalten entfernt man das Lösungsmittel weitgehend im Vakuum, nimmt den Rückstand in 500 ml Ethylacetat auf, wäscht dreimal mit je 200 ml Wasser und einmal mit 300 ml ges. Kochsalzlösung und trocknet über Magnesiumsulfat. Man filtriert vom Trockenmittel ab, engt das Filtrat zur Trockene ein und kristallisiert den Feststoff aus Acetonitril um. Ausbeute: 18.3 g (68 mmol), 68 %; Reinheit: ca. 95 %ig n. ¹H-NMR.

Analog können folgende Verbindungen dargestellt werden.

| Bsp. | Edukte Variante | Produkt | Ausbeute |
|---|---|---|---|
| S2 | 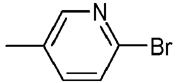 3510-66-5 | 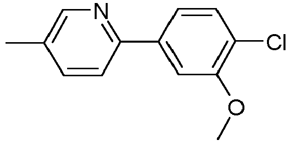 | 83% |
| | 627525-96-6 | | |
| | A | | |
| S3 | 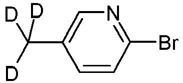 1185306-03-9 | 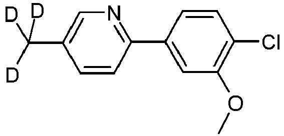 | 85% |
| | 627525-96-6 | | |
| | A | | |
| S4 | 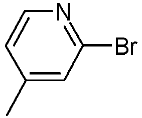 4926-28-7 | 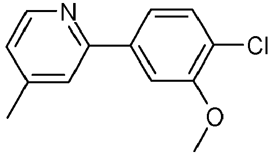 | 88% |
| | 627525-96-6 | | |
| | A | | |
| S5 | 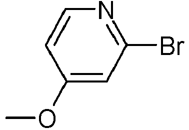 | 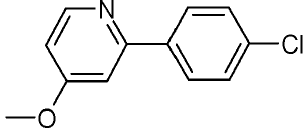 | 74% |
| | 89488-29-9 | | |
| | 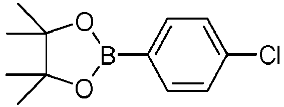 | | |
| | 195062-61-4 | | |
| | A | | |
| S6 | 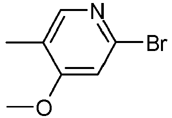 | 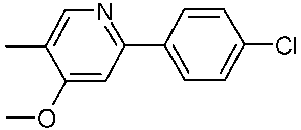 | 70% |
| | 1227574-33-5 | | |
| | 195062-61-4 | | |
| | A | | |
| S7 | 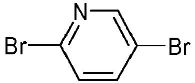 | 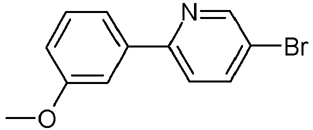 | 65% |
| | 624-28-2 | | |
| | 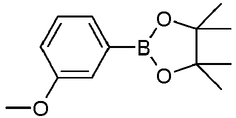 | | |
| | 325142-84-5 | | |
| | B | | |
| S8 | 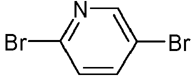 | 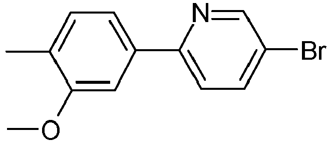 | 69% |
| | 624-28-2 | | |
| | 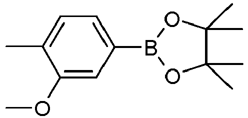 | | |
| | 1417036-28-2 | | |
| | B | | |
| S9 | 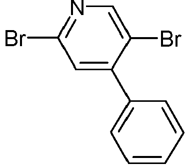 | 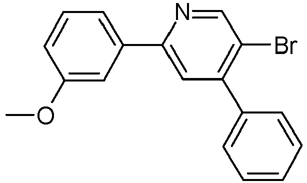 | 67% |
| | 1381937-40-1 | | |
| | 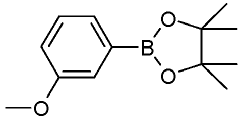 | | |
| | 325142-84-5 | | |
| | B | | |
| S10 | 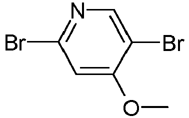 | 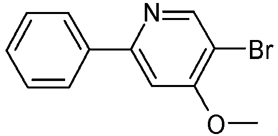 | 65% |
| | 1211520-71-6 | | |
| | 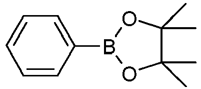 | | |
| | 24388-23-6 | | |
| | **B** | | |
| S11 | 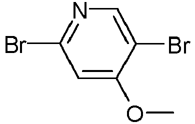 | 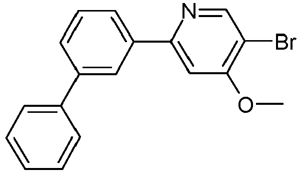 | 70% |
| | 1211520-71-6 | | |
| | 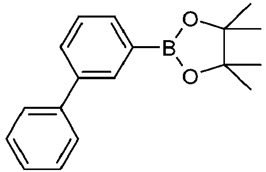 | | |
| | 912844-88-3 | | |
| | B | | |
| S12 | 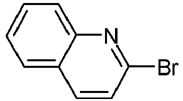 | 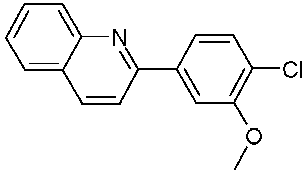 | 73% |
| | 2005-43-8 | | |
| | 627525-96-6 | | |
| | A | | |
| S13 | 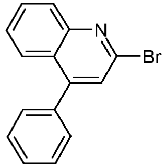 | 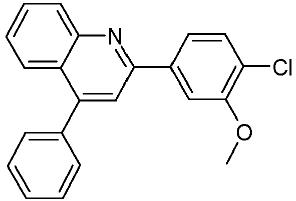 | 77% |
| | 857206-12-3S | | |
| | 627525-96-6 | | |
| | A | | |
| S14 | 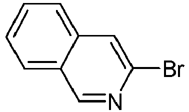 | 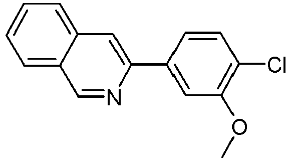 | 77% |
| | 34784-02-6 | | |
| | 627525-96-6 | | |
| | A | | |
| S15 | 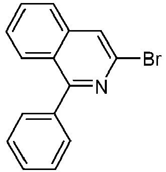 | 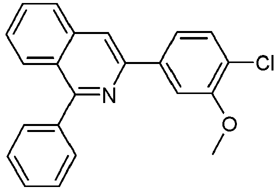 | 77% |
| | 2073111-76-7 | | |
| | 627525-96-6 | | |
| | A | | |
| S16 | 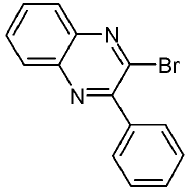 | 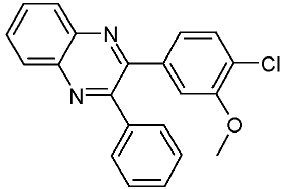 | 73% |
| | 1195563-58-6 | | |
| | 627525-96-6 | | |
| | A | | |

### Beispiel S50:

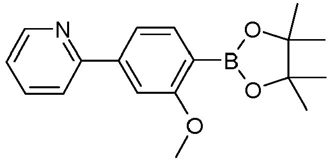

### Variante A:

Ein Gemisch aus 22.0 g (100 mmol) S1, 26.7 g (105 mmol) Bis(pinacolato)diboran, 29.4 g (300 mmol) Kaliumacetat (wasserfrei), 50 g Glaskugeln (3 mm Durchmesser) und 300 ml THF wird unter gutem Rühren mit 821 mg (2 mmol) SPhos und dann mit 225 mg (1 mmol) Palladium(II)-acetat versetzt und 16 h unter Rückfluss erhitzt. Nach Erkalten saugt man von den Salzen und Glaskugeln über ein mit THF vorgeschlämmtes Celite-Bett ab, wäscht dieses mit etwas THF nach und engt das Filtrat zur Trockene ein. Man nimmt den Rückstand in 100 ml MeOH auf, rührt warm aus, saugt vom auskristallisierten Produkt ab, wäscht zweimal mit je 30 ml Methanol nach und trocknet im Vakuum. Ausbeute: 27.4 g (88 mmol), 88 %; Reinheit: ca. 95 %ig n. ¹H-NMR.

### Variante B:

Durchführung analog zu Variante A, jedoch wird das SPhos durch Tricyclohexylphosphin ersetzt.

Analog können folgende Verbindungen dargestellt werden.

| Bsp. | Edukt Variante | Produkt | Ausbeute |
|---|---|---|---|
| S51 | S2 | 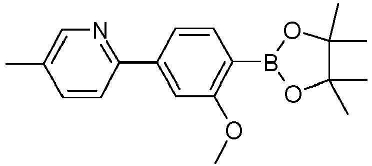 | 90% |
| | A | | |
| S52 | S3 | 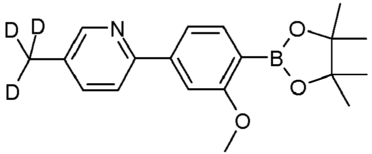 | 89% |
| | A | | |
| S53 | S4 | 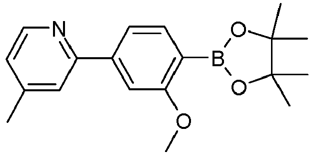 | 87% |
| | A | | |
| S54 | S5 | 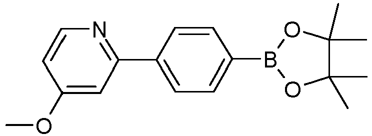 | 90% |
| | A | | |
| S55 | S6 | 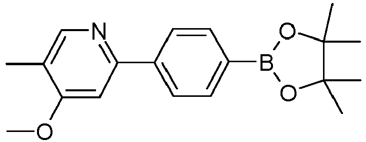 | 87% |
| | A | | |
| S56 | S7 | 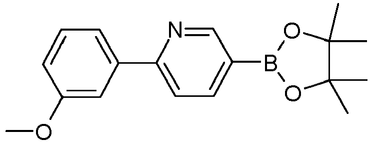 | 84% |
| | A | | |
| S57 | S8 | 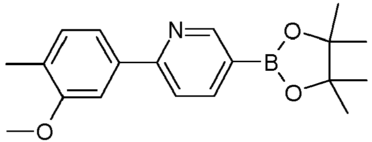 | 88% |
| | A | | |
| S58 | S9 | 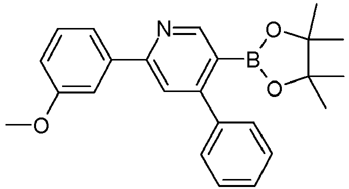 | 85% |
| | B | | |
| S59 | S10 | 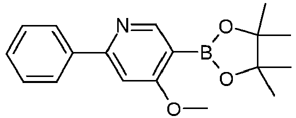 | 87% |
| | A | | |
| S60 | S11 | 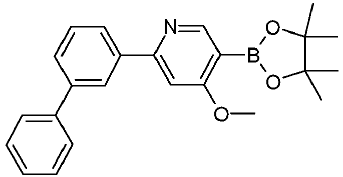 | 90% |
| | A | | |
| S61 | S12 | 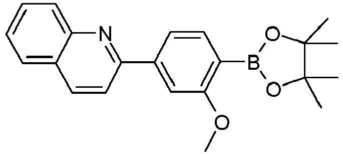 | 94% |
| | A | | |
| S62 | S13 | 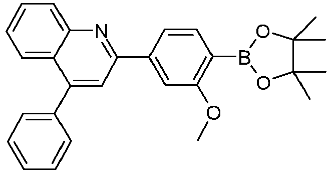 | 91% |
| | A | | |
| S63 | S14 | 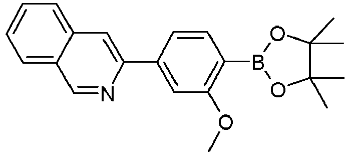 | 90% |
| | A | | |
| S64 | S15 | 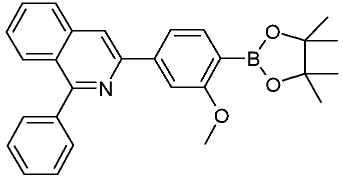 | 90% |
| | A | | |
| S65 | S16 | 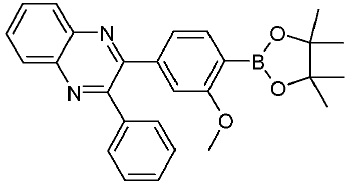 | 90% |
| | A | | |
| S66 | 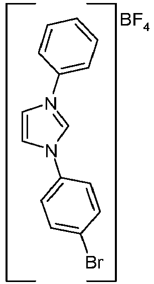 | 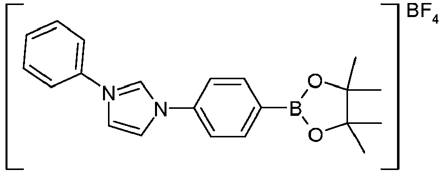 Ausrühren mit Acetonitril | 55% |
| | 1434057-17-6 | | |
| | A | | |

### Beispiel S100:

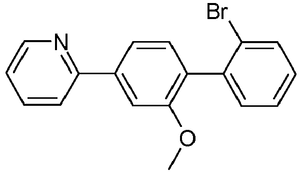

Ein Gemisch aus 31.1 g (100 mmol) S50, 28.3 g (100 mmol) 1-Brom-2-iodbenzol, 31.8 g (300 mmol) Natriumcarbonat, 200 ml Toluol, 70 ml Ethanol und 200 ml Wasser wird unter sehr gutem Rühren mit 788 mg (3 mmol) Triphenylphosphin und dann mit 225 mg (1 mmol) Palladium(II)-acetat versetzt und 48 h unter Rückfluss erhitzt. Nach Erkalten trennt man die org. Phase ab, wäscht diese einmal mit 300 ml Wasser und einmal mit 300 ml ges. Kochsalzlösung und trocknet über Magnesiumsulfat. Man filtriert vom Trockenmittel ab und engt das Filtrat um Vakuum vollständig ein. Der Rückstand wird Flash-chromatographiert (Säulenautomat Torrent der Fa. A. Semrau). Ausbeute: 32.3 g (95 mmol), 95 %; Reinheit: ca. 97 %ig n. ¹H-NMR.

Analog können folgende Verbindungen dargestellt werden.

| Bsp. | Edukt | Produkt | Ausbeute |
|---|---|---|---|
| S101 | S51 | 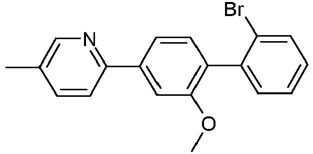 | 90% |
| S102 | S52 | 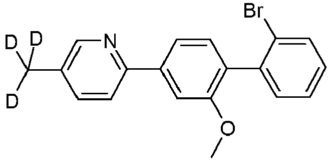 | 87% |
| S103 | S53 | 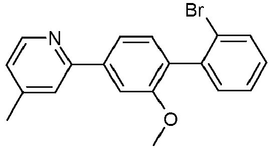 | 91% |
| S104 | S54 | 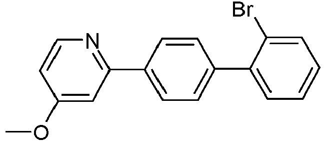 | 86% |
| S105 | S55 | 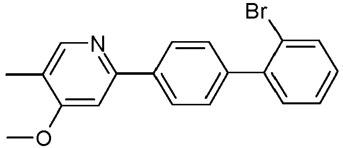 | 93% |
| S106 | S56 | 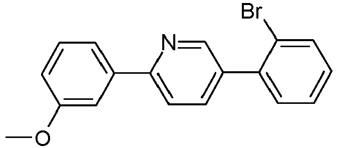 | 86% |
| S107 | S57 | 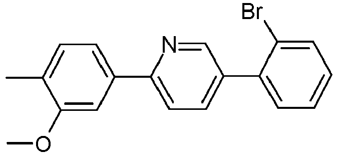 | 86% |
| S108 | S58 | 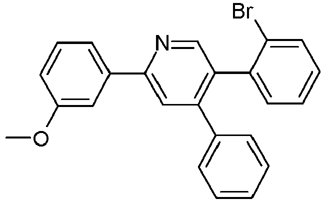 | 89% |
| S109 | S59 | 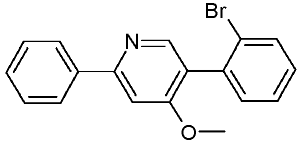 | 87% |
| S110 | S60 | 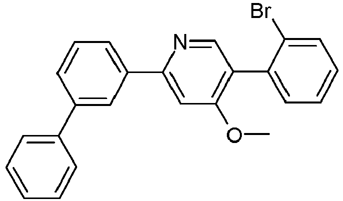 | 90% |
| S111 | S61 | 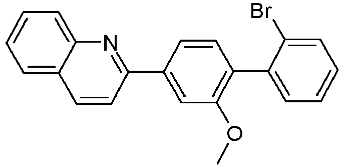 | 88% |
| S112 | S62 | 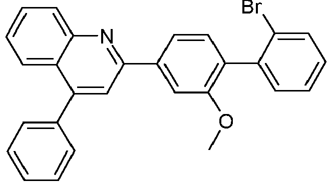 | 85% |
| S113 | S63 | 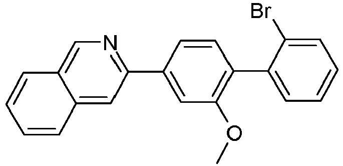 | 8ß% |
| S114 | S64 | 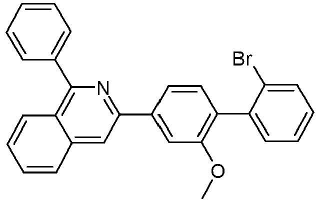 | 80% |
| S115 | S65 | 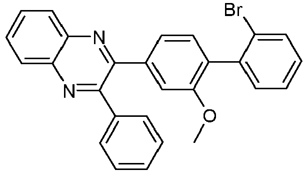 | 76% |
| S116 | 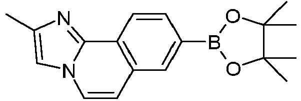 1989597-11-6 | 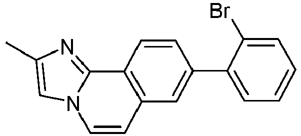 | 80% |
| S117 | 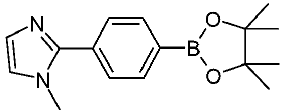 1394374-23-2 | 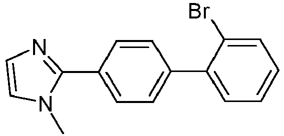 | 89% |
| S118 | 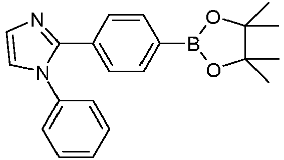 1621467-82-0 | 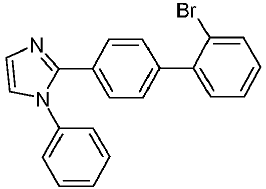 | 86% |
| S119 | 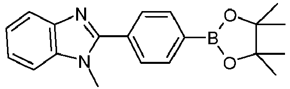 1466412-09-8 | 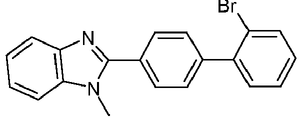 | 85% |
| S120 | 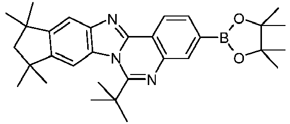 1989597 -13-8 | 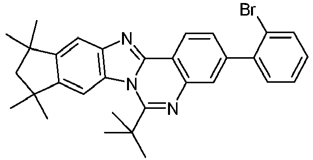 | 77% |
| S121 | 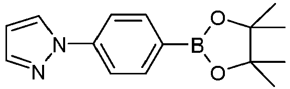 1312478-63-9 | 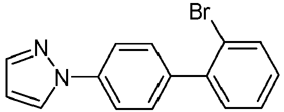 | 80% |
| S122 | S66 | 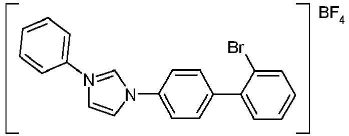 Extraktion der Wasserphase mit Dichlormethan; Umkristallisation der Rohprodukts aus Acetonitril / MeOH | 67% |
| S123 | 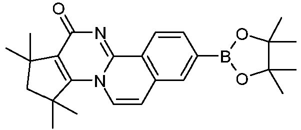 1989597 -91-2 | 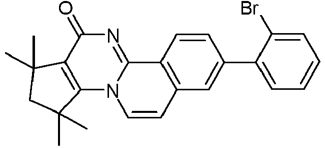 | 85% |

### Beispiel S150:

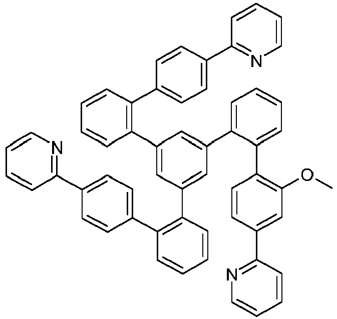

Ein Gemisch aus 66.3 g (100 mmol) 2,2'-[5"-(4,4,5,5-tetramethyl-1,3,2-dioxaborolan-2-yl)[1,1':2', 1":3", 1'":2"', 1""-quinquephenyl]-4,4""-diyl]bis-pyridine [1989597-72-9], 34.0 g (100 mmol) S100, 63.7 g (300 mmol) Trikaliumphosphat, 300 ml Toluol, 150 ml Dioxan und 300 ml Wasser wird unter gutem Rühren mit 1.64 g (4 mmol) SPhos und dann mit 449 mg (2 mmol) Palladium(II)acetat versetzt und anschließend 24 h unter Rückfluss erhitzt. Nach Erkalten trennt man die org. Phase ab, wäscht diese zweimal mit je 300 ml Wasser und einmal mit 300 ml ges. Kochsalzlösung und trocknet über Magnesiumsulfat. Man filtriert vom Trockenmittel ab, engt das Filtrat im Vakuum zur Trockene ein und kristallisiert das glasartige Rohprodukt in der Siedehitze aus Acetonitril (∼100 ml) unter Zusatz von Ethylacetat (∼20 ml) und dann ein zweites mal aus Butylacetat um. Ausbeute: 68.5 g (86 mmol), 86 %; Reinheit: ca. 95 %ig n. ¹H-NMR.

Analog können folgende Verbindungen dargestellt werden.

| Bsp. | Edukte | Produkt | Ausbeute |
|---|---|---|---|
| S151 | 1989597-72-9 | 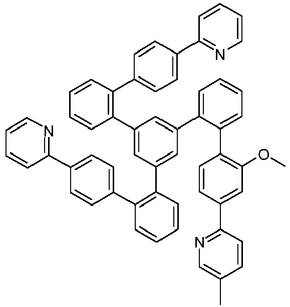 | 83% |
| | S101 | | |
| S152 | 1989597 -72-9 | 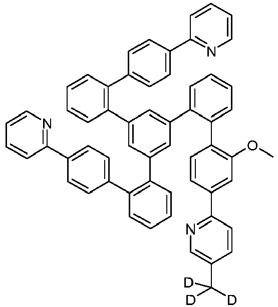 | 80% |
| | S102 | | |
| S153 | 1989597-72-9 | 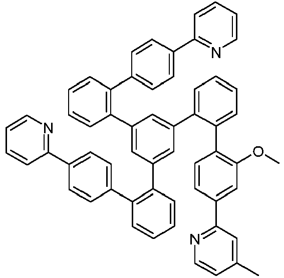 | 85% |
| | S103 | | |
| S154 | 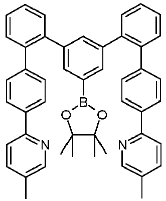 | 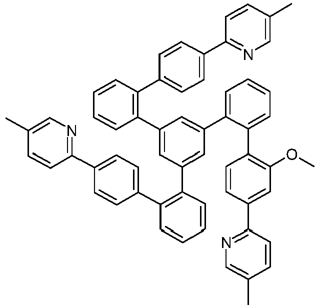 | 87% |
| | Darstellung analog zu 1989597-72-9 gemäß WO 2016/124304 durch Einsatz von 2-Brom-5-methyl pyridin | | |
| | S101 | | |
| S155 | 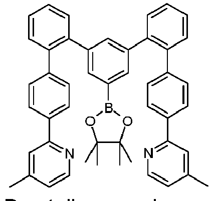 | 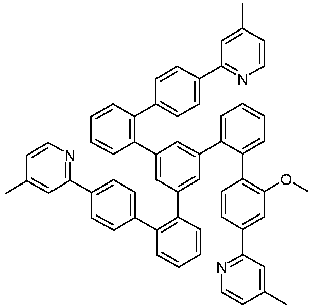 | 85% |
| | Darstellung analog zu 1989597-72-9 gemäß WO 2016/124304 durch Einsatz von 2-Brom-4-methyl pyridin | | |
| | S103 | | |
| S156 | 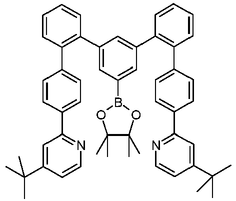 1989597-75-2 | 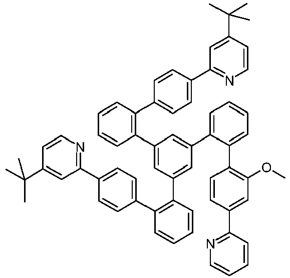 | 88% |
| | S100 | | |
| S157 | 1989597-72-9 | 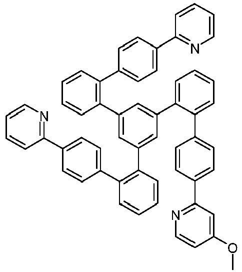 | 81% |
| | S104 | | |
| S158 | 1989597-72-9 | 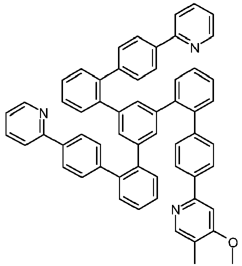 | 78% |
| | S105 | | |
| S159 | 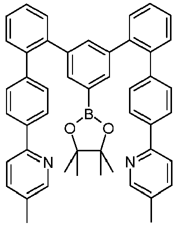 | 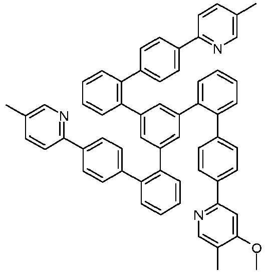 | 80% |
| | S105 | | |
| S160 | 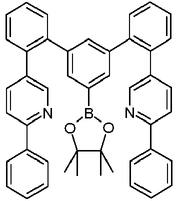 | 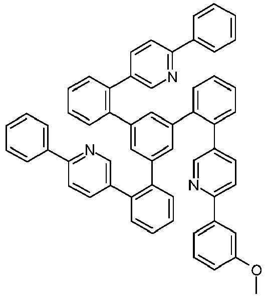 | 80% |
| | 1989597-70-7 | | |
| | S106 | | |
| S161 | 1989597-70-7 | 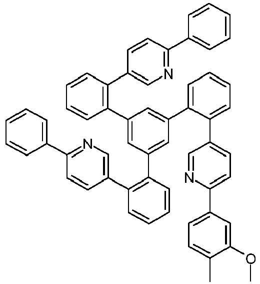 | 78% |
| | S107 | | |
| S162 | 1989597-70-7 | 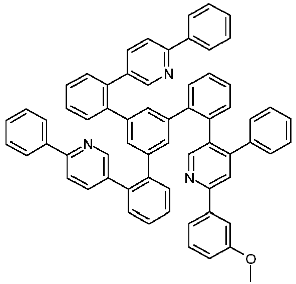 | 86% |
| | S108 | | |
| S163 | 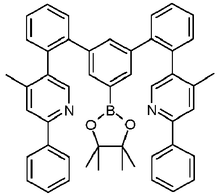 | 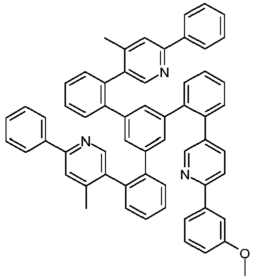 | 77% |
| | 1989597-71-8 | | |
| | S106 | | |
| S164 | 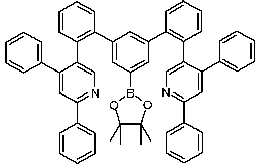 | 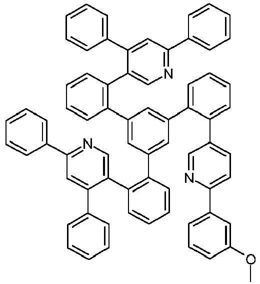 | 81% |
| | 1989597-74-1 | | |
| | S106 | | |
| S165 | 1989597-70-7 | 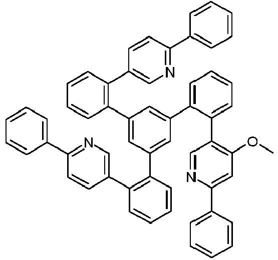 | 80% |
| | S109 | | |
| S166 | 1989597-70-7 | 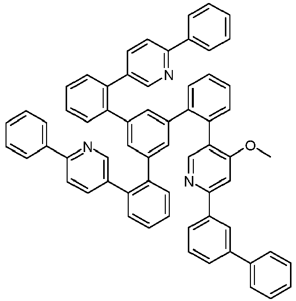 | 82% |
| | S110 | | |
| S167 | 1989597-71-8 | 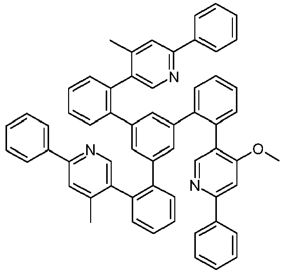 | 86% |
| | S109 | | |
| S168 | 1989597-72-9 | 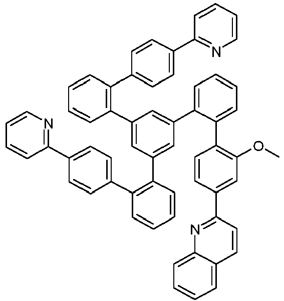 | 80% |
| | S111 | | |
| S169 | 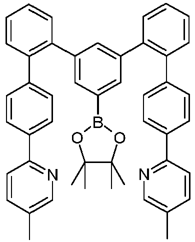 | 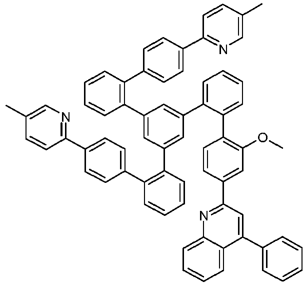 | 86% |
| | S112 | | |
| S170 | 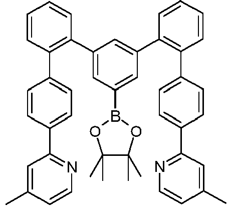 | 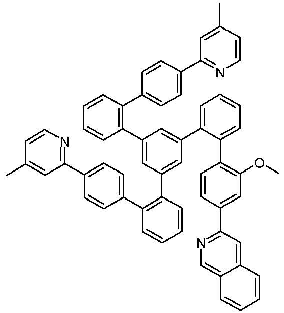 | 88% |
| | S113 | | |
| S171 | 1989597-72-9 | 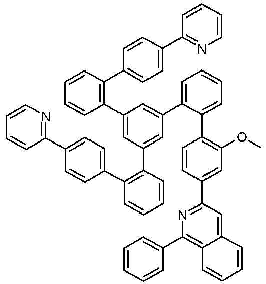 | 85% |
| | S114 | | |
| S172 | 1989597-72-9 | 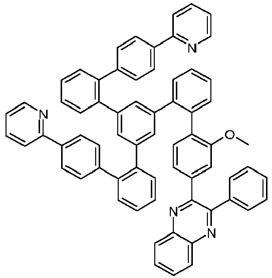 | 83% |
| | S115 | | |
| S173 | S350 | 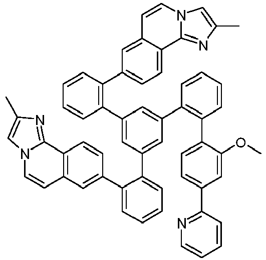 | 77% |
| | S100 | | |
| S174 | S350 | 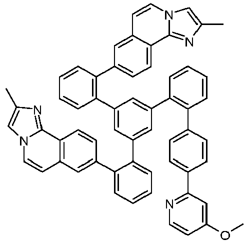 | 80% |
| | S104 | | |
| S175 | S351 | 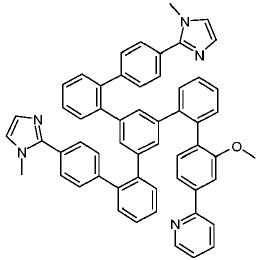 | 83% |
| | S100 | | |
| S176 | S351 | 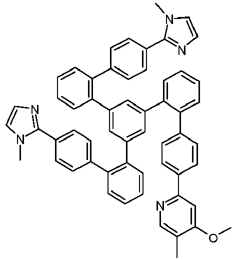 | 85% |
| | S105 | | |
| S177 | S352 | 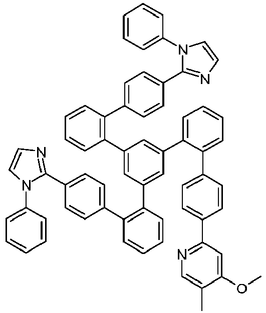 | 79% |
| | S105 | | |
| S178 | S353 | 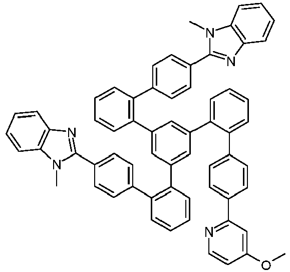 | 83% |
| | S104 | | |
| S179 | S354 | 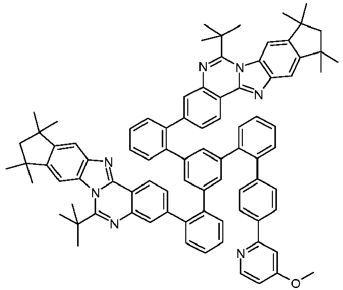 | 74% |
| | S104 | | |
| S180 | S355 | 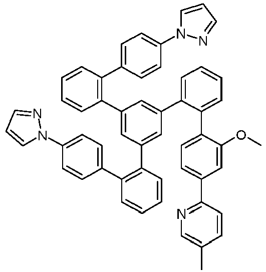 | 86% |
| | S101 | | |
| S181 | S355 | 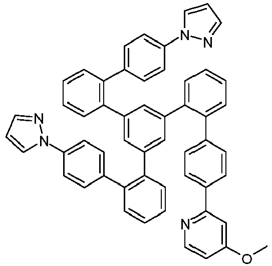 | 86% |
| | S104 | | |
| S182 | S355 | 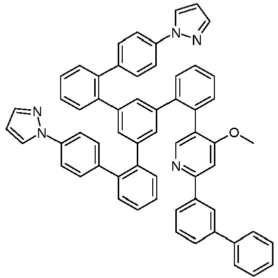 | 80% |
| | S110 | | |
| S183 | S356 | 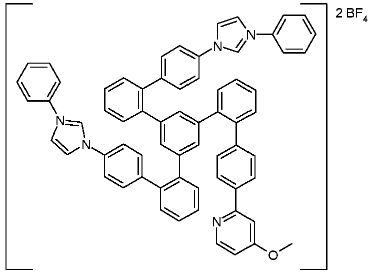 | 67% |
| | S104 | | |
| | | Extraktion der Wasserphase mit DCM | |
| S184 | S357 | 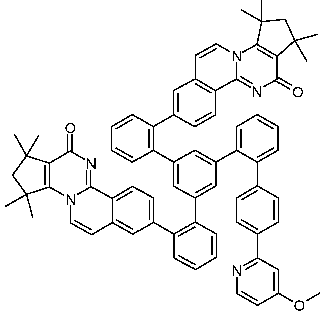 | 81% |
| | S104 | | |

### Beispiel S200:

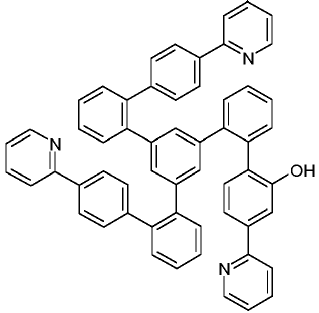

Ein Gemisch aus 79.6 g (100 mmol) S150 und 115.6 g (1 mol) Pyridinium-Hydrochlorid wird am Wasserabscheider 4 h auf 220 °C (Heizschale) erhitzt, wobei das Destillat von Zeit zu Zeit abgelassen wird. Man lässt die Reaktionsmischung abkühlen, gibt ab ∼150 °C tropfenweise 500 ml Wasser zu (Vorsicht: Siedeverzüge) und rührt über Nacht nach. Man saugt vom beigen Feststoff ab, suspendiert diesen in 700 ml MeOH, stellt unter Rühren durch Zugabe von Triethylamin neutral, rührt weitere 5 h nach und gibt gegebenenfalls erneut Triethylamin bis zur neutralen Reaktion zu. Man saugt von Feststoff ab, wäscht diesen dreimal mit je 100 ml MeOH und trocknet im Vakuum. Ausbeute: 74.3 g (95 mmol), 95 %; Reinheit: ca. 95 %ig n. ¹H-NMR.

Analog können folgende Verbindungen dargestellt werden.

| Bsp. | Edukte | Produkt | Ausbeute |
|---|---|---|---|
| S201 | S151 | 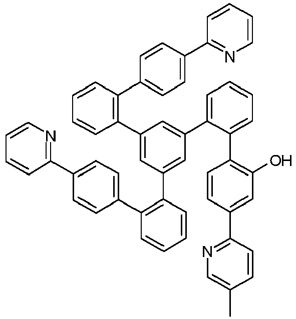 | 90% |
| S202 | S152 | 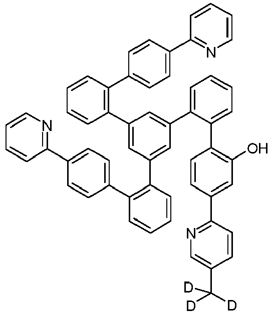 | 92% |
| S203 | S153 | 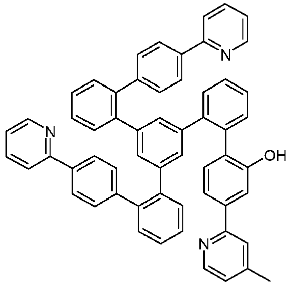 | 94% |
| S204 | S154 | 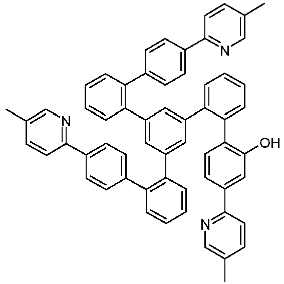 | 90% |
| S205 | S155 | 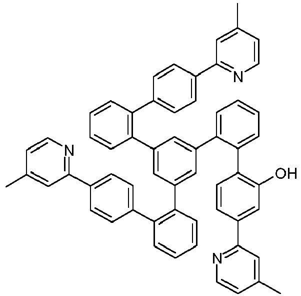 | 94% |
| S206 | S156 | 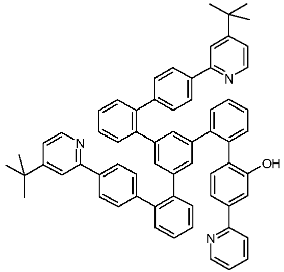 | 90% |
| S207 | S157 | 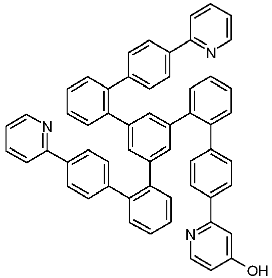 | 95% |
| S208 | S158 | 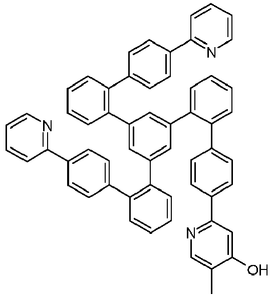 | 95% |
| S209 | S159 | 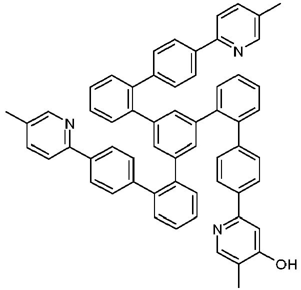 | 95% |
| S210 | S160 | 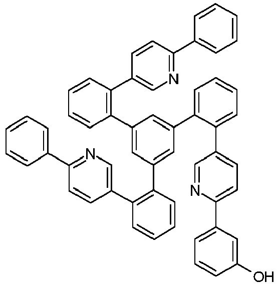 | 90% |
| S211 | S161 | 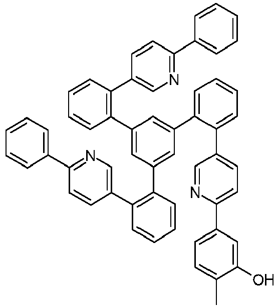 | 90% |
| S212 | S162 | 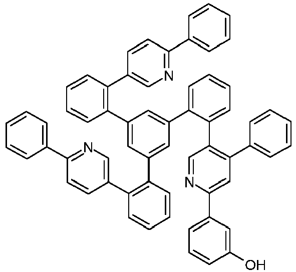 | 89% |
| S213 | S163 | 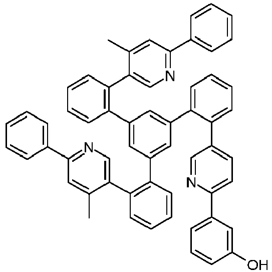 | 90% |
| S214 | S164 | 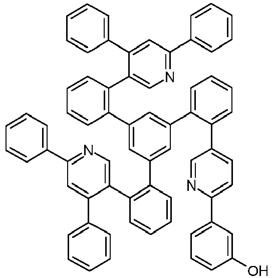 | 93% |
| S215 | S165 | 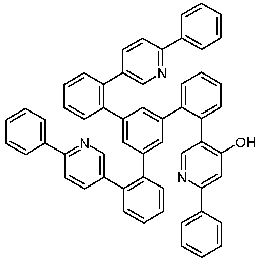 | 90% |
| S216 | S166 | 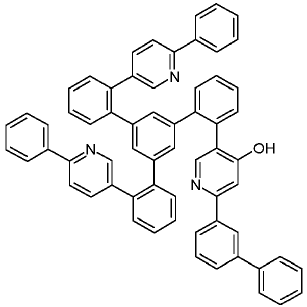 | 91% |
| S217 | S167 | 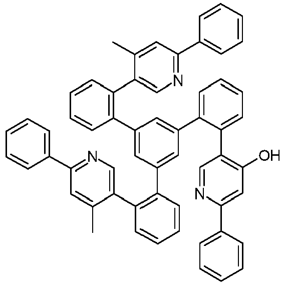 | 95% |
| S218 | S168 | 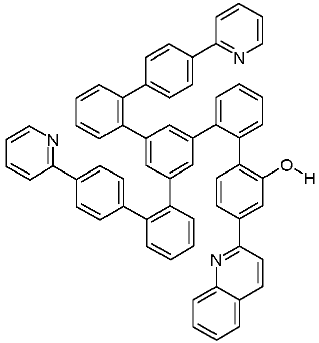 | 92% |
| S219 | S169 | 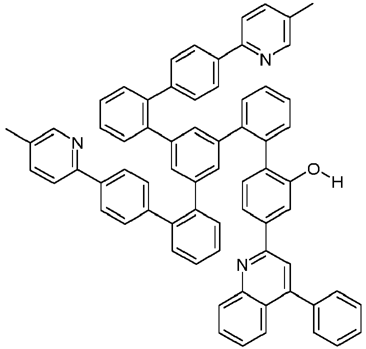 | 95% |
| S220 | S170 | 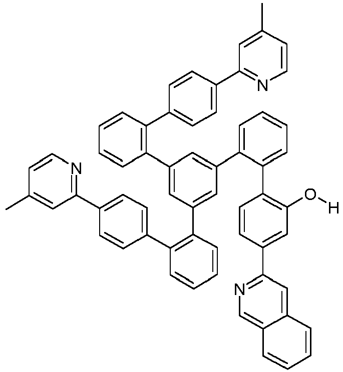 | 92% |
| S221 | S171 | 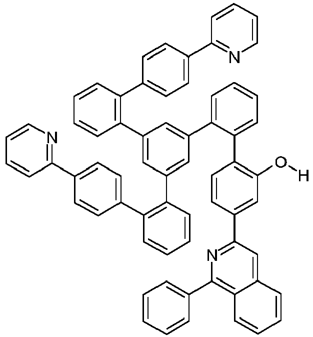 | 95% |
| S222 | S172 | 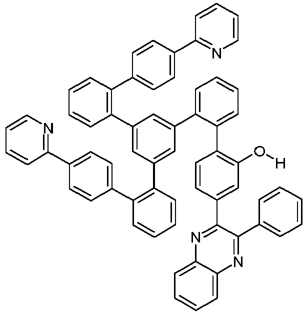 | 93% |
| S223 | S173 | 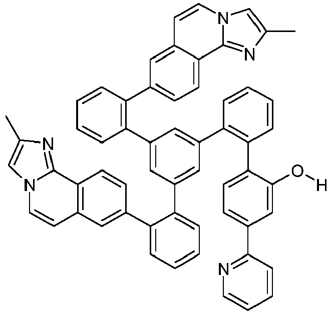 | 90% |
| S224 | S174 | 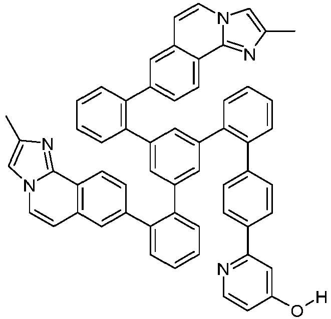 | 90% |
| S225 | S175 | 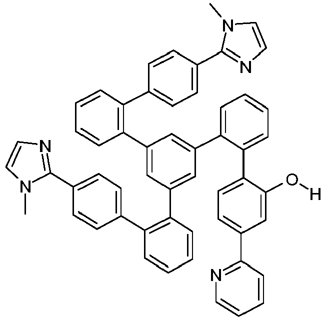 | 92% |
| S226 | S176 | 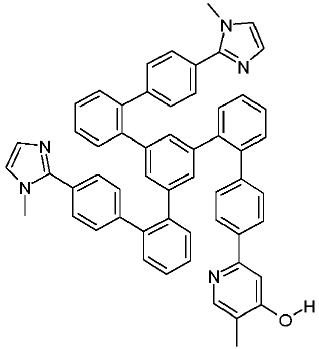 | 89% |
| S227 | S177 | 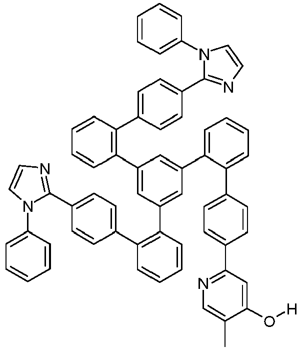 | 90% |
| S228 | S178 | 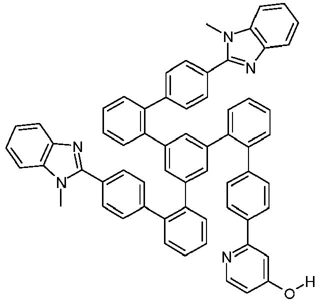 | 93% |
| S229 | S179 | 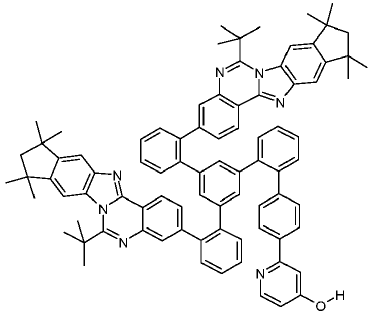 | 91% |
| S230 | S180 | 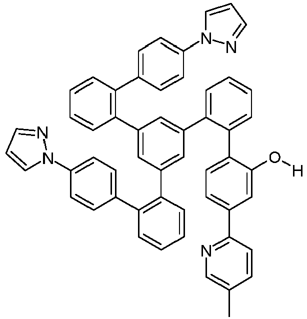 | 90$ |
| S231 | S181 | 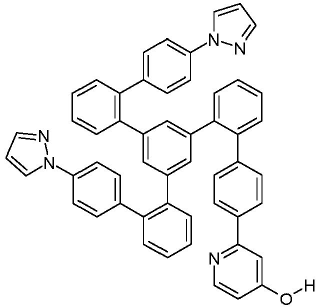 | 95% |
| S232 | S182 | 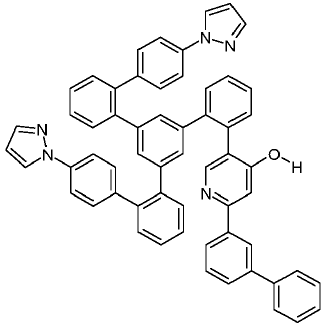 | 93% |
| S233 | S183 | 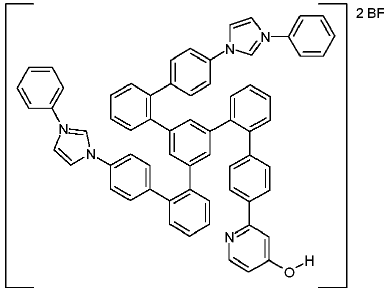 | 62% |
| S234 | S184 | 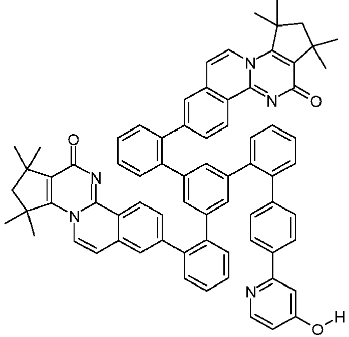 | 90% |

### Beispiel S250:

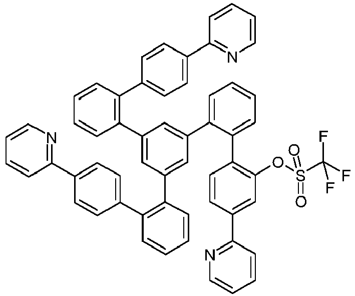

Eine Suspension von 78.2 g (100 mmol) S200 in 1000 ml DCM wird unter Eiskühlung bei 0 °C und gutem Rühren mit 23.7 ml (300 mmol) Pyridin und dann tropfenweise mit 33.6 ml (200 mmol) Trifluormethansulfonsäureanhydrid versetzt. Man rührt 1 h bei 0 °C und dann 4 h bei Raumtemperatur nach. Man gießt die Reaktionslösung auf 3 I Eiswasser, rührt 15 min. nach, trennt die org. Phase ab, wäscht diese einmal mit 300 ml Eiswasser und einmal mit 300 ml ges. Kochsalzlösung, trocknet über Magnesiumsulfat, filtriert vom Trockenmittel ab, engt das Filtrat zur Trockene und kristallisiert den Schaum aus Ethylacetat in der Siedehitze um. Ausbeute: 68.6 g (75 mmol), 75 %; Reinheit: ca. 95 %ig n. ¹H-NMR.

Analog können folgende Verbindungen dargestellt werden.

| Bsp. | Edukt | Produkt | Ausbeute |
|---|---|---|---|
| S251 | S201 | 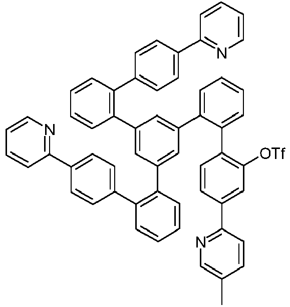 | 79% |
| S252 | S202 | 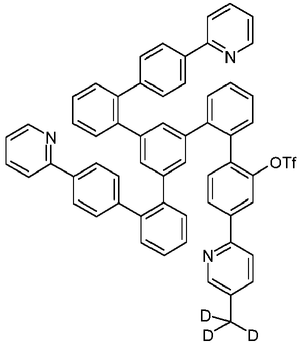 | 75% |
| S253 | S203 | 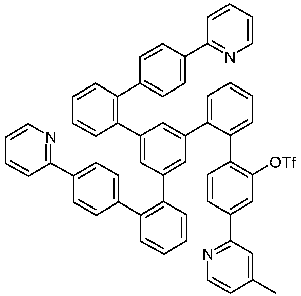 | 77% |
| S254 | S204 | 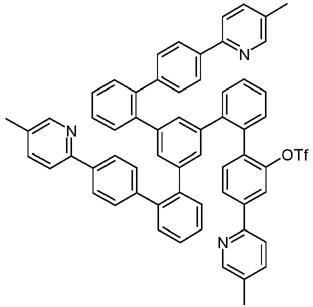 | 70% |
| S255 | S205 | 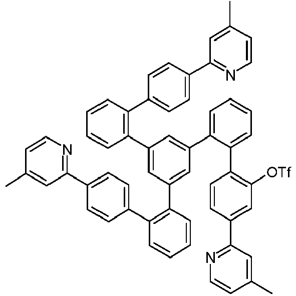 | 68% |
| S256 | S206 | 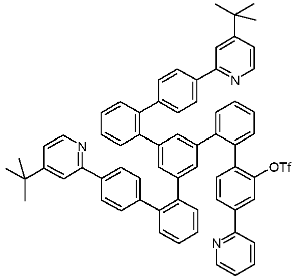 | 73% |
| S257 | S207 | 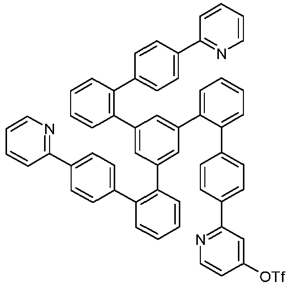 | 80% |
| S258 | S208 | 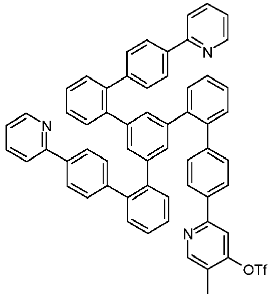 | 77% |
| S259 | S209 | 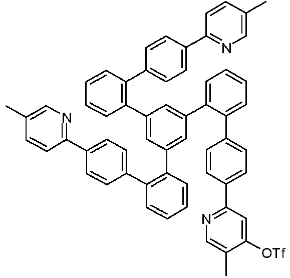 | 76% |
| S260 | S210 | 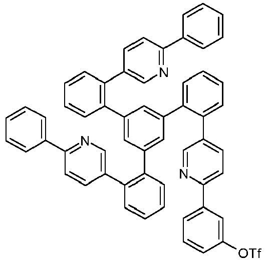 | 91% |
| S261 | S211 | 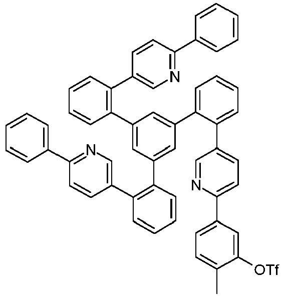 | 84% |
| S262 | S212 | 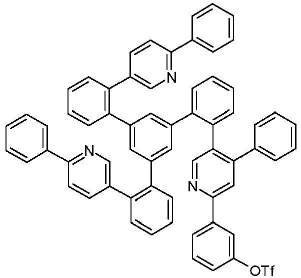 | 86% |
| S263 | S213 | 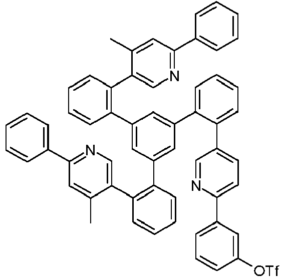 | 80% |
| S264 | S214 | 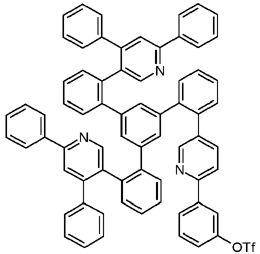 | 81% |
| S265 | S215 | 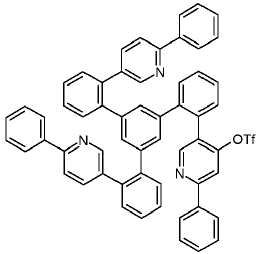 | 79% |
| S266 | S216 | 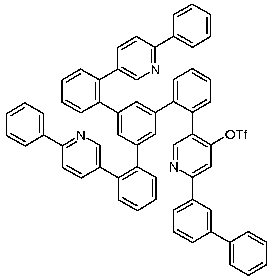 | 76% |
| S267 | S217 | 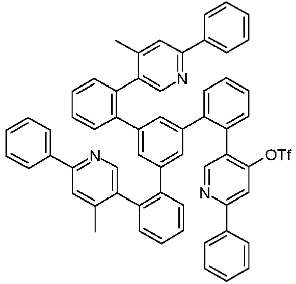 | 78% |
| S268 | S218 | 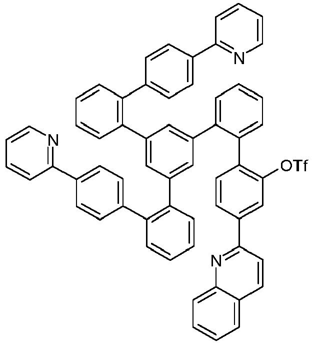 | 76% |
| S269 | S219 | 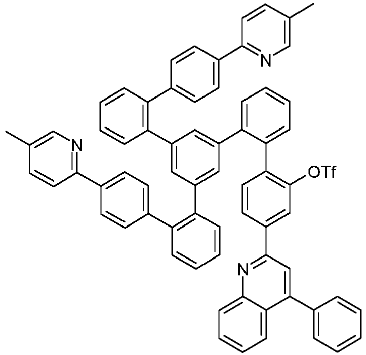 | 79% |
| S270 | S220 | 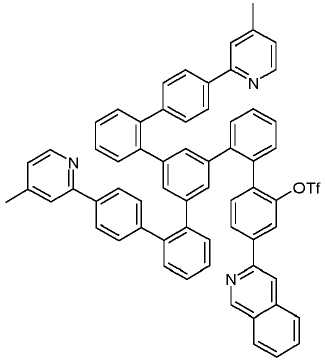 | 82% |
| S271 | S221 | 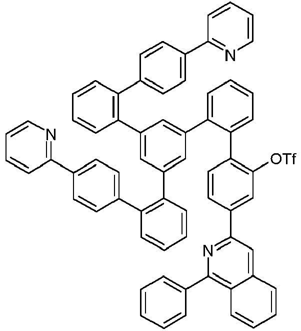 | 85% |
| S272 | S222 | 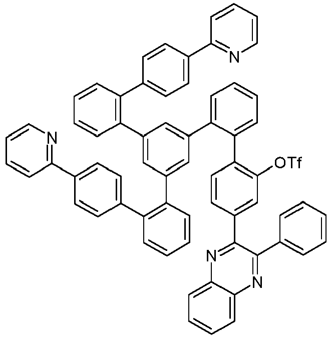 | 80% |
| S273 | S223 | 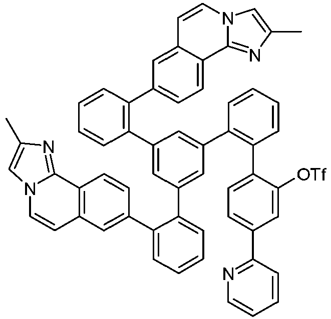 | 85% |
| S274 | S224 | 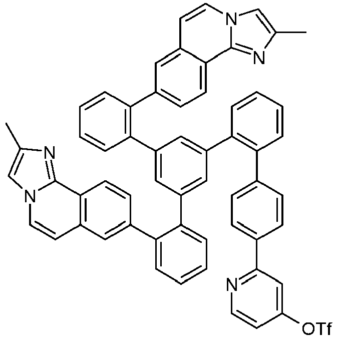 | 80% |
| S275 | S225 | 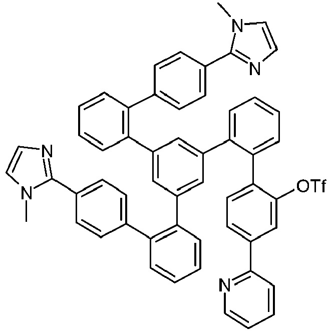 | 78% |
| S276 | S226 | 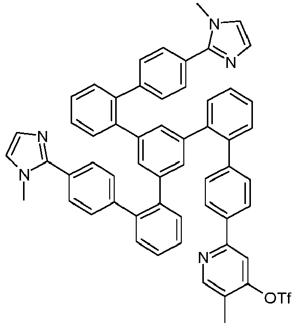 | 84% |
| S277 | S227 | 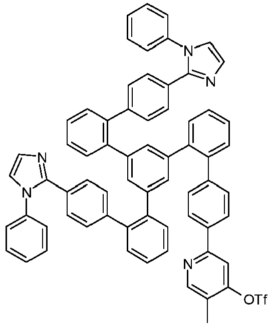 | 79% |
| S278 | S228 | 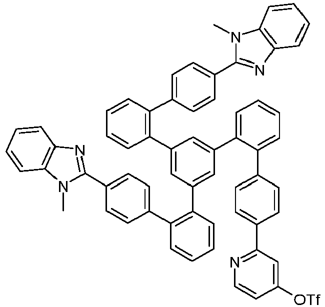 | 83% |
| S279 | S229 | 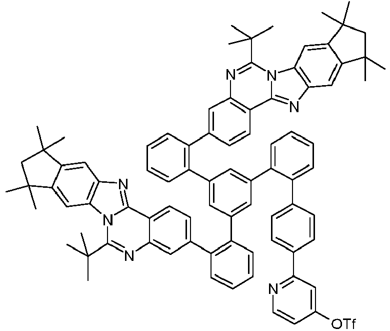 | 75% |
| S280 | S230 | 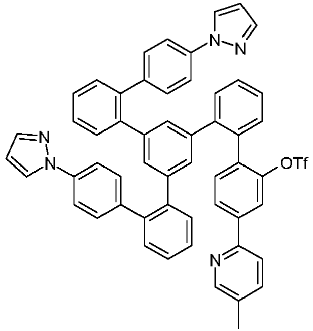 | 80% |
| S281 | S231 | 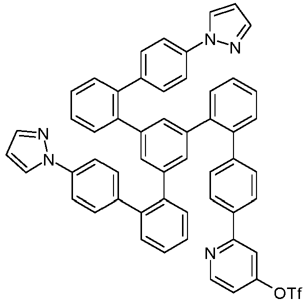 | 88% |
| S282 | S232 | 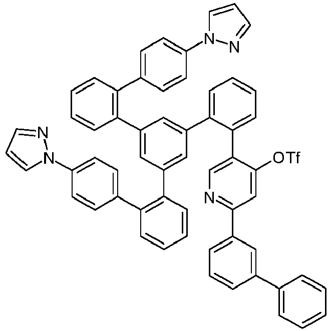 | 79% |
| S283 | S233 | 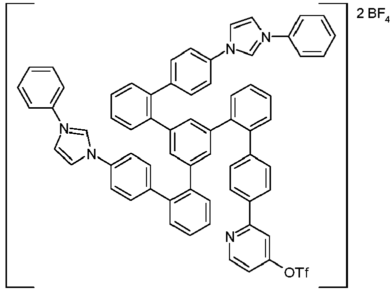 | 80% |
| S284 | S234 | 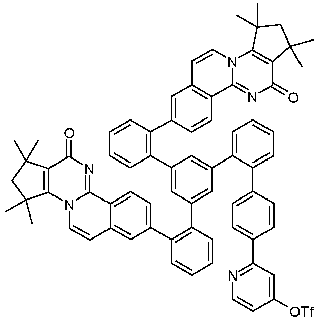 | 82% |

### Beispiel S300:

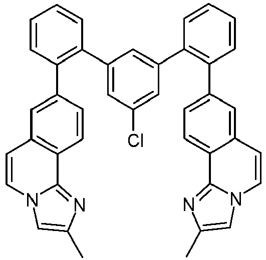

Ein gut gerührtes Gemisch aus 67.4 g (200 mmol) S116, 36.5 g (100 mmol) 2,2'-(5-Chlor-1,3-phenylen)bis[4,4,5,5-tetramethyl-1,3,2-dioxaborolan [1417036-49-7], 63.6 g (600 mmol) Natriumcarbonat, 500 ml Toluol, 250 ml Ethanol und 500 ml Wasser wird mit 1.57 g (6 mmol) Triphenylphosphin und dann mit 449 mg (2 mmol) Palladiumacetat versetzt und 24 h unter Rückfluss erhitzt. Nach Erkalten trennt man die org. Phase ab, wäscht diese zweimal mit je 300 ml Wasser und einmal mit 300 ml ges. Kochsalzlösung und trocknet über Magnesiumsulfat. Man filtriert vom Trockenmittel ab, engt das Filtrat im Vakuum zur Trockene ein und kristallisiert das glasartige Rohprodukt in der Siedehitze aus Acetonitril (ca. 150 ml) unter Zusatz von Ethylacetat (ca. 20 ml) um. Ausbeute: 55.0 g (88 mmol), 88 %; Reinheit: ca. 95 %ig n. ¹H-NMR.

Analog können folgende Verbindungen dargestellt werden:

| Bsp. | Edukt | Produkt | Ausbeute |
|---|---|---|---|
| S301 | S117 | 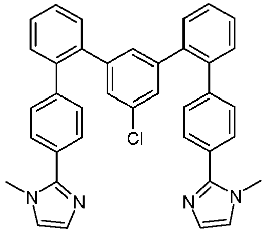 | 83% |
| S302 | S118 | 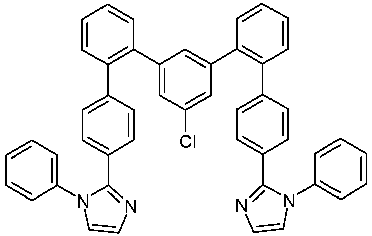 | 83% |
| S303 | S119 | 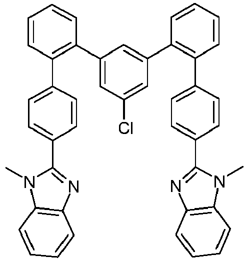 | 85% |
| S304 | S120 | 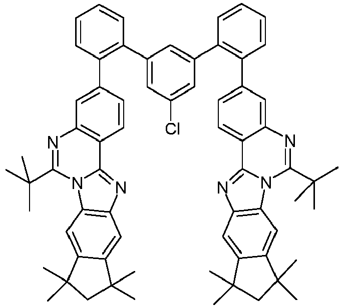 | 89% |
| S305 | S121 | 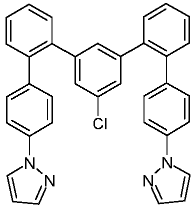 | 88% |
| S306 | S122 | 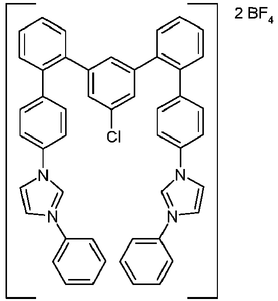 Extraktion der Wasserphase mit Dichlormethan | 60% |
| S307 | S123 | 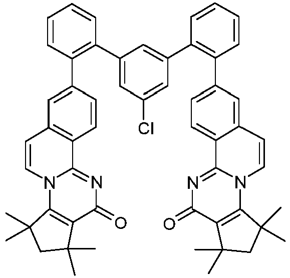 | 86% |

### Beispiel S350:

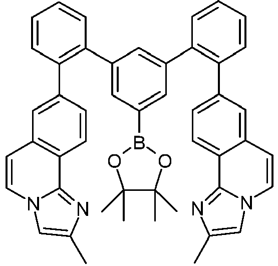

Darstellung analog zu Beispiel S50, Variante A. Einsatz von 62.5 g (100 mmol) S300. Ausbeute: 64.5 g (90 mmol) 90%; Reinheit: ca. 95 %ig n. ¹H-NMR.

Analog können folgende Verbindungen dargestellt werden:

| Bsp. | Edukt | Produkt | Ausbeute |
|---|---|---|---|
| S351 | S301 | 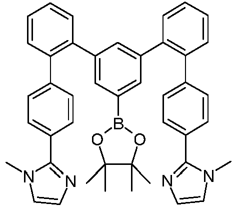 | 87% |
| S352 | S302 | 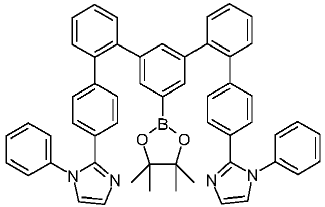 | 84% |
| S353 | S303 | 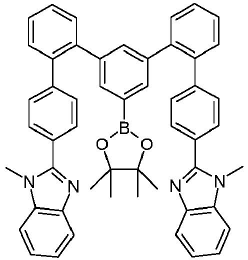 | 86% |
| S354 | S304 | 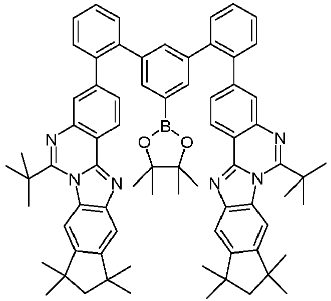 | 89% |
| S355 | S305 | 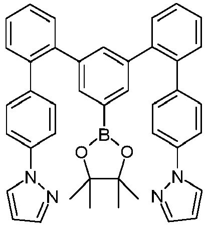 | 86% |
| S356 | S306 | 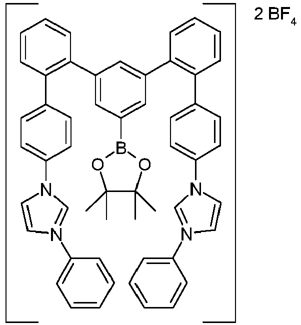 | 56% |
| S357 | S307 | 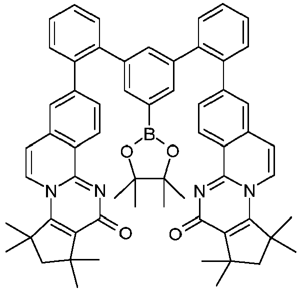 | 90% |

### B: Synthese der Liganden L:

### Beispiel L1:

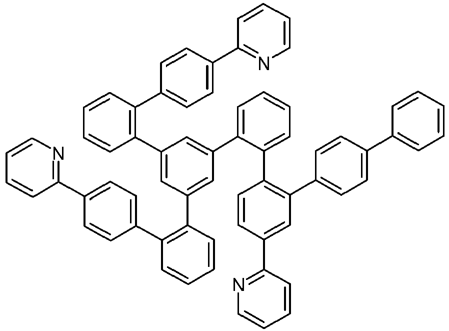

Ein Gemisch aus 91.4 g (100 mmol) S250, 30.6 g (110 mmol) 2-[1,1'-Biphenyl]-4-yl-4,4,5,5-tetramethyl-1,3,2-dioxaborolan [144432-80-4], 53.1 g (250 mmol) Trikaliumphosphat, 800 ml THF und 200 ml Wasser wird unter kräftigem Rühren mit 1.64 g (4 mmol) SPhos und dann mit 449 mg (2 mmol) Palladium(II)acetat versetzt und 16 h unter Rückfluss erhitzt. Nach Erkalten trennt man die wässrige Phase ab, engt die org. Phase weitgehend ein, nimmt den Rückstand in 500 ml Ethylacetat auf, wäscht die org. Phase zweimal mit je 300 ml Wasser, einmal mit 2%iger, wässriger N-Acetylcystein-Lösung und einmal mit 300 ml ges. Kochsalzlösung und trocknet über Magnesiumsulfat. Man filtriert vom Trockenmittel über ein mit Ethylacetat vorgeschlämmtes Kieselgel-Bett ab, wäscht mit Ethylacetat nach, engt das Filtrat zur Trockene ein und kristallisiert den Rückstand aus ca. 200 ml Acetonitril unter Zugabe von ca. 50 ml Ethylacetat in der Siedehitze um. Ausbeute: 70.5 g (77 mmol), 77 %; Reinheit: ca. 97 %ig n. ¹H-NMR.

Analog können folgende Verbindungen dargestellt werden.

| Bsp. | Edukt | Produkt | Ausbeute |
|---|---|---|---|
| L2 | 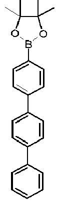 S250 1080632-76-3 | 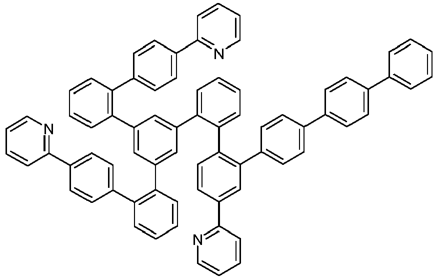 | 75% |
| L6 | 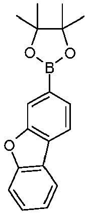 S250 1056113-50-8 | 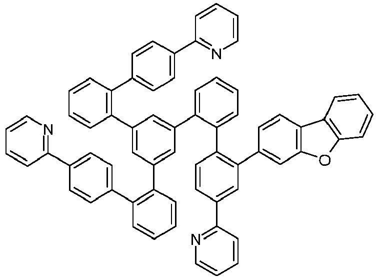 | 83% |
| L7 | 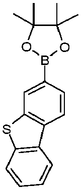 S250 1362691-15-3 | 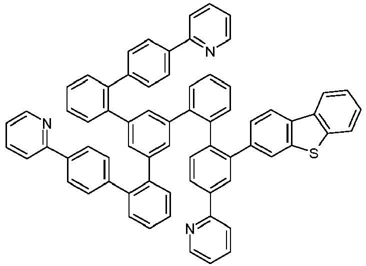 | 85% |
| L8 | 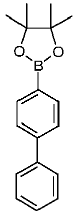 S251 144432-80-4 | 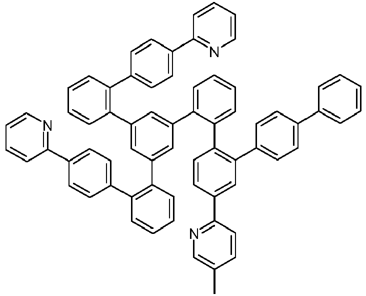 | 80% |
| L9 | 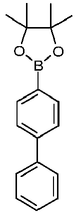 S252 144432-80-4 | 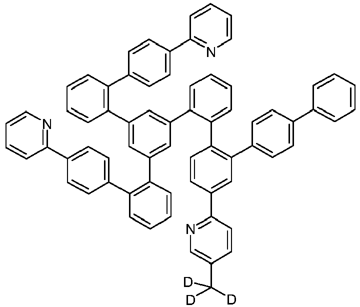 | 74% |
| L11 | 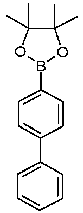 S254 144432-80-4 | 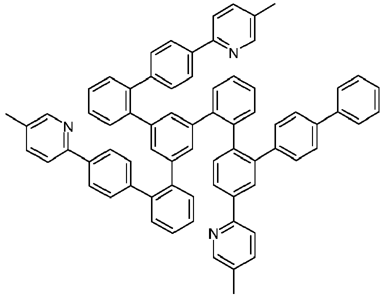 | 77% |
| L12 | 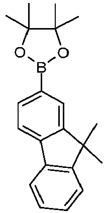 S255 569343-09-5 | 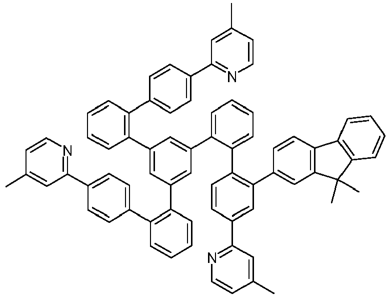 | 80% |
| L13 | 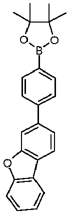 S256 2007912-69-6 | 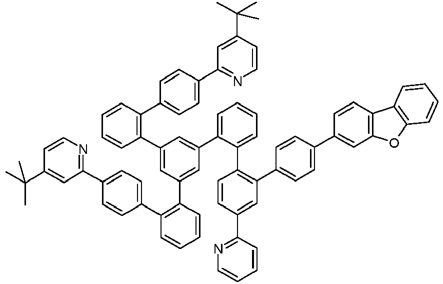 | 70% |
| L14 | 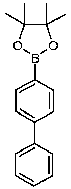 S257 144432-80-4 | 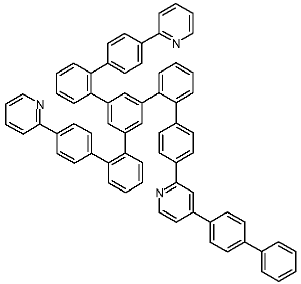 | 88% |
| L16 | 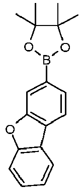 S257 1056113-50-8 | 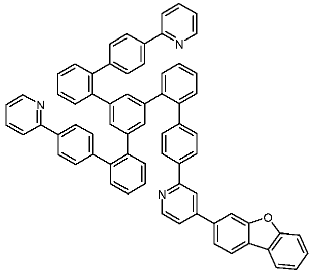 | 80% |
| L17 | 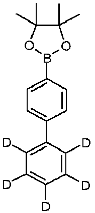 S258 1197180-12-3 | 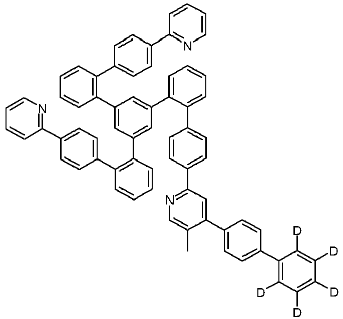 | 76% |
| L18 | 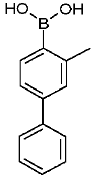 S259 1383628-42-9 | 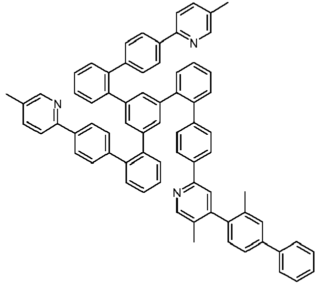 | 74% |
| L19 | 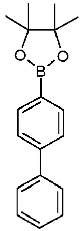 S260 144432-80-4 | 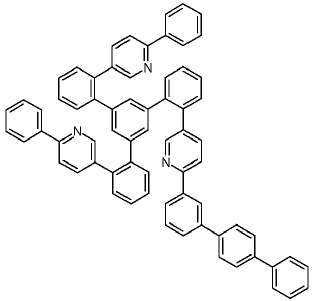 | 84% |
| L20 | 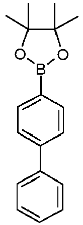 S261 144432-80-4 | 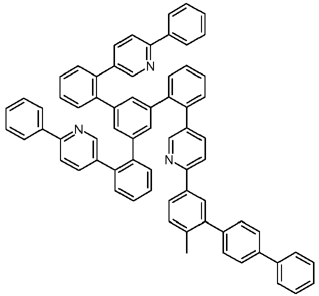 | 79% |
| L21 | 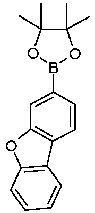 S261 1056113-50-8 | 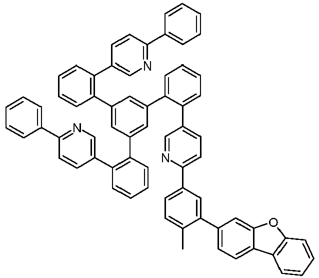 | 78% |
| L22 | 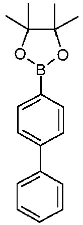 S262 144432-80-4 | 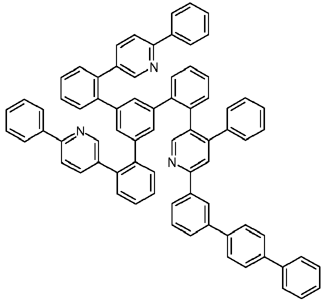 | 83% |
| L23 | 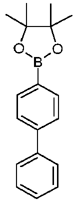 S263 144432-80-4 | 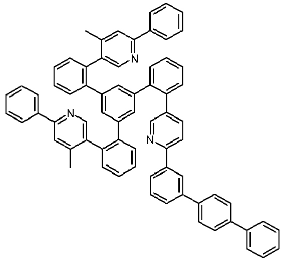 | 85% |
| L24 | 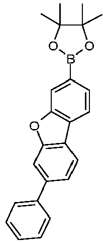 S264 1959608-16-2 | 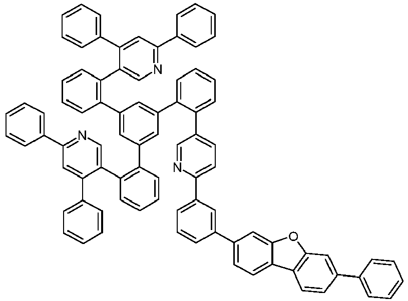 | 79% |
| L25 | 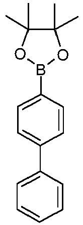 S265 144432-80-4 | 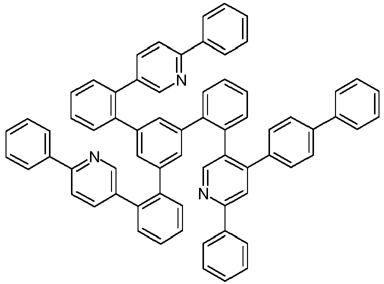 | 75% |
| L27 | 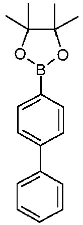 S266 144432-80-4 | 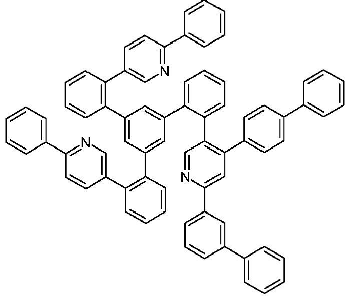 | 76% |
| L28 | 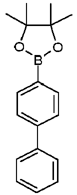 S267 144432-80-4 | 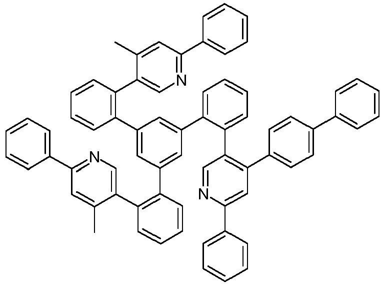 | 75% |
| L29 | 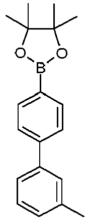 S267 1381960-59-3 | 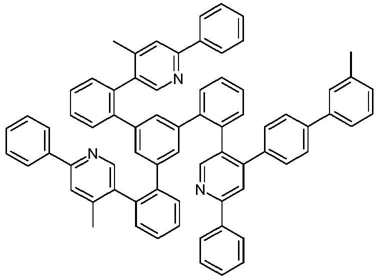 | 77% |
| L35 | 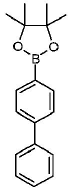 S273 144432-80-4 | 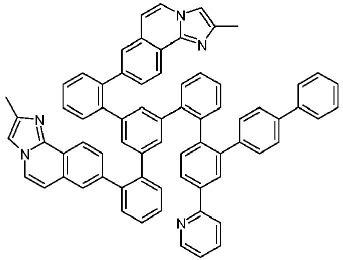 | 70% |
| L36 | 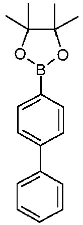 S274 144432-80-4 | 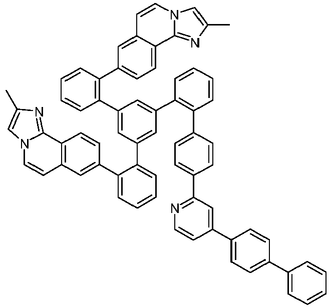 | 74% |
| L37 | 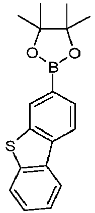 S275 1362691-15-3 | 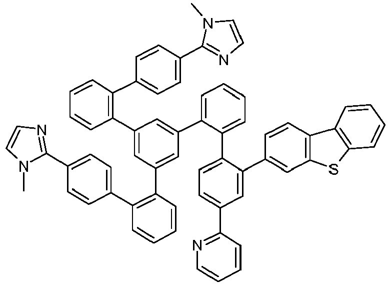 | 76% |
| L38 | 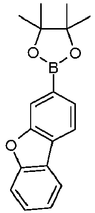 S276 1056113-50-8 | 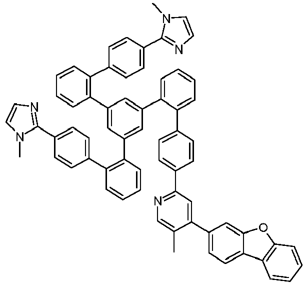 | 71% |
| L39 | 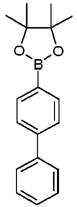 S277 144432-80-4 | 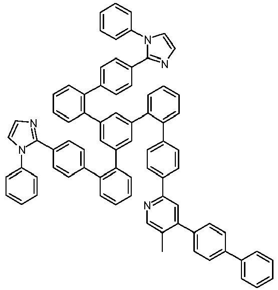 | 68% |
| L40 | 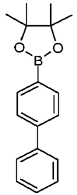 S278 144432-80-4 | 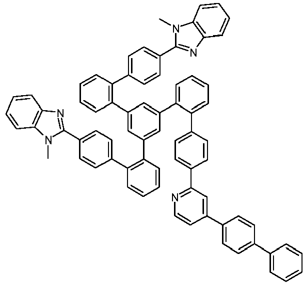 | 70% |
| L41 | 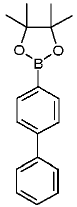 S279 144432-80-4 | 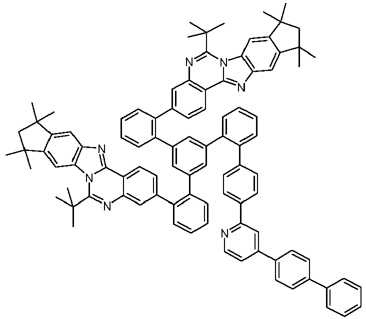 | 74% |
| L42 | 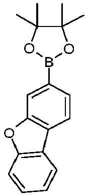 S280 1056113-50-8 | 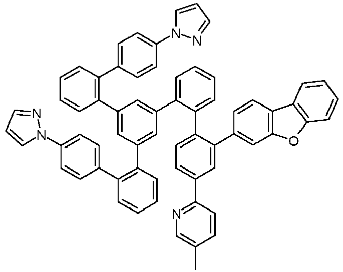 | 77% |
| L43 | 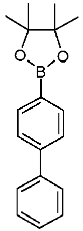 S281 144432-80-4 | 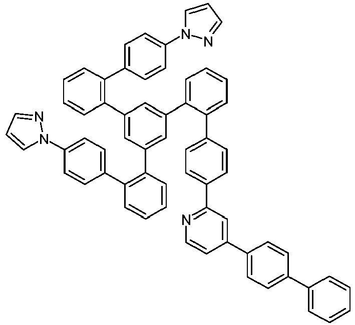 | 76% |
| L44 | 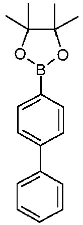 S282 144432-80-4 | 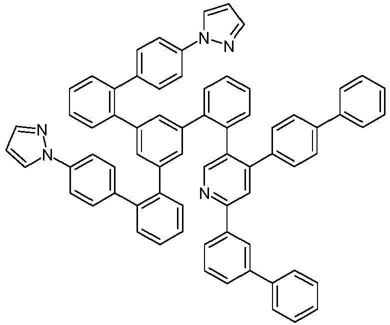 | 75% |
| L45 | 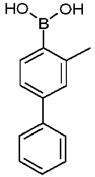 S283 1383628-42-9 | 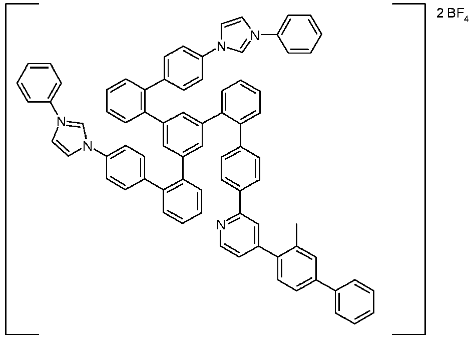 | 57% |
| L46 | 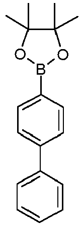 S284 144432-80-4 | 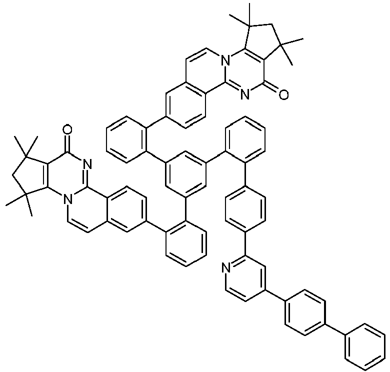 | 72% |

### C: Darstellung der Metallkomplexe

### Beispiel Ir(L1):

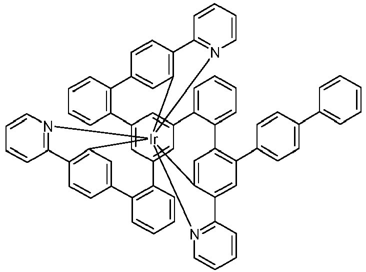

### Variante A:

Ein Gemisch aus 9.18 g (10 mmol) des Liganden L1, 4.90 g (10 mmol) Tris-acetylacetonato-iridium(III) [15635-87-7] und 120 g Hydrochinon [123-31-9] werden in einem 1000 mL Zweihalsrundkolben mit einem glasummantelten Magnetkern vorgelegt. Der Kolben wird mit einem Wasserabscheider (für Medien geringerer Dichte als Wasser) und einem Luftkühler mit Argonüberlagerung versehen. Der Kolben wird in einer Metallheizschale platziert und die Apparatur über die Argonüberlagerung von oben her 15 min. mit Argon gespült, wobei man das Argon aus dem Seitenhals des Zweihalskolbens ausströmen lässt. Über den Seitenhals des Zweihalskolbens führt man ein glasummanteltes Pt-100 Thermoelement in den Kolben ein und platziert das Ende kurz oberhalb des Magnetrührkerns. Die Apparatur wird mit mehreren lockeren Wicklungen von Haushaltsaluminiumfolie thermisch isoliert, wobei die Isolation bis zur Mitte des Steigrohres des Wasserabscheiders geführt wird. Dann wird die Apparatur schnell mit einem Laborheizrührwerk auf 250-255 °C, gemessen am Pt-100 Thermofühler, der in die aufgeschmolzene, gerührte Reaktionsmischung eintaucht, erhitzt. Während der nächsten 1 h wird das Reaktionsgemisch bei 250-255 °C gehalten, wobei wenig Kondensat abdestilliert und sich im Wasserabscheider sammelt. Nach 1 h lässt man auf 190 °C abkühlen, entfernt die Heizschale und tropft dann 100 ml Ethylenglycol zu. Nach Erkalten auf 100 °C tropft man langsam 400 ml Methanol zu. Die so erhaltene beige Suspension wird über eine Umkehrfritte filtriert. Der beige Feststoff wird dreimal mit 50 ml Methanol gewaschen und dann im Vakuum getrocknet (Rohausbeute: quantitativ). Der so erhaltene Feststoff wird in 200 ml Dichlormethan gelöst und über ca. 1 kg mit Dichlormethan vorgeschlämmtes Kieselgel (Säulendurchmesser ca. 18 cm) unter Luft- und Lichtausschluss filtriert, wobei dunkle Anteile am Start liegen bleiben. Die Kernfraktion wird herausgeschnitten und am Rotationsverdampfer eingeengt, wobei gleichzeitig kontinuierlich MeOH bis zur Kristallisation zugetropft wird. Nach Absaugen, Waschen mit wenig MeOH und Trocknen im Vakuum erfolgt die weitere Reinigung des orangenfarbenen Produkts durch viermalige kontinuierliche Heißextraktion mit Dichlormethan/iso-Propanol 1:1 (vv) und dann viermalige Heißextraktion mit Dichlormethan/Acetonitril (Vorlagemenge jeweils ca. 200 ml, Extraktionshülse: Standard Soxhletthülsen aus Cellulose der Fa. Whatman) unter sorgfältigem Luft- und Lichtausschluss. Über das Verhältnis Dichlormethan (Niedersieder und Gutlöser) : iso-Propanol bzw. Acetonitril (Hochsieder und Schlechtlöser) kann der Verlust in die Mutterlauge eingestellt werden. Typischerweise sollte er 3-6 Gew.-% der eingesetzten Menge betragen. Es können zur Heißextration auch andere Lösungsmittel wie Toluol, Xylol, Essigester, Butylacetat, etc. verwendet werden. Abschließend wird das Produkt im Hochvakuum bei p ∼ 10⁻⁶ mbar und T ∼ 400 - 450 °C fraktioniert sublimiert. Ausbeute: 6.65 g (6.0 mmol), 60 %; Reinheit: > 99.9 %ig nach HPLC.

### Variante B:

Durchführung analog Ir(L1) Variante A, jedoch werden statt 120 g Hydrochinon 300 ml Ethylenglycol [111-46-6] verwendet, und es wird 16 h bei 190 °C gerührt. Nach Erkalten auf 70 °C wird mit 300 ml Ethanol verdünnt, der Feststoff wird abgesaugt (P3), dreimal mit je 100 ml Ethanol gewaschen und dann im Vakuum getrocknet. Die weitere Reinigung erfolgt wie unter Variante A beschrieben. Ausbeute: 6.32 g (5.7 mmol), 57 %; Reinheit: > 99.9 %ig nach HPLC.

### Variante C:

Durchführung analog Ir(L1) Variante B, jedoch werden statt 4.90 g (10 mmol) Tris-acetylacetonato-iridium(III) [15635-87-7] 3.53 g (10 mmol) Iridium(III)chlorid x n H₂O (n ca. 3) und statt 120 g Hydrochinon 300 ml 2-Ethoxyethanol/Wasser (3:1, vv) verwendet, und es wird 30 h im Rührautoklaven bei 190 °C gerührt. Nach Erkalten wird der Feststoff abgesaugt (P3), dreimal mit je 30 ml Ethanol gewaschen und dann im Vakuum getrocknet. Die weitere Reinigung erfolgt wie unter Variante B beschrieben. Ausbeute: 6.01 g (5.5 mmol), 55 %; Reinheit: > 99.9 %ig nach HPLC.

Die Metallkomplexe fallen üblicherweise als 1:1 Mischung der A- und Δ-Isomere/Enantiomere an. Die im Folgenden aufgeführten Abbildungen der Komplexen zeigen üblicherweise nur ein Isomer. Werden Liganden mit drei verschiedenen Teilliganden eingesetzt, bzw. werden chirale Liganden als Racemat eingesetzt, fallen die abgeleiteten Metallkomplexe als Diastereomerenmischung an. Diese können durch fraktionierte Kristallisation oder chromatographisch getrennt werden, z. B. mit einem Säulenautomaten (CombiFlash der Fa. A. Semrau). Werden chirale Liganden enantiomerenrein eingesetzt, fallen die abgeleiteten Metallkomplexe als Diastereomerenmischung an, deren Trennung durch fraktionierte Kristallisation oder Chromatographie zu reinen Enantiomeren führt. Die getrennten Diastereomeren bzw. Enantiomeren können wie oben beschrieben z. B. durch Heißextraktion weiter gereinigt werden.

Analog können folgende Verbindungen dargestellt werden:

| Bsp. | Ligand | Produkt | Ausbeute |
|---|---|---|---|
| | | Variante / Extraktionsmittel* | |
| Ir(L2) | L2 | 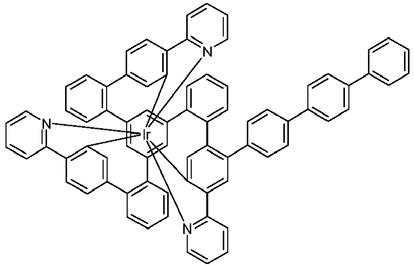 | 65% |
| Ir(L6) | L6 | 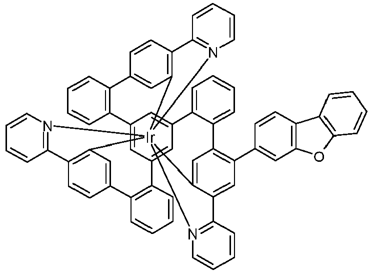 B / DCM/i-Pr 1:1 dann Toluol | 60% |
| Ir(L7) | L7 | 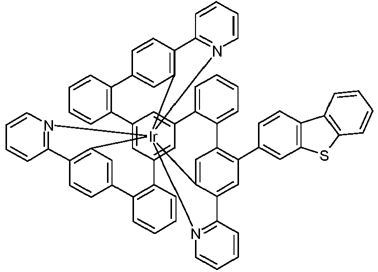 | 61% |
| Ir(L8) | L8 | 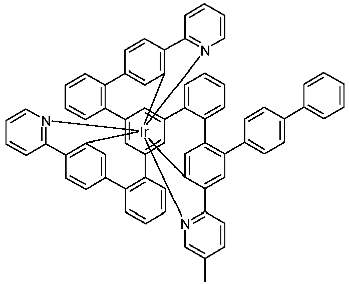 | 65% |
| Ir(L9) | L9 | 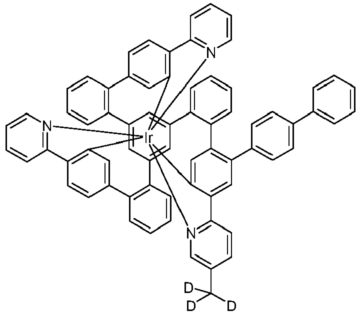 | 59% |
| Ir(L11) | L11 | 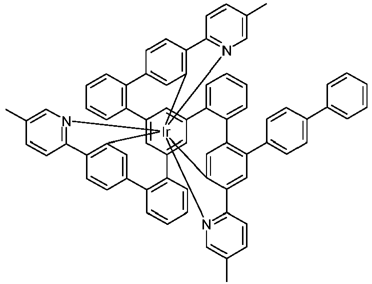 | 62% |
| Ir(L12) | L12 | 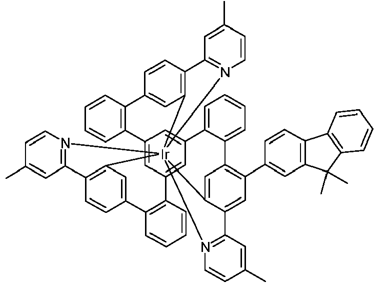 | 60% |
| Ir(L13) | L13 | 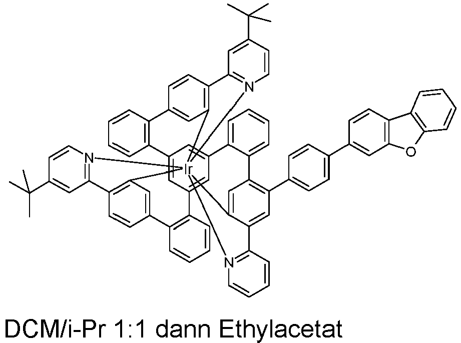 | 58% |
| Ir(L14) | L14 | 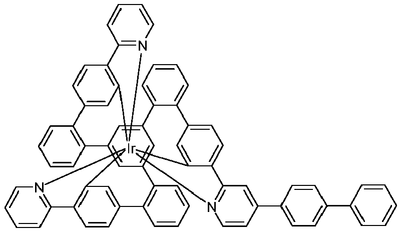 | 64% |
| Ir(L16) | L16 | 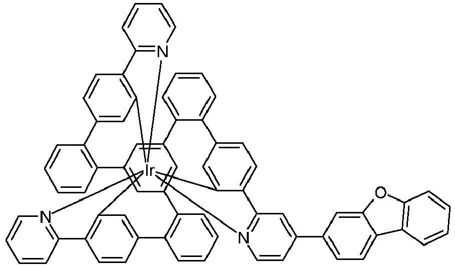 | 63% |
| Ir(L17) | L17 | 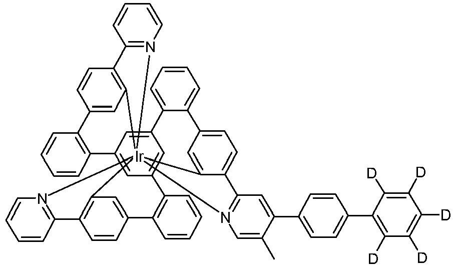 | 64% |
| Ir(L18) | L18 | 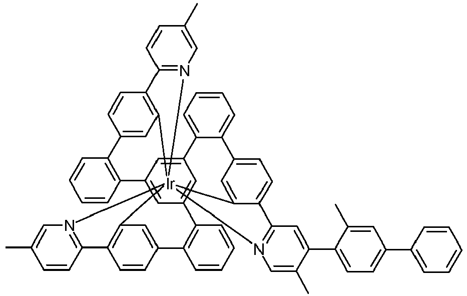 | 61% |
| Ir(L19) | L19 | 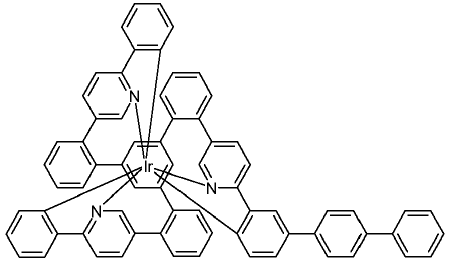 | 70% |
| Ir(L20) | L20 | 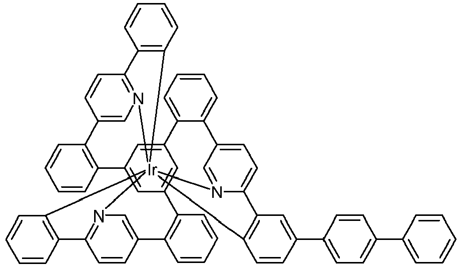 | 67% |
| Ir(L21) | L21 | 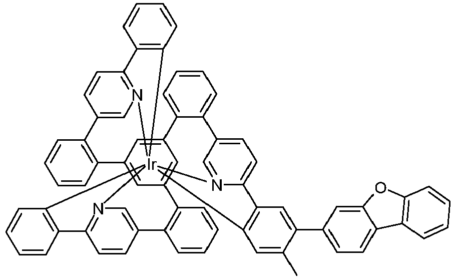 | 64% |
| Ir(L22) | L22 | 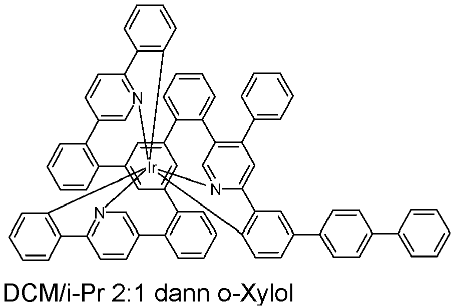 | 71% |
| Ir(L23) | L23 | 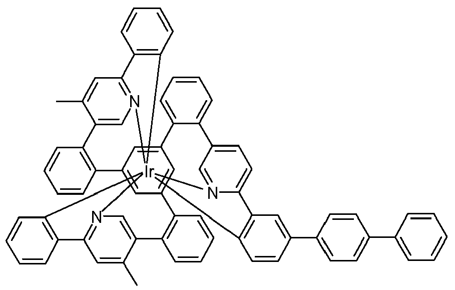 | 63% |
| Ir(L24) | L24 | 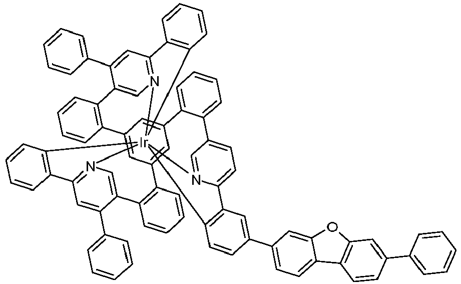 | 60% |
| Ir(L25) | L25 | 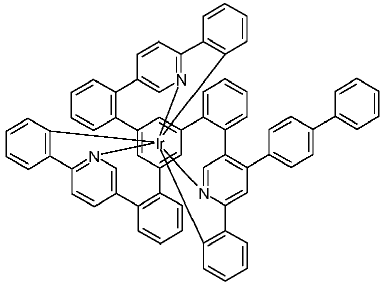 | 65% |
| Ir(L27) | L27 | 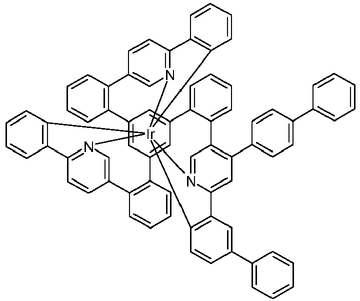 | 68% |
| Ir(L28) | L28 | 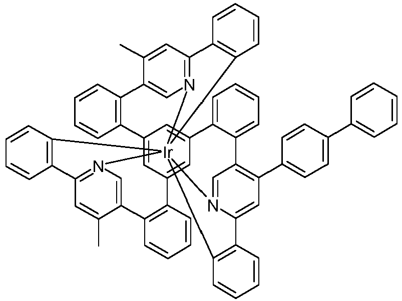 | 62% |
| Ir(L29) | L29 | 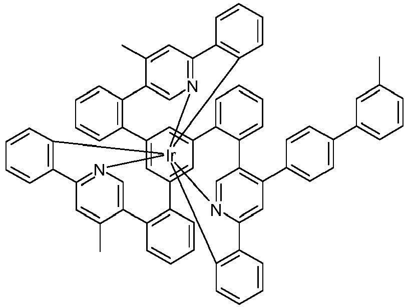 | 64% |
| Ir(L35) | L35 | 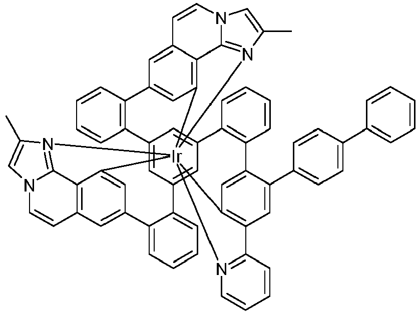 | 69% |
| Ir(L36) | L36 | 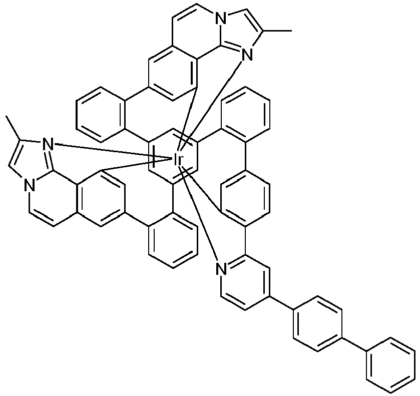 | 67% |
| Ir(L37) | L37 | 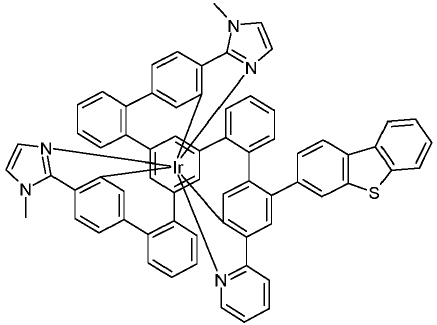 | 63% |
| Ir(L38) | L38 | 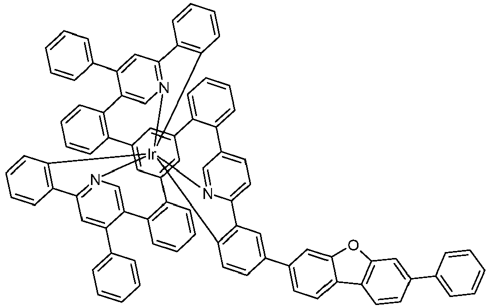 | 68% |
| Ir(L39) | L39 | 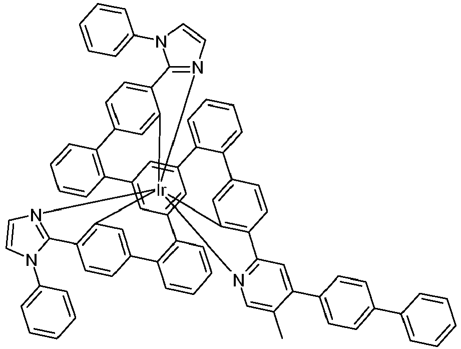 | 64% |
| Ir(L40) | L40 | 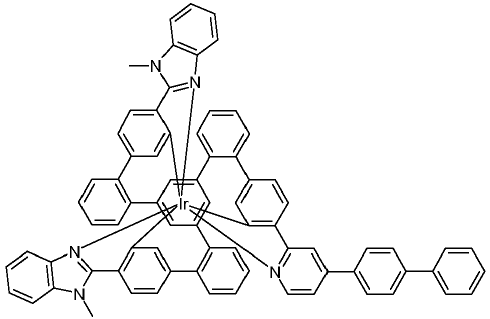 | 65% |
| Ir(L41) | L41 | 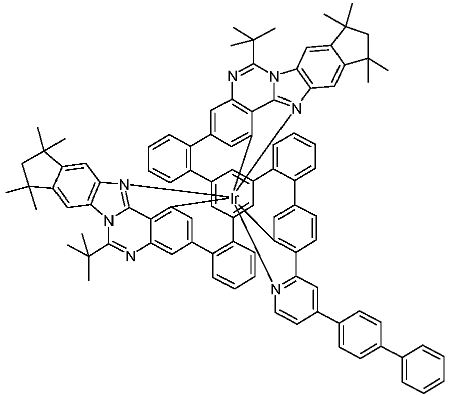 | 67% |
| Ir(L42) | L42 | 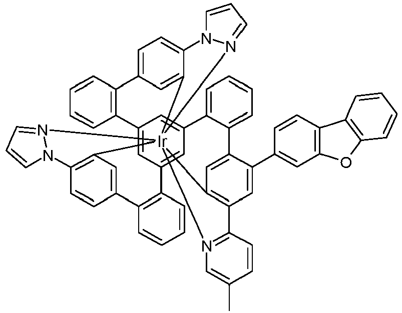 | 70% |
| Ir(L43) | L43 | 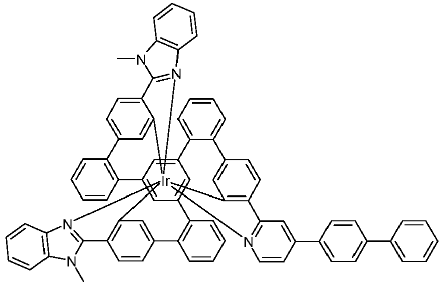 | 68% |
| Ir(L44) | L44 | 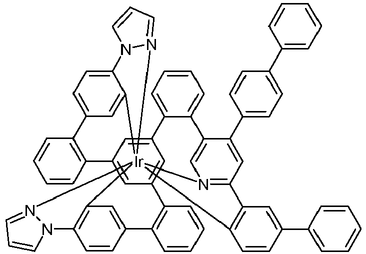 | 66% |
| Ir(L45) | L45 | 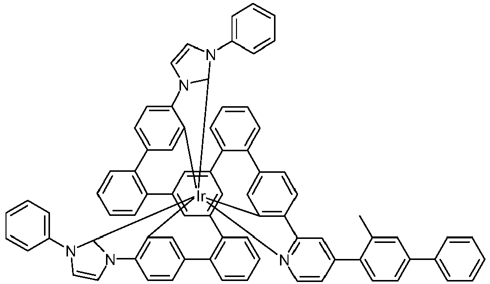 Zugabe von 25 mmol NaO-t-Bu zur Reaktionsmischung | 46% |
| Ir(L46) | L46 | 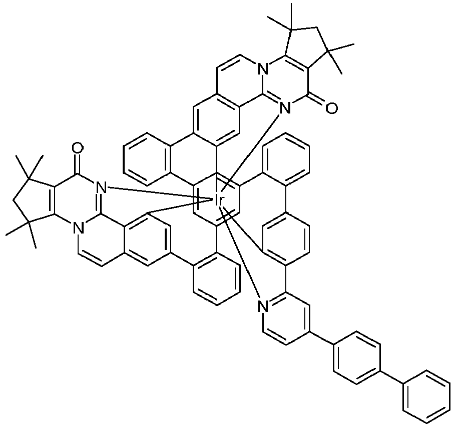 | 65% |

| | | | |
|---|---|---|---|
| * sofern abweichend von Standarddurchführung | | | |

### D: Funktionalisierung der Metallkomplexe

### 1) Deuterierung von Metallkomplexen

### A) Deuterierung der Methylgruppen

Eine Suspension von 1 mmol des sauberen Komplexes (Reinheit > 99.9 %) mit x Methylgruppen (x = 1, 2, 3) in einem Gemisch aus 50 ml DMSO-d6 (Deuterierungsgrad > 99.8 %) und 5 ml Methanol-d1 (Deuterierungsgrad > 99.8 %) wird mit 0.2 mmol Natriumhydrid versetzt und dann unter Rühren erhitzt (ca. 100 °C), bis eine klare gelb-orange Lösung entstanden ist. Man rührt weitere 5 min. für Komplexe mit Methylgruppen para zum Pyridin-Stickstoff bzw. weitere 30 min. für Komplexe mit Methylgruppen meta zum Pyridin-Stickstoff nach, kühlt mit Hilfe eines Kaltwasserbades ab, versetzt tropfenweise ab ca. 60 °C mit 5 ml 1N DCl in D₂O, rührt 1 h nach, saugt vom Feststoff ab und wäscht diesen dreimal mit je 10 ml H₂O/MeOH (1:1, vv) und dann dreimal mit je 10 ml MeOH und trocknet im Vakuum. Der Feststoff wird mit DCM über Kieselgel filtriert. Das Filtrat wird im Vakuum eingeengt, gleichzeitig tropfenweise mit MeOH versetzt und dadurch zur Kristallisation gebracht. Abschließend wird fraktioniert sublimiert, wie unter "C: Darstellung der Metallkomplexe, Variante A" beschrieben. Ausbeute typischerweise 80-90%, Deuterierungsgrad > 95 %.

Auf die oben beschriebene Weise können folgende deuterierte Komplexe dargestellt werden:

| Bsp. | Edukt | Produkt | Ausbeute |
|---|---|---|---|
| Ir(L11-D9) | Ir(L11) | 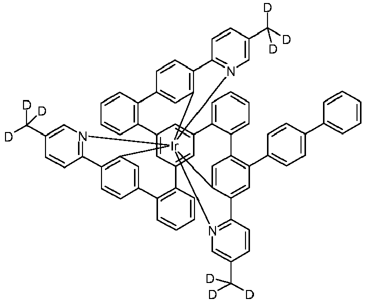 | 92% |
| Ir(L23-D6) | Ir(L23) | 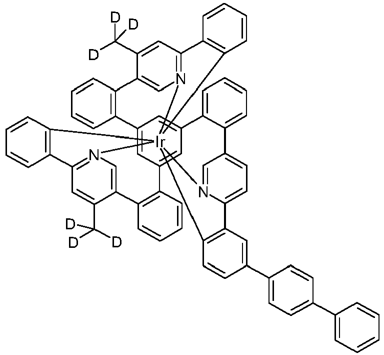 | 94% |
| Ir(L28-D6) | Ir(L28) | 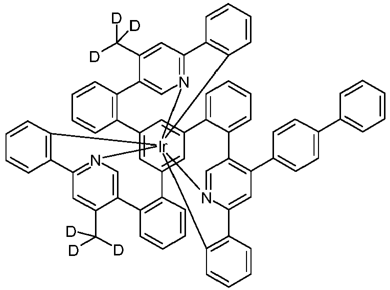 | 90% |

### B) Kern-Deuterierung am Pyridin

Eine Suspension von 1 mmol des sauberen Komplexes (Reinheit > 99.9 %) in einem Gemisch aus 50 ml DMSO-d6 (Deuterierungsgrad > 99.8 %) und 0.5 ml Methanol-d1 (Deuterierungsgrad > 99.8 %) wird mit 3 mmol Natriumhydrid versetzt und dann unter Rühren auf 140 °C erhitzt. Man rührt 6 h bei 140 °C nach, kühlt die klare orange Lösung mit Hilfe eines Kaltwasserbades ab, versetzt tropfenweise ab ca. 60 °C mit 5 ml 1N DCl in D₂O, rührt 1 h nach, saugt vom Feststoff ab, wäscht diesen dreimal mit je 10 ml H₂O/MeOH (1:1, vv) und dann dreimal mit je 10 ml MeOH und trocknet im Vakuum. Der Feststoff wird mit DCM über Kieselgel filtriert. Das Filtrat wird im Vakuum eingeengt, gleichzeitig tropfenweise mit MeOH versetzt und dadurch zur Kristallisation gebracht. Abschließend wird fraktioniert sublimiert, wie unter "C: Darstellung der Metallkomplexe, Variante A" beschrieben. Ausbeute typischerweise 80-90 %.

Auf die oben beschriebene Weise können folgende deuterierte Komplexe dargestellt werden:

| Bsp. | Edukt | Produkt | Ausbeute |
|---|---|---|---|
| Ir(L1-D9) | Ir(L1) | 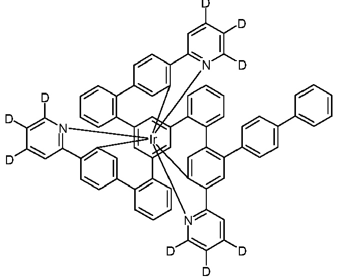 | 93% |
| Ir(L6-D9) | Ir(L6) | 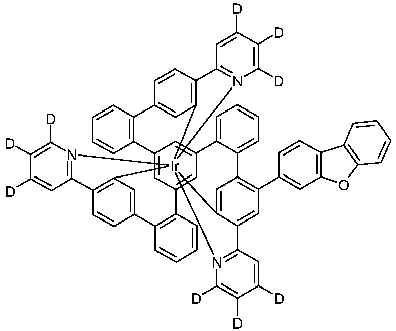 | 95% |
| Ir(L19-D3) | Ir(L19) | 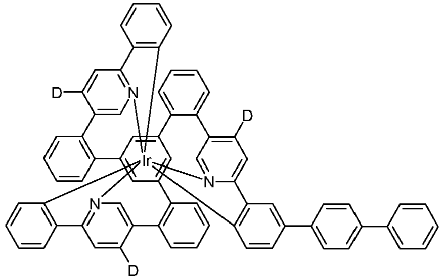 | 89% |

### 2) Bromierung der Metallkomplexe

Eine Lösung bzw. Suspension von 10 mmol eines Komplexes, der in para-Position zum Iridium A x C-H-Gruppen (mit A = 1, 2, 3) trägt, in 500 ml bis 2000 ml Dichlormethan, je nach Löslichkeit der Metallkomplexe, wird unter Licht- und Luftausschluss bei -30 bis +30 °C mit A x 10.5 mmol N-Halogen-succinimid (Halogen: Cl, Br, I) versetzt und 20 h gerührt. In DCM schlecht lösliche Komplexe können auch in anderen Lösemitteln (TCE, THF, DMF, Chlorbenzol, etc.) und bei erhöhter Temperatur umgesetzt werden. Anschließend wird das Lösungsmittel im Vakuum weitgehend entfernt. Der Rückstand wird mit 100 ml Methanol ausgekocht. Der Feststoff wird abgesaugt, dreimal mit 30 ml Methanol gewaschen und im Vakuum getrocknet. Man erhält so die in para-Position zum Iridium bromierten Komplexe. Komplexe mit einem HOMO (CV) von ca. -5.1 bis -5.0 eV und betragsmäßig kleiner neigen zur Oxidation (Ir(III) → Ir(IV)), wobei das Oxidationsmittel Brom, freigesetzt aus NBS, ist. Diese Oxidationsreaktion ist durch eine deutliche Grünfärbung der ansonsten gelben bis roten Lösungen bzw. Suspensionen der Emitter zu erkennen. In solchen Fällen wird ein weiteres Äquivalent NBS zugesetzt. Zur Aufarbeitung setzt man 300-500 ml Methanol und 2 ml Hydrazin Hydrat als Reduktionsmittel zu, wodurch sich die grünen Lösungen bzw. Suspensionen gelb verfärben (Reduktion Ir(IV) → Ir(III). Dann zieht man im Vakuum das Lösemittel weitgehend ab, versetzt mit 300 ml Methanol, saugt den Feststoff ab, wäscht dreimal mit je 100 ml Methanol und trocknet im Vakuum.

Unterstöchiometrische Bromierungen, z. B. Mono- und Dibromierungen, von Komplexen mit 3 C-H-Gruppen in para-Position zum Iridium verlaufen meist weniger selektiv als die stöchiometrischen Bromierungen. Die Rohprodukte dieser Bromierungen können chromatographisch (CombiFlash Torrent der Fa. A. Semrau) getrennt werden.

### Synthese von Ir(L1-2Br)

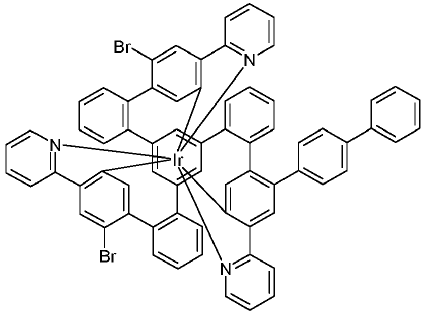

Eine bei 0 °C gerührte Suspension von 11.1 g (10 mmol) Ir(L1) in 500 ml DCM wird auf einmal mit 3.7 g (21.0 mmol) N-Bromsuccinimid versetzt und 20 h gerührt. Nach Entfernen von ca. 450 ml des DCMs im Vakuum wird die gelbe Suspension mit 100 ml Methanol versetzt. Der Feststoff wird abgesaugt, dreimal mit ca. 50 ml Methanol gewaschen und im Vakuum getrocknet. Ausbeute: 12.3 g (9.7 mmol), 97 %; Reinheit: > 99.0 %ig nach NMR.

Analog können folgende Verbindungen dargestellt werden:

| Bsp. | Edukt Bromierungsprodukt | Ausbeute |
|---|---|---|
| Ir(L6-2Br) | Ir(L6) | 95% |
| | 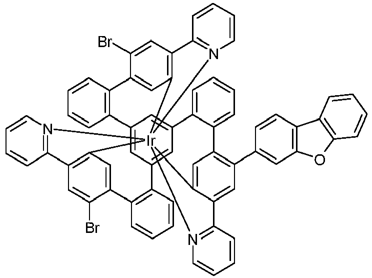 | |
| I(L11-2Br) | Ir(L11) | 95% |
| | 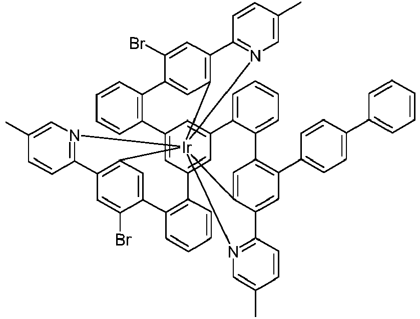 | |
| Ir(L14-3Br) | Ir(L14) | 92% |
| | 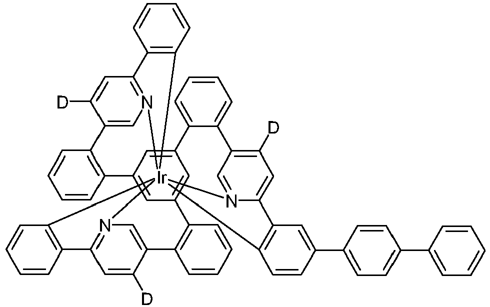 | |
| Ir(L16-3Br) | Ir(I16) | 96% |
| | 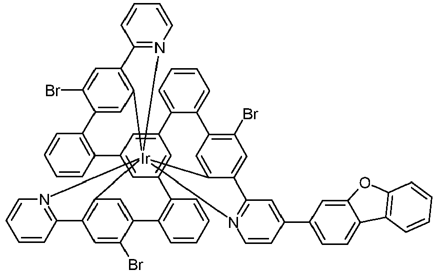 | |
| Ir(L18-3Br) | Ir(L18) | 94% |
| | 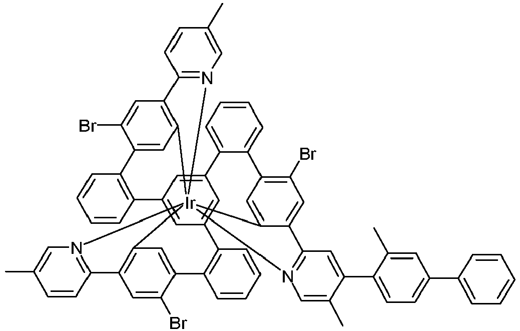 | |
| Ir(L19-2Br) | Ir(L19) | 95% |
| | 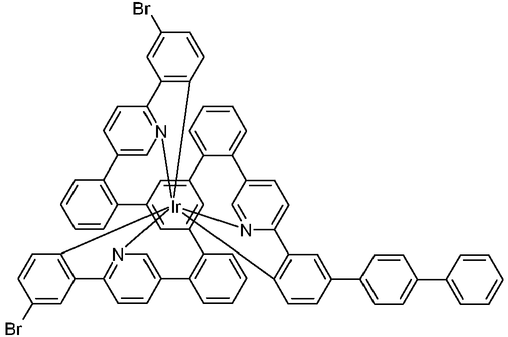 | |
| Ir(I22-2Br) | Ir(L22) | 95% |
| | 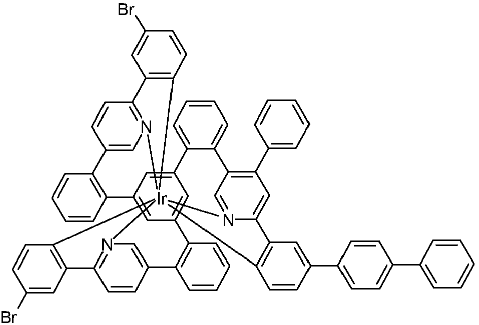 | |
| Ir(L28-3Br) | Ir(L28) | 93% |
| | 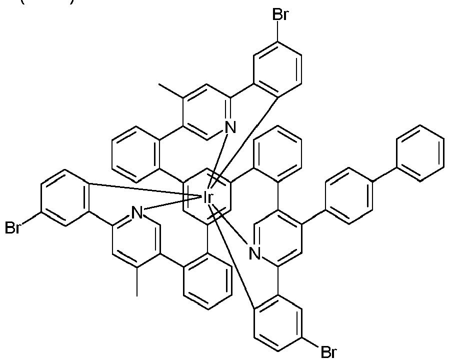 | |

### 3) Cyanierung der Metallkomplexe

Ein Gemisch aus 10 mmol des bromierten Komplexes, 20 mmol Kupfer(I)-cyanid pro Brom-Funktion und 300 ml NMP wird 40 h bei 180 °C gerührt. Nach Erkalten entfernt man das Lösemittel im Vakuum, nimmt den Rückstand in 500 ml Dichlormethan auf, filtriert über Celite von den Kupfersalzen ab, engt das Dichlormethan im Vakuum fast bis zur Trockene ein, gibt 100 ml Ethanol zu, saugt vom ausgefallenen Feststoff ab, wäscht diesen zweimal mit je 50 ml Ethanol und trocknet im Vakuum. Das Rohprodukt wird durch Chromatographie und/oder Heißextraktion gereinigt. Das Tempern erfolgt im Hochvakuum (p ca. 10⁻⁶ mbar) im Temperaturbereich von ca. 200-300 °C. Die Sublimation erfolgt im Hochvakuum (p ca. 10⁻⁶ mbar) im Temperaturbereich von ca. 350-450 °C, wobei die Sublimation bevorzugt in Form einer fraktionierten Sublimation durchgeführt wird.

### Synthese von Ir(L1-2CN)

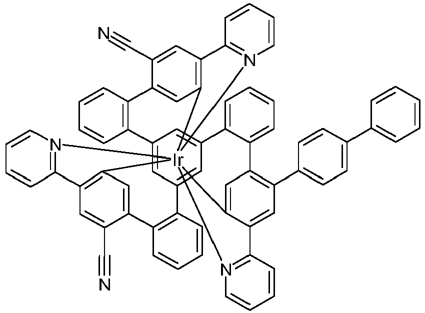

Einsatz von 12.7 g (10 mmol) Ir(L1-2Br) und 3.6 g (40 mmol) Kupfer(I)-cyanid. Chromatographie an Kieselgel mit Dichlormethan, viermalige Heißextraktion mit Dichlormethan/Acetonitril (2:1, vv), Sublimation. Ausbeute: 6.4 g (5.5 mmol), 55 %; Reinheit: ca. 99.9 %ig nach HPLC.

Analog können folgende Verbindungen dargestellt werden:

| Bsp. | Edukt Cyanierungsprodukt | |
|---|---|---|
| Ir(L6-2CN) | Ir(L6-2Br) | 58% |
| | 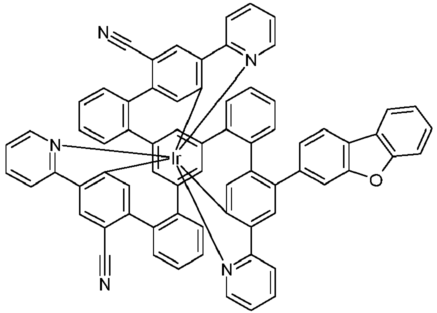 | |
| Ir(L11-2CN) | Ir(L11-2Br) | 55% |
| | 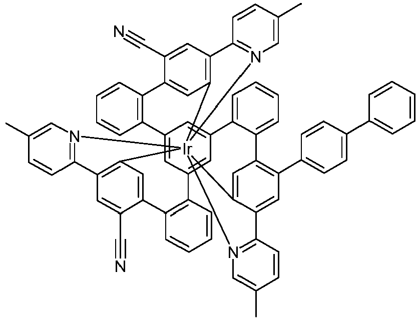 | |
| Ir(L14-3CN) | Ir(L14-3Br) | 51% |
| | 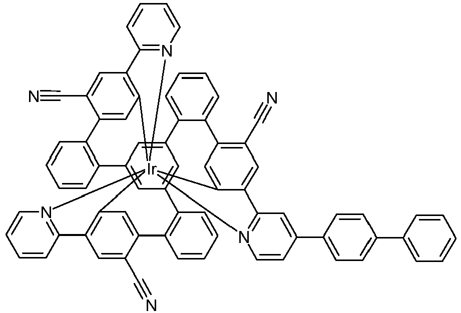 | |
| Ir(I16-3CN) | Ir(I16-3Br) | 56% |
| | 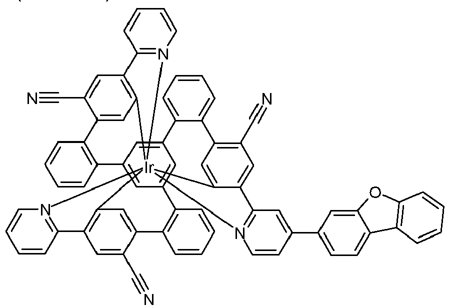 | |
| Ir(L18-3CN) | Ir(L18-3Br) | 53% |
| | 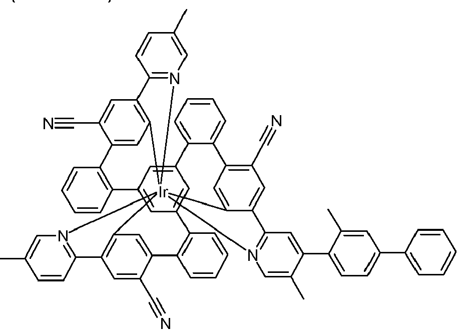 | |
| Ir(L19-2CN) | Ir(L19-2Br) | 60% |
| | 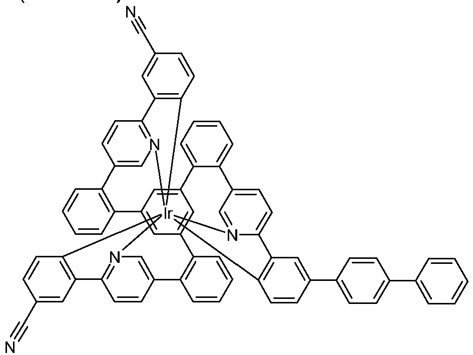 | |
| Ir(L22-2CN) | Ir(L22-2Br) | 58% |
| | 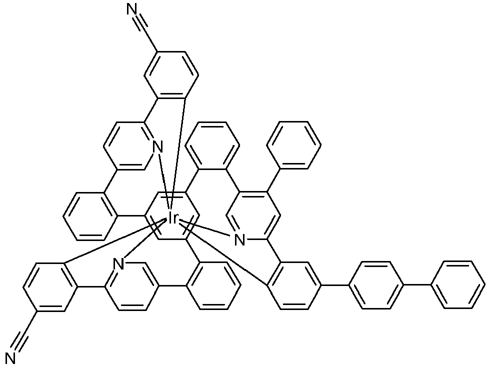 | |
| Ir(L28-3CN) | Ir(L28-3Br) | 59% |
| | 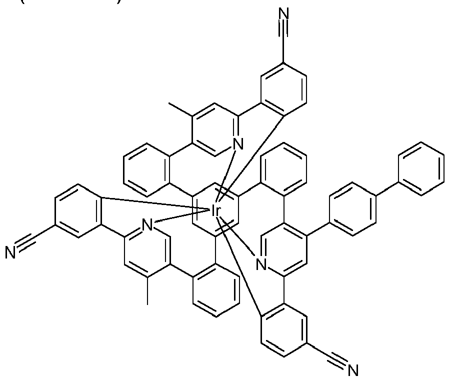 | |

### Beispiel: Herstellung der OLEDs

### 1) Vakuum-prozessierte Devices:

Die Herstellung von erfindungsgemäßen OLEDs sowie OLEDs nach dem Stand der Technik erfolgt nach einem allgemeinen Verfahren gemäß WO 2004/058911, das auf die hier beschriebenen Gegebenheiten (Schichtdickenvariation, verwendete Materialien) angepasst wird.

In den folgenden Beispielen werden die Ergebnisse verschiedener OLEDs vorgestellt. Gereinigte Glasplättchen (Reinigung in Miele Laborspülmaschine, Reiniger Merck Extran), die mit strukturiertem ITO (Indium Zinn Oxid) der Dicke 50 nm beschichtet sind, werden 25 Minuten mit UV-Ozon vorbehandelt (UV-Ozon Generator PR-100, Firma UVP) und innerhalb 30 min. zur verbesserten Prozessierung mit 20 nm PEDOT:PSS beschichtet (Poly(3,4-ethylendioxythiophen)poly(styrolsulfonat), bezogen als CLEVIOS™ P VP Al 4083 von Heraeus Precious Metals GmbH Deutschland, aus wässriger Lösung aufgeschleudert) und anschließend bei 180 °C 10 min. lang ausgeheizt. Diese beschichteten Glasplättchen bilden die Substrate, auf welche die OLEDs aufgebracht werden. Die OLEDs haben prinzipiell folgenden Schichtaufbau: Substrat / Lochinjektionsschicht 1 (HIL1) bestehend aus HTM1 dotiert mit 5 % NDP-9 (kommerziell erhältlich von der Fa. Novaled), 20 nm / Lochtransportschicht 1 (HTL1) bestehend aus HTM1, 220 nm für grüne/gelbe Devices, 110 nm für rote Devices / Lochtransportschicht 2 (HTL2) / Emissionsschicht (EML) / Lochblockierschicht (HBL) / Elektronentransportschicht (ETL) / optionale Elektroneninjektionsschicht (EIL) und abschließend eine Kathode. Die Kathode wird durch eine 100 nm dicke Aluminiumschicht gebildet.

Zunächst werden vakuum-prozessierte OLEDs beschrieben. Hierfür werden alle Materialien in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Co-Verdampfung in einem bestimmten Volumenanteil beigemischt wird. Eine Angabe wie M1:M2:Ir(L2) (55%:35%:10%) bedeutet hierbei, dass das Material M1 in einem Volumenanteil von 55%, M2 in einem Volumenanteil von 35% und Ir(L1) in einem Volumenanteil von 10% in der Schicht vorliegt. Analog kann auch die Elektronentransportschicht aus einer Mischung zweier Materialien bestehen. Der genaue Aufbau der OLEDs ist Tabelle 1 zu entnehmen. Die zur Herstellung der OLEDs verwendeten Materialien sind in Tabelle 4 gezeigt.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik, sowie die Lebensdauer bestimmt. Die Elektrolumineszenzspektren werden bei einer Leuchtdichte von 1000 cd/m² bestimmt und daraus die CIE 1931 x und y Farbkoordinaten berechnet. Als Lebensdauer LD90 wird die Zeit definiert, nach der die Leuchtdichte bei Betrieb mit einer Starthelligkeit von 10000 cd/m² auf 90 % der Startleuchtdichte abgesunken ist. Die OLEDs können initital auch bei anderen Startleuchtdichten betrieben werden. Die Werte für die Lebensdauer können dann mit Hilfe dem Fachmann bekannten Umrechnungsformeln auf eine Angabe für andere Startleuchtdichten umgerechnet werden.

### Verwendung von erfindungsgemäßen Verbindungen als Emittermaterialien in phosphoreszierenden OLEDs

Die erfindungsgemäßen Verbindungen lassen sich unter anderem als phosphoreszierende Emittermaterialien in der Emissionsschicht in OLEDs einsetzen. Als Vergleich gemäß dem Stand der Technik werden die Iridiumkomplexe gemäß Tabelle 4 verwendet. Die Ergebnisse der OLEDs sind in Tabelle 2 zusammengefasst.

**Tabelle 1: Aufbau der OLEDs**

| **Bsp.** | **HTL2 Dicke** | **EML Dicke** | **HBL Dicke** | **ETL Dicke** |
|---|---|---|---|---|
| Ref.D1 | HTM2 10 nm | M1:M2:Ir-Ref.1 (59%:29%:12%) 30 nm | ETM1 10 nm | ETM1:ETM2 (50%:50%) 30 nm |
| Ref.D2 | HTM2 10 nm | M1:M2:Ir-Ref.2 (59%:29%:12%) 30 nm | ETM1 10 nm | ETM1:ETM2 (50%:50%) 30 nm |
| Ref.D3 | HTM2 10 nm | M1:M2:Ir-Ref.3 (59%:29%:12%) 30 nm | ETM1 10 nm | ETM1:ETM2 (50%:50%) 30 nm |
| Ref.D4 | HTM2 10 nm | M1:M2:Ir-Ref.4 (59%:29%:12%) 30 nm | ETM1 10 nm | ETM1:ETM2 (50%:50%) 30 nm |
| Ref.D5 | HTM2 10 nm | M1:M2:Ir-Ref.5 (59%:29%:12%) 30 nm | ETM1 10 nm | ETM1:ETM2 (50%:50%) 30 nm |
| Ref.D6 | HTM2 10 nm | M6:Ir-Ref.6 (88%:12%) 40 nm | ETM1 10nm | ETM1:ETM2 (50%:50%) 30 nm |
| D1A | HTM2 10 nm | M1:M2:Ir(L1) (59%:29%:12%) 30 nm | ETM1 10 nm | ETM1:ETM2 (50%:50%) 30 nm |
| D1B | HTM2 10 nm | M1:M7:Ir(L1) (49%:29%:22%) 30 nm | ETM1 10nm | ETM1:ETM2 (50%:50%) 30 nm |
| D1C | HTM2 10 nm | M1:M8:Ir(L1) (68%:25%:7%) 30 nm | ETM1 10 nm | ETM1:ETM2 (50%:50%) 30 nm |
| D1D | HTM2 10 nm | M1:M9:Ir(L1) (58%:35%:7%) 30 nm | ETM1 10 nm | ETM1:ETM2 (50%:50%) 30 nm |
| D1E | HTM2 10 nm | M1:M9:Ir(L1) (46%:50%:4%) 30 nm | ETM1 10 nm | ETM1:ETM2 (50%:50%) 30 nm |
| D1-D9 | HTM2 10 nm | M1:M2:Ir(L1-D9) (59%:29%:12%) 30 nm | ETM1 10 nm | ETM1:ETM2 (50%:50%) 30 nm |
| D2 | HTM2 10 nm | M1:M2:Ir(L2) (59%:29%:12%) 30 nm | ETM1 10 nm | ETM1:ETM2 (50%:50%) 30 nm |
| D6 | HTM2 10 nm | M1:M2:Ir(L6) (59%:29%:12%) 30 nm | ETM1 10 nm | ETM1:ETM2 (50%:50%) 30 nm |
| D6-D9 | HTM2 10 nm | M1:M2:Ir(L6-D9) (59%:29%:12%) 30 nm | ETM1 10 nm | ETM1:ETM2 (50%:50%) 30 nm |
| D6-2CN | HTM2 10 nm | M1:M2:Ir(L6-2CN) (29%:59%:12%) 30 nm | ETM1 10 nm | ETM1:ETM2 (50%:50%) 30 nm |
| D7 | HTM2 10 nm | M1:M2:Ir(L7) (59%:29%:12%) 30 nm | ETM1 10 nm | ETM1:ETM2 (50%:50%) 30 nm |
| D8 | HTM2 10 nm | M1:M2:Ir(L8) (59%:29%:12%) 30 nm | ETM1 10 nm | ETM1:ETM2 (50%:50%) 30 nm |
| D9 | HTM2 10 nm | M1:M2:Ir(L9) (59%:29%:12%) 30 nm | ETM1 10 nm | ETM1:ETM2 (50%:50%) 30 nm |
| D11 | HTM2 10 nm | M1:M2:Ir(L11) (59%:29%:12%) 30 nm | ETM1 10 nm | ETM1:ETM2 (50%:50%) 30 nm |
| D11-D9 | HTM2 10 nm | M1:M2:Ir(L11-D9) (59%:29%:12%) 30 nm | ETM1 10 nm | ETM1:ETM2 (50%:50%) 30 nm |
| D12 | HTM2 10 nm | M1:M2:Ir(L12) (59%:29%:12%) 30 nm | ETM1 10 nm | ETM1:ETM2 (50%:50%) 30 nm |
| D13 | HTM2 10 nm | M1:M2:Ir(L13) (59%:29%:12%) 30 nm | ETM1 10 nm | ETM1:ETM2 (50%:50%) 30 nm |
| D14A | HTM2 10 nm | M1:M2:Ir(L14) (62%:31%:7%) 30 nm | ETM1 10 nm | ETM1:ETM2 (50%:50%) 30 nm |
| D14B | HTM2 10 nm | M1:M2:Ir(L14) (59%:29%:12%) 30 nm | ETM1 10 nm | ETM1:ETM2 (50%:50%) 30 nm |
| D14C | HTM2 10 nm | M1:M2:Ir(L14) (56%:27%:17%) 30 nm | ETM1 10 nm | ETM1:ETM2 (50%:50%) 30 nm |
| D14D | HTM2 10 nm | M1:M2:Ir(L14) (41.5%:41.5%:17%) 30 nm | ETM1 10 nm | ETM1:ETM2 (50%:50%) 30 nm |
| D14E | HTM2 10 nm | M1:M7:Ir(L14) (26%:52%:22%) 30 nm | ETM1 10 nm | ETM1:ETM2 (50%:50%) 30 nm |
| D14-3CN | HTM2 10 nm | M1:M2:Ir(L14-3CN) (29%:59%:12%) 30 nm | ETM1 10 nm | ETM1:ETM2 (50%:50%) 30 nm |
| D16 | HTM2 10 nm | M1:M2:Ir(L16) (59%:29%:12%) 30 nm | ETM1 10 nm | ETM1:ETM2 (50%:50%) 30 nm |
| D17 | HTM2 10 nm | M1:M2:Ir(L17) (59%:29%:12%) 30 nm | ETM1 10 nm | ETM1:ETM2 (50%:50%) 30 nm |
| D18 | HTM2 10 nm | M1:M2:Ir(L18) (59%:29%:12%) 30 nm | ETM1 10 nm | ETM1:ETM2 (50%:50%) 30 nm |
| D19 | HTM2 10 nm | M1:M2:Ir(L19) (41.5%:41.5%:17%) 30 nm | ETM1 10 nm | ETM1:ETM2 (50%:50%) 30 nm |
| D19-D3 | HTM2 10 nm | M1:M2:Ir(L19-D3) (41.5%:41.5%:17%) 30 nm | ETM1 10 nm | ETM1:ETM2 (50%:50%) 30 nm |
| D20 | HTM2 10 nm | M1:M2:Ir(L20) (41.5%:41.5%:17%) 30 nm | ETM1 10 nm | ETM1:ETM2 (50%:50%) 30 nm |
| D21 | HTM2 10 nm | M1:M2:Ir(L21) (41.5%:41.5%:17%) 30 nm | ETM1 10 nm | ETM1:ETM2 (50%:50%) 30 nm |
| D22 | HTM2 10 nm | M1:M2:Ir(L22) (41.5%:41.5%:17%) 30 nm | ETM1 10 nm | ETM1:ETM2 (50%:50%) 30 nm |
| D23 | HTM2 10 nm | M1:M2:Ir(L23) (41.5%:41.5%:17%) 30 nm | ETM1 10 nm | ETM1:ETM2 (50%:50%) 30 nm |
| D23-D6 | HTM2 10 nm | M1:M2:Ir(L23-D6) (41.5%:41.5%:17%) 30 nm | ETM1 10 nm | ETM1:ETM2 (50%:50%) 30 nm |
| D24 | HTM2 10 nm | M1:M2:Ir(L24) (41.5%:41.5%:17%) 30 nm | ETM1 10 nm | ETM1:ETM2 (50%:50%) 30 nm |
| D25 | HTM2 10 nm | M1:M2:Ir(L25) (41.5%:41.5%:17%) 30 nm | ETM1 10 nm | ETM1:ETM2 (50%:50%) 30 nm |
| D27 | HTM2 10 nm | M1:M2:Ir(L27) (41.5%:41.5%:17%) 30 nm | ETM1 10 nm | ETM1:ETM2 (50%:50%) 30 nm |
| D28 | HTM2 10 nm | M1:M2:Ir(L28) (41.5%:41.5%:17%) 30 nm | ETM1 10 nm | ETM1:ETM2 (50%:50%) 30 nm |
| D28-D6 | HTM2 10 nm | M1:M2:Ir(L28-D6) (41.5%:41.5%:17%) 30 nm | ETM1 10 nm | ETM1:ETM2 (50%:50%) 30 nm |
| D29 | HTM2 10 nm | M1:M2:Ir(L29) (41.5%:41.5%:17%) 30 nm | ETM1 10 nm | ETM1:ETM2 (50%:50%) 30 nm |
| D35 | HTM2 10 nm | M1:M2:Ir(L35) (59%:29%:12%) 30 nm | ETM1 10 nm | ETM1:ETM2 (50%:50%) 30 nm |
| D36 | HTM2 10 nm | M1:M2:Ir(L36) (59%:29%:12%) 30 nm | ETM1 10 nm | ETM1:ETM2 (50%:50%) 30 nm |
| D37 | HTM2 10 nm | M1 :M2:lr(L37) (59%:29%:12%) 30 nm | ETM1 10 nm | ETM1:ETM2 (50%:50%) 30 nm |
| D38 | HTM2 10 nm | M1:M2:Ir(L38) (59%:29%:12%) 30 nm | ETM1 10 nm | ETM1:ETM2 (50%:50%) 30 nm |
| D39 | HTM2 10 nm | M1:M2:Ir(L39) (59%:29%:12%) 30 nm | ETM1 10 nm | ETM1:ETM2 (50%:50%) 30 nm |
| D40 | HTM2 10 nm | M1:M2:Ir(L40) (59%:29%:12%) 30 nm | ETM1 10 nm | ETM1:ETM2 (50%:50%) 30 nm |
| D41 | HTM2 10 nm | M1:M2:Ir(L41) (59%:29%:12%) 30 nm | ETM1 10 nm | ETM1:ETM2 (50%:50%) 30 nm |
| D42 | HTM2 10 nm | M1:M2:Ir(L42) (59%:29%:12%) 30 nm | ETM1 10 nm | ETM1:ETM2 (50%:50%) 30 nm |
| D43 | HTM2 10 nm | M1:M2:Ir(L43) (59%:29%:12%) 30 nm | ETM1 10 nm | ETM1:ETM2 (50%:50%) 30 nm |
| D44 | HTM2 10 nm | M1:M2:Ir(L44) (59%:29%:12%) 30 nm | ETM1 10 nm | ETM1:ETM2 (50%:50%) 30 nm |
| D45 | HTM2 10 nm | M1:M2:Ir(L45) (59%:29%:12%) 30 nm | ETM1 10 nm | ETM1:ETM2 (50%:50%) 30 nm |
| D46 | HTM2 10 nm | M1:M2:Ir(L46) (59%:29%:12%) 30 nm | ETM1 10 nm | ETM1:ETM2 (50%:50%) 30 nm |

**Tabelle 2: Ergebnisse der Vakuum-prozessierten OLEDs**

| **Bsp.** | **EQE (%) 1000 cd/m²** | **Spannung (V) 1000 cd/m²** | **CIE x/y 1000 cd/m²** | **LD90 (h) 10000 cd/m²** |
|---|---|---|---|---|
| Ref.D1 | 17.5 | 3.2 | 0.31/0.63 | 60 |
| Ref.D2 | 20.2 | 3.1 | 0.32/0.64 | 250 |
| Ref.D3 | 19.3 | 3.1 | 0.40/0.59 | 150 |
| Ref.D4 | 24.0 | 3.1 | 0.45/0.55 | 400 |
| Ref.D5 | 20.9 | 3.2 | 0.34/0.62 | 120 |
| Ref.D6 | 17.5 | 3.0 | 0.41/0.52 | 120 |
| D1A | 22.3 | 3.2 | 0.34/0.64 | 850 |
| D1B | 22.6 | 3.3 | 0.34/0.64 | 1200 |
| D1C | 20.4 | 2.8 | 0.34/0.64 | 900 |
| D1D | 22.6 | 3.1 | 0.33/0.64 | 1000 |
| D1E | 22.9 | 3.0 | 0.33/0.65 | 700 |
| D1-D6 | 22.2 | 3.2 | 0.33/0.64 | 1000 |
| D2 | 23.5 | 3.1 | 0.34/0.63 | 850 |
| D6 | 22.8 | 3.2 | 0.34/0.64 | 960 |
| D6-D6 | 23.8 | 3.2 | 0.33/0.64 | 990 |
| D6-2CN | 21.5 | 3.5 | 0.27/0.62 | 280 |
| D7 | 24.0 | 3.2 | 0.34/0.64 | 940 |
| D8 | 23.0 | 3.2 | 0.34/0.63 | 920 |
| D9 | 23.4 | 3.2 | 0.34/0.63 | 950 |
| D11 | 22.5 | 3.2 | 0.35/0.63 | 850 |
| D11-D9 | 22.9 | 3.2 | 0.34/0.63 | 900 |
| D12 | 21.2 | 3.2 | 0.34/0.64 | 820 |
| D13 | 23.5 | 3.2 | 0.34/0.64 | 920 |
| D14A | 29.0 | 3.0 | 0.46/0.53 | 800 |
| D14B | 28.8 | 3.1 | 0.48/0.52 | 1100 |
| D14C | 27.8 | 3.2 | 0.49/0.51 | 1400 |
| D14D | 27.9 | 3.1 | 0.49/0.51 | 1800 |
| D14E | 25.3 | 3.1 | 0.49/0.50 | 4400 |
| D14-3CN | 26.6 | 3.6 | 0.35/0.62 | 250 |
| D16 | 29.1 | 3.1 | 0.50/0.49 | 1200 |
| D17 | 24.8 | 3.2 | 0.36/0.62 | 450 |
| D18 | 24.9 | 3.3 | 0.35/0.63 | 400 |
| D19 | 23.7 | 3.3 | 0.37/0.61 | 900 |
| D19-D3 | 22.8 | 3.3 | 0.37/0.61 | 1000 |
| D20 | 23.2 | 3.3 | 0.35/0.62 | 550 |
| D21 | 21.5 | 3.2 | 0.36/0.62 | 4500 |
| D22 | 22.7 | 3.3 | 0.36/0.62 | 1300 |
| D23 | 23.7 | 3.3 | 0.35/0.62 | 1100 |
| D23-D6 | 23.9 | 3.3 | 0.35/0.63 | 1150 |
| D24 | 22.6 | 3.2 | 0.38/0.61 | 900 |
| D25 | 24.0 | 3.1 | 0.41/0.58 | 1100 |
| D27 | 25.4 | 3.2 | 0.42/0.57 | 1200 |
| D28 | 24.3 | 3.2 | 0.40/0.59 | 1400 |
| D28-D6 | 24.5 | 3.1 | 0.39/0.60 | 1500 |
| D29 | 22.7 | 3.2 | 0.38/0.61 | 900 |
| D35 | 22.4 | 3.1 | 0.40/0.60 | 440 |
| D36 | 22.3 | 3.0 | 0.44/0.55 | 600 |
| D37 | 23.1 | 3.1 | 0.40/0.60 | 540 |
| D38 | 25.8 | 3.2 | 0.33/0.62 | 700 |
| D39 | 24.0 | 3.1 | 0.41/0.58 | 500 |
| D40 | 25.1 | 3.1 | 0.40/0.59 | 600 |
| D41 | 21.5 | 3.1 | 0.34/0.63 | 500 |
| D42 | 24.5 | 3.1 | 0.33/0.63 | 700 |
| D43 | 25.5 | 3.0 | 0.40/0.58 | 800 |
| D44 | 24.9 | 3.0 | 0.49/0.50 | 1100 |
| D45 | 21.8 | 3.1 | 0.27/0.64 | 500 |
| D46 | 23.9 | 3.1 | 0.48/0.50 | 550 |

### Lösungs-prozessierte Devices:

### A: Aus niedermolekularen löslichen Funktionsmaterialien

Die erfindungsgemäßen Iridiumkomplexe können auch aus Lösung verarbeitet werden und führen dort zu prozesstechnisch wesentlich einfacheren OLEDs, im Vergleich zu den vakuumprozessierten OLEDs, mit dennoch guten Eigenschaften. Die Herstellung solcher Bauteile lehnt sich an die Herstellung polymerer Leuchtdioden (PLEDs) an, die in der Literatur bereits vielfach beschrieben ist (z. B. in der WO 2004/037887). Der Aufbau setzt sich zusammen aus Substrat / ITO / Lochinjektionsschicht (60 nm) / Interlayer (20 nm) / Emissionsschicht (60 nm) / Lochblockierschicht (10 nm) / Elektronentransportschicht (40 nm) / Kathode. Dazu werden Substrate der Firma Technoprint (Sodalimeglas) verwendet, auf welche die ITO-Struktur (Indium-Zinn-Oxid, eine transparente, leitfähige Anode) aufgebracht wird. Die Substrate werden im Reinraum mit DI Wasser und einem Detergens (Deconex 15 PF) gereinigt und dann durch eine UV/Ozon-Plasmabehandlung aktiviert. Danach wird ebenfalls im Reinraum eine 20 nm Lochinjektionsschicht durch Spin-Coating aufgebracht. Die benötigte Spinrate hängt vom Verdünnungsgrad und der spezifischen Spin-Coater-Geometrie ab. Um Restwasser aus der Schicht zu entfernen, werden die Substrate für 30 Minuten bei 200 °C auf einer Heizplatte ausgeheizt. Die verwendete Interlayer dient dem Lochtransport, in diesem Fall wird HL-X von Merck verwendet. Die Interlayer kann alternativ auch durch eine oder mehrere Schichten ersetzt werden, die lediglich die Bedingung erfüllen müssen, durch den nachgelagerten Prozessierungsschritt der EML-Abscheidung aus Lösung nicht wieder abgelöst zu werden. Zur Herstellung der Emissionsschicht werden die erfindungsgemäßen Triplettemitter zusammen mit den Matrixmaterialien in Toluol oder Chlorbenzol gelöst. Der typische Feststoffgehalt solcher Lösungen liegt zwischen 16 und 25 g/L, wenn, wie hier, die für eine Device typische Schichtdicke von 60 nm mittels Spincoating erzielt werden soll. Die lösungsprozessierten Devices vom Typ1 enthalten eine Emissionsschicht aus M4:M5:IrL (18%:60%:22%), die vom Typ2 enthalten eine Emissionsschicht aus M4:M5:IrLa:IrLb (30%:34%:28%:8%), d. h. sie enthalten zwei verschiedene Iridiumkomplexe. Die Emissionsschicht wird in einer Inertgasatmosphäre, im vorliegenden Fall Argon, aufgeschleudert und 10 min bei 160 °C ausgeheizt. Darüber wird die Lochblockierschicht (10 nm ETM1) und die Elektronentransportschicht (40 nm ETM1 (50%) / ETM2 (50%)) aufgedampft (Aufdampfanlagen von Lesker o. a., typischer Aufdampfdruck 5 x 10⁻⁶ mbar). Zuletzt wird eine Kathode aus Aluminium (100 nm) (hochreines Metall von Aldrich) aufgedampft. Um das Device vor Luft und Luftfeuchtigkeit zu schützen, wird die Vorrichtung abschließend verkapselt und dann charakterisiert. Die genannten OLED-Beispiele sind noch nicht optimiert, Tabelle 3 fasst die erhaltenen Daten zusammen. Als Lebensdauer LD50 wird die Zeit definiert, nach der die Leuchtdichte bei Betrieb mit einer Starthelligkeit von 1000 cd/m² auf 50 % der Startleuchtdichte absinkt.

**Tabelle 3: Ergebnisse mit aus Lösung prozessierten Materialien**

| **Bsp.** | **Emitter Device** | **EQE (%) 1000 cd/m²** | **Spannung (V) 1000 cd/m²** | **CIE x/y** | **LD50 (h) 1000 cd/m²** |
|---|---|---|---|---|---|
| **Grüne, Gelbe, Orange und Rote OLEDs** | | | | | |
| Sol-Ref.GreenD1 | Ir-Sol-Ref.1 | 21.8 | 4.5 | 0.34/0.62 | 360000 |
| Sol-GreenD2 | Ir(L18) Typ1 | 23.2 | 4.2 | 0.34/0.63 | 390000 |
| Sol-GreenD3 | Ir(L11-2CN) Typ1 M9:M5:IrL (25%:55%:20%) | 21.9 | 4.5 | 0.27/0.61 | 60000 |
| Sol-GreenD4 | Ir(L14-3CN) M9:M5:IrL (25%:55%:20%) | 22.0 | 4.8 | 0.23/0.53 | 40000 |

**Tabelle 4: Strukturformeln der verwendeten Materialien**

| | |
|---|---|
| 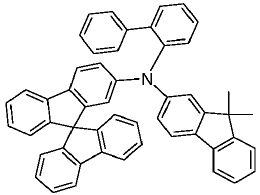 | 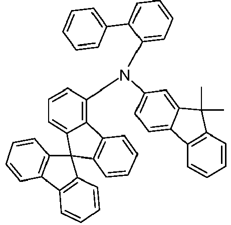 |
| HTM1 | |
| [136463-07-5] | HTM2 |
| | [1450933-44-4] |
| 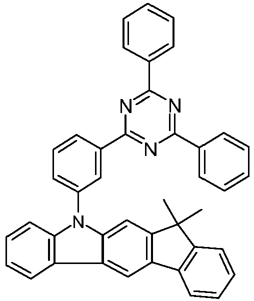 | 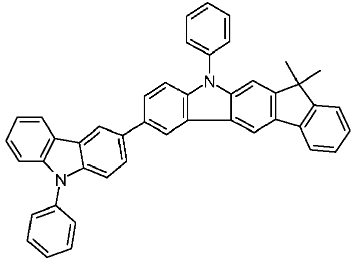 |
| | M2 |
| M1 | [1357150-54-9] |
| [1257248-13-7] | |
| 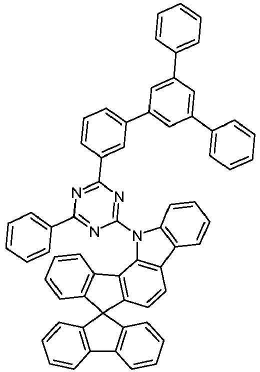 | 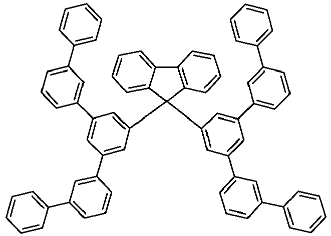 |
| | M5 |
| | 1246496-85-4 |
| M4 | |
| 1616231-60-7 | |
| 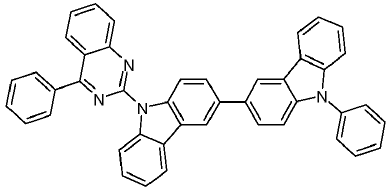 | 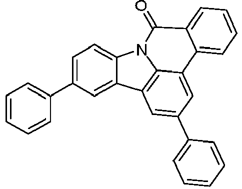 |
| M6 | M7 |
| 1398395-92-0 | 1915695-76-5 |
| 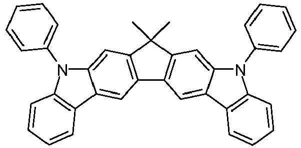 | 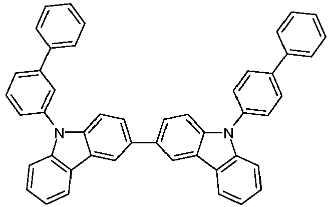 |
| M8 | |
| 1257248-72-8 | |
| | M9 |
| | 1643479-47-3 |
| 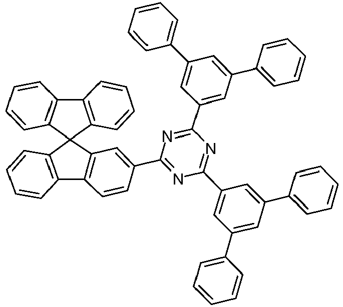 | 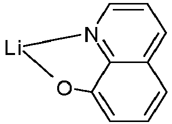 |
| | ETM2 |
| | [25387-93-3] |
| | |
| ETM1 = M10 | |
| [1233200-52-6] | |
| 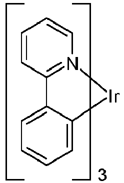 | 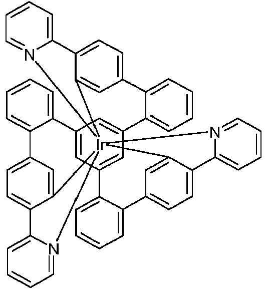 |
| Ir-Ref.1 | |
| [94928-86-6] | Ir-Ref.2 |
| | [1989600-78-3] |
| 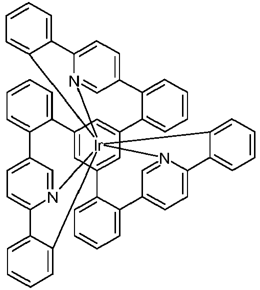 | 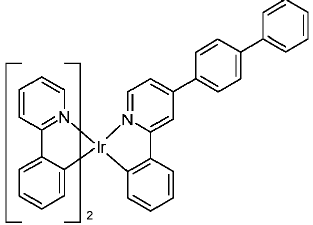 |
| | Ir-Ref.4 |
| Ir-Ref.3 | Darstellung analog zu [1215281-24-5] nach |
| [1989600-75-0] | WO 2010/027583 unter |
| | Verwendung von [1810861-59-6] |
| 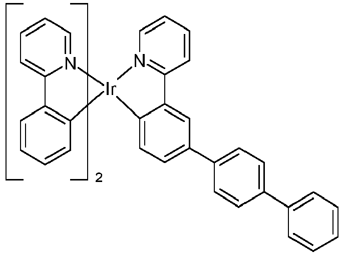 | 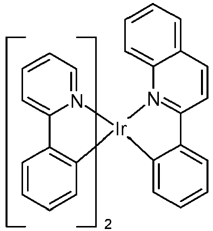 |
| Ir-Ref.5 | Ir-Ref.6 |
| Darstellung nach WO | 1327278-60-3 |
| 2004/026886 unter Verwendung von [454454-89-8] und [5122-94-1] | |
| 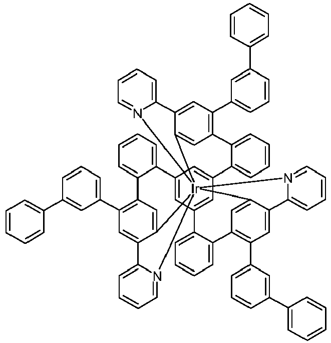 | 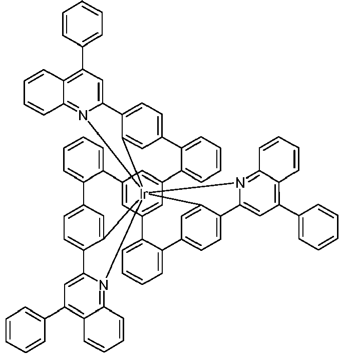 |
| Ir-Sol-Ref.1 | Ir-Sol-Ref.2 |
| [1989601-89-9] | [1989605-98-2] |

## Patentansprüche

1. Verbindung der Formel (1), 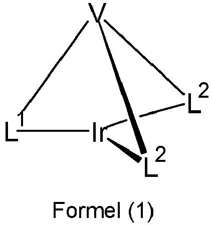
wobei für die verwendeten Symbole gilt:
L¹ ist ein Teilligand gemäß einer der Formeln (2a) bis (2d), der über die beiden Gruppen D an das Iridium koordiniert und der über die gestrichelte Bindung an V gebunden ist, 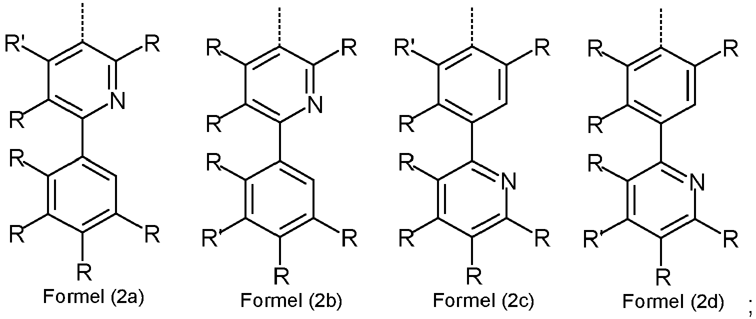
R' ist eine Gruppe der Formel (3), 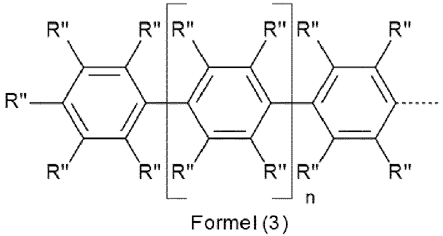
wobei die gestrichelte Bindung die Verknüpfung der Gruppe andeutet;
R" ist gleich oder verschieden bei jedem Auftreten H, D, F, CN, eine geradkettige Alkylgruppe mit 1 bis 10 C-Atomen, in der auch ein oder mehrere H-Atome durch D oder F ersetzt sein können, oder eine verzweigte oder cyclische Alkylgruppe mit 3 bis 10 C-Atomen, in der auch ein oder mehrere H-Atome durch D oder F ersetzt sein können, oder eine Alkenylgruppe mit 2 bis 10 C-Atomen, in der auch ein oder mehrere H-Atome durch D oder F ersetzt sein können; dabei können auch zwei benachbarte Reste R" bzw. zwei Reste R" an benachbarten Phenylgruppen miteinander ein Ringsystem bilden; oder zwei R" an benachbarten Phenylgruppen stehen zusammen für eine Gruppe ausgewählt aus O oder S, so dass die beiden Phenylringe zusammen mit der verbrückenden Gruppe für ein Dibenzofuran oder Dibenzothiophen stehen, und die weiteren R" sind wie vorstehend definiert;
n ist 0, 1, 2, 3, 4 oder 5;
L² ist gleich oder verschieden bei jedem Auftreten ein bidentater, monoanionischer Teilligand, der über ein Kohlenstoffatom und ein Stickstoffatom oder über zwei Kohlenstoffatome oder über zwei Stickstoffatome an das Iridium koordiniert und der mit einem oder mehreren Resten R substituiert sein kann;
V ist eine Gruppe der Formel (6b) oder (7b), wobei die gestrichelten Bindungen die Position der Verknüpfung der Teilliganden L¹ und L² darstellen, 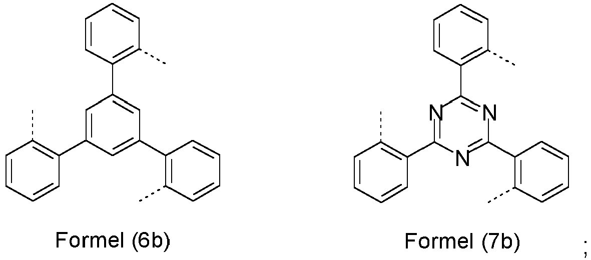
R ist bei jedem Auftreten gleich oder verschieden H, D, F, Cl, Br, I, N(R¹)₂, OR¹, SR¹, CN, NO₂, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R¹ substituiert sein kann und wobei eine oder mehrere nicht benachbarte CH₂-Gruppen durch Si(R¹)₂, C=O, NR¹, O, S oder CONR¹ ersetzt sein können, oder eine Aryl- oder Heteroarylgruppe mit 5 bis 10 aromatischen Ringatomen, die jeweils durch einen oder mehrere nicht-aromatische Reste R¹ substituiert sein kann; dabei können zwei Reste R auch miteinander ein aliphatisches oder heteroaliphatisches Ringsystem bilden;
R¹ ist bei jedem Auftreten gleich oder verschieden H, D, F, Cl, Br, I, N(R²)₂, OR², SR², CN, NO₂, Si(R²)₃, B(OR²)₂, C(=O)R², P(=O)(R²)₂, S(=O)R², S(=O)₂R², OSO₂R², eine geradkettige Alkylgruppe mit 1 bis 20 C-Atomen oder eine Alkenyl- oder Alkinylgruppe mit 2 bis 20 C-Atomen oder eine verzweigte oder cyclische Alkylgruppe mit 3 bis 20 C-Atomen, wobei die Alkyl-, Alkenyl- oder Alkinylgruppe jeweils mit einem oder mehreren Resten R² substituiert sein kann und wobei eine oder mehrere nicht benachbarte CH₂-Gruppen durch Si(R²)₂, C=O, NR², O, S oder CONR² ersetzt sein können, oder eine Aryl- oder Heteroarylgruppe mit 5 bis 10 aromatischen Ringatomen, die jeweils durch einen oder mehrere Reste R² substituiert sein kann; dabei können zwei oder mehrere Reste R¹ miteinander aliphatisches oder heteroaliphatisches ein Ringsystem bilden;
R² ist bei jedem Auftreten gleich oder verschieden H, D, F oder ein aliphatischer organischer Rest, insbesondere ein Kohlenwasserstoffrest, mit 1 bis 20 C-Atomen, in dem auch ein oder mehrere H-Atome durch F ersetzt sein können;
dabei können die drei bidentaten Teilliganden L¹ und L² außer durch die Brücke V auch noch durch eine weitere Brücke zu einem Kryptat geschlossen sein;
dabei ist die folgende Verbindung von der Erfindung ausgenommen:

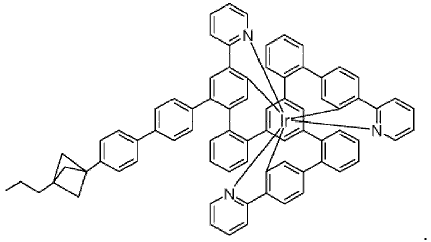

2. Verbindung nach Anspruch 1, **dadurch gekennzeichnet, dass** L¹ eine Struktur gemäß einer der Formeln (2a') bis (2d') aufweist, 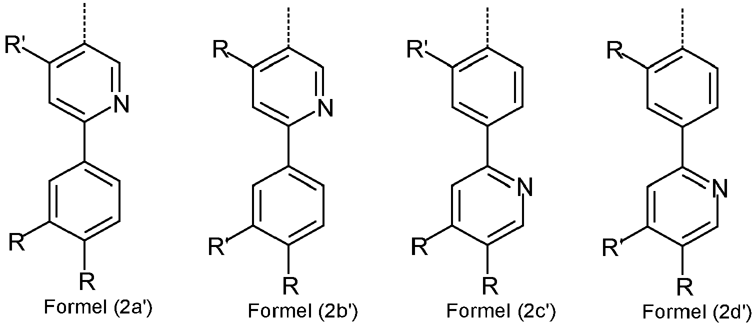 wobei die verwendeten Symbole die in Anspruch 1 genannten Bedeutungen aufweisen.

3. Verbindung nach Anspruch 1 oder 2, **dadurch gekennzeichnet, dass** in der Gruppe der Formel (3) beide Substituenten R", welche in den ortho-Positionen zu dem Kohlenstoffatom gebunden sind, mit dem diese Gruppe an den Phenylpyridinliganden gebunden ist, gleich oder verschieden H oder D sind.

4. Verbindung nach einem oder mehreren der Ansprüche 1 bis 3, **dadurch gekennzeichnet, dass** die Struktur der Formel (3) ausgewählt ist aus den Strukturen der Formeln (3a) bis (3n), 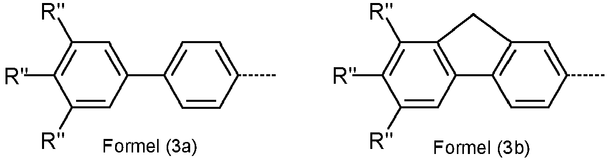 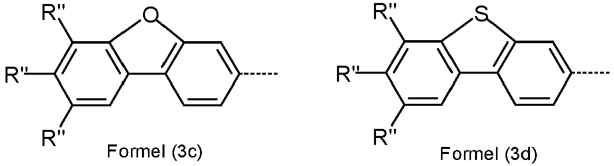 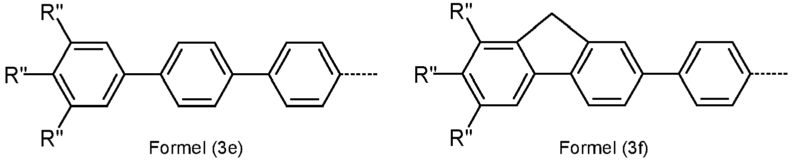 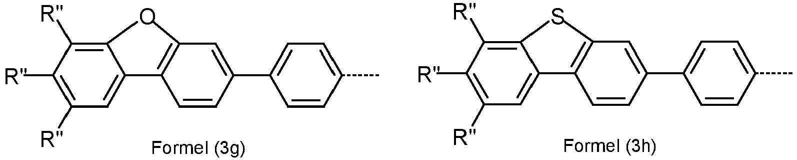 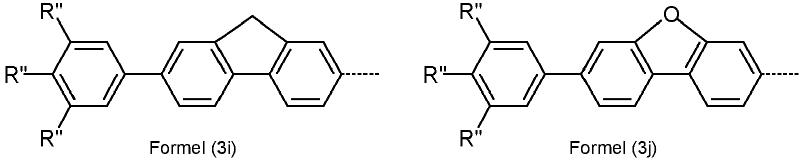 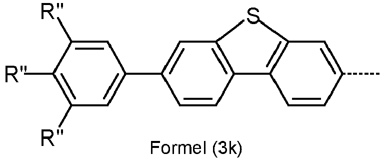 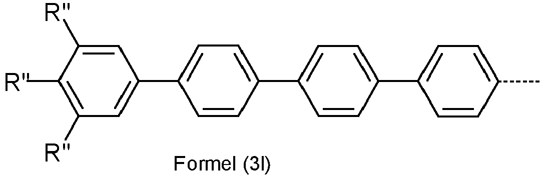 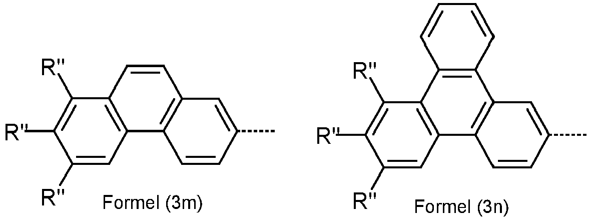 wobei die verwendeten Symbole die in Anspruch 1 genannten Bedeutungen aufweisen und wobei die Fluorengruppe in 9-Position noch mit ein oder zwei Alkylgruppen mit jeweils 1 bis 6 C-Atomen substituiert sein kann.

5. Verbindung nach einem oder mehreren der Ansprüche 1 bis 4, **dadurch gekennzeichnet, dass** die Substituenten R" gleich oder verschieden bei jedem Auftreten ausgewählt sind aus der Gruppe bestehend aus H, D, CN und einer Alkylgruppe mit 1 bis 4 C-Atomen.

6. Verbindung nach einem oder mehreren der Ansprüche 1 bis 5, **dadurch gekennzeichnet, dass** das Strukturfragment Ir(L²) eine höhere Triplettenergie aufweist als das Strukturfragment Ir(L¹).

7. Verbindung nach einem oder mehreren der Ansprüche 1 bis 6, **dadurch gekennzeichnet, dass** L² gleich oder verschieden bei jedem Auftreten für eine Struktur gemäß den Formeln (L-1), (L-2) oder (L-3) steht, 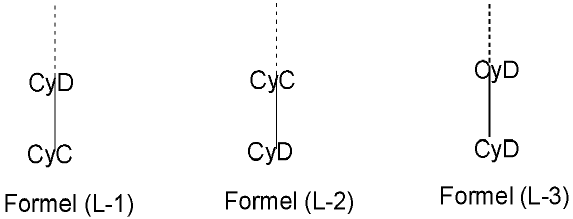
wobei die gestrichelte Bindung die Bindung des Teilliganden an V darstellt und für die weiteren verwendeten Symbole gilt:
CyC ist gleich oder verschieden bei jedem Auftreten eine durch R substituierte oder unsubstituierte Aryl- oder Heteroarylgruppe mit 5 bis 14 aromatischen Ringatomen, welche jeweils über ein Kohlenstoffatom an das Metall koordiniert und welche über eine kovalente Bindung mit CyD verbunden ist;
CyD ist gleich oder verschieden bei jedem Auftreten eine durch R substituierte oder unsubstituierte Heteroarylgruppe mit 5 bis 14 aromatischen Ringatomen, welche über ein Stickstoffatom oder über ein Carben-Kohlenstoffatom an das Metall koordiniert und welche über eine kovalente Bindung mit CyC verbunden ist;
dabei können mehrere der Substituenten R miteinander ein aliphatisches oder heteroaliphatisches Ringsystem bilden, und CyC und CyD können miteinander durch eine Gruppe gemäß einer der Formeln (17) bis (26) verknüpft sein, 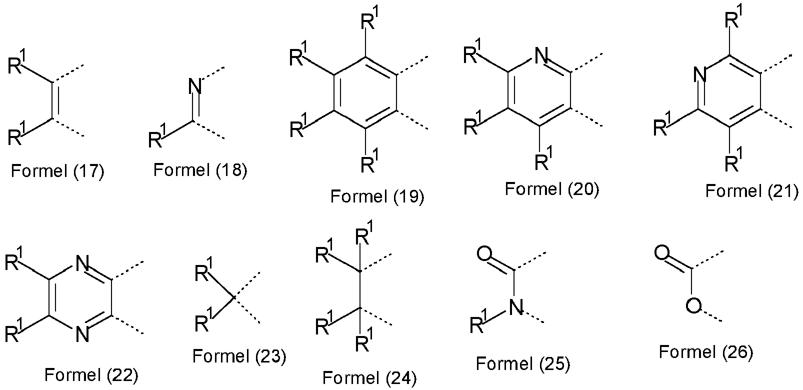
wobei R¹ die in Anspruch 1 genannten Bedeutungen aufweist und die gestrichelten Bindungen die Bindungen an CyC bzw. CyD andeuten.

8. Verbindung nach einem oder mehreren der Ansprüche 1 bis 7, **dadurch gekennzeichnet, dass** die Verbindung zwei Substituenten R oder zwei Substituenten R¹ enthält, die an benachbarte Kohlenstoffatome gebunden sind und die miteinander einen Ring gemäß einer der Formeln (27) bis (33) bilden, 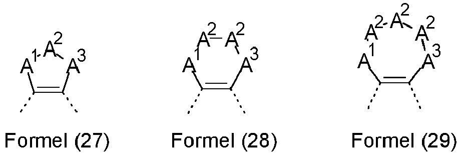 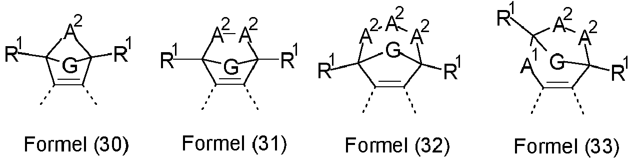 wobei R¹ und R² die in Anspruch 1 genannten Bedeutungen aufweisen, die gestrichelten Bindungen die Verknüpfung der beiden Kohlenstoffatome im Liganden andeuten und weiterhin gilt:
A¹, A³ ist gleich oder verschieden bei jedem Auftreten C(R³)₂, O, S, NR³ oder C(=O);
A² ist C(R¹)₂, O, S, NR³ oder C(=O);
G ist eine Alkylengruppe mit 1, 2 oder 3 C-Atomen, welche mit einem oder mehreren Resten R² substituiert sein kann, -CR²=CR²- oder eine ortho-verknüpfte Arylen- oder Heteroarylengruppe mit 5 oder 6 aromatischen Ringatomen, welche durch einen oder mehrere Reste R² substituiert sein kann;
R³ ist gleich oder verschieden bei jedem Auftreten H, F, OR², eine geradkettige Alkylgruppe mit 1 bis 10 C-Atomen, eine verzweigte oder cyclische Alkylgruppe mit 3 bis 10 C-Atomen, wobei die Alkylgruppe jeweils mit einem oder mehreren Resten R² substituiert sein kann, wobei eine oder mehrere nicht benachbarte CH₂-Gruppen durch R²C=CR², C≡C, Si(R²)₂, C=O, NR², O, S oder CONR² ersetzt sein können, oder eine Aryl- oder Heteroarylgruppe mit 5 oder 6 aromatischen Ringatomen, das jeweils durch einen oder mehrere Reste R² substituiert sein kann; dabei können zwei Reste R³, welche an dasselbe Kohlenstoffatom gebunden sind, miteinander ein aliphatisches Ringsystem bilden und so ein Spirosystem aufspannen; weiterhin kann R³ mit einem benachbarten Rest R oder R¹ ein aliphatisches Ringsystem bilden; mit der Maßgabe, dass nicht zwei Heteroatome und nicht zwei Gruppe C=O direkt aneinander gebunden sind.

9. Verfahren zur Herstellung einer Verbindung nach einem oder mehreren der Ansprüche 1 bis 8 durch Umsetzung des entsprechenden Liganden mit Iridiumalkoholaten der Formel (34), Iridiumketoketonaten der Formel (35), Iridiumhalogeniden der Formel (36), Iridiumcarboxylaten der Formel (37) oder Iridiumverbindungen, die sowohl Alkoholat- und/oder Halogenid- und/oder Hydroxy- wie auch Ketoketonatreste tragen, 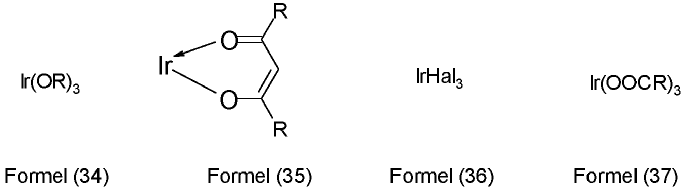 wobei R die in Anspruch 1 angegebenen Bedeutungen hat, Hal = F, Cl, Br oder I ist und das Iridiumedukt auch als das entsprechende Hydrat vorliegen kann.

10. Formulierung enthaltend mindestens eine Verbindung nach einem oder mehreren der Ansprüche 1 bis 8 und mindestens ein Lösemittel und/oder eine weitere organische oder anorganische Verbindung.

11. Verwendung einer Verbindung nach einem oder mehreren der Ansprüche 1 bis 8 in einer elektronischen Vorrichtung oder als Sauerstoff-Sensibilisator oder als Photoinitiator oder Photokatalysator.

12. Elektronische Vorrichtung enthaltend mindestens eine Verbindung nach einem oder mehreren der Ansprüche 1 bis 8.

13. Elektronische Vorrichtung nach Anspruch 12, **dadurch gekennzeichnet, dass** es sich um eine organische Elektrolumineszenzvorrichtung handelt und die Verbindung nach einem oder mehreren der Ansprüche 1 bis 8 zusammen mit einem Matrixmaterial in einer oder mehreren emittierenden Schichten vorliegt.

## Claims

1. Compound of the formula (1) 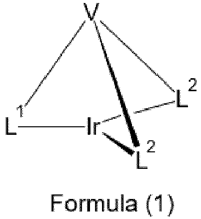
where the symbols used are as follows:
L¹ is a sub-ligand of one of the formulae (2a) to (2d) which coordinates to the iridium via the two D groups and which is bonded to V via the dotted bond, 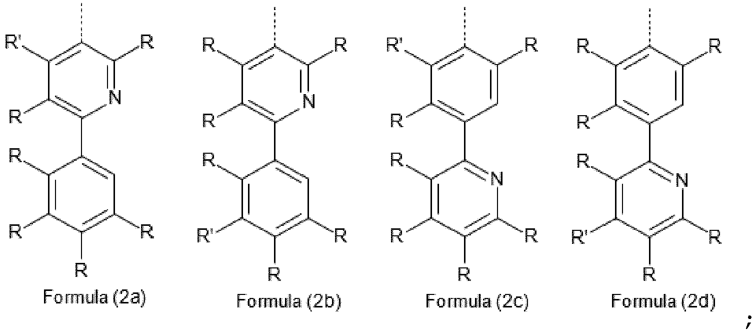
R' is a group of the formula (3), 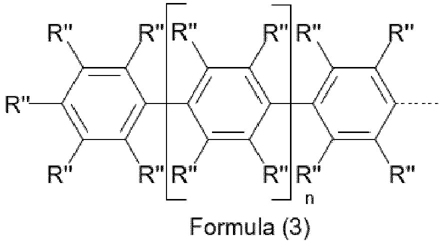
where the dotted bond indicates the linkage of the group;
R" is the same or different at each instance and is H, D, F, CN, a straight-chain alkyl group having 1 to 10 carbon atoms in which one or more hydrogen atoms may also be replaced by D or F, or a branched or cyclic alkyl group having 3 to 10 carbon atoms in which one or more hydrogen atoms may also be replaced by D or F, or an alkenyl group having 2 to 10 carbon atoms in which one or more hydrogen atoms may also be replaced by D or F; at the same time, two adjacent R" radicals or two R" radicals on adjacent phenyl groups together may also form a ring system; or two R" on adjacent phenyl groups together are a group selected from O and S, such that the two phenyl rings together with the bridging group are a dibenzofuran or dibenzothiophene, and the further R" are as defined above;
n is 0, 1, 2, 3, 4 or 5;
L² is the same or different at each instance and is a bidentate monoanionic sub-ligand which coordinates to the iridium via one carbon atom and one nitrogen atom or via two carbon atoms or via two nitrogen atoms and which may be substituted by one or more R radicals;
V is a group of the formula (6b) or (7b), where the dotted bonds represent the position of the linkage of the sub-ligands L¹ and L², 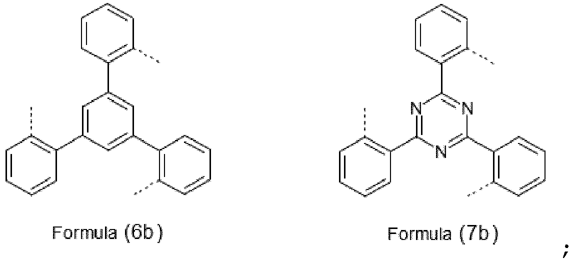
R is the same or different at each instance and is H, D, F, Cl, Br, I, N(R¹)₂, OR¹, SR¹, CN, NO₂, COOH, C(=O)N(R¹)₂, Si(R¹)₃, B(OR¹)₂, C(=O)R¹, P(=O)(R¹)₂, S(=O)R¹, S(=O)₂R¹, OSO₂R¹, a straightchain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R¹ radicals and where one or more nonadjacent CH₂ groups may be replaced by Si(R¹)₂, C=O, NR¹, O, S or CONR¹, or an aryl or heteroaryl group which has 5 to 10 aromatic ring atoms and may be substituted in each case by one or more nonaromatic R¹ radicals; at the same time, two R radicals together may also form an aliphatic or heteroaliphatic ring system;
R¹ is the same or different at each instance and is H, D, F, Cl, Br, I, N(R²)₂, OR², SR², CN, NO₂, Si(R²)₃, B(OR²)₂, C(=O)R², P(=O)(R²)₂, S(=O)R², S(=O)₂R², OSO₂R², a straight-chain alkyl group having 1 to 20 carbon atoms or an alkenyl or alkynyl group having 2 to 20 carbon atoms or a branched or cyclic alkyl group having 3 to 20 carbon atoms, where the alkyl, alkenyl or alkynyl group may in each case be substituted by one or more R² radicals and where one or more nonadjacent CH₂ groups may be replaced by Si(R²)₂, C=O, NR², O, S or CONR², or an aryl or heteroaryl group which has 5 to 10 aromatic ring atoms and may be substituted in each case by one or more R² radicals; at the same time, two or more R¹ radicals together may form an aliphatic or heteroaliphatic ring system;
R² is the same or different at each instance and is H, D, F or an aliphatic organic radical, especially a hydrocarbyl radical, having 1 to 20 carbon atoms, in which one or more hydrogen atoms may also be replaced by F;
at the same time, the three bidentate sub-ligands L¹ and L², apart from by the bridge V, may also be closed by a further bridge to form a cryptate;
with exclusion of the following compound from the invention:

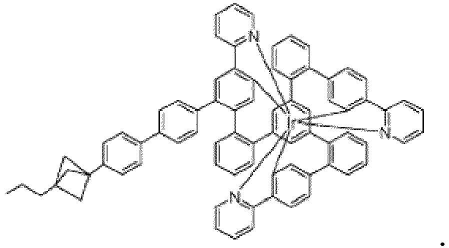

2. Compound according to Claim 1, **characterized in that** L¹ has a structure of one of the formulae (2a') to (2d') 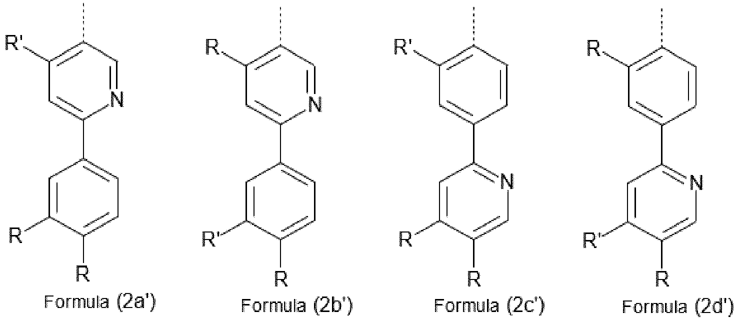 where the symbols used have the definitions given in Claim 1.

3. Compound according to Claim 1 or 2, **characterized in that** the two substituents R" bonded in the ortho positions to the carbon atom by which the group of the formula (3) is bonded to the phenylpyridine ligands in this group are the same or different and are H or D.

4. Compound according to one or more of Claims 1 to 3, **characterized in that** the structure of the formula (3) is selected from the structures of the formulae (3a) to (3n) 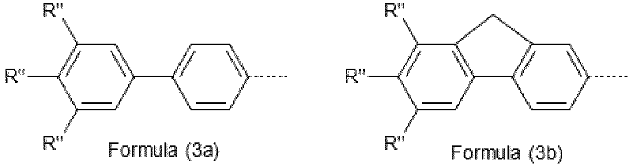 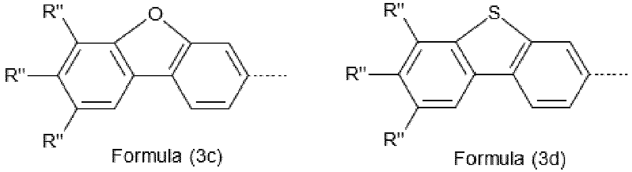 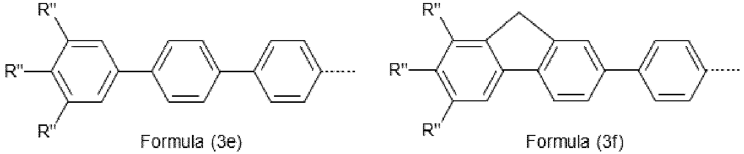 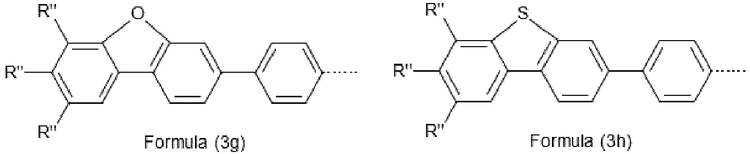 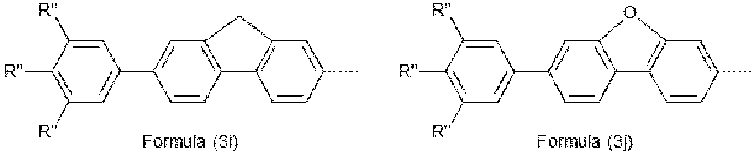 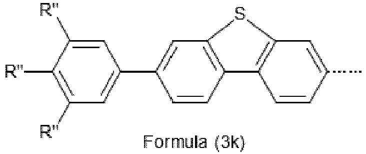 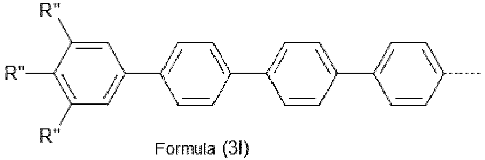 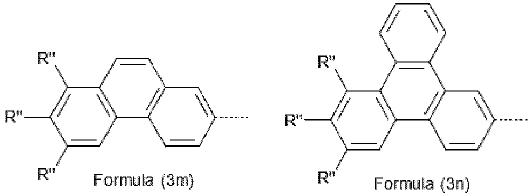 where the symbols used have the definitions given in Claim 1 and where the fluorene group in the 9 position may also be substituted by one or two alkyl groups each having 1 to 6 carbon atoms.

5. Compound according to one or more of Claims 1 to 4, **characterized in that** the substituents R" are the same or different at each instance and are selected from the group consisting of H, D, CN and an alkyl group having 1 to 4 carbon atoms.

6. Compound according to one or more of Claims 1 to 5, **characterized in that** the structure fragment Ir(L²) has a higher triplet energy than the structure fragment Ir(L¹).

7. Compound according to one or more of Claims 1 to 6, **characterized in that** L² is the same or different at each instance and is a structure of the formula (L-1), (L-2) or (L-3) 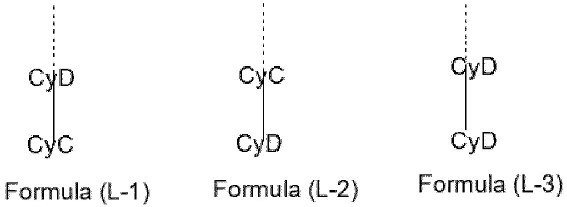
where the dotted bond represents the bond of the sub-ligand to V and the other symbols used are as follows:
CyC is the same or different at each instance and is an R-substituted or unsubstituted aryl or heteroaryl group which has 5 to 14 aromatic ring atoms and coordinates in each case to the metal via a carbon atom and which is bonded to CyD via a covalent bond;
CyD is the same or different at each instance and is an R-substituted or unsubstituted heteroaryl group which has 5 to 14 aromatic ring atoms and coordinates to the metal via a nitrogen atom or via a carbene carbon atom and which is bonded to CyC via a covalent bond;
at the same time, two or more of the substituents R together may form an aliphatic or heteroaliphatic ring system, and CyC and CyD may be joined to one another by a group of one of the formulae (17) to (26) : 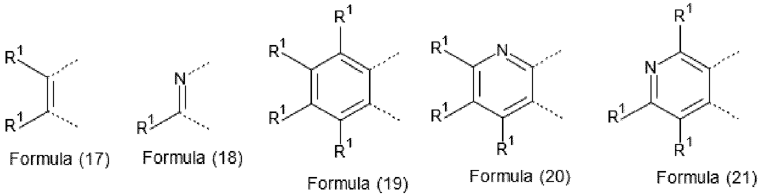 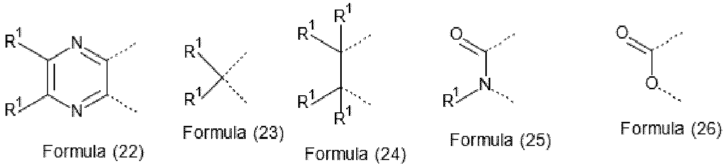
where R¹ has the definitions given in Claim 1 and the dotted bonds indicate the bonds to CyC or CyD.

8. Compound according to one or more of Claims 1 to 7, **characterized in that** the compound has two substituents R or two substituents R¹ which are bonded to adjacent carbon atoms and which together form a ring of one of the formulae (27) to (33), 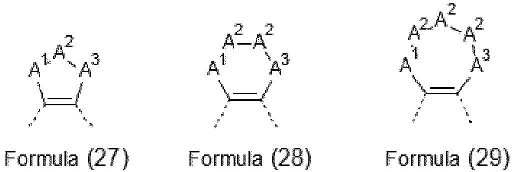 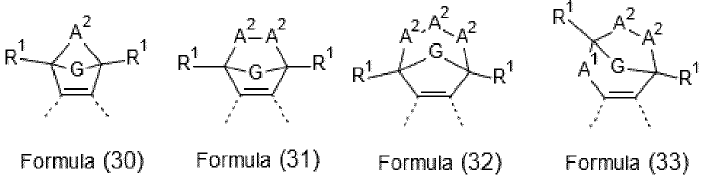
where R¹ and R² have the definitions given in Claim 1, the dotted bonds signify the linkage of the two carbon atoms in the ligand and, in addition:
A¹, A³ is the same or different at each instance and is C(R³)₂, O, S, NR³ or C(=O);
A² is C(R¹)₂, O, S, NR³ or C(=O);
G is an alkylene group which has 1, 2 or 3 carbon atoms and may be substituted by one or more R² radicals, -CR²=CR²- or an ortho-bonded arylene or heteroarylene group which has 5 or 6 aromatic ring atoms and may be substituted by one or more R² radicals;
R³ is the same or different at each instance and is H, F, OR², a straight-chain alkyl group having 1 to 10 carbon atoms, a branched or cyclic alkyl group having 3 to 10 carbon atoms, where the alkyl group in each case may be substituted by one or more R² radicals, where one or more nonadjacent CH₂ groups may be replaced by R²C=CR², C=C, Si(R²)₂, C=O, NR², O, S or CONR², or an aryl or heteroaryl group which has 5 or 6 aromatic ring atoms and may be substituted in each case by one or more R² radicals; at the same time, two R³ radicals which are bonded to the same carbon atom may together form an aliphatic ring system and thus form a spiro system; in addition, R³ with an adjacent R or R¹ radical may form an aliphatic ring system;
with the proviso that no two heteroatoms and no two C=O groups are bonded directly to one another.

9. Process for preparing a compound according to one or more of Claims 1 to 8 by reacting the appropriate ligand with iridium alkoxides of the formula (34), iridium ketoketonates of the formula (35), iridium halides of the formula (36), iridium carboxylates of the formula (37) or iridium compounds which bear both alkoxide and/or halide and/or hydroxyl and ketoketonate radicals, 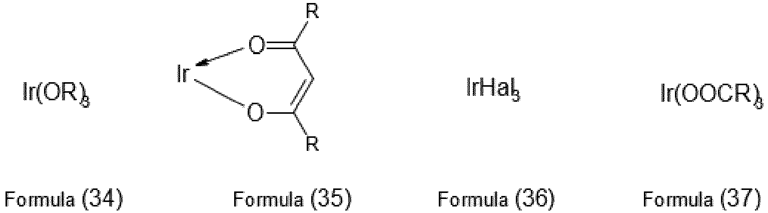 where R has the definitions given in Claim 1, Hal = F, Cl, Br or I and the iridium reactant may also be in the form of the corresponding hydrate.

10. Formulation comprising at least one compound according to one or more of Claims 1 to 8 and at least one solvent and/or a further organic or inorganic compound.

11. Use of a compound according to one or more of Claims 1 to 8 in an electronic device or as oxygen sensitizer or as photoinitiator or photocatalyst.

12. Electronic device comprising at least one compound according to one or more of Claims 1 to 8.

13. Electronic device according to Claim 12, **characterized in that** it is an organic electroluminescent device and the compound according to one or more of Claims 1 to 8 is present together with a matrix material in one or more emitting layers.

## Revendications

1. Composé de formule (1), 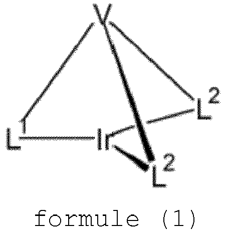
ce qui suit s'appliquant aux symboles utilisés :
L¹ étant un ligand partiel selon l'une des formules (2a) à (2d), qui se coordine à l'iridium par l'intermédiaire des deux groupes D et qui est lié à V par l'intermédiaire de la liaison en pointillés, 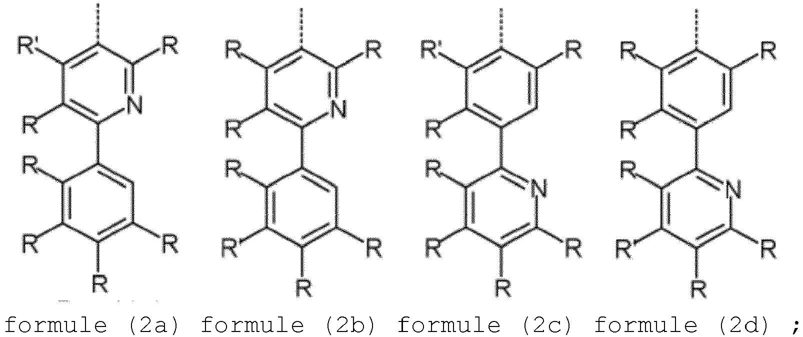
R' étant un groupe de formule (3) 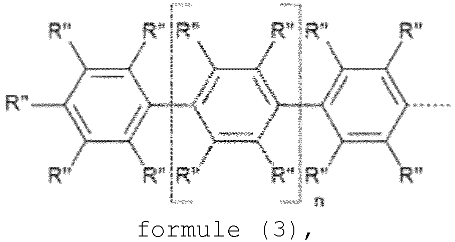
la liaison en pointillés indiquant la connexion du groupe ;
R", identique ou différent en chaque occurrence, étant H, D, F, CN, un groupe alkyle linéaire comportant 1 à 10 atomes de C, dans lequel également un ou plusieurs atomes de H peuvent être remplacés par D ou F, ou un groupe alkyle ramifié ou cyclique comportant 3 à 10 atomes de C, dans lequel également un ou plusieurs atomes de H peuvent être remplacés par D ou F, ou un groupe alcényle comportant 2 à 10 atomes de C, dans lequel également un ou plusieurs atomes de H peuvent être remplacés par D ou F ; à cet égard, deux radicaux R" adjacents ou deux radicaux R" au niveau de groupes phényle adjacents pouvant également former un système cyclique l'un avec l'autre ; ou deux R" au niveau de groupes phényle adjacents représentant ensemble un groupe choisi parmi O et S, de sorte que les deux cycles phényle, conjointement avec le groupe pontant, représentent un dibenzofuranne ou dibenzothiophène, et les autres R" étant définis comme précédemment ;
n étant 0, 1, 2, 3, 4 ou 5 ;
L², identique ou différent en chaque occurrence, étant un ligand partiel bidentate, monoanionique, qui se coordine à l'iridium par l'intermédiaire d'un atome de carbone et d'un atome d'azote ou par l'intermédiaire de deux atomes de carbone ou par l'intermédiaire de deux atomes d'azote et qui peut être substitué par un ou plusieurs radicaux R ;
V étant un groupe de formule (6b) ou (7b), les liaisons en pointillés indiquant la position de la connexion des ligands partiels L¹ et L², 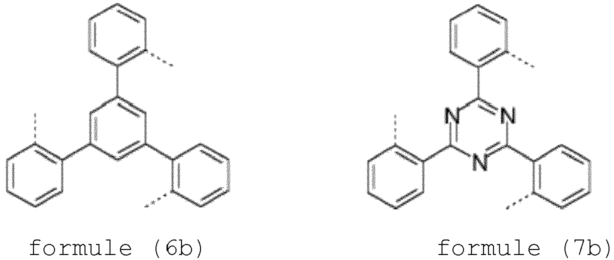
R, identique ou différent en chaque occurrence, étant H, D, F, Cl, Br, I, N(R¹)₂, OR¹, SR¹, CN, NO₂, COOH, C(=O)N(R¹)₂, Si(R¹)₃, B(OR¹)₂, C(=O)R¹, P(=O) (R¹)₂, S(=O)R¹, S(=O)₂R¹, OSO₂R¹, un groupe alkyle linéaire comportant 1 à 20 atomes de C ou un groupe alcényle ou alcynyle comportant 2 à 20 atomes de C ou un groupe alkyle ramifié ou cyclique comportant 3 à 20 atomes de C, le groupe alkyle, alcényle ou alcynyle pouvant chaque fois être substitué par un ou plusieurs radicaux R¹ et un ou plusieurs groupes CH₂ non adjacents pouvant être remplacés par Si(R¹)₂, C=O, NR¹, O, S ou CONR¹, ou un groupe aryle ou hétéroaryle comportant 5 à 10 atomes de cycle aromatique, qui à chaque fois peut être substitué par un ou plusieurs radicaux R¹ non aromatiques ; à cet égard, deux radicaux R pouvant également former l'un avec l'autre un système cyclique aliphatique ou hétéroaliphatique ;
R¹, identique ou différent en chaque occurrence, étant H, D, F, Cl, Br, I, N(R²)₂, OR², SR², CN, NO₂, Si(R²)₃, B(OR²)₂, C(=O)R², P(=O)(R²)₂, S(=O)R², S(=O)₂R², OSO₂R², un groupe alkyle linéaire comportant 1 à 20 atomes de C ou un groupe alcényle ou alcynyle comportant 2 à 20 atomes de C ou un groupe alkyle ramifié ou cyclique comportant 3 à 20 atomes de C, le groupe alkyle, alcényle ou alcynyle pouvant chaque fois être substitué par un ou plusieurs radicaux R² et un ou plusieurs groupes CH₂ non adjacents pouvant être remplacés par Si(R²)₂, C=O, NR², O, S ou CONR², ou un groupe aryle ou hétéroaryle comportant 5 à 10 atomes de cycle aromatique, qui à chaque fois peut être substitué par un ou plusieurs radicaux R² non aromatiques ; à cet égard, deux radicaux R¹ ou plus pouvant également former l'un avec l'autre un système cyclique aliphatique ou hétéroaliphatique ;
R², identique ou différent en chaque occurrence, étant H, D, F ou un radical organique aliphatique, en particulier un radical hydrocarboné, comportant 1 à 20 atome de C, dans lequel également un ou plusieurs atomes de H peuvent être remplacés par F ;
à cet égard, les trois ligands partiels bidentates L¹ et L² pouvant être fermés, outre par le pont V, encore également par un autre pont pour donner un cryptate ;
à cet égard, le composé suivant étant exclu de l'invention :

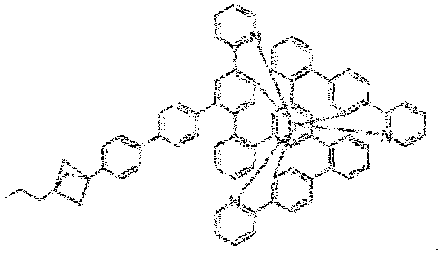

2. Composé selon la revendication 1, **caractérisé en ce que** L¹ présente une structure selon l'une des formules (2a') à (d') 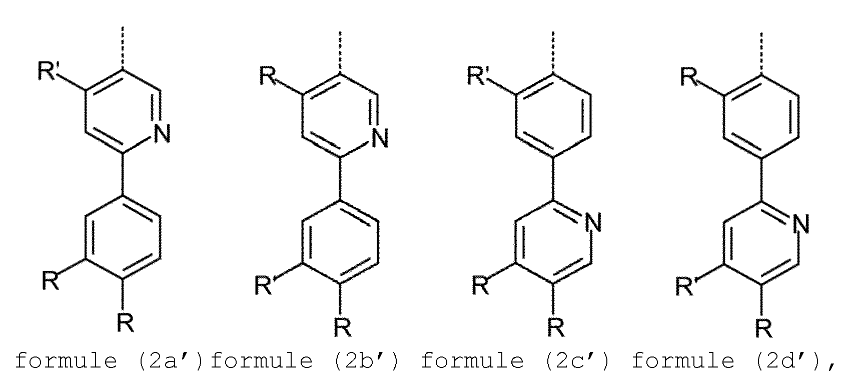 les symboles utilisés présentant les significations mentionnées dans la revendication 1.

3. Composé selon la revendication 1 ou 2, **caractérisé en ce que** dans le groupe de formule (3), les deux substituants R'', qui sont liés dans les positions ortho par rapport à l'atome de carbone, avec lequel ce groupe est lié aux ligands phénylpyridine, sont, de manière identique ou différente, H ou D.

4. Composé selon l'une ou plusieurs des revendications 1 à 3, **caractérisé en ce que** la structure de formule (3) est choisie parmi les structures des formules (3a) à (3n), 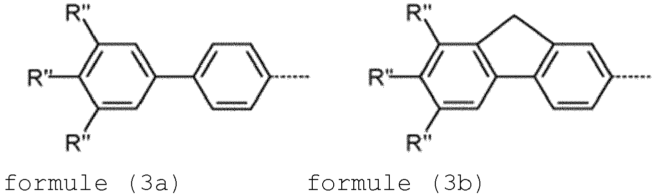 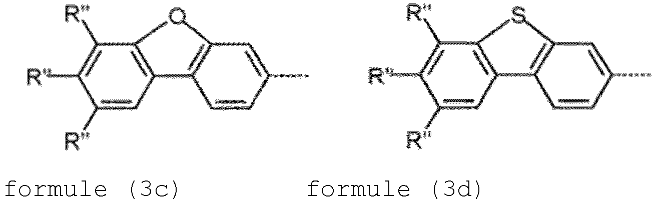 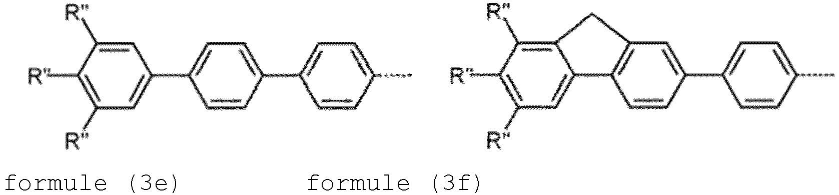 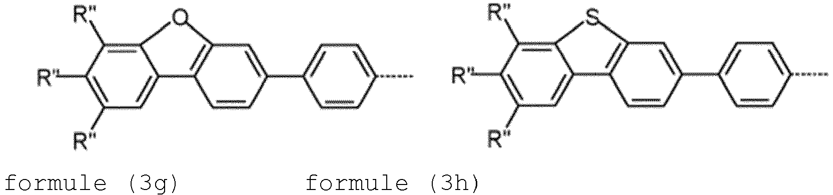 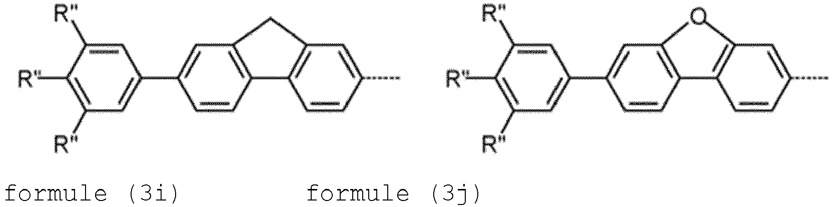 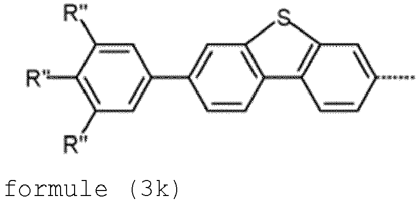 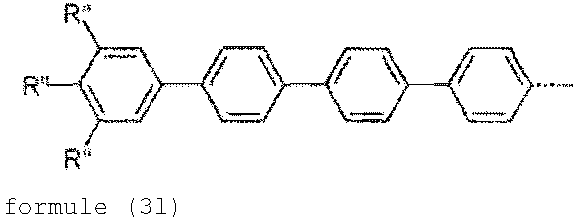 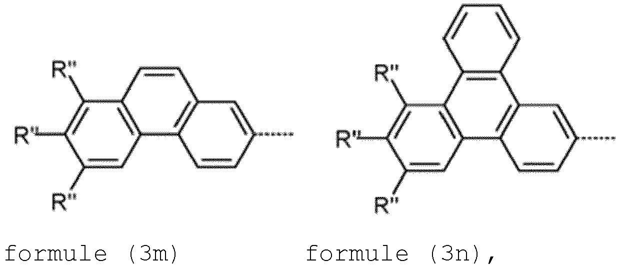 les symboles utilisés présentant les significations mentionnées dans la revendication 1 et le groupe fluorène en position 9 pouvant encore être substitué par un ou deux groupes alkyle comportant à chaque fois 1 à 6 atomes de C.

5. Composé selon l'une ou plusieurs des revendications 1 à 4, **caractérisé en ce que** les substituants R", identiques ou différents en chaque occurrence, sont choisis dans le groupe constitué par H, D, CN et un groupe alkyle comportant 1 à 4 atomes de C.

6. Composé selon l'une ou plusieurs des revendications 1 à 5, **caractérisé en ce que** le fragment de structure Ir(L²) présente une énergie de triplet plus élevée que le fragment de structure Ir(L¹).

7. Composé selon l'une ou plusieurs des revendications 1 à 6, **caractérisé en ce que** L², identique ou différent en chaque occurrence, représente une structure selon la formule (L-1), (L-2) ou (L-3), 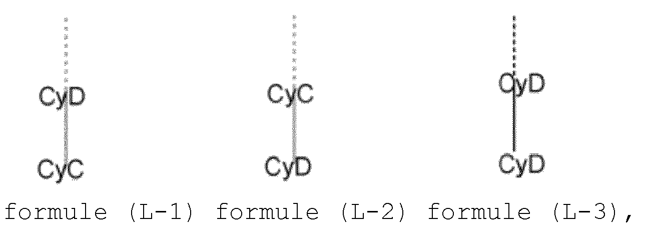
la liaison en pointillés indiquant la liaison du ligand partiel à V et ce qui suit s'appliquant aux autres symboles utilisés :
CyC, identique ou différent en chaque occurrence, étant un groupe aryle ou hétéroaryle substitué ou non substitué par R comportant 5 à 14 atomes de cycle aromatique, qui se coordine au métal à chaque fois par intermédiaire d'un atome de carbone et qui est relié à CyD par l'intermédiaire d'une liaison covalente ;
CyD, identique ou différent en chaque occurrence, étant un groupe hétéroaryle substitué ou non substitué par R comportant 5 à 14 atomes de cycle aromatique, qui se coordine au métal par intermédiaire d'un atome d'azote ou par l'intermédiaire d'un atome de carbone de carbène et qui est relié à CyC par l'intermédiaire d'une liaison covalente ;
à cet égard, plusieurs des substituants R pouvant former un système cyclique aliphatique ou hétéroaliphatique les uns avec les autres, et CyC et CyD pouvant être reliés l'un à l'autre par un groupe selon l'une des formules (17) à (26), 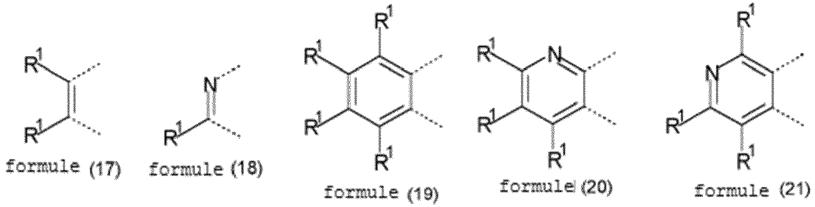 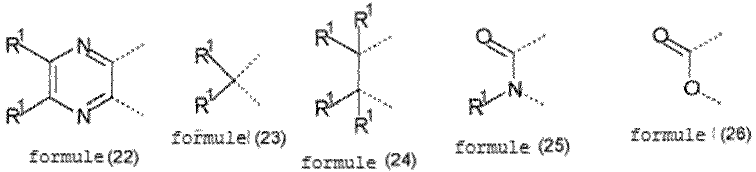
R¹ présentant les significations mentionnées dans la revendication 1 et les liaisons en pointillés indiquant les liaisons à CyC ou CyD.

8. Composé selon l'une ou plusieurs des revendications 1 à 7, **caractérisé en ce que** le composé contient deux substituants R ou deux substituants R¹, qui sont liés à des atomes de carbone adjacents et qui forment l'un avec l'autre un cycle selon l'une des formules (27) à (33), 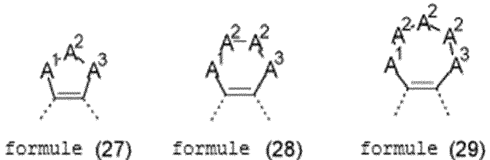 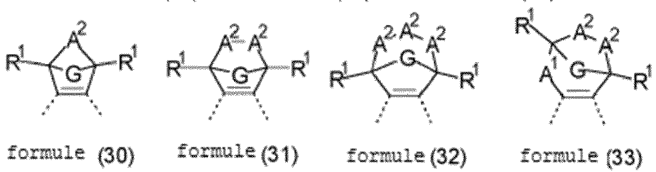
R¹ et R² présentant les significations mentionnées dans la revendication 1, les liaisons en pointillés indiquant la connexion des deux atomes de carbone dans le ligand et en outre :
A¹, A³, identiques ou différents en chaque occurrence, étant C(R³)₂, O, S, NR³ ou C(=O);
A² étant C(R¹)₂, O, S, NR³ ou C(=O);
G étant un groupe alkylène comportant 1, 2 ou 3 atomes de C, qui peut être substitué par un ou plusieurs radicaux R², -CR²=CR²⁻ ou un groupe arylène ou hétéroarylène lié en ortho comportant 5 ou 6 atomes de cycle aromatique qui peut être substitué par un ou plusieurs radicaux R² ;
R³, identique ou différent en chaque occurrence, étant H, F, OR², un groupe alkyle linéaire comportant 1 à 10 atomes de C, un groupe alkyle ramifié ou cyclique comportant 3 à 10 atomes de C, le groupe alkyle pouvant à chaque fois être substitué par un ou plusieurs radicaux R², un ou plusieurs groupes CH₂ non adjacents pouvant être remplacés par R²C=CR², C=C, Si(R²)₂, C=O, NR², O, S ou CONR², ou un groupe aryle ou hétéroaryle comportant 5 ou 6 atomes de cycle aromatique, qui peut à chaque fois être substitué par un ou plusieurs radicaux R² ; à cet égard, deux radicaux R³ qui sont liés au même atome de carbone pouvant former l'un avec l'autre un système cyclique aliphatique et définir ainsi un système spiro ; en outre, R³ pouvant former un système cyclique aliphatique avec un radical R ou R¹ adjacent ;
à la condition que deux hétéroatomes et deux groupes C=O ne soient pas directement liés l'un à l'autre.

9. Procédé pour la préparation d'un composé selon l'une ou plusieurs des revendications 1 à 8 par transformation du ligand correspondant avec des alcoolates d'iridium de formule (34) des cétocétonates d'iridium de formule (35), des halogénures d'iridium de formule (36), des carboxylates d'iridium de formule (37) ou des composés de l'iridium qui portent aussi bien des radicaux alcoolate et/ou halogénure et/ou hydroxy qu'également des radicaux cétocétonate, 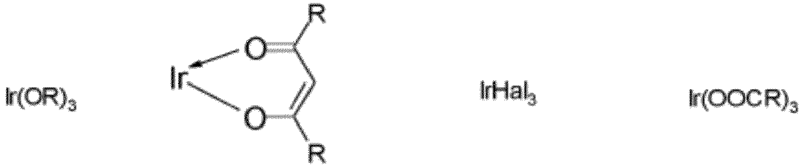 R possédant les significations mentionnées dans la revendication 1, Hal = F, Cl, Br ou I et l'éduit d'iridium pouvant être présent également en tant qu'hydrate correspondant.

10. Formulation contenant au moins un composé selon l'une ou plusieurs des revendications 1 à 8 et au moins un solvant et/ou un composé organique ou inorganique supplémentaire.

11. Utilisation d'un composé selon l'une ou plusieurs des revendications 1 à 8 dans un dispositif électronique ou en tant que sensibilisateur à l'oxygène ou en tant que photoinitiateur ou photocatalyseur.

12. Dispositif électronique contenant au moins un composé selon l'une ou plusieurs des revendications 1 à 8.

13. Dispositif électronique selon la revendication 12, **caractérisé en ce qu'**il s'agit d'un dispositif électroluminescent organique et le composé selon l'une ou plusieurs des revendications 1 à 8, conjointement avec un matériau de matrice, est présent dans une ou plusieurs couches émettrices.
